# EUROPEAN PATENT SPECIFICATION

(11) **EP 1 977 510 B1**
(45) Date of publication and mention of the grant of the patent: **23.03.2011**
(21) Application number: 06777144.4
(22) Date of filing: 01.09.2006
(51) Int. Cl.: H03H 17/02

(54) **EFFICIENT FILTERING WITH A COMPLEX MODULATED FILTERBANK**
EFFIZIENTE FILTERUNG MIT EINER KOMPLEX MODULIERTEN FILTERBANK
FILTRAGE EFFICACE AVEC UNE BATTERIE DE FILTRES MODULÉS COMPLEXES

(30) Priority: 27.01.2006 US 762592 P; 10.04.2006 US 744559 P
(43) Date of publication of application: 08.10.2008
(60) Divisional application: 10194523.6
(73) Proprietor: Dolby International AB, 1101 BA Amsterdam (NL)
(72) Inventor: VILLEMOES, Lars, S-175 56 Järfälla (SE)
(74) Representative: Zinkler, Franz
(86) International application number: PCT/EP2006/008565
(87) International publication number: WO 2007/085275

(56) References cited:
- EP-A1- 0 531 242
- WO-A2-2004/097794
- US-B1- 6 236 731

## Description

### TECHNICAL FIELD

The present invention relates to a filter apparatus and a method for filtering a time domain input signal, a filter generator and a method for generating an intermediate filter definition signal, especially for the field of encoding, decoding, manipulating and filtering of audio signals, e.g. in the field of HRTF (head related transfer function).

### BACKGROUND OF THE INVENTION

It has been shown in [P. Ekstrand, "Bandwidth extension of audio signals by spectral band replication", Proc. 1st IEEE Benelux Workshop on Model based Processing and Coding of Audio (MPCA-2002), pp. 53-58, Leuven, Belgium, 2002], that a complex-exponential modulated filter bank is an excellent tool for spectral envelope adjustment of audio signals. One application of this feature is audio coding based on Spectral Band Replication (SBR). Other fruitful applications of a complex filter bank include frequency selective panning and spatialization for parametric stereo, see [E. Schuijers, J. Breebart, H. Purnhagen, J. Engdegård: "Low complexity parametric stereo coding", Proc. 116th AES convention, 2004, paper 6073] and parametric multichannel coding, see [J. Herre et al.: "The reference model architecture for MPEG spatial audio coding", Proc. 118th AES convention, 2005, paper 6447]. In those applications the frequency resolution of the complex filter bank is further enhanced at low frequencies by means of sub-subband filtering. The combined *hybrid* filter bank hereby achieves a frequency resolution that enables the processing of spatial cues at a spectral resolution which closely follows the spectral resolution of the binaural auditory system.

In some applications, however, the resolution of the filter bank is still insufficient, in the sense that simple gain modifications in each subband do not suffice to truthfully model the action of a given filter. For binaural rendering of multi-channel audio by means of HRTF (head related transfer function) related filtering, the intricate phase characteristics of the filters are important for the perceived audio quality. It is of course possible to apply fast convolution methods based on the DFT (Discrete Fourier Transform) as a post-process to the multi-channel rendering, but if the rendering device already contains the signals in the subband domain of complex exponential modulated filter bank, there are significant advantages in terms of computational complexity and algorithmic integration in performing the HRTF derived filtering in the subband domain, which will be outlined in more detail later. Since HRTF's are different for each individual and the derived filters depend on virtual source and/or listener positions which can for instance be changed by control signals, user interfaces or by other description signals, it is also important to be able to efficiently convert a given HRTF related filter into subband domain filters.

The EP 0531242 A1 relates to a method of matched parcelling into sub-bands suppressing or strongly limiting spectral aliasing comprising the steps of transforming a digital source signal into at least two distinct frequency sub-bands, processing each of the frequency sub-bands by filtering incorporating the steps of defining a global filtering profile, determining a set of partial filtering profiles each associated with one of the sub-bands, and filtering each of the sub-bands according to the partial filtering profile associated with it. The method furthermore comprises inversely transforming the filtered sub-bands, delivering a reconstructed filtered signal, wherein the partial filtering profiles determined during the determination step are constrained in such a way that said reconstructed filtered signal corresponds substantially to the direct filtering of the digital source signal according to the global filtering profile. In particular, these partial profiles are constrained in such a way that the spectral aliasing still present after filtering is substantially compensated.

It is therefore the object of the present invention to provide a filter apparatus for filtering a time domain input signal or a method for filtering a time domain input signal, which allow a more efficient or a more flexible manipulation of a time domain input signal with a better quality.

### SUMMARY OF THE INVENTION

This object is achieved by a filter apparatus according to claim 1, by a method for filtering a time domain input signal according to claim 23 or by a computer program according to claim 24.

Embodiments of the present invention are based on the finding that a more efficient and/or a more flexible filtering (or manipulation)of a time domain input signal can be achieved in the subband domain, which is sometimes also referred to as QMF domain (quadrature mirror filter), with a better quality compared to other manipulation schemes. The gain with respect to efficiency, especially computational efficiency, is a consequence of the shorter impulse responses of the intermediate filters compared to the impulse response of a filter having the non-uniform filter characteristic in the time domain and the fact that the subband signals can be processed independently from one another. Due to the shorter impulse responses an embodiment of a filter apparatus can process each complex subband signals output by the complex analysis filter bank individually. Hence, the filtering can be carried out parallely, which speeds up the processing of the time domain input signal dramatically compared to manipulating the time domain input signal directly due to the shorter impulse responses.

Embodiments of the present invention are especially favorable when it comes to balancing computational efficiency on the one hand and quality on the other hand. While a direct processing of the time domain input signal in the time domain can be achieved by a convolution with the impulse response of a filter having the non-uniform amplitude/frequency characteristic, which usually leads to a very good quality, the convolution requires a high computational effort because of the length of the impulse response of the filter in the time domain.

On the other hand, transforming an audio signal into the frequency domain by performing a Fourier transformation represents the tremendous drawback that other manipulations, which are necessary in modern acoustical systems, cannot be efficiently performed in the Fourier domain with a high quality.

Hence, by employing a plurality of intermediate filters, each having a shorter impulse response compared to an impulse response of a filter having the filter characteristic of a corresponding filter in the time domain, of which at least one has an impulse response with at least two non-vanishing values represents a highly favorable compromise between computational efficiency on the one hand and quality on the other hand. As a consequence, embodiments of inventive filter apparatuses represent an excellent compromise between a direct processing of the time domain input signal for instance by means of convoluting the time domain input signal with the longer impulse response indicative of the non-uniform filter characteristic, which leads to an enormous computational effort, and employing a Fourier transform, which leads to more problems in the further course of processing the signals.

The advantages of the embodiments of the present invention unfold especially in the context of FIR-filters (final impulse response), as each of the intermediate filters of the plurality of intermediate filters has a significantly shorter impulse response compared to the impulse response of the FIR-filter in the time domain. Hence, by parallely processing the different subband signals output by the complex analysis filter bank the computational efficiency can drastically be improved. This aspect is especially important in the field of filters having long impulse responses. One field of application, in which filters with very long impulse responses frequently occur, are HRTF-related applications (HRTF = head related transfer function), like for instance down-mixing multiple channel audio signals for feeding to headphones, other head-related speaker systems or stereo sound systems.

In many concrete applications the computational efficiency is even more increased, as the audio signals are already present in the (complex) subband or QMF domain. Hence, in many concrete implementations, the complex analysis filter bank and the complex synthesis filter bank for generating the plurality of complex subband signals from the time domain input signal and for synthesizing the time domain output signal are already present.

### BRIEF DESCRIPTION OF THE DRAWINGS

The present invention will now be described by way of illustrative examples; not limiting the scope or spirit of the invention, with reference to the accompanying drawings, in which:
Fig. la illustrates the processing of a digital audio signal by means of subband filtering in a system comprising a filter generator and a filter apparatus;
Fig. 1b illustrates a possible solution for a complex analysis bank;
Fig. 1c illustrates a possible solution for a complex synthesis filter bank;
Fig. 1d illustrates a further possible solution for a complex synthesis filter bank;
Fig. le illustrates an interplay of an embodiment of a filter generator with a plurality of intermediate filters of an embodiment of a filter apparatus;
Fig. 2 illustrates the processing of a digital audio signal by.means of direct form filtering;
Fig. 3 illustrates a preferred embodiment of a system with a filter converter;
Fig. 4 illustrates a given filter impulse response;
Fig. 5 illustrates an impulse response obtained by complex gain adjustment of subbands;
Fig. 6 illustrates the magnitude response of a given filter;
Fig. 7 illustrates the magnitude response of a filter obtained by complex gain adjustment of subbands;
Fig. 8 compares the performance of the present invention with complex gain adjustment of subbands;
Fig. 9 illustrates a preferred embodiment of a filter apparatus comprising an optional embodiment of a filter generator and further components;
Fig. 10 illustrates a filter characteristic along with several frequency bands for different subbands; and
Fig. 11 illustrates a preferred embodiment of a filter generator.

### DESCRIPTION OF PREFERRED EMBODIMENTS

The below-described embodiments are merely illustrative for the principles of the present invention of efficient filtering with a complex modulated filterbank. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

In the following, objects with the same or similar functional properties are denoted with the same reference signs. Unless explicitly noted otherwise, the description with respect to objects with similar or equal functional properties can be exchanged with respect to each other.

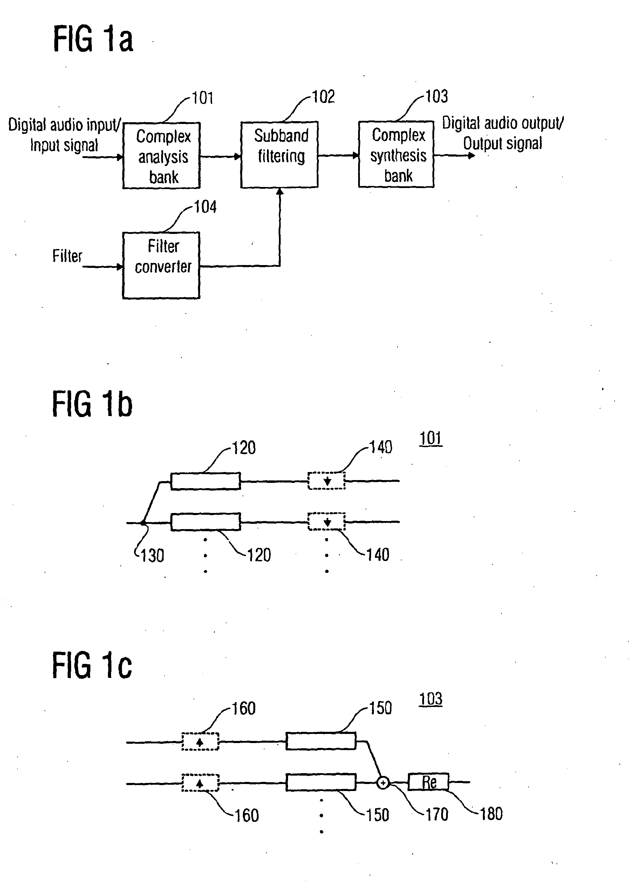

Figure la illustrates in the form of a system comprising embodiments of both a filter apparatus and a filter generator the processing of a digital audio signal by means of subband filtering according to the present invention. This signal path can for instance represent a part of a spatial audio rendering system where the input is a received audio channel and the output is a component of a signal to be played back at the right ear. The input signal (Digital audio signal or time domain input signal) is analyzed by the complex analysis bank **101** by means of filtering with a set of *L* analysis filters followed by downsampling of a factor *L*, wherein *L* is a positive integer, preferably larger than 1. Typically the factor *L* is a power of 2, preferably *L* = 64. The analysis filters are usually obtained by a complex modulation of a prototype filter *p*(*v*), wherein *v* is a positive integer indicating an index in an array of data or an index of a value in a signal not downsampled by factor *L.* The output of the filter bank consists of *L* subband signals that are processed by a subband filtering **102.** This subband filtering consists of a combination of manipulations such as subband gain adjustment according to received control data and application of finite impulse response filters applied separately in each subband. The filter taps of the subband filters are obtained from an (inventive) filter converter **104** as an embodiment of a filter generator which takes as input a filter described by direct form filter taps, a frequency domain description or an impulse response (signal). The complex synthesis bank **103** reconstructs an output signal by means of upsampling by a factor *L,* filtering by *L* synthesis filters, summation of all the results, and extraction of the real part. The summation of all the results and the extraction of the real part can also be switched with respect to their order, as will be outlined more closely with respect to Figs. 1c and ld.

Fig. 1b shows a complex analysis bank **101** in more detail. The complex analysis bank **101** comprises a plurality of *L* intermediate analysis filters **120** for each subband to be output by complex analysis bank **101.** To be more precise, each of the *L* intermediate analysis filters **120** is connected in parallel to a node **130** to which the time domain input signal to be processed is provided. Each of the intermediate analysis filters **120** is adapted for filtering the input signal of the complex analysis bank **101** with respect to a center frequency of each subband. According to the center frequencies of the different subbands, each subband is labeled by a subband index or index *n*, wherein *n* is a non-negative integer, typically in the range from 0 to *L*-1. The intermediate analysis filters **120** of the complex analysis bank **101** can be derived from a prototype filter *p*(ν) by a complex modulation according to the subband index *n* of the subband to which the intermediate analysis filter **120** is applied. More details concerning the complex modulation of a prototype filter are explained below.

Either directly by the intermediate analysis filters **120** or by an optional downsampler **140** (denoted by doted line in Fig. 1b) the sampling frequency of the signal output by the intermediate analysis filter bank **120** is reduced by a factor *L.* As mentioned before, the downsamplers **140** supplied to each subband signal output by the corresponding intermediate analysis filters **120** are optional as, depending on the concrete implementation, the downsampling can also be carried out in the frame work of the intermediate analysis filters **120.** In principle, downsampling the signal output by the intermediate analysis filters **120** is not required. Nevertheless, the presence of the explicit or implicit downsamplers **140** is a preferred option as the amount of data provided by the complex analysis bank **101** would alternatively be raised by a factor of *L,* leading to a significant redundancy of data.

Fig. lc illustrates a possible solution for a complex synthesis bank **103,** The complex synthesis bank **103** comprises *L* intermediate synthesis filters to which the *L* subband signals from the subband filtering **102** are provided to. Depending on the concrete implementation of the complex synthesis bank **103** prior to the filtering in the frame work of the intermediate synthesis filters **150,** the subband signals are upsampled by *L* upsampler **160,** which reconstruct the sampled frequency of the subband signals by increasing the sampling frequency by a factor of *L.* In other words, the optional upsampler **160** reconstruct or reform the subband signals provided to the upsampler **160** in such a way that the information contained in each of the subband signals is retained while the sampling frequency is increased by a factor of *L.* Nevertheless, as already explained in the context of Fig. 1b, the upsamplers **160** are optional components, as the upsampling can also be carried out in the frame work of the intermediate synthesis filters **150.** Hence, the step of upsampling the subband signals carried out by the upsampler **160** can be simultaneously processed in the frame work of the intermediate synthesis filers **150.** If, however, the downsamplers **190** are neither explicitly nor implicitly implemented, the upsamplers **160** do not have to be implemented explicitly or implicitly.

The intermediate synthesis filters **150** are connected via an output to an adder **170** which sums up the filtered subband signals output by the *L* intermediate synthesis filters **150.** The adder **170** is further connected to a real part extractor **180,** which extracts or forms a real valued signal or rather a (real valued) time domain output signal based on the complex valued signal provided by the adder **170.** The real part extractor **180** can perform this task for instance by extracting the real part of a complex valued signal provided by the adder **170,** by calculating the absolute value of the complex valued signal provided by the adder **170** or by another method that forms a real valued output signal based on a complex valued input signal. In the case of the system shown in Fig. 1a, the signal output by the real part extractor **180** is the time domain output signal output by the embodiment of the inventive filter apparatus.

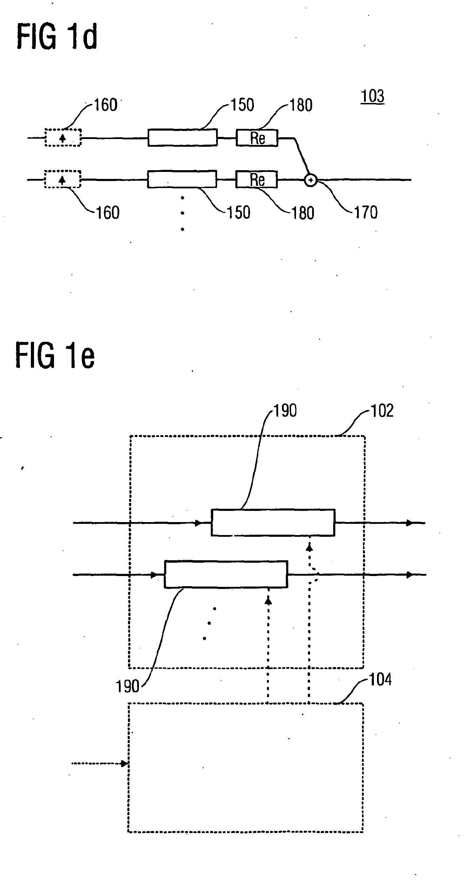

The second possible solution for a complex synthesis bank **103** shown in Fig. 1d differs from the first possible solution shown in Fig. 1c only concerning the real part extractors **180** and the adder **170.** To be more precise, the outputs of the intermediate synthesis filters **150** are connected separately from each subband to a real part extractor **180** extracting or forming a real valued signal based on the complex valued signal output by the intermediate synthesis filters **150.** The real part extractor **180** are then connected to the adder **170,** which sums up the *L* real valued signals derived from the *L* filtered subband signals to form the real valued output signal provided by the adder **170,** which in the case of the system shown in Fig. la is the time domain output signal.

Fig. 1e shows the subband filtering **102** and its interplay with the filter converter **104** in more details. The subband filtering 102 comprises a plurality of intermediate filters **190,** wherein one intermediate filter **190** is provided for each complex valued subband signal provided to the subband filtering **102.** Hence, the subband filtering **102** comprises *L* intermediate filters **190.**

The filter converter **104** is connected to each of the intermediate filters **190.** As a consequence, the filter converter **104** is capable of providing the filter taps for each of the intermediate filters **190** of the subband filtering **102.** More details concerning the filtering done by the intermediate filters **190** will be explained in the further course of the application. Hence, the filters taps provided to the different intermediate filters **190** and output by the filter converter **104** form the intermediate filter definition signal.

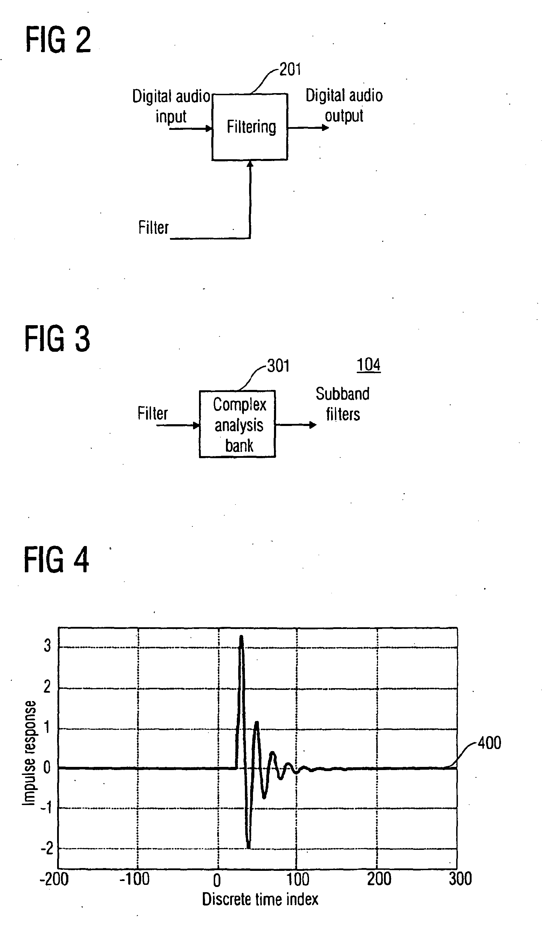

Furthermore, it should be noted that the embodiments, solutions and implementations can comprise additional and/or optional delays for delaying any of the signals or a subset of signals, which have been omitted in Fig. 1a to le for the sake of simplicity. Also in the Fig. 2 to 11 optional delays have been omitted for the sake of simplicity. Nevertheless, delays or delayers can be comprised in elements shown (e.g. filters) or added as optional elements in all embodiments depending on their concrete implementation.

Figure 2 illustrates the processing of a digital audio signal by means of direct form filtering **201.** If the same filter is given as input to the filter converter **104** of Fig. 1 and the direct filtering **201,** a design goal for the filter converter **104** is that the digital audio output of **103** should be perceptually (or audibly) indistinguishable from the digital audio output of the direct filtering **201,** if the digital audio inputs to the complex analysis bank **101** and the direct filtering **201** are identical and the processing in the direct filtering **102** consists of pure stationary subband filtering.

In the embodiment of the system shown in Fig. la to Fig. 1e the filter input to the filter converter **104** is given as a filter definition signal, which can for instance comprise the filter taps of a corresponding time domain filter, a frequency domain description (amplitude/frequency characteristic and/or phase/frequency characteristic) or an impulse response signal of the appropriate filter.

In the case of the direct filtering **201** the same filter definition signal can in principle be used. Depending on the concrete implementation and the filter definition signal, the filtering can be carried out by direct application of the filter taps in the frame work a digital filter, by a discrete Fourier transform along with a transfer function or another frequency domain description or by means of convolution with the impulse response signal.

Figure 3 illustrates a preferred embodiment of a filter converter **104** according to the present invention as an embodiment of a filter generator. The filter is assumed to be given by its impulse response. Viewing this impulse response as a discrete time signal, it is analyzed by an *L*-band complex analysis (filter) bank **301.** The resulting subband signal outputs are then exactly the impulse responses of filters to be applied separately in each subband in the subband filtering **102.** In the preferred embodiment shown in Fig. 3, the filter definition signal provided to the filter converter **104** and its complex analysis bank or complex analysis filter bank **301** is the impulse response signal indicative of the amplitude/frequency characteristic of a filter, which is to be transferred into the subband domain. Hence, the output of the complex analysis (filter) bank **301** of each of the *L* subbands represents the impulse response of the intermediate filters comprised in the subband filtering **102.**

The complex analysis bank **301** is in principle derived from the analysis bank **101** but it has a different prototype filter and a slightly different modulation structure, the details of which will be outlined in the following description. The same fast algorithms that are used for an implementation of the complex analysis bank **101** can be reused for complex analysis bank **301,** leading to a very fast and very efficient conversion process.

Moreover, the length of the prototype filter *q*(*v*) can be designed to be only a fraction of the length of the prototype filter *p*(*v*). Due to the downsampling by a factor *L,* the length of subband filters are also a factor of *L* smaller than the sum of the lengths of the given time domain filter and the prototype filter *q*(*v*). The computational effort is thus reduced in comparison to the direct form filtering **201** by approximately a factor of *L*/4. The offset factor of 4 is due to the replacement of real filtering with complex filtering. Another offset is the computational cost of the complex analysis and synthesis banks **101** and **103.** For efficient implementations this cost is comparable to the cost of rather short FIR filters, and hence negligible, as outlined before. Moreover, this offset of the reduction in computational cost does not exist for systems that already employs these two filter banks **101** and **103.**

Figure 4 illustrates an example of a given filter impulse response **400.** It consists of 192 (= 64·3) nonzero taps. In other words, the impulse response **400** shown in Fig. 4 comprises 192 non-vanishing values.

In the present application, a non-vanishing tap or value is a tap or a value which is ideally not equal to zero. Nevertheless, due to implementation restraints in the frame work of this application a non-vanishing value or tap is a real valued or complex valued tap or value with an absolute value which is larger than a predetermined threshold, e.g. 10^{-*s*} or 2^{-*s*}, wherein s is a positive integer depending on the requirements of a concrete-implementation. In digital systems this threshold is preferably defined in the binary system (basis 2), wherein the integer s has a predetermined value depending on the specifics of the implementation. Typically, the value s is 4, 5, 6, 7, 8, 10, 12, 14, 16 or 32.

The impulse response **400** of the system of Figure 1 is indistinguishable from this given impulse response at the resolution of the image, in a case where a *L* = 64 band filterbank with a prototype filter of length 640 (= 64·10) is applied and a prototype filter of length 192 (= 69·3) is used for the filter converter **104** of Figure 3. The corresponding intermediate subband filters have only 5 (= 3+3-1) taps each, as will be explained later.

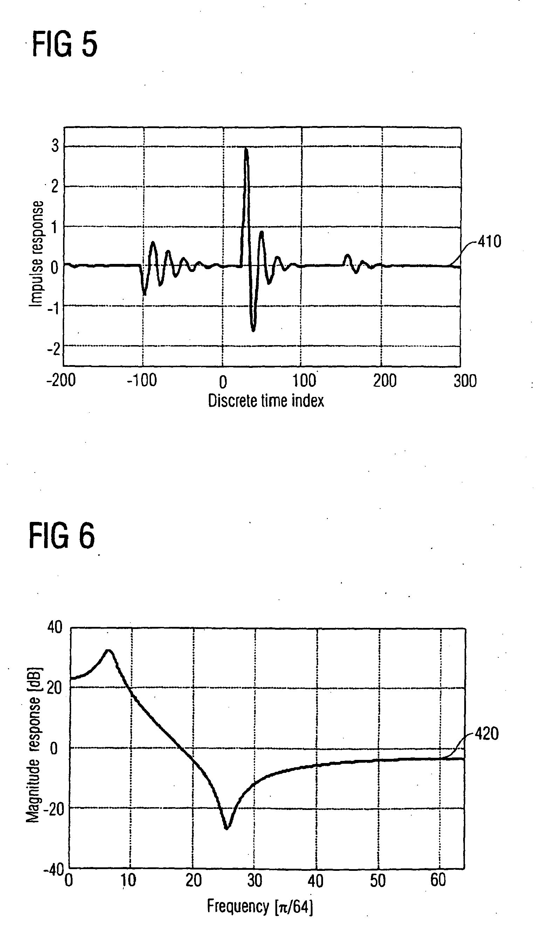

Figure 5 illustrates the impulse response **410** of the system of Figure 1 with a 64 band filterbank, in a special case corresponding to prior art usage for envelope adjustment and equalization. In this case, the subband filters or rather intermediate filters **190** are all of one tap only, so a constant complex gain is applied to each subband. For each subband, the corresponding gain is chosen to be equal to the complex frequency response of the filter of Figure 4 evaluated at the center frequency of the particular subband. As it can be seen from the result, there are severe pre-echo artefact and there will be a significant perceptual difference between the application of this filter response compared to the target impulse response **400** of figure 4.

Figure 6 illustrates the magnitude response **420** of the filter of Figure 4. The frequency scale of Fig. 6 is adjusted to the resolution of a 64 band filter bank (*L* = 64).

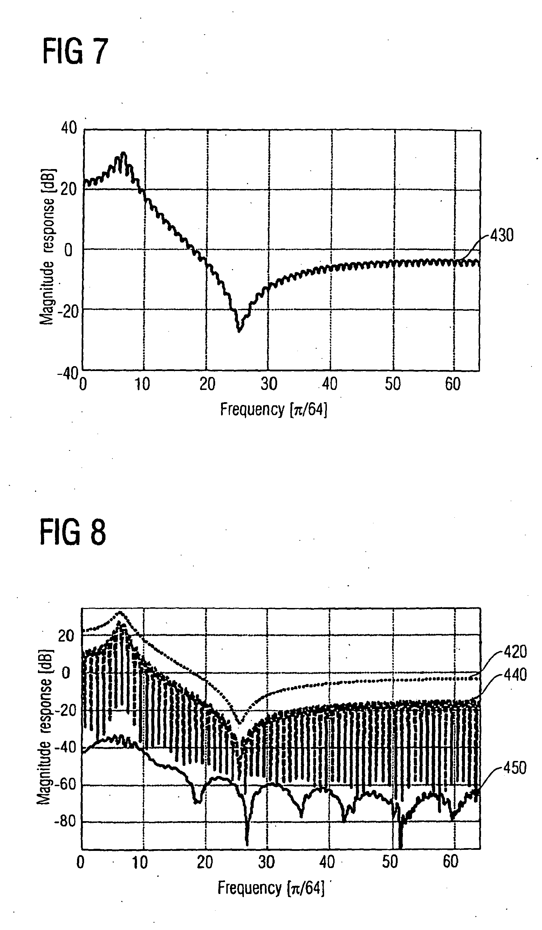

Figure 7 illustrates the magnitude response **430** of the filter underlying the impulse response **410** shown in Figure 5. As it can be seen, the usage of only one gain per subband results in a poor approximation to the desired frequency response. The main reason for this is the fast variation of the target phase spectrum. In fact, this prior art method is better suited at modeling linear phase responses.

Figure 8 finally compares the performance of an embodiment of the present invention and of the prior art method of complex gain adjustment of subbands. The dotted curve is a redrawing of the target magnitude response **420** of Figure 6. The dashed curve **440** is the magnitude response of the difference between the complex frequency responses of the target filter and its approximation by the prior art method. The solid curve **450** is the magnitude response of the difference between the complex frequency responses of the target filter and its approximation by the method taught by the present invention with the parameters as discussed during the description of Figure 4. As it can be seen, the error of the prior art method is small only at the 64 midpoints of filter bank subbands whereas the inventive method leads to an approximation quality in the 50 dB range. It should be pointed out that this is also the level of performance one measures when comparing the output of the inventive system to the output of the reference system for an arbitrary input signal.

As the comparison of the two curves **440** and **450** in Fig. 8 shows, an embodiment of an inventive filter apparatus, an embodiment of a filter generator and a system comprising both embodiments offer a significant advantage concerning the quality of the manipulation of an input signal. The significant difference concerning the quality of filtering (or manipulation) of the input signal outlined above is a consequence of the fact that at least one of the intermediate filters 190 has an impulse response with two or more non-vanishing values. In other words, at least one of the intermediate filters **190** comprises at least two non-vanishing filter taps. Furthermore, it is important to note that the number of subbands *L* processed by an embodiment of a filter apparatus is larger or at least equal to 2. Nevertheless, the number of subbands *L* is significantly smaller than the number of frequency bands required for a comparable quality in the case of a Fourier transform-based filtering combined with a filter mainly described by an amplitude/frequency characteristic and/or a phase/frequency characteristic as the transfer function of the filter.

Due to the fact that the impulse response of the intermediate filters **190** are significantly shorter than the impulse response of the underlying filter characteristic in the time domain, the computations with respect to each subband can be carried out significantly faster. Furthermore, as the different subband signals can be processed independently, both an embodiment of the filter apparatus as well as an embodiment of the filter generator **104** can process the respective input signals highly efficiently in a fast and a parallel manner. Hence, the processing of both a digital audio input as an input signal as well as an impulse response indicative of a filter characteristic can be carried out highly efficiently in a parallel fashion. As outlined earlier, an embodiment of an inventive filter apparatus as well as an embodiment of an inventive filter generator combine the advantages of both a direct processing of audio signals in the time domain leading to a very high quality and using a combination of a Fourier transform along with a transfer function in the frequency domain offering a high efficiency as each frequency band is only multiplied with a (complex or real valued) tap in the process of filtering the signal.

On the other hand, the disadvantages of both, purely processing the input signals in the time domain, which leads to an enormous computation effort, and those of a Fourier transform, can be significantly reduced and suppressed to a level that the output of an embodiment of a filter apparatus is perceptually indistinguishable from the quality of a direct processing in the time domain.

These two advantages offer a great flexibility for filtering digital signals with varying filtering characteristics. This is especially important in the field of HRTF, as HRTF-related filters usually have a very long impulse response. Hence, an embodiment of an inventive filter apparatus comprising a complex analysis filter bank **101,** a plurality of intermediate filters **190** in the subband filtering **102** and a complex synthesis filter bank **103** offers especially in the field of HRTF-related applications significant computational advantages due to the possible parallel processing of subband signals.

Embodiments of a filter generator and embodiments of systems comprising both a filter apparatus and a filter generator offer furthermore the advantage that filters can easily be adapted to specific environments, parameters or other specific needs of the application at hand. Especially in terms of HRTF-related applications, an embodiment of such a system can be used in head-tracking applications, in which several sources of sounds and noises as well as the position of the listener vary over time. Such an embodiment of a system comprising a filter apparatus and a filter generator therefore offer a highly efficient and flexible way to present an audio impression of a three dimensional arrangement of sound sources with respect to a varying position and orientation of a hypothetical listener via headphones or other head-related sound systems (stereo sound systems).

As this last example illustrates, an embodiment of an inventive filter apparatus along with an inventive filter generator offers not only a highly efficient system for audio manipulation with an excellent quality but also a very flexible way to introduce altering audio impressions in an efficient way.

### Complex modulated filter banks

In the following, let $Z \left(ω\right) = {\sum }_{ν = - ∞}^{∞} z \left(ν\right) ⁢ exp \left(-iνω\right)$be the discrete time Fourier transform of a discrete time signal *z*(*v*). As before, ν is an integer indicating an index or a time index of a time signal, while ω = 2 π · *f* is the circular frequency associated to the frequency *f*, n is the circular number (π = 3.1415926...) and $\sqrt{- 1}$is the imaginary unit.

The complex exponential modulated *L*-band filterbank is defined from a real valued prototype filter *p*(*v*) of finite length. For the computations below it will be assumed by extension with zeros that the prototype filter is defined for all integers *v*. Given a real valued discrete time signal *x*(*v*) the analysis filter bank **101** applies, as already explained, the complex modulated prototype filters followed by downsampling by a factor *L* in order to output the subband signals, ${c}_{n} \left(k\right) = {\sum }_{ν = - ∞}^{∞} x ⁢ \left(ν+kL\right) ⁢ p \left(ν\right) ⁢ exp \left(-i⁢\frac{π}{L}⁢\left(n+\frac{1}{2}\right)⁢\left(ν+θ\right)\right) ,$ for each subband index *n*=0,1,...,*L*-1, and integer time index *k*. The time index *k* differs from the time index ν with respect to the fact that *k* refers to the downsampled signals, whereas the integer ν withers to signals with the full sample frequency.

Given complex valued subband signals *dₙ*(*k*), the synthesis filter bank **103** applies filtering followed by upsampling by a factor of *L* and a real value extraction in order to output the real valued signals, as already explained, to obtain the output signal $y \left(ν\right) = Re \left\{2⁢L{\sum }_{k = - \infty }^{\infty } {\sum }_{n = 0}^{L - 1}{d}_{n}\left(k\right)⁢p⁢\left(ν-k⁢L\right)⁢exp\left(i⁢\frac{π}{L}⁢\left(n+\frac{1}{2}\right)⁢\left(ν-k⁢L+ψ\right)\right)\right\} .$

In the equations (1) and (2) θ and ψ represent (constant) phase factors for filtering the real valued discrete time signal *x*(ν) into complex valued subband signal and for reconstructing real valued output samples *y*(ν) from complex valued subband signals *dₙ*(*k*). It is well known that a prototype filter and fixed phase factors θ and ψ can be chosen to give perfect reconstruction, *y*(ν)=*x*(ν), in the case where *dₙ*(*k*) = *cₙ*(*k*), that is when the subband signals are unaltered. In practice, the perfect reconstruction property will hold true up to a delay (and/or a sign change), but in the computations that follow, this detail will be ignored by allowing the use of an acausal prototype filter. The present invention is applicable to the pseudo QMF type of design as taught by PCT/SE02/00626 "Aliasing reduction using complex exponential modulated filter banks". Here the prototype filter is symmetric *p*(-*v*)=*p*(*v*), and its discrete time Fourier transform *P*(ω) essentially vanishes outside the interval |ω| ≤ π/*L*. The perfect reconstruction is also replaced by a near-perfect reconstruction property. For the derivation that follows it will be assumed for simplicity that both perfect reconstruction holds and that *P*(ω)=0 for *π*/*L<*|*ω*|*≤π.* Moreover, the phase factors are assumed to satisfy the condition that ψ-θ is equal to an integer multiple of 4*L.*

In a critically sampled filter bank, the alteration of subband signals prior to synthesis usually leads to the introduction of aliasing artifacts. This is overcome here due to the fact that an oversampling by a factor two is introduced by using complex valued signals. Although the total sampling rate of the subband samples is identical to the sampling rate of the discrete time input signal, the input signal is real valued and the subband samples are complex valued. As it will be outlined below, the absence of alias opens the door for efficient time invariant signal processing.

### Subband filtering in a complex modulated filter bank

Consider the modification of subband filtering **102** of each subband signal obtained by filtering the analysis samples *cₙ*(*k*) from the complex analysis bank **101** with a filter with impulse response *gₙ*(*k*) prior to the synthesis (2) performed by the complex synthesis (filter) bank **103** ${d}_{n} \left(k\right) = {\sum }_{l} {g}_{n} \left(l\right) ⁢ {c}_{n} ⁢ \left(k-l\right) .$

Elementary computations show that given the assumptions on the frequency response of the prototype filter, the resulting effect on the reconstructed time signal is that of a discrete time filtering $Y \left(ω\right) = G \left(ω\right) ⁢ X \left(ω\right) ,$ where $G \left(ω\right) = {\sum }_{n = - L}^{L - 1} {G}_{n} \left(L⁢ω\right) ⁢ {\left|P⁢\left(ω-\frac{π}{L}⁢\left(n+\frac{1}{2}\right)\right)\right|}^{2} .$

Here, Gₙ=Σ*ₖgₙ*(*k*)exp(=*ik*ω) the discrete time Fourier transform of the filter applied in subband *n* for *n* ≥ 0 and ${G}_{n} \left(ω\right) = {G}_{- 1 - n} ⁢ {\left(-ω\right)}^{*} for n < 0 .$ ${\sum }_{n = - L}^{L - 1} {\left|P⁢\left(ω-\frac{π}{L}⁢\left(n+\frac{1}{2}\right)\right)\right|}^{2} = 1$

Another case of interest is *Gₙ*(*ω*) = *exp*(*-iω*) which leads to *G*(ω)= exp(*-iL*ω), so that *y*(*v*) = *x*(*v-L*).

### Approximating a given filter response by subband filtering

Let *H*(ω) be a given filter (e.g. transfer function) with real valued impulse response *h*(*v*). This data is considered as input to the filter converter **104.** In view of (5) and (7), a trivial choice for the subband filters which result in the desired response *G*(ω)=*H*(ω) is given by ${G}_{n} \left(ω\right) = H \left(ω/L\right) , for \left|ω-π⁢\left(n+1/2\right)\right| \leq π ,$

The drawback of this formula is that although *H*(ω) is a smooth function of ω, the periodized segment of it defined by (8) will exhibit jumps and the impulse response of the subband filters will be unnecessarily long. The prior art usage of the complex pseudo QMF bank for equalization or envelope adjustment consists of applying a single gain g*ₙ* in each subband, which results in the transfer function $G \left(ω\right) = {\sum }_{n = - L}^{L - 1} {g}_{n} | P ⁢ \left(ω-\frac{π}{L}⁢\left(n+\frac{1}{2}\right)\right) ⁢ {|}^{2}$ with the extension ${g}_{n} = - {g}_{- 1 - n}^{*}$ for *n*<0 defined in accordance with (6). In view of (7), one achieves $G ⁢ \left(\frac{π}{L}⁢\left(n+\frac{1}{2}\right)\right) = {g}_{n} , for n = 0 , 1 , \text{...} , L - 1 ,$ and the transfer function is interpolated between those frequencies. For target filter responses *H*(ω) that vary slowly as a function of the frequency ω, a first method of approximating the filter is therefore obtained by choosing ${G}_{n} \left(ω\right) = H ⁢ \left(\frac{π}{L}⁢\left(n+\frac{1}{2}\right)\right) .$

An example of the resulting quality of this procedure is given in figures 5 and 7.

According to an embodiment of the present invention a filter generator or a filter converters **104** is used to teach to convert the filter (defined by its impulse response) *h*(*v*) into intermediate subband filters **190** by means of the second analysis filter bank **301** which employs real valued prototype filter *q*(*v*), ${g}_{n} \left(k\right) = {\sum }_{ν = - ∞}^{∞} h ⁢ \left(ν+kL\right) ⁢ q \left(ν\right) ⁢ exp \left(-i⁢\frac{π}{L}⁢\left(n+\frac{1}{2}\right)⁢ν\right) .$

In terms of Fourier transforms this reads ${G}_{n} \left(ω\right) = \frac{1}{L} {\sum }_{l = 0}^{L - 1} H ⁢ \left(\frac{ω + 2 ⁢ πl}{L}\right) ⁢ Q ⁢ {\left(\frac{ω + 2 ⁢ πl}{L}-\frac{π}{L}⁢\left(n+\frac{1}{2}\right)\right)}^{*} .$

The advantage of this procedure is that any given filter *h*(*v*) can be efficiently transformed into intermediate subband filter responses. If *q(v)* has *K_{Q}·L* taps, a time domain filter *h*(*v*) of *K_{H}·L* taps is converted into subband domain filters (12) with *K_{H}*+*K_{Q}*-1 taps, wherein *K_{H}* and *K_{Q}* are positive integers. With respect to the exemplary numbers given in the context of the description of Fig. 4, *K_{H}* and *K_{Q}* are equal to 3 and with a prototype filter length and an impulse response corresponding to a length of 3 · 64 = 192 (*L* = 64) each. Hence, each intermediate subband filter **190** has an impulse response length of only 3 + 3 - 1 = 5 taps each.

### Design of the prototype filter for the filter converter

Insertion of (13) into (5) yields $G \left(ω\right) = {\sum }_{l = 0}^{L - 1} H ⁢ \left(ω+\frac{2 ⁢ π}{L}⁢l\right) {\sum }_{n = - L}^{L - 1} \frac{1}{L} ⁢ Q ⁢ {\left(ω+\frac{2 ⁢ π}{L}⁢l-\frac{π}{L}⁢\left(n+\frac{1}{2}\right)\right)}^{*} ⁢ {\left|P⁢\left(ω-\frac{π}{L}⁢\left(n+\frac{1}{2}\right)\right)\right|}^{2} .$

Hence, the condition for *G(*ω) = *H*(ω) to hold is that ${\sum }_{n = - L}^{L - 1} \frac{1}{L} ⁢ Q ⁢ {\left(ω+\frac{2 ⁢ π}{L}⁢l-\frac{π}{L}⁢\left(n+\frac{1}{2}\right)\right)}^{*} ⁢ {\left|P⁢\left(ω-\frac{π}{L}⁢\left(n+\frac{1}{2}\right)\right)\right|}^{2} = δ \left[l\right] ,$ where δ[*l*]=1 for *l*=0 and δ[l]=0 for *l*≠0. A simple solution to (15) is given by the brick wall filter $Q \left(ω\right) = { \begin{matrix}L , & for \left|ω\right| \leq π / L ; \\ 0 , & for π / L < \left|ω\right| \leq π .\end{matrix}$

This prototype filter corresponds to the choice (8) and has the disadvantage of having an infinite and slowly decaying impulse response *q*(*v*). Instead, the present invention teaches to solve (15) approximately (e.g. in the least-square sense) with a finite impulse response filter *q*(*v*). The time domain equivalent of (15) is the system of linear equations for *n*=0,1,...,*L*-1 and for all integers *k*, ${\sum }_{ν = - ∞}^{∞} {p}_{2} ⁢ \left(n+v⁢L-2⁢kL\right) ⁢ q ⁢ \left(n+ν⁢L\right) = \frac{1}{2 ⁢ L} ⁢ δ \left[k\right] ,$ where ${p}_{2} \left(ν\right) = {\sum }_{l = - ∞}^{∞} p \left(l\right) ⁢ p ⁢ \left(l+ν\right)$ is the autocorrelation of *p*(*v*). For any given support length the system of linear equations (16) can be solved in the least squares sense for a prototype filter *q*(*v*). It is desirable to use a support significantly shorter than that of the original filter bank prototype filter *p*(*v*), and in that case the linear system (16) is over-determined. A given quality of approximation can also be traded for other desirable properties via joint optimization. One example of such a property is a low pass type of frequency response *Q*(ω).

In the following the determination of a multi-slot QMF representation (subband domain) of the HRTF filters is described. The filter conversion from the time domain into the complex QMF subband domain is performed by an FIR filter in the filter converter **104** of Fig. 1a. To be more precise, the following description outlines a method for implementing a given FIR filter *h*(ν) of length *Nₕ* in the complex QMF subband domain. The principle of the operation is illustrated in Fig. la in the case of a system also comprising an embodiment of an inventive filter apparatus.

The subband filtering itself is carried out by a set of or a plurality of intermediate filters **190** inside the subband filtering **102.** To be more precise, the subband filtering consist of the separate application of one complex valued FIR intermediate filter *gₙ*(*l*) for each QMF subband with an index *n* = 0,1,...,63. In other words, in the following description special references will be made to embodiments with *L* = 64 different subband signals. Nevertheless, this specific number of subband signals is not essential and the appropriate equations will also be given in a more general form.

One of the key components of the system shown in Fig. la is the filter converter **104,** which converts the given time domain FIR filter *h*(*v*) into the complex subband domain filters *gₙ*(*l*). The filter converter **104** comprises a complex analysis bank **301** similar to the QMF analysis bank **101.** The prototype filter of the complex analysis filter bank **301** of the filter converter **104** *q*(*v*) of length 192 (= 3·64) for the specific case of *L* = 64 subband signals are created by solving in the least square sense the over determined system of the equation (16). The filter coefficients *q*(*v*) or rather the relations they fulfill will be described in more detail for the case of *L* = 64 subbands signals later on.

To be more accurate in terms of mathematical description, an extension with zeros in the time domain FIR filter is defined by ${h}^{} \left(υ\right) = { \begin{matrix}h \left(υ\right) & , & υ = 0 , 1 , … , {N}_{h} - 1 , \\ 0 & , & otherwise\end{matrix}$

The resulting intermediate subband domain filters are based on equation (12) and can be expressed in the general case as ${g}_{n} \left(l\right) = {\sum }_{ν = 0}^{{N}_{q} - 1} {h}^{} ⁢ \left(υ+L⋅\left(l-{l}_{0}\right)\right) ⋅ q \left(υ\right) ⋅ exp \left(-i⁢\frac{π}{L}⁢\left(n+\frac{1}{2}\right)⁢\left(υ-{υ}_{0}\right)\right)$ wherein *l*₀ any ν₀ are delays, *l* is an integer indicating an index of the filter taps and *N_{q}* (= *N_{Q}*) is the length of the impulse response of the prototype filter *q*(ν).

It should be noted, that in the frame work of the present application under an equation being based on an equation an introduction of additional delays (cf. *l₀* and ν₀) factors, additional coefficients and an introduction of a window function or another simple function is understood.

In the case *L* = 64, the expression for the subband domain filters or intermediate filters **190** becomes ${g}_{n} \left(l\right) = {\sum }_{v = 0}^{1 ⁢ 9 ⁢ 1} {h}^{} ⁢ \left(υ+64⋅\left(l-2\right)\right) ⋅ q \left(υ\right) ⋅ exp \left(-i⁢\frac{π}{6 ⁢ 4}⁢\left(n+\frac{1}{2}\right)⁢\left(υ-9⁢5\right)\right)$

These subdomain filters have a length *L_{q} = Kₕ* + 2, where ${K}_{h} = ⌈ {N}_{h} / 6 ⁢ 4 ⌉$ and *Nₕ* is the length of the impulse response *h*(*v*) of the filter characteristics to be transferred into the subband domain.

In this case, the integer *n* = 0, 1, ..., 63 is once again the index of a subband and *l* = 0, 1, ..., (*Kₕ*+1) is an integer indicating taps of the resulting intermediate filters **190**.

The extra addend of (-2) in equation (20) as compared to equation (12) is there, because equation (12) was developed without any regard to casualty of filters. Real implementations will cause always introduce delays. Hence, depending on the concrete implementation, additional delayers or delays can be implemented in the embodiments shown in Figs. 1a to 1e and Figs. 2 to 11, which have been omitted for the sake of simplicity in Figures mentioned.

As outlined earlier, in many cases the system of linear equations (16) is over determined. Nevertheless, it can be solved or approximated in the least square sense with respect to the prototype filter coefficients *q*(*v*). Solving the system of linear equations (16) in the least square sense, leads to the filters taps of the prototype filter q(v) to fulfill the following relations for integers ν from 0 to 191:$- 0 . 2 ⁢ 0 ⁢ 4 \leq q \left[0\right] \leq - 0 . 2 ⁢ 0 ⁢ 2$$- 0 . 1 ⁢ 9 ⁢ 9 \leq q \left[1\right] \leq - 0 . 1 ⁢ 9 ⁢ 7$$- 0 . 1 ⁢ 9 ⁢ 4 \leq q \left[2\right] \leq - 0.1 ⁢ 9 ⁢ 2$ $- 0 . 1 ⁢ 8 ⁢ 9 \leq q \left[3\right] \leq - 0 . 1 ⁢ 8 ⁢ 7$ $- 0 . 1 ⁢ 8 ⁢ 3 \leq q \left[4\right] \leq - 0 . 1 ⁢ 8 ⁢ 1$ $- 0 . 1 ⁢ 7 ⁢ 8 \leq q \left[5\right] \leq - 0 . 1 ⁢ 7 ⁢ 6$ $- 0 . 1 ⁢ 7 ⁢ 2 \leq q \left[6\right] \leq - 0 . 1 ⁢ 7 ⁢ 0$ $- 0 . 1 ⁢ 6 ⁢ 6 \leq q \left[7\right] \leq - 0 . 1 ⁢ 6 ⁢ 4$ $- 0 . 1 ⁢ 6 ⁢ 0 \leq q \left[8\right] \leq - 0 . 1 ⁢ 5 ⁢ 8$ $- 0 . 1 ⁢ 5 ⁢ 4 \leq q \left[9\right] \leq - 0 . 1 ⁢ 5 ⁢ 2$ $- 0 . 1 ⁢ 4 ⁢ 8 \leq q \left[1⁢0\right] \leq - 0 . 1 ⁢ 4 ⁢ 6$ $- 0 . 1 ⁢ 4 ⁢ 2 \leq q \left[1⁢1\right] \leq - 0 . 1 ⁢ 4 ⁢ 0$ $- 0 . 1 ⁢ 3 ⁢ 5 \leq q \left[1⁢2\right] \leq - 0 . 1 ⁢ 3 ⁢ 3$ $- 0 . 1 ⁢ 2 ⁢ 9 \leq q \left[1⁢3\right] \leq - 0 . 1 ⁢ 2 ⁢ 7$ $- 0 . 1 ⁢ 2 ⁢ 2 \leq q \left[1⁢4\right] \leq - 0 . 1 ⁢ 2 ⁢ 0$ $- 0 . 1 ⁢ 1 ⁢ 6 \leq q \left[1⁢5\right] \leq - 0 . 1 ⁢ 1 ⁢ 4$ $- 0 . 1 ⁢ 0 ⁢ 9 \leq q \left[1⁢6\right] \leq - 0 . 1 ⁢ 0 ⁢ 7$ $- 0 . 1 ⁢ 0 ⁢ 2 \leq q \left[1⁢7\right] \leq - 0 . 1 ⁢ 0 ⁢ 0$ $- 0 . 0 ⁢ 9 ⁢ 6 \leq q \left[1⁢8\right] \leq - 0 . 0 ⁢ 9 ⁢ 4$ $- 0 . 0 ⁢ 8 ⁢ 9 \leq q \left[1⁢9\right] \leq - 0 . 0 ⁢ 8 ⁢ 7$ $- 0 . 0 ⁢ 8 ⁢ 2 \leq q \left[2⁢0\right] \leq - 0 . 0 ⁢ 8 ⁢ 0$ $- 0 . 0 ⁢ 7 ⁢ 5 \leq q \left[2⁢1\right] \leq - 0 . 0 ⁢ 7 ⁢ 3$ $- 0.068 \leq q \left[2⁢2\right] \leq - 0 . 0 ⁢ 6 ⁢ 6$ $- 0 . 0 ⁢ 6 ⁢ 1 \leq q \left[2⁢3\right] \leq - 0 . 0 ⁢ 5 ⁢ 9$ $- 0 . 0 ⁢ 5 ⁢ 4 \leq q \left[2⁢4\right] \leq - 0 . 0 ⁢ 5 ⁢ 2$ $- 0 . 0 ⁢ 4 ⁢ 6 \leq q \left[2⁢5\right] \leq - 0 . 0 ⁢ 4 ⁢ 4$ $- 0 . 0 ⁢ 3 ⁢ 9 \leq q \left[2⁢6\right] \leq - 0 . 0 ⁢ 3 ⁢ 7$ $- 0 . 0 ⁢ 3 ⁢ 2 \leq q \left[2⁢7\right] \leq - 0 . 0 ⁢ 3 ⁢ 0$ $- 0 . 0 ⁢ 2 ⁢ 4 \leq q \left[2⁢8\right] \leq - 0 . 0 ⁢ 2 ⁢ 2$ $- 0 . 0 ⁢ 1 ⁢ 7 \leq q \left[2⁢9\right] \leq - 0 . 0 ⁢ 1 ⁢ 5$ $- 0 . 0 ⁢ 0 ⁢ 9 \leq q \left[3⁢0\right] \leq - 0 . 0 ⁢ 0 ⁢ 7$ $- 0 . 0 ⁢ 0 ⁢ 2 \leq q \left[3⁢1\right] \leq 0 . 0 ⁢ 0 ⁢ 0$ $0.0 ⁢ 0 ⁢ 6 \leq q \left[3⁢2\right] \leq 0 . 0 ⁢ 0 ⁢ 8$ $0.0 ⁢ 1 ⁢ 4 \leq q \left[3⁢3\right] \leq 0 . 0 ⁢ 1 ⁢ 6$ $0.0 ⁢ 2 ⁢ 1 \leq q \left[3⁢4\right] \leq 0 . 0 ⁢ 2 ⁢ 3$ $0.0 ⁢ 2 ⁢ 9 \leq q \left[3⁢5\right] \leq 0 . 0 ⁢ 3 ⁢ 1$ $0.0 ⁢ 3 ⁢ 7 \leq q \left[3⁢6\right] \leq 0 . 0 ⁢ 3 ⁢ 9$ $0.0 ⁢ 4 ⁢ 5 \leq q \left[3⁢7\right] \leq 0 . 0 ⁢ 4 ⁢ 7$ $0.0 ⁢ 5 ⁢ 4 \leq q \left[3⁢8\right] \leq 0 . 0 ⁢ 5 ⁢ 6$ $0.0 ⁢ 6 ⁢ 2 \leq q \left[3⁢9\right] \leq 0 . 0 ⁢ 6 ⁢ 4$ $0.0 ⁢ 7 ⁢ 0 \leq q \left[4⁢0\right] \leq 0 . 072$ $0.079 \leq q \left[4⁢1\right] \leq 0 . 0 ⁢ 8 ⁢ 1$ $0.087 \leq q \left[4⁢2\right] \leq 0 . 0 ⁢ 8 ⁢ 9$ $0.0 ⁢ 9 ⁢ 6 \leq q \left[4⁢3\right] \leq 0 . 0 ⁢ 9 ⁢ 8$ $0.1 ⁢ 0 ⁢ 5 \leq q \left[4⁢4\right] \leq 0 . 1 ⁢ 0 ⁢ 7$ $0.1 ⁢ 1 ⁢ 3 \leq q \left[4⁢5\right] \leq 0 . 1 ⁢ 1 ⁢ 5$ $0.1 ⁢ 2 ⁢ 2 \leq q \left[4⁢6\right] \leq 0 . 1 ⁢ 2 ⁢ 4$ $0.1 ⁢ 3 ⁢ 2 \leq q \left[4⁢7\right] \leq 0 . 1 ⁢ 3 ⁢ 4$ $0.1 ⁢ 4 ⁢ 1 \leq q \left[4⁢8\right] \leq 0 . 1 ⁢ 4 ⁢ 3$ $0.1 ⁢ 5 ⁢ 0 \leq q \left[4⁢9\right] \leq 0 . 1 ⁢ 5 ⁢ 2$ $0.1 ⁢ 6 ⁢ 0 \leq q \left[5⁢0\right] \leq 0 . 1 ⁢ 6 ⁢ 2$ $0.1 ⁢ 7 ⁢ 0 \leq q \left[5⁢1\right] \leq 0 . 1 ⁢ 7 ⁢ 2$ $0.1 ⁢ 8 ⁢ 0 \leq q \left[5⁢2\right] \leq 0 . 1 ⁢ 8 ⁢ 2$ $0.1 ⁢ 9 ⁢ 0 \leq q \left[5⁢3\right] \leq 0 . 1 ⁢ 9 ⁢ 2$ $0.2 ⁢ 0 ⁢ 0 \leq q \left[5⁢4\right] \leq 0 . 2 ⁢ 0 ⁢ 2$ $0.2 ⁢ 1 ⁢ 0 \leq q \left[5⁢5\right] \leq 0 . 2 ⁢ 1 ⁢ 2$ $0.2 ⁢ 2 ⁢ 1 \leq q \left[5⁢6\right] \leq 0 . 2 ⁢ 2 ⁢ 3$ $0.2 ⁢ 3 ⁢ 2 \leq q \left[5⁢7\right] \leq 0 . 2 ⁢ 3 ⁢ 4$ $0.2 ⁢ 4 ⁢ 3 \leq q \left[5⁢8\right] \leq 0 . 2 ⁢ 4 ⁢ 5$ $0.2 ⁢ 5 ⁢ 4 \leq q \left[5⁢9\right] \leq 0 . 2 ⁢ 5 ⁢ 6$ $0.266 \leq q \left[60\right] \leq 0 . 2 ⁢ 6 ⁢ 8$ $0.2 ⁢ 7 ⁢ 8 \leq q \left[6⁢1\right] \leq 0 . 2 ⁢ 8 ⁢ 0$ $0.2 ⁢ 9 ⁢ 0 \leq q \left[6⁢2\right] \leq 0 . 2 ⁢ 9 ⁢ 2$ $0.3 ⁢ 0 ⁢ 3 \leq q \left[6⁢3\right] \leq 0 . 3 ⁢ 0 ⁢ 5$ $0.9 ⁢ 0 ⁢ 2 \leq q \left[6⁢4\right] \leq 0 . 9 ⁢ 0 ⁢ 4$ $0.9 ⁢ 0 ⁢ 9 \leq q \left[6⁢5\right] \leq 0 . 9 ⁢ 1 ⁢ 1$ $0.9 ⁢ 1 ⁢ 7 \leq q \left[6⁢6\right] \leq 0 . 9 ⁢ 1 ⁢ 9$ $0.9 ⁢ 2 ⁢ 4 \leq q \left[6⁢7\right] \leq 0 . 9 ⁢ 2 ⁢ 6$ $0.9 ⁢ 3 ⁢ 0 \leq q \left[6⁢8\right] \leq 0 . 9 ⁢ 3 ⁢ 2$ $0.9 ⁢ 3 ⁢ 6 \leq q \left[6⁢9\right] \leq 0 . 9 ⁢ 3 ⁢ 8$ $0.9 ⁢ 4 ⁢ 2 \leq q \left[7⁢0\right] \leq 0 . 9 ⁢ 4 ⁢ 4$ $0.9 ⁢ 4 ⁢ 7 \leq q \left[71\right] \leq 0 . 9 ⁢ 4 ⁢ 9$ $0.9 ⁢ 5 ⁢ 2 \leq q \left[7⁢2\right] \leq 0 . 9 ⁢ 5 ⁢ 4$ $0.9 ⁢ 5 ⁢ 7 \leq q \left[7⁢3\right] \leq 0 . 9 ⁢ 5 ⁢ 9$ $0.9 ⁢ 6 ⁢ 1 \leq q \left[7⁢4\right] \leq 0 . 9 ⁢ 6 ⁢ 3$ $0.9 ⁢ 6 ⁢ 5 \leq q \left[7⁢5\right] \leq 0 . 9 ⁢ 6 ⁢ 7$ $0.9 ⁢ 6 ⁢ 9 \leq q \left[7⁢6\right] \leq 0 . 9 ⁢ 7 ⁢ 1$ $0.9 ⁢ 7 ⁢ 2 \leq q \left[7⁢7\right] \leq 0 . 9 ⁢ 7 ⁢ 4$ $0.9 ⁢ 7 ⁢ 5 \leq q \left[78\right] \leq 0 . 977$ $0.9 ⁢ 7 ⁢ 8 \leq q \left[7⁢9\right] \leq 0 . 9 ⁢ 8 ⁢ 0$ $0.9 ⁢ 8 ⁢ 1 \leq q \left[8⁢0\right] \leq 0 . 9 ⁢ 8 ⁢ 3$ $0.9 ⁢ 8 ⁢ 4 \leq q \left[8⁢1\right] \leq 0 . 9 ⁢ 8 ⁢ 6$ $0.9 ⁢ 8 ⁢ 6 \leq q \left[8⁢2\right] \leq 0 . 9 ⁢ 8 ⁢ 8$ $0.9 ⁢ 8 ⁢ 8 \leq q \left[8⁢3\right] \leq 0 . 9 ⁢ 9 ⁢ 0$ $0.9 ⁢ 9 ⁢ 0 \leq q \left[8⁢4\right] \leq 0 . 9 ⁢ 9 ⁢ 2$ $0.9 ⁢ 9 ⁢ 2 \leq q \left[8⁢5\right] \leq 0 . 9 ⁢ 9 ⁢ 4$ $0.9 ⁢ 9 ⁢ 3 \leq q \left[8⁢6\right] \leq 0 . 9 ⁢ 9 ⁢ 5$ $0.9 ⁢ 9 ⁢ 5 \leq q \left[8⁢7\right] \leq 0 . 9 ⁢ 9 ⁢ 7$ $0.9 ⁢ 9 ⁢ 6 \leq q \left[8⁢8\right] \leq 0 . 9 ⁢ 9 ⁢ 8$ $0.9 ⁢ 9 ⁢ 7 \leq q \left[8⁢9\right] \leq 0 . 9 ⁢ 9 ⁢ 9$ $0.9 ⁢ 9 ⁢ 8 \leq q \left[9⁢0\right] \leq 1 . 0 ⁢ 0 ⁢ 0$ $0.9 ⁢ 9 ⁢ 9 \leq q \left[9⁢1\right] \leq 1 . 0 ⁢ 0 ⁢ 1$ $0.9 ⁢ 9 ⁢ 9 \leq q \left[9⁢2\right] \leq 1 . 0 ⁢ 0 ⁢ 1$ $1.0 ⁢ 0 ⁢ 0 \leq q \left[9⁢3\right] \leq 1 . 0 ⁢ 0 ⁢ 2$ $1.0 ⁢ 0 ⁢ 0 \leq q \left[9⁢4\right] \leq 1 . 0 ⁢ 0 ⁢ 2$ $1.0 ⁢ 0 ⁢ 0 \leq q \left[9⁢5\right] \leq 1 . 0 ⁢ 0 ⁢ 2$ $1.0 ⁢ 0 ⁢ 0 \leq q \left[9⁢6\right] \leq 1 . 0 ⁢ 0 ⁢ 2$ $1.0 ⁢ 0 ⁢ 0 \leq q \left[9⁢7\right] \leq 1 . 0 ⁢ 0 ⁢ 2$ $0.9 ⁢ 9 ⁢ 9 \leq q \left[9⁢8\right] \leq 1 . 0 ⁢ 0 ⁢ 1$ $0.9 ⁢ 9 ⁢ 9 \leq q \left[9⁢9\right] \leq 1 . 0 ⁢ 0 ⁢ 1$ $0.9 ⁢ 9 ⁢ 8 \leq q \left[1⁢0⁢0\right] \leq 1 . 0 ⁢ 0 ⁢ 0$ $0.9 ⁢ 9 ⁢ 7 \leq q \left[1⁢0⁢1\right] \leq 0 . 9 ⁢ 9 ⁢ 9$ $0.9 ⁢ 9 ⁢ 6 \leq q \left[1⁢0⁢2\right] \leq 0 . 9 ⁢ 9 ⁢ 8$ $0.9 ⁢ 9 ⁢ 5 \leq q \left[1⁢0⁢3\right] \leq 0 . 9 ⁢ 9 ⁢ 7$ $0.9 ⁢ 9 ⁢ 3 \leq q \left[1⁢0⁢4\right] \leq 0 . 9 ⁢ 9 ⁢ 5$ $0.9 ⁢ 9 ⁢ 2 \leq q \left[1⁢0⁢5\right] \leq 0 . 9 ⁢ 9 ⁢ 4$ $0.9 ⁢ 9 ⁢ 0 \leq q \left[1⁢0⁢6\right] \leq 0 . 9 ⁢ 9 ⁢ 2$ $0.9 ⁢ 8 ⁢ 8 \leq q \left[107\right] \leq 0 . 9 ⁢ 9 ⁢ 0$ $0.9 ⁢ 8 ⁢ 6 \leq q \left[1⁢0⁢8\right] \leq 0 . 9 ⁢ 8 ⁢ 8$ $0.9 ⁢ 8 ⁢ 4 \leq q \left[1⁢0⁢9\right] \leq 0 . 9 ⁢ 8 ⁢ 6$ $0.9 ⁢ 8 ⁢ 1 \leq q \left[1⁢1⁢0\right] \leq 0 . 9 ⁢ 8 ⁢ 3$ $0.9 ⁢ 7 ⁢ 8 \leq q \left[1⁢1⁢1\right] \leq 0 . 9 ⁢ 8 ⁢ 0$ $0.9 ⁢ 7 ⁢ 5 \leq q \left[1⁢1⁢2\right] \leq 0 . 9 ⁢ 7 ⁢ 7$ $0.9 ⁢ 7 ⁢ 2 \leq q \left[1⁢1⁢3\right] \leq 0 . 9 ⁢ 7 ⁢ 4$ $0.9 ⁢ 6 ⁢ 9 \leq q \left[1⁢1⁢4\right] \leq 0 . 9 ⁢ 7 ⁢ 1$ $0.9 ⁢ 6 ⁢ 5 \leq q \left[1⁢1⁢5\right] \leq 0 . 9 ⁢ 6 ⁢ 7$ $0.9 ⁢ 6 ⁢ 1 \leq q \left[1⁢1⁢6\right] \leq 0 . 9 ⁢ 6 ⁢ 3$ $0.9 ⁢ 5 ⁢ 7 \leq q \left[1⁢1⁢7\right] \leq 0 . 9 ⁢ 5 ⁢ 9$ $0.9 ⁢ 5 ⁢ 2 \leq q \left[1⁢1⁢8\right] \leq 0 . 9 ⁢ 5 ⁢ 4$ $0.9 ⁢ 4 ⁢ 7 \leq q \left[1⁢1⁢9\right] \leq 0 . 9 ⁢ 4 ⁢ 9$ $0.9 ⁢ 4 ⁢ 2 \leq q \left[1⁢2⁢0\right] \leq 0 . 9 ⁢ 4 ⁢ 4$ $0.9 ⁢ 3 ⁢ 6 \leq q \left[1⁢2⁢1\right] \leq 0 . 9 ⁢ 3 ⁢ 8$ $0.9 ⁢ 3 ⁢ 0 \leq q \left[1⁢2⁢2\right] \leq 0 . 9 ⁢ 3 ⁢ 2$ $0.9 ⁢ 2 ⁢ 4 \leq q \left[1⁢2⁢3\right] \leq 0 . 9 ⁢ 2 ⁢ 6$ $0.9 ⁢ 1 ⁢ 7 \leq q \left[1⁢2⁢4\right] \leq 0 . 9 ⁢ 1 ⁢ 9$ $0.9 ⁢ 0 ⁢ 9 \leq q \left[1⁢2⁢5\right] \leq 0 . 9 ⁢ 1 ⁢ 1$ $0.9 ⁢ 0 ⁢ 2 \leq q \left[1⁢2⁢6\right] \leq 0 . 9 ⁢ 0 ⁢ 4$ $0.8 ⁢ 9 ⁢ 3 \leq q \left[1⁢2⁢7\right] \leq 0 . 8 ⁢ 9 ⁢ 5$ $0.2 ⁢ 9 ⁢ 0 \leq q \left[1⁢2⁢8\right] \leq 0 . 2 ⁢ 9 ⁢ 2$ $0.2 ⁢ 7 ⁢ 8 \leq q \left[1⁢2⁢9\right] \leq 0 . 2 ⁢ 8 ⁢ 0$ $0.2 ⁢ 6 ⁢ 6 \leq q \left[1⁢3⁢0\right] \leq 0 . 2 ⁢ 6 ⁢ 8$ $0.2 ⁢ 5 ⁢ 4 \leq q \left[1⁢3⁢1\right] \leq 0 . 2 ⁢ 5 ⁢ 6$ $0.2 ⁢ 4 ⁢ 3 \leq q \left[1⁢3⁢2\right] \leq 0 . 2 ⁢ 4 ⁢ 5$ $0.2 ⁢ 3 ⁢ 2 \leq q \left[1⁢3⁢3\right] \leq 0 . 2 ⁢ 3 ⁢ 4$ $0.2 ⁢ 2 ⁢ 1 \leq q \left[1⁢3⁢4\right] \leq 0 . 2 ⁢ 2 ⁢ 3$ $0.2 ⁢ 1 ⁢ 0 \leq q \left[1⁢3⁢5\right] \leq 0 . 2 ⁢ 1 ⁢ 2$ $0.2 ⁢ 0 ⁢ 0 \leq q \left[1⁢3⁢6\right] \leq 0 . 2 ⁢ 0 ⁢ 2$ $0.1 ⁢ 9 ⁢ 0 \leq q \left[1⁢3⁢7\right] \leq 0 . 1 ⁢ 9 ⁢ 2$ $0.1 ⁢ 8 ⁢ 0 \leq q \left[1⁢3⁢8\right] \leq 0 . 1 ⁢ 8 ⁢ 2$ $0.1 ⁢ 7 ⁢ 0 \leq q \left[1⁢3⁢9\right] \leq 0 . 1 ⁢ 7 ⁢ 2$ $0.1 ⁢ 6 ⁢ 0 \leq q \left[1⁢4⁢0\right] \leq 0 . 1 ⁢ 6 ⁢ 2$ $0.1 ⁢ 5 ⁢ 0 \leq q \left[1⁢4⁢1\right] \leq 0 . 1 ⁢ 5 ⁢ 2$ $0.1 ⁢ 4 ⁢ 1 \leq q \left[1⁢4⁢2\right] \leq 0 . 1 ⁢ 4 ⁢ 3$ $0.1 ⁢ 3 ⁢ 2 \leq q \left[143\right] \leq 0 . 1 ⁢ 3 ⁢ 4$ $0.1 ⁢ 2 ⁢ 2 \leq q \left[1⁢4⁢4\right] \leq 0 . 1 ⁢ 2 ⁢ 4$ $0.1 ⁢ 1 ⁢ 3 \leq q \left[1⁢4⁢5\right] \leq 0 . 1 ⁢ 1 ⁢ 5$ $0.1 ⁢ 0 ⁢ 5 \leq q \left[1⁢4⁢6\right] \leq 0 . 1 ⁢ 0 ⁢ 7$ $0.0 ⁢ 9 ⁢ 6 \leq q \left[1⁢4⁢7\right] \leq 0 . 0 ⁢ 9 ⁢ 8$ $0.0 ⁢ 8 ⁢ 7 \leq q \left[1⁢4⁢8\right] \leq 0 . 0 ⁢ 8 ⁢ 9$ $0.0 ⁢ 7 ⁢ 9 \leq q \left[1⁢4⁢9\right] \leq 0 . 0 ⁢ 8 ⁢ 1$ $0.0 ⁢ 7 ⁢ 0 \leq q \left[1⁢5⁢0\right] \leq 0 . 0 ⁢ 7 ⁢ 2$ $0.0 ⁢ 6 ⁢ 2 \leq q \left[1⁢5⁢1\right] \leq 0 . 0 ⁢ 6 ⁢ 4$ $0.0 ⁢ 5 ⁢ 4 \leq q \left[1⁢5⁢2\right] \leq 0 . 0 ⁢ 5 ⁢ 6$ $0.0 ⁢ 4 ⁢ 5 \leq q \left[1⁢5⁢3\right] \leq 0 . 0 ⁢ 4 ⁢ 7$ $0.0 ⁢ 3 ⁢ 7 \leq q \left[1⁢5⁢4\right] \leq 0 . 0 ⁢ 3 ⁢ 9$ $0.0 ⁢ 2 ⁢ 9 \leq q \left[1⁢5⁢5\right] \leq 0 . 0 ⁢ 3 ⁢ 1$ $0.0 ⁢ 2 ⁢ 1 \leq q \left[1⁢5⁢6\right] \leq 0 . 0 ⁢ 2 ⁢ 3$ $0.0 ⁢ 1 ⁢ 4 \leq q \left[1⁢5⁢7\right] \leq 0 . 0 ⁢ 1 ⁢ 6$ $0.0 ⁢ 0 ⁢ 6 \leq q \left[1⁢5⁢8\right] \leq 0 . 0 ⁢ 0 ⁢ 8$ $- 0 . 0 ⁢ 0 ⁢ 2 \leq q \left[1⁢5⁢9\right] \leq 0 . 0 ⁢ 0 ⁢ 0$ $- 0 . 0 ⁢ 0 ⁢ 9 \leq q \left[1⁢6⁢0\right] \leq - 0 . 0 ⁢ 0 ⁢ 7$ $- 0 . 0 ⁢ 1 ⁢ 7 \leq q \left[1⁢6⁢1\right] \leq - 0 . 0 ⁢ 1 ⁢ 5$ $- 0 . 0 ⁢ 2 ⁢ 4 \leq q \left[1⁢6⁢2\right] \leq - 0 . 0 ⁢ 2 ⁢ 2$ $- 0 . 0 ⁢ 3 ⁢ 2 \leq q \left[1⁢6⁢3\right] \leq - 0 . 0 ⁢ 3 ⁢ 0$ $- 0 . 0 ⁢ 3 ⁢ 9 \leq q \left[1⁢6⁢4\right] \leq - 0 . 0 ⁢ 3 ⁢ 7$ $- 0 . 0 ⁢ 4 ⁢ 6 \leq q \left[1⁢6⁢5\right] \leq - 0 . 0 ⁢ 4 ⁢ 4$ $- 0 . 0 ⁢ 5 ⁢ 4 \leq q \left[1⁢6⁢6\right] \leq - 0 . 0 ⁢ 5 ⁢ 2$ $- 0 . 0 ⁢ 6 ⁢ 1 \leq q \left[1⁢6⁢7\right] \leq - 0 . 0 ⁢ 5 ⁢ 9$ $- 0 . 0 ⁢ 6 ⁢ 8 \leq q \left[1⁢6⁢8\right] \leq - 0 . 0 ⁢ 6 ⁢ 6$ $- 0 . 0 ⁢ 7 ⁢ 5 \leq q \left[1⁢6⁢9\right] \leq - 0 . 0 ⁢ 7 ⁢ 3$ $- 0 . 0 ⁢ 8 ⁢ 2 \leq q \left[1⁢7⁢0\right] \leq - 0 . 0 ⁢ 8 ⁢ 0$ $- 0 . 0 ⁢ 8 ⁢ 9 \leq q \left[1⁢7⁢1\right] \leq - 0 . 0 ⁢ 8 ⁢ 7$ $- 0 . 0 ⁢ 9 ⁢ 6 \leq q \left[1⁢7⁢2\right] \leq - 0 . 0 ⁢ 9 ⁢ 4$ $- 0 . 1 ⁢ 0 ⁢ 2 \leq q \left[1⁢7⁢3\right] \leq - 0 . 1 ⁢ 0 ⁢ 0$ $- 0 . 1 ⁢ 0 ⁢ 9 \leq q \left[1⁢7⁢4\right] \leq - 0 . 1 ⁢ 0 ⁢ 7$ $- 0 . 1 ⁢ 1 ⁢ 6 \leq q \left[1⁢7⁢5\right] \leq - 0 . 1 ⁢ 1 ⁢ 4$ $- 0 . 1 ⁢ 2 ⁢ 2 \leq q \left[1⁢7⁢6\right] \leq - 0 . 1 ⁢ 2 ⁢ 0$ $- 0 . 1 ⁢ 2 ⁢ 9 \leq q \left[1⁢7⁢7\right] \leq - 0 . 1 ⁢ 2 ⁢ 7$ $- 0 . 1 ⁢ 3 ⁢ 5 \leq q \left[1⁢7⁢8\right] \leq - 0 . 1 ⁢ 3 ⁢ 3$ $- 0 . 1 ⁢ 4 ⁢ 2 \leq q \left[1⁢7⁢9\right] \leq - 0 . 1 ⁢ 4 ⁢ 0$ $- 0 . 1 ⁢ 4 ⁢ 8 \leq q \left[1⁢8⁢0\right] \leq - 0 . 1 ⁢ 4 ⁢ 6$ $- 0 . 1 ⁢ 5 ⁢ 4 \leq q \left[1⁢8⁢1\right] \leq - 0 . 1 ⁢ 5 ⁢ 2$ $- 0 . 1 ⁢ 6 ⁢ 0 \leq q \left[1⁢8⁢2\right] \leq - 0 . 1 ⁢ 5 ⁢ 8$ $- 0 . 1 ⁢ 6 ⁢ 6 \leq q \left[1⁢8⁢3\right] \leq - 0 . 1 ⁢ 6 ⁢ 4$ $- 0 . 1 ⁢ 7 ⁢ 2 \leq q \left[1⁢8⁢4\right] \leq - 0 . 1 ⁢ 7 ⁢ 0$ $- 0 . 1 ⁢ 7 ⁢ 8 \leq q \left[1⁢8⁢5\right] \leq - 0 . 1 ⁢ 7 ⁢ 6$ $- 0 . 1 ⁢ 8 ⁢ 3 \leq q \left[1⁢8⁢6\right] \leq - 0 . 1 ⁢ 8 ⁢ 1$ $- 0 . 1 ⁢ 8 ⁢ 9 \leq q \left[1⁢8⁢7\right] \leq - 0 . 1 ⁢ 8 ⁢ 7$ $- 0 . 1 ⁢ 9 ⁢ 4 \leq q \left[1⁢8⁢8\right] \leq - 0 . 1 ⁢ 9 ⁢ 2$ $- 0 . 1 ⁢ 9 ⁢ 9 \leq q \left[1⁢8⁢9\right] \leq - 0 . 1 ⁢ 9 ⁢ 7$ $- 0 . 2 ⁢ 0 ⁢ 4 \leq q \left[1⁢9⁢0\right] \leq - 0 . 2 ⁢ 0 ⁢ 2$ $- 0 . 2 ⁢ 0 ⁢ 9 \leq q \left[1⁢9⁢1\right] \leq - 0 . 2 ⁢ 0 ⁢ 7$

To be more precise, the filter coefficients *q*(*v*) obey the following relations:$- 0 . 2 ⁢ 0 ⁢ 2 ⁢ 9 ⁢ 4 \leq q \left[0\right] \leq - 0 . 2 ⁢ 0 ⁢ 2 ⁢ 9 ⁢ 2$ $- 0 . 1 ⁢ 9 ⁢ 8 ⁢ 0 ⁢ 4 \leq q \left[1\right] \leq - 0 .19802$ $- 0 . 1 ⁢ 9 ⁢ 2 ⁢ 9 ⁢ 5 \leq q \left[2\right] \leq - 0 . 1 ⁢ 9 ⁢ 2 ⁢ 9 ⁢ 3$ $- 0 . 1 ⁢ 8 ⁢ 7 ⁢ 6 ⁢ 8 \leq q \left[3\right] \leq - 0 . 1 ⁢ 8 ⁢ 7 ⁢ 6 ⁢ 6$ $- 0 . 1 ⁢ 8 ⁢ 2 ⁢ 2 ⁢ 6 \leq q \left[4\right] \leq - 0 . 1 ⁢ 8 ⁢ 2 ⁢ 2 ⁢ 4$ $- 0.17668 \leq q \left[5\right] \leq - 0 . 1 ⁢ 7 ⁢ 6 ⁢ 6 ⁢ 6$ $- 0 . 1 ⁢ 7 ⁢ 0 ⁢ 9 ⁢ 7 \leq q \left[6\right] \leq - 0 .17095$ $- 0 . 1 ⁢ 6 ⁢ 5 ⁢ 1 ⁢ 4 \leq q \left[7\right] \leq - 0 .16512$ $- 0 . 1 ⁢ 5 ⁢ 9 ⁢ 1 ⁢ 9 \leq q \left[8\right] \leq - 0 . 1 ⁢ 5 ⁢ 9 ⁢ 1 ⁢ 7$ $- 0 . 1 ⁢ 5 ⁢ 3 ⁢ 1 ⁢ 3 \leq q \left[9\right] \leq - 0 . 1 ⁢ 5 ⁢ 3 ⁢ 1 ⁢ 1$ $- 0 . 1 ⁢ 4 ⁢ 6 ⁢ 9 ⁢ 7 \leq q \left[1⁢0\right] \leq - 0 .14695$ $- 0 . 1 ⁢ 4 ⁢ 0 ⁢ 7 ⁢ 1 \leq q \left[1⁢1\right] \leq - 0 . 1 ⁢ 4 ⁢ 0 ⁢ 6 ⁢ 9$ $- 0 . 1 ⁢ 3 ⁢ 4 ⁢ 3 ⁢ 7 \leq q \left[1⁢2\right] \leq - 0 .13435$ $- 0 . 1 ⁢ 2 ⁢ 7 ⁢ 9 ⁢ 4 \leq q \left[1⁢3\right] \leq - 0 . 1 ⁢ 2 ⁢ 7 ⁢ 9 ⁢ 2$ $- 0 . 1 ⁢ 2 ⁢ 1 ⁢ 4 ⁢ 4 \leq q \left[1⁢4\right] \leq - 0 .12142$ $- 0 . 1 ⁢ 1 ⁢ 4 ⁢ 8 ⁢ 6 \leq q \left[1⁢5\right] \leq - 0 .11484$ $- 0 . 1 ⁢ 0 ⁢ 8 ⁢ 2 ⁢ 1 \leq q \left[1⁢6\right] \leq - 0 . 1 ⁢ 0 ⁢ 8 ⁢ 1 ⁢ 9$ $- 0 . 1 ⁢ 0 ⁢ 1 ⁢ 4 ⁢ 9 \leq q \left[1⁢7\right] \leq - 0 .10147$ $- 0 . 0 ⁢ 9 ⁢ 4 ⁢ 7 ⁢ 1 \leq q \left[1⁢8\right] \leq - 0 . 0 ⁢ 9 ⁢ 4 ⁢ 6 ⁢ 9$ $- 0 . 0878 ⁢ 6 \leq q \left[1⁢9\right] \leq - 0 . 0 ⁢ 8 ⁢ 7 ⁢ 8 ⁢ 4$ $- 0 . 0 ⁢ 8 ⁢ 0 ⁢ 9 ⁢ 5 \leq q \left[2⁢0\right] \leq - 0 . 0 ⁢ 8 ⁢ 0 ⁢ 9 ⁢ 3$ $- 0 . 0 ⁢ 7 ⁢ 3 ⁢ 9 ⁢ 7 \leq q \left[2⁢1\right] \leq - 0 . 0 ⁢ 7 ⁢ 3 ⁢ 9 ⁢ 5$ $- 0 . 0 ⁢ 6 ⁢ 6 ⁢ 9 ⁢ 4 \leq q \left[2⁢2\right] \leq - 0 . 0 ⁢ 6 ⁢ 6 ⁢ 9 ⁢ 2$ $- 0 . 0 ⁢ 5 ⁢ 9 ⁢ 8 ⁢ 4 \leq q \left[2⁢3\right] \leq - 0 . 0 ⁢ 5 ⁢ 9 ⁢ 8 ⁢ 2$ $- 0 . 0 ⁢ 5 ⁢ 2 ⁢ 6 ⁢ 9 \leq q \left[2⁢4\right] \leq - 0 . 0 ⁢ 5 ⁢ 2 ⁢ 6 ⁢ 7$ $- 0 . 0 ⁢ 4 ⁢ 5 ⁢ 4 ⁢ 7 \leq q \left[2⁢5\right] \leq - 0 . 0 ⁢ 4 ⁢ 5 ⁢ 4 ⁢ 5$ $- 0 . 0 ⁢ 3 ⁢ 8 ⁢ 1 ⁢ 9 \leq q \left[2⁢6\right] \leq - 0 . 0 ⁢ 3 ⁢ 8 ⁢ 1 ⁢ 7$ $- 0 . 0 ⁢ 3 ⁢ 0 ⁢ 8 ⁢ 5 \leq q \left[2⁢7\right] \leq - 0 . 0 ⁢ 3 ⁢ 0 ⁢ 8 ⁢ 3$ $- 0 . 0 ⁢ 2 ⁢ 3 ⁢ 4 ⁢ 5 \leq q \left[2⁢8\right] \leq - 0 . 0 ⁢ 2 ⁢ 3 ⁢ 4 ⁢ 3$ $- 0 . 0 ⁢ 1 ⁢ 5 ⁢ 9 ⁢ 8 \leq q \left[2⁢9\right] \leq - 0 . 0 ⁢ 1 ⁢ 5 ⁢ 9 ⁢ 6$ $- 0 . 0 ⁢ 0 ⁢ 8 ⁢ 4 ⁢ 5 \leq q \left[3⁢0\right] \leq - 0 . 0 ⁢ 0 ⁢ 8 ⁢ 4 ⁢ 3$ $- 0 . 0 ⁢ 0 ⁢ 0 ⁢ 8 ⁢ 4 \leq q \left[3⁢1\right] \leq - 0 . 0 ⁢ 0 ⁢ 0 ⁢ 8 ⁢ 2$ $0.0 ⁢ 0 ⁢ 6 ⁢ 8 ⁢ 3 \leq q \left[3⁢2\right] \leq 0 . 0 ⁢ 0 ⁢ 6 ⁢ 8 ⁢ 5$ $0.0 ⁢ 1 ⁢ 4 ⁢ 5 ⁢ 8 \leq q \left[3⁢3\right] \leq 0 . 0 ⁢ 1 ⁢ 4 ⁢ 6 ⁢ 0$ $0.0 ⁢ 2 ⁢ 2 ⁢ 4 ⁢ 0 \leq q \left[3⁢4\right] \leq 0 . 0 ⁢ 2 ⁢ 2 ⁢ 4 ⁢ 2$ $0.0 ⁢ 3 ⁢ 0 ⁢ 3 ⁢ 0 \leq q \left[3⁢5\right] \leq 0 . 0 ⁢ 3 ⁢ 0 ⁢ 3 ⁢ 2$ $0.0 ⁢ 3 ⁢ 8 ⁢ 2 ⁢ 8 \leq q \left[3⁢6\right] \leq 0 . 0 ⁢ 3 ⁢ 8 ⁢ 3 ⁢ 0$ $0.0 ⁢ 4 ⁢ 6 ⁢ 3 ⁢ 5 \leq q \left[3⁢7\right] \leq 0 . 0 ⁢ 4 ⁢ 6 ⁢ 3 ⁢ 7$ $0.0 ⁢ 5 ⁢ 4 ⁢ 5 ⁢ 1 \leq q \left[3⁢8\right] \leq 0 . 0 ⁢ 5 ⁢ 4 ⁢ 5 ⁢ 3$ $0.0 ⁢ 6 ⁢ 2 ⁢ 7 ⁢ 5 \leq q \left[3⁢9\right] \leq 0 . 0 ⁢ 6 ⁢ 2 ⁢ 7 ⁢ 7$ $0.0 ⁢ 7 ⁢ 1 ⁢ 1 ⁢ 0 \leq q \left[4⁢0\right] \leq 0 . 071 ⁢ 1 ⁢ 2$ $0.0 ⁢ 7 ⁢ 9 ⁢ 5 ⁢ 4 \leq q \left[4⁢1\right] \leq 0 . 0 ⁢ 7 ⁢ 9 ⁢ 5 ⁢ 6$ $0.0 ⁢ 8 ⁢ 8 ⁢ 0 ⁢ 9 \leq q \left[4⁢2\right] \leq 0 . 0 ⁢ 8 ⁢ 8 ⁢ 1 ⁢ 1$ $0.0 ⁢ 9 ⁢ 6 ⁢ 7 ⁢ 5 \leq q \left[4⁢3\right] \leq 0 . 0 ⁢ 9 ⁢ 6 ⁢ 7 ⁢ 7$ $0.10552 \leq q \left[4⁢4\right] \leq 0 .10554$ $0.11442 \leq q \left[4⁢5\right] \leq 0 . 1 ⁢ 1 ⁢ 4 ⁢ 4 ⁢ 4$ $0.12344 \leq q \left[4⁢6\right] \leq 0 .12346$ $0.13259 \leq q \left[4⁢7\right] \leq 0 .13261$ $0.14189 \leq q \left[4⁢8\right] \leq 0 .14191$ $0.15132 \leq q \left[49\right] \leq 0 .15134$ $0.16091 \leq q \left[50\right] \leq 0 .16093$ $0.17066 \leq q \left[51\right] \leq 0 .17068$ $0.18058 \leq q \left[52\right] \leq 0 .18060$ $0.19067 \leq q \left[5⁢3\right] \leq 0 .19069$ $0.20095 \leq q \left[54\right] \leq 0 .20097$ $0.21143 \leq q \left[55\right] \leq 0 .21145$ $0.22211 \leq q \left[56\right] \leq 0 .22213$ $0.23300 \leq q \left[57\right] \leq 0 .23302$ $0.2 ⁢ 4 ⁢ 4 ⁢ 1 ⁢ 2 \leq q \left[5⁢8\right] \leq 0 . 2 ⁢ 4 ⁢ 4 ⁢ 1 ⁢ 4$ $0.2 ⁢ 5 ⁢ 5 ⁢ 4 ⁢ 9 \leq q \left[5⁢9\right] \leq 0 . 2 ⁢ 5 ⁢ 5 ⁢ 5 ⁢ 1$ $0.2 ⁢ 6 ⁢ 7 ⁢ 1 ⁢ 1 \leq q \left[6⁢0\right] \leq 0 . 2671 ⁢ 3$ $0.2 ⁢ 7 ⁢ 8 ⁢ 9 ⁢ 9 \leq q \left[6⁢1\right] \leq 0 . 2 ⁢ 7 ⁢ 9 ⁢ 0 ⁢ 1$ $0.2 ⁢ 9 ⁢ 1 ⁢ 1 ⁢ 7 \leq q \left[6⁢2\right] \leq 0 . 2 ⁢ 9 ⁢ 1 ⁢ 1 ⁢ 9$ $0.30364 \leq q \left[6⁢3\right] \leq 0 .30366$ $0.90252 \leq q \left[64\right] \leq 0 .90254$ $0.91035 \leq q \left[6⁢5\right] \leq 0 . 9 ⁢ 1 ⁢ 0 ⁢ 3 ⁢ 7$ $0.91769 \leq q \left[66\right] \leq 0 .91771$ $0.92457 \leq q \left[6⁢7\right] \leq 0 .92459$ $0.9 ⁢ 3 ⁢ 1 ⁢ 0 ⁢ 1 \leq q \left[6⁢8\right] \leq 0 . 9 ⁢ 3 ⁢ 1 ⁢ 0 ⁢ 3$ $0.9 ⁢ 3 ⁢ 7 ⁢ 0 ⁢ 5 \leq q \left[6⁢9\right] \leq 0 . 9 ⁢ 3 ⁢ 7 ⁢ 0 ⁢ 7$ $0.9 ⁢ 4 ⁢ 2 ⁢ 7 ⁢ 0 \leq q \left[7⁢0\right] \leq 0 . 9 ⁢ 4 ⁢ 2 ⁢ 7 ⁢ 2$ $0.9 ⁢ 4 ⁢ 8 ⁢ 0 ⁢ 0 \leq q \left[71\right] \leq 0 . 9 ⁢ 4 ⁢ 8 ⁢ 0 ⁢ 2$ $0.9 ⁢ 5 ⁢ 2 ⁢ 9 ⁢ 5 \leq q \left[7⁢2\right] \leq 0 . 9 ⁢ 5 ⁢ 2 ⁢ 9 ⁢ 7$ $0.9 ⁢ 5 ⁢ 7 ⁢ 5 ⁢ 8 \leq q \left[7⁢3\right] \leq 0 . 9 ⁢ 5 ⁢ 7 ⁢ 6 ⁢ 0$ $0.9 ⁢ 6 ⁢ 1 ⁢ 9 ⁢ 0 \leq q \left[7⁢4\right] \leq 0 . 9 ⁢ 6 ⁢ 1 ⁢ 9 ⁢ 2$ $0.9 ⁢ 6 ⁢ 5 ⁢ 9 ⁢ 3 \leq q \left[7⁢5\right] \leq 0 . 9 ⁢ 6 ⁢ 5 ⁢ 9 ⁢ 5$ $0.9 ⁢ 6 ⁢ 9 ⁢ 6 ⁢ 8 \leq q \left[7⁢6\right] \leq 0 . 9 ⁢ 6 ⁢ 9 ⁢ 7 ⁢ 0$ $0.9 ⁢ 7 ⁢ 3 ⁢ 1 ⁢ 7 \leq q \left[7⁢7\right] \leq 0 . 9 ⁢ 7 ⁢ 3 ⁢ 1 ⁢ 9$ $0.9 ⁢ 7 ⁢ 6 ⁢ 4 ⁢ 1 \leq q \left[7⁢8\right] \leq 0 . 9 ⁢ 7 ⁢ 6 ⁢ 4 ⁢ 3$ $0.9 ⁢ 7 ⁢ 9 ⁢ 4 ⁢ 0 \leq q \left[7⁢9\right] \leq 0 . 9 ⁢ 7 ⁢ 9 ⁢ 4 ⁢ 2$ $0.9 ⁢ 8 ⁢ 2 ⁢ 1 ⁢ 7 \leq q \left[8⁢0\right] \leq 0 . 9 ⁢ 8 ⁢ 2 ⁢ 1 ⁢ 9$ $0.9 ⁢ 8 ⁢ 4 ⁢ 7 ⁢ 2 \leq q \left[8⁢1\right] \leq 0 . 9 ⁢ 8 ⁢ 4 ⁢ 7 ⁢ 4$ $0.9 ⁢ 8 ⁢ 7 ⁢ 0 ⁢ 6 \leq q \left[8⁢2\right] \leq 0 . 9 ⁢ 8 ⁢ 7 ⁢ 0 ⁢ 8$ $0.9 ⁢ 8 ⁢ 9 ⁢ 1 ⁢ 9 \leq q \left[8⁢3\right] \leq 0 . 9 ⁢ 8 ⁢ 9 ⁢ 2 ⁢ 1$ $0.9 ⁢ 9 ⁢ 1 ⁢ 1 ⁢ 3 \leq q \left[8⁢4\right] \leq 0 . 9 ⁢ 9 ⁢ 1 ⁢ 1 ⁢ 5$ $0.9 ⁢ 9 ⁢ 2 ⁢ 8 ⁢ 8 \leq q \left[8⁢5\right] \leq 0 . 9 ⁢ 9 ⁢ 2 ⁢ 9 ⁢ 0$ $0.9 ⁢ 9 ⁢ 4 ⁢ 4 ⁢ 4 \leq q \left[8⁢6\right] \leq 0 . 9 ⁢ 9 ⁢ 4 ⁢ 4 ⁢ 6$ $0.9 ⁢ 9 ⁢ 5 ⁢ 8 ⁢ 3 \leq q \left[8⁢7\right] \leq 0 . 9 ⁢ 9 ⁢ 5 ⁢ 8 ⁢ 5$ $0.99704 \leq q \left[8⁢8\right] \leq 0 . 9 ⁢ 9 ⁢ 7 ⁢ 0 ⁢ 6$ $0.9 ⁢ 9 ⁢ 8 ⁢ 0 ⁢ 9 \leq q \left[8⁢9\right] \leq 0 . 9 ⁢ 9 ⁢ 8 ⁢ 1 ⁢ 1$ $0.9 ⁢ 9 ⁢ 8 ⁢ 9 ⁢ 6 \leq q \left[9⁢0\right] \leq 0 . 9 ⁢ 9 ⁢ 8 ⁢ 9 ⁢ 8$ $0.9 ⁢ 9 ⁢ 9 ⁢ 6 ⁢ 7 \leq q \left[9⁢1\right] \leq 0 . 9 ⁢ 9 ⁢ 9 ⁢ 6 ⁢ 9$ $1.0 ⁢ 0 ⁢ 0 ⁢ 2 ⁢ 3 \leq q \left[9⁢2\right] \leq 1 . 0 ⁢ 0 ⁢ 0 ⁢ 2 ⁢ 5$ $1.00062 \leq q \left[9⁢3\right] \leq 1 .00064$ $1.00086 \leq q \left[94\right] \leq 1 .00088$ $1.00093 \leq q \left[95\right] \leq 1 .00095$ $1.00086 \leq q \left[96\right] \leq 1 .00088$ $1.00062 \leq q \left[97\right] \leq 1 .00064$ $1.0 ⁢ 0 ⁢ 0 ⁢ 2 ⁢ 3 \leq q \left[9⁢8\right] \leq 1 . 0 ⁢ 0 ⁢ 0 ⁢ 2 ⁢ 5$ $0.9 ⁢ 9 ⁢ 9 ⁢ 6 ⁢ 7 \leq q \left[9⁢9\right] \leq 0 . 9 ⁢ 9 ⁢ 9 ⁢ 6 ⁢ 9$ $0.99896 \leq q \left[1⁢0⁢0\right] \leq 0 .99898$ $0.99809 \leq q \left[1⁢0⁢1\right] \leq 0 .99811$ $0.99704 \leq q \left[1⁢0⁢2\right] \leq 0 .99706$ $0.99583 \leq q \left[1⁢0⁢3\right] \leq 0 .99585$ $0.99444 \leq q \left[104\right] \leq 0 .99446$ $0.99288 \leq q \left[105\right] \leq 0 .99290$ $0.99113 \leq q \left[106\right] \leq 0 .99115$ $0.98919 \leq q \left[107\right] \leq 0 .98921$ $0.9 ⁢ 8 ⁢ 7 ⁢ 0 ⁢ 6 \leq q \left[1⁢0⁢8\right] \leq 0 . 9 ⁢ 8 ⁢ 7 ⁢ 0 ⁢ 8$ $0.9 ⁢ 8 ⁢ 4 ⁢ 7 ⁢ 2 \leq q \left[1⁢0⁢9\right] \leq 0 . 9 ⁢ 8 ⁢ 4 ⁢ 7 ⁢ 4$ $0.9 ⁢ 8 ⁢ 2 ⁢ 1 ⁢ 7 \leq q \left[1⁢1⁢0\right] \leq 0 . 9 ⁢ 8 ⁢ 2 ⁢ 1 ⁢ 9$ $0.9 ⁢ 7 ⁢ 9 ⁢ 4 ⁢ 0 \leq q \left[1⁢1⁢1\right] \leq 0 . 9 ⁢ 7 ⁢ 9 ⁢ 4 ⁢ 2$ $0.9 ⁢ 7 ⁢ 6 ⁢ 4 ⁢ 1 \leq q \left[1⁢1⁢2\right] \leq 0 . 9 ⁢ 7 ⁢ 6 ⁢ 4 ⁢ 3$ $0.97317 \leq q \left[1⁢1⁢3\right] \leq 0.97319$ $0.96968 \leq q \left[114\right] \leq 0.96970$ $0.96593 \leq q \left[1⁢1⁢5\right] \leq 0 .96595$ $0.96190 \leq q \left[116\right] \leq 0.96192$ $0.95758 \leq q \left[117\right] \leq 0.95760$ $0.9 ⁢ 5 ⁢ 2 ⁢ 9 ⁢ 5 \leq q \left[1⁢1⁢8\right] \leq 0 . 9 ⁢ 5 ⁢ 2 ⁢ 9 ⁢ 7$ $0.9 ⁢ 4 ⁢ 8 ⁢ 0 ⁢ 0 \leq q \left[1⁢1⁢9\right] \leq 0 . 9 ⁢ 4 ⁢ 8 ⁢ 0 ⁢ 2$ $0.9 ⁢ 4 ⁢ 2 ⁢ 7 ⁢ 0 \leq q \left[1⁢2⁢0\right] \leq 0 . 9 ⁢ 4 ⁢ 2 ⁢ 7 ⁢ 2$ $0.93705 \leq q \left[1⁢2⁢1\right] \leq 0 .93707$ $0.93101 \leq q \left[1⁢2⁢2\right] \leq 0 .93103$ $0.9 ⁢ 2 ⁢ 4 ⁢ 5 ⁢ 7 \leq q \left[1⁢2⁢3\right] \leq 0 . 9 ⁢ 2 ⁢ 4 ⁢ 5 ⁢ 9$ $0.9 ⁢ 1 ⁢ 7 ⁢ 6 ⁢ 9 \leq q \left[1⁢2⁢4\right] \leq 0 . 9 ⁢ 1 ⁢ 7 ⁢ 7 ⁢ 1$ $0.9 ⁢ 1 ⁢ 0 ⁢ 3 ⁢ 5 \leq q \left[1⁢2⁢5\right] \leq 0 . 9 ⁢ 1 ⁢ 0 ⁢ 3 ⁢ 7$ $0.90252 \leq q \left[1⁢2⁢6\right] \leq 0 .90254$ $0.89416 \leq q \left[1⁢2⁢7\right] \leq 0 .89418$ $0.2 ⁢ 9 ⁢ 1 ⁢ 1 ⁢ 7 \leq q \left[1⁢2⁢8\right] \leq 0 . 2 ⁢ 9 ⁢ 1 ⁢ 1 ⁢ 9$ $0.2 ⁢ 7 ⁢ 8 ⁢ 9 ⁢ 9 \leq q \left[1⁢2⁢9\right] \leq 0 . 2 ⁢ 7 ⁢ 9 ⁢ 0 ⁢ 1$ $0.2 ⁢ 6 ⁢ 7 ⁢ 1 ⁢ 1 \leq q \left[1⁢3⁢0\right] \leq 0 . 2 ⁢ 6 ⁢ 7 ⁢ 1 ⁢ 3$ $0.2 ⁢ 5 ⁢ 5 ⁢ 4 ⁢ 9 \leq q \left[1⁢3⁢1\right] \leq 0 . 2 ⁢ 5 ⁢ 5 ⁢ 5 ⁢ 1$ $0.2 ⁢ 4 ⁢ 4 ⁢ 1 ⁢ 2 \leq q \left[1⁢3⁢2\right] \leq 0 . 2 ⁢ 4 ⁢ 4 ⁢ 1 ⁢ 4$ $0.23300 \leq q \left[1⁢3⁢3\right] \leq 0 .23302$ $0.22211 \leq q \left[134\right] \leq 0 .22213$ $0.21143 \leq q \left[135\right] \leq 0 .21145$ $0.20095 \leq q \left[1⁢3⁢6\right] \leq 0 .20097$ $0.19067 \leq q \left[135\right] \leq 0 .19069$ $0.18058 \leq q \left[1⁢3⁢8\right] \leq 0 .18060$ $0.17066 \leq q \left[139\right] \leq 0 .17068$ $0.16091 \leq q \left[140\right] \leq 0 .16093$ $0.15132 \leq q \left[141\right] \leq 0 .15134$ $0.14189 \leq q \left[142\right] \leq 0 .14191$ $0.13259 \leq q \left[1⁢4⁢3\right] \leq 0 . 1 ⁢ 3 ⁢ 2 ⁢ 6 ⁢ 1$ $0.12344 \leq q \left[144\right] \leq 0 . 12346$ $0.11442 \leq q \left[145\right] \leq 0 . 11444$ $0.10552 \leq q \left[1⁢4⁢6\right] \leq 0 .10554$ $0.09675 \leq q \left[147\right] \leq 0 . 09677$ $0.0 ⁢ 8 ⁢ 8 ⁢ 0 ⁢ 9 \leq q \left[1⁢4⁢8\right] \leq 0 . 0 ⁢ 8 ⁢ 8 ⁢ 1 ⁢ 1$ $0.07954 \leq q \left[1⁢4⁢9\right] \leq 0 . 0 ⁢ 7 ⁢ 9 ⁢ 5 ⁢ 6$ $0.0 ⁢ 7 ⁢ 1 ⁢ 1 ⁢ 0 \leq q \left[1⁢5⁢0\right] \leq 0 . 0 ⁢ 7 ⁢ 1 ⁢ 1 ⁢ 2$ $0.06275 \leq q \left[1⁢5⁢1\right] \leq 0 .06277$ $0.05451 \leq q \left[1⁢5⁢2\right] \leq 0 . 0 ⁢ 5 ⁢ 4 ⁢ 5 ⁢ 3$ $0.0 ⁢ 4 ⁢ 6 ⁢ 3 ⁢ 5 \leq q \left[1⁢5⁢3\right] \leq 0 . 0 ⁢ 4 ⁢ 6 ⁢ 3 ⁢ 7$ $0.0 ⁢ 3 ⁢ 8 ⁢ 2 ⁢ 8 \leq q \left[1⁢5⁢4\right] \leq 0 . 0 ⁢ 3 ⁢ 8 ⁢ 3 ⁢ 0$ $0.0 ⁢ 3 ⁢ 0 ⁢ 3 ⁢ 0 \leq q \left[1⁢5⁢5\right] \leq 0 . 0 ⁢ 3 ⁢ 0 ⁢ 3 ⁢ 2$ $0.0 ⁢ 2 ⁢ 2 ⁢ 4 ⁢ 0 \leq q \left[1⁢5⁢6\right] \leq 0 . 0 ⁢ 2 ⁢ 2 ⁢ 4 ⁢ 2$ $0.0 ⁢ 1 ⁢ 4 ⁢ 5 ⁢ 8 \leq q \left[1⁢5⁢7\right] \leq 0 . 0 ⁢ 1 ⁢ 4 ⁢ 6 ⁢ 0$ $0.00683 \leq q \left[1⁢5⁢8\right] \leq 0 .00685$ $- 0.000683 \leq q \left[159\right] \leq - 0.00082$ $- 0.00845 \leq q \left[160\right] \leq - 0.00843$ $- 0 . 0 ⁢ 1 ⁢ 5 ⁢ 9 ⁢ 8 \leq q \left[1⁢6⁢1\right] \leq - 0.01596$ $- 0.02345 \leq q \left[162\right] \leq - 0.02343$ $- 0 . 0 ⁢ 3 ⁢ 0 ⁢ 8 ⁢ 5 \leq q \left[1⁢6⁢3\right] \leq - 0 . 0 ⁢ 3 ⁢ 0 ⁢ 8 ⁢ 3$ $- 0 . 0 ⁢ 3 ⁢ 8 ⁢ 1 ⁢ 9 \leq q \left[1⁢6⁢4\right] \leq - 0 . 0 ⁢ 3 ⁢ 8 ⁢ 1 ⁢ 7$ $- 0 . 0 ⁢ 4 ⁢ 5 ⁢ 4 ⁢ 7 \leq q \left[1⁢6⁢5\right] \leq - 0 . 0 ⁢ 4 ⁢ 5 ⁢ 4 ⁢ 5$ $- 0 . 0 ⁢ 5 ⁢ 2 ⁢ 6 ⁢ 9 \leq q \left[1⁢6⁢6\right] \leq - 0 . 0 ⁢ 5 ⁢ 2 ⁢ 6 ⁢ 7$ $- 0 . 0 ⁢ 5 ⁢ 9 ⁢ 8 ⁢ 4 \leq q \left[1⁢6⁢7\right] \leq - 0 . 0 ⁢ 5 ⁢ 9 ⁢ 8 ⁢ 2$ $- 0 . 0 ⁢ 6 ⁢ 6 ⁢ 9 ⁢ 4 \leq q \left[1⁢6⁢8\right] \leq - 0 . 0 ⁢ 6 ⁢ 6 ⁢ 9 ⁢ 2$ $- 0 . 0 ⁢ 7 ⁢ 3 ⁢ 9 ⁢ 7 \leq q \left[1⁢6⁢9\right] \leq - 0 . 0 ⁢ 7 ⁢ 3 ⁢ 9 ⁢ 5$ $- 0 . 0 ⁢ 8 ⁢ 0 ⁢ 9 ⁢ 5 \leq q \left[1⁢7⁢0\right] \leq - 0 . 0 ⁢ 8 ⁢ 0 ⁢ 9 ⁢ 3$ $- 0 . 0 ⁢ 8 ⁢ 7 ⁢ 8 ⁢ 6 \leq q \left[1⁢7⁢1\right] \leq - 0 . 0 ⁢ 8 ⁢ 7 ⁢ 8 ⁢ 4$ $- 0 . 0 ⁢ 9 ⁢ 4 ⁢ 7 ⁢ 1 \leq q \left[1⁢7⁢2\right] \leq - 0 . 0 ⁢ 9 ⁢ 4 ⁢ 6 ⁢ 9$ $- 0 . 1 ⁢ 0 ⁢ 1 ⁢ 4 ⁢ 9 \leq q \left[173\right] \leq - 0 . 1 ⁢ 0 ⁢ 1 ⁢ 4 ⁢ 7$ $- 0 . 1 ⁢ 0 ⁢ 8 ⁢ 2 ⁢ 1 \leq q \left[1⁢7⁢4\right] \leq - 0 . 1 ⁢ 0 ⁢ 8 ⁢ 1 ⁢ 9$ $- 0 . 1 ⁢ 1 ⁢ 4 ⁢ 8 ⁢ 6 \leq q \left[1⁢7⁢5\right] \leq - 0 . 1 ⁢ 1 ⁢ 4 ⁢ 8 ⁢ 4$ $- 0 . 1 ⁢ 2 ⁢ 1 ⁢ 4 ⁢ 4 \leq q \left[1⁢7⁢6\right] \leq - 0 . 1 ⁢ 2 ⁢ 1 ⁢ 4 ⁢ 2$ $- 0 . 1 ⁢ 2 ⁢ 7 ⁢ 9 ⁢ 4 \leq q \left[1⁢7⁢7\right] \leq - 0 . 1 ⁢ 2 ⁢ 7 ⁢ 9 ⁢ 2$ $- 0 . 1 ⁢ 3 ⁢ 4 ⁢ 3 ⁢ 7 \leq q \left[1⁢7⁢8\right] \leq - 0 . 1 ⁢ 3 ⁢ 4 ⁢ 3 ⁢ 5$ $- 0 . 1 ⁢ 4 ⁢ 0 ⁢ 7 ⁢ 1 \leq q \left[1⁢7⁢9\right] \leq - 0 . 1 ⁢ 4 ⁢ 0 ⁢ 6 ⁢ 9$ $- 0 . 1 ⁢ 4 ⁢ 6 ⁢ 9 ⁢ 7 \leq q \left[1⁢8⁢0\right] \leq - 0 . 1 ⁢ 4 ⁢ 6 ⁢ 9 ⁢ 5$ $- 0 . 1 ⁢ 5 ⁢ 3 ⁢ 1 ⁢ 3 \leq q \left[1⁢8⁢1\right] \leq - 0 . 1 ⁢ 5 ⁢ 3 ⁢ 1 ⁢ 1$ $- 0 . 1 ⁢ 5 ⁢ 9 ⁢ 1 ⁢ 9 \leq q \left[1⁢8⁢2\right] \leq - 0 . 1 ⁢ 5 ⁢ 9 ⁢ 1 ⁢ 7$ $- 0 . 1 ⁢ 6 ⁢ 5 ⁢ 1 ⁢ 4 \leq q \left[1⁢8⁢3\right] \leq - 0 . 1 ⁢ 6 ⁢ 5 ⁢ 1 ⁢ 2$ $- 0 . 1 ⁢ 7 ⁢ 0 ⁢ 9 ⁢ 7 \leq q \left[1⁢8⁢4\right] \leq - 0 . 1 ⁢ 7 ⁢ 0 ⁢ 9 ⁢ 5$ $- 0.17668 \leq q \left[1⁢8⁢5\right] \leq - 0 . 1 ⁢ 7 ⁢ 6 ⁢ 6 ⁢ 6$ $- 0 . 1 ⁢ 8 ⁢ 2 ⁢ 2 ⁢ 6 \leq q \left[1⁢8⁢6\right] \leq - 0 . 1 ⁢ 8 ⁢ 2 ⁢ 2 ⁢ 4$ $- 0 . 1 ⁢ 8 ⁢ 7 ⁢ 6 ⁢ 8 \leq q \left[1⁢8⁢7\right] \leq - 0 . 1 ⁢ 8 ⁢ 7 ⁢ 6 ⁢ 6$ $- 0 . 1 ⁢ 9 ⁢ 2 ⁢ 9 ⁢ 5 \leq q \left[1⁢8⁢8\right] \leq - 0 . 1 ⁢ 9 ⁢ 2 ⁢ 9 ⁢ 3$ $- 0 . 1 ⁢ 9 ⁢ 8 ⁢ 0 ⁢ 4 \leq q \left[1⁢8⁢9\right] \leq - 0 . 1 ⁢ 9 ⁢ 8 ⁢ 0 ⁢ 2$ $- 0 . 2 ⁢ 0 ⁢ 2 ⁢ 9 ⁢ 4 \leq q \left[1⁢9⁢0\right] \leq - 0 . 2 ⁢ 0 ⁢ 2 ⁢ 9 ⁢ 2$ $- 0 . 2 ⁢ 0 ⁢ 7 ⁢ 6 ⁢ 4 \leq q \left[1⁢9⁢1\right] \leq - 0 . 2 ⁢ 0 ⁢ 7 ⁢ 6 ⁢ 2$

Even more accurately, the filter coefficients q(v) can be expressed by the following equations for the integer ν in the range between 0 and 191, wherein according to the requirements and specifications of special implementations, the prototype filter coefficients may deviate from the following equations either individually or from the maximum absolute value typically by 10%, 5% or 2% and preferably by 1% or 0.1%:$q \left[0\right] = - 0 . 2 ⁢ 0 ⁢ 2 ⁢ 9 ⁢ 3 ⁢ 4 ⁢ 3 ⁢ 3 ⁢ 8 ⁢ 0$ $q \left[1\right] = - 0 . 1 ⁢ 9 ⁢ 8 ⁢ 0 ⁢ 3 ⁢ 3 ⁢ 1 ⁢ 5 ⁢ 8 ⁢ 8$ $q \left[2\right] = - 0 . 1 ⁢ 9 ⁢ 2 ⁢ 9 ⁢ 4 ⁢ 1 ⁢ 1 ⁢ 5 ⁢ 1 ⁢ 9$ $q \left[3\right] = - 0 . 1 ⁢ 8 ⁢ 7 ⁢ 6 ⁢ 7 ⁢ 4 ⁢ 4 ⁢ 2 ⁢ 2 ⁢ 2$ $q \left[4\right] = - 0 . 1 ⁢ 8 ⁢ 2 ⁢ 2 ⁢ 4 ⁢ 7 ⁢ 4 ⁢ 0 ⁢ 1 ⁢ 1$ $q \left[5\right] = - 0 . 1 ⁢ 7 ⁢ 6 ⁢ 6 ⁢ 7 ⁢ 3 ⁢ 0 ⁢ 2 ⁢ 0 ⁢ 2$ $q \left[6\right] = - 0 . 1 ⁢ 7 ⁢ 0 ⁢ 9 ⁢ 6 ⁢ 2 ⁢ 8 ⁢ 6 ⁢ 3 ⁢ 6$ $q \left[7\right] = - 0 . 1 ⁢ 6 ⁢ 5 ⁢ 1 ⁢ 2 ⁢ 7 ⁢ 3 ⁢ 0 ⁢ 0 ⁢ 5$ $q \left[8\right] = - 0 . 1 ⁢ 5 ⁢ 9 ⁢ 1 ⁢ 7 ⁢ 5 ⁢ 6 ⁢ 0 ⁢ 2 ⁢ 4$ $q \left[9\right] = - 0 . 1 ⁢ 5 ⁢ 3 ⁢ 1 ⁢ 1 ⁢ 6 ⁢ 0 ⁢ 4 ⁢ 5 ⁢ 5$ $q \left[1⁢0\right] = - 0 .1469560005$ $q \left[1⁢1\right] = - 0 . 1 ⁢ 4 ⁢ 0 ⁢ 7 ⁢ 0 ⁢ 2 ⁢ 0 ⁢ 1 ⁢ 3 ⁢ 2$ $q \left[1⁢2\right] = - 0 . 1 ⁢ 3 ⁢ 4 ⁢ 3 ⁢ 5 ⁢ 9 ⁢ 8 ⁢ 7 ⁢ 3 ⁢ 8$ $q \left[1⁢3\right] = - 0 . 1 ⁢ 2 ⁢ 7 ⁢ 9 ⁢ 3 ⁢ 4 ⁢ 6 ⁢ 7 ⁢ 9 ⁢ 0$ $q \left[1⁢4\right] = - 0 .1214308876$ $q \left[1⁢5\right] = - 0 . 1 ⁢ 1 ⁢ 4 ⁢ 8523686$ $q \left[1⁢6\right] = - 0 . 108 ⁢ 2 ⁢ 0 ⁢ 2 ⁢ 4 ⁢ 4 ⁢ 5 ⁢ 4$ $q \left[1⁢7\right] = - 0 . 1 ⁢ 0 ⁢ 1 ⁢ 4 ⁢ 8 ⁢ 3 ⁢ 9 ⁢ 3 ⁢ 4 ⁢ 1$ $q \left[1⁢8\right] = - 0 . 0 ⁢ 9 ⁢ 4 ⁢ 6 ⁢ 9 ⁢ 9 ⁢ 1 ⁢ 7 ⁢ 8 ⁢ 3$ $q \left[19\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[2⁢0\right] = - 0 . 0 ⁢ 8 ⁢ 0 ⁢ 9 ⁢ 3 ⁢ 8 ⁢ 1 ⁢ 2 ⁢ 6 ⁢ 8$ $q \left[2⁢1\right] = - 0 . 0 ⁢ 7 ⁢ 3 ⁢ 9 ⁢ 6 ⁢ 4 ⁢ 4 ⁢ 1 ⁢ 7 ⁢ 4$ $q \left[2⁢2\right] = - 0 . 0 ⁢ 6 ⁢ 6 ⁢ 9 ⁢ 2 ⁢ 9 ⁢ 6 ⁢ 8 ⁢ 3 ⁢ 1$ $q \left[2⁢3\right] = - 0 . 0 ⁢ 5 ⁢ 9 ⁢ 8 ⁢ 3 ⁢ 4 ⁢ 3 ⁢ 0 ⁢ 8 ⁢ 1$ $q \left[2⁢4\right] = - 0 . 0 ⁢ 5 ⁢ 2 ⁢ 6 ⁢ 7 ⁢ 8 ⁢ 3 ⁢ 4 ⁢ 6 ⁢ 6$ $q \left[2⁢5\right] = - 0 . 0 ⁢ 4 ⁢ 5 ⁢ 4 ⁢ 6 ⁢ 1 ⁢ 5 ⁢ 3 ⁢ 8 ⁢ 8$ $q \left[2⁢6\right] = - 0 . 0 ⁢ 3 ⁢ 8 ⁢ 1 ⁢ 8 ⁢ 3 ⁢ 3 ⁢ 2 ⁢ 4 ⁢ 9$ $q \left[2⁢7\right] = - 0 . 0 ⁢ 3 ⁢ 0 ⁢ 8 ⁢ 4 ⁢ 2 ⁢ 8 ⁢ 5 ⁢ 7 ⁢ 2$ $q \left[2⁢8\right] = - 0 . 0 ⁢ 2 ⁢ 3 ⁢ 4 ⁢ 3 ⁢ 9 ⁢ 0 ⁢ 1 ⁢ 1 ⁢ 5$ $q \left[29\right] = - 0 . 0 ⁢ 1 ⁢ 5 ⁢ 9 ⁢ 7 ⁢ 0 ⁢ 3 ⁢ 9 ⁢ 5 ⁢ 7$ $q \left[3⁢0\right] = - 0 . 0 ⁢ 0 ⁢ 8 ⁢ 4 ⁢ 3 ⁢ 5 ⁢ 3 ⁢ 5 ⁢ 8 ⁢ 4$ $q \left[3⁢1\right] = - 0 . 0 ⁢ 0 ⁢ 0 ⁢ 8 ⁢ 3 ⁢ 1 ⁢ 9 ⁢ 9 ⁢ 5 ⁢ 6$ $q \left[3⁢2\right] = 0 . 0 ⁢ 0 ⁢ 6 ⁢ 8 ⁢ 4 ⁢ 1 ⁢ 8 ⁢ 4 ⁢ 3 ⁢ 5$ $q \left[3⁢3\right] = 0.0145885527$ $q \left[3⁢4\right] = 0 . 0 ⁢ 2 ⁢ 2 ⁢ 4 ⁢ 1 ⁢ 0 ⁢ 7 ⁢ 6 ⁢ 4 ⁢ 8.$ $q \left[3⁢5\right] = 0 . 0 ⁢ 3 ⁢ 0 ⁢ 3 ⁢ 1 ⁢ 1 ⁢ 3 ⁢ 4 ⁢ 9 ⁢ 5$ $q \left[3⁢6\right] = 0 . 0 ⁢ 3 ⁢ 8 ⁢ 2 ⁢ 9 ⁢ 3 ⁢ 4 ⁢ 1 ⁢ 2 ⁢ 6$ $q \left[3⁢7\right] = 0 . 0 ⁢ 4 ⁢ 6 ⁢ 3 ⁢ 6 ⁢ 0 ⁢ 2 ⁢ 9 ⁢ 5 ⁢ 9$ $q \left[3⁢8\right] = 0 . 0 ⁢ 5 ⁢ 4 ⁢ 5 ⁢ 1 ⁢ 5 ⁢ 5 ⁢ 7 ⁢ 8 ⁢ 9$ $q \left[39\right] = 0 . 0627630810$ $q \left[4⁢0\right] = 0 . 0 ⁢ 7 ⁢ 1 ⁢ 1 ⁢ 0 ⁢ 6 ⁢ 8 ⁢ 6 ⁢ 5 ⁢ 7$ $q \left[4⁢1\right] = 0 . 0 ⁢ 7 ⁢ 9 ⁢ 5 ⁢ 5 ⁢ 1 ⁢ 2 ⁢ 4 ⁢ 5 ⁢ 3$ $q \left[4⁢2\right] = 0 . 0 ⁢ 8 ⁢ 8 ⁢ 1 ⁢ 0 ⁢ 0 ⁢ 7 ⁢ 8 ⁢ 7 ⁢ 9$ $q \left[4⁢3\right] = 0 . 0 ⁢ 9 ⁢ 6 ⁢ 7 ⁢ 6 ⁢ 0 ⁢ 3 ⁢ 2 ⁢ 5 ⁢ 9$ $q \left[4⁢4\right] = 0 . 1 ⁢ 0 ⁢ 5 ⁢ 5 ⁢ 3 ⁢ 4 ⁢ 9 ⁢ 6 ⁢ 5 ⁢ 8$ $q \left[4⁢5\right] = 0 . 1 ⁢ 1 ⁢ 4 ⁢ 4301 ⁢ 0 ⁢ 0 ⁢ 0$ $q \left[4⁢6\right] = 0 . 1 ⁢ 2 ⁢ 3 ⁢ 4 ⁢ 5 ⁢ 1 ⁢ 4 ⁢ 2 ⁢ 2 ⁢ 2$ $q \left[4⁢7\right] = 0 . 1 ⁢ 3 ⁢ 2 ⁢ 6 ⁢ 0 ⁢ 4 ⁢ 9 ⁢ 4 ⁢ 3 ⁢ 4$ $q \left[4⁢8\right] = 0 . 1 ⁢ 4 ⁢ 1 ⁢ 8 ⁢ 9 ⁢ 7 ⁢ 0 ⁢ 1 ⁢ 2 ⁢ 3$ $q \left[4⁢9\right] = 0 . 1 ⁢ 5 ⁢ 1 ⁢ 3 ⁢ 3 ⁢ 4 ⁢ 3 ⁢ 3 ⁢ 7 ⁢ 0$ $q \left[5⁢0\right] = 0 . 1 ⁢ 6 ⁢ 0 ⁢ 9 ⁢ 2 ⁢ 4 ⁢ 0 ⁢ 1 ⁢ 2 ⁢ 6$ $q \left[5⁢1\right] = 0 .1706735517$ $q \left[5⁢2\right] = 0.1805909194$ $q \left[5⁢3\right] = 0.1906845753$ $q \left[5⁢4\right] = 0.2009635191$ $q \left[5⁢5\right] = 0.2114373458$ $q \left[5⁢6\right] = 0 . 2 ⁢ 2 ⁢ 2 ⁢ 1 ⁢ 1 ⁢ 6 ⁢ 3 ⁢ 0 ⁢ 8 ⁢ 0$ $q \left[5⁢7\right] = 0 . 2 ⁢ 3 ⁢ 3 ⁢ 0 ⁢ 1 ⁢ 1 ⁢ 3 ⁢ 8 ⁢ 6 ⁢ 8$ $q \left[5⁢8\right] = 0 . 2 ⁢ 4 ⁢ 4 ⁢ 1 ⁢ 3 ⁢ 4 ⁢ 3 ⁢ 7 ⁢ 4 ⁢ 2$ $q \left[5⁢9\right] = 0 . 2 ⁢ 5 ⁢ 5 ⁢ 4 ⁢ 9 ⁢ 7 ⁢ 9 ⁢ 6 ⁢ 6 ⁢ 4$ $q \left[6⁢0\right] \to 0 . 2 ⁢ 6 ⁢ 7 ⁢ 1 ⁢ 1 ⁢ 5 ⁢ 8 ⁢ 7 ⁢ 0 ⁢ 0$ $q \left[6⁢1\right] = 0 . 2 ⁢ 7 ⁢ 9 ⁢ 0 ⁢ 0 ⁢ 2 ⁢ 9 ⁢ 2 ⁢ 3 ⁢ 6$ $q \left[6⁢2\right] = 0 . 2 ⁢ 9 ⁢ 1 ⁢ 1 ⁢ 7 ⁢ 5 ⁢ 2 ⁢ 3 ⁢ 4 ⁢ 9$ $q \left[6⁢3\right] = 0 . 3 ⁢ 0 ⁢ 3 ⁢ 6 ⁢ 5 ⁢ 0 ⁢ 3 ⁢ 3 ⁢ 5 ⁢ 0$ $q \left[6⁢4\right] = 0 . 9 ⁢ 0 ⁢ 2 ⁢ 5 ⁢ 2 ⁢ 7 ⁢ 5 ⁢ 7 ⁢ 1 ⁢ 3$ $q \left[6⁢5\right] = 0 . 9 ⁢ 1 ⁢ 0 ⁢ 3 ⁢ 5 ⁢ 8 ⁢ 5 ⁢ 1 ⁢ 9 ⁢ 6$ $q \left[6⁢6\right] = 0 . 9 ⁢ 1 ⁢ 7 ⁢ 6 ⁢ 9 ⁢ 7 ⁢ 7 ⁢ 8 ⁢ 2 ⁢ 5$ $q \left[6⁢7\right] = 0 . 9 ⁢ 2 ⁢ 4 ⁢ 5 ⁢ 7 ⁢ 6 ⁢ 0 ⁢ 6 ⁢ 8 ⁢ 3$ $q \left[6⁢8\right] = 0 . 9 ⁢ 3 ⁢ 1 ⁢ 0 ⁢ 2 ⁢ 1 ⁢ 4 ⁢ 5 ⁢ 8 ⁢ 1$ $q \left[6⁢9\right] = 0 . 9 ⁢ 3 ⁢ 7 ⁢ 0 ⁢ 5 ⁢ 9 ⁢ 6 ⁢ 7 ⁢ 3 ⁢ 9$ $q \left[7⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[71\right] = 0 . 9 ⁢ 4 ⁢ 8 ⁢ 0 ⁢ 0 ⁢ 7 ⁢ 0 ⁢ 6 ⁢ 0 ⁢ 6$ $q \left[7⁢2\right] = 0 . 9 ⁢ 5 ⁢ 2 ⁢ 9 ⁢ 5 ⁢ 7 ⁢ 8 ⁢ 5 ⁢ 6 ⁢ 6$ $q \left[73\right] = 0.9575850672$ $q \left[7⁢4\right] = 0 . 9 ⁢ 6 ⁢ 1 ⁢ 9 ⁢ 0 ⁢ 5 ⁢ 6 ⁢ 1 ⁢ 5 ⁢ 8$ $q \left[7⁢5\right] = 0 . 9 ⁢ 6 ⁢ 5 ⁢ 9 ⁢ 3 ⁢ 5 ⁢ 1 ⁢ 0 ⁢ 6 ⁢ 5$ $q \left[76\right] = 0 . 9696879297$ $q \left[7⁢7\right] = 0 . 9 ⁢ 7 ⁢ 3 ⁢ 1 ⁢ 7 ⁢ 7 ⁢ 3 ⁢ 547$ $q \left[7⁢8\right] = 0 . 9 ⁢ 7 ⁢ 6 ⁢ 4 ⁢ 1 ⁢ 5 ⁢ 6 ⁢ 1 ⁢ 1 ⁢ 9$ $q \left[7⁢9\right] = 0 . 9 ⁢ 7 ⁢ 9 ⁢ 4 ⁢ 1 ⁢ 3 ⁢ 9 ⁢ 6 ⁢ 4 ⁢ 0$ $q \left[8⁢0\right] = 0 . 9 ⁢ 8 ⁢ 2 ⁢ 1 ⁢ 8 ⁢ 2 ⁢ 7 ⁢ 6 ⁢ 9 ⁢ 2$ $q \left[8⁢1\right] = 0 . 9 ⁢ 8 ⁢ 4 ⁢ 7 ⁢ 3 ⁢ 1 ⁢ 5 ⁢ 3 ⁢ 7 ⁢ 7$ $q \left[8⁢2\right] = 0 . 9 ⁢ 8 ⁢ 7 ⁢ 0 ⁢ 6 ⁢ 8 ⁢ 9 ⁢ 7 ⁢ 9 ⁢ 0$ $q \left[8⁢3\right] = 0 . 9 ⁢ 8 ⁢ 9 ⁢ 2 ⁢ 0 ⁢ 3 ⁢ 0 ⁢ 4 ⁢ 6 ⁢ 2$ $q \left[8⁢4\right] = 0 . 9 ⁢ 9 ⁢ 1 ⁢ 1 ⁢ 4 ⁢ 0 ⁢ 9 ⁢ 7 ⁢ 2 ⁢ 8$ $q \left[85\right] = 0 . 9 ⁢ 9 ⁢ 2 ⁢ 8 ⁢ 8 ⁢ 9 ⁢ 3 ⁢ 0 ⁢ 6 ⁢ 7$ $q \left[8⁢6\right] = 0 . 9 ⁢ 9 ⁢ 4 ⁢ 4 ⁢ 5 ⁢ 3 ⁢ 9 ⁢ 3 ⁢ 9 ⁢ 5$ $q \left[8⁢7\right] = 0 . 9 ⁢ 9 ⁢ 5 ⁢ 8 ⁢ 4 ⁢ 0 ⁢ 1 ⁢ 3 ⁢ 1 ⁢ 8$ $q \left[8⁢8\right] = 0 . 9 ⁢ 9 ⁢ 7 ⁢ 0 ⁢ 5 ⁢ 2 ⁢ 5 ⁢ 3 ⁢ 5 ⁢ 2$ $q \left[8⁢9\right] = 0 . 9 ⁢ 9 ⁢ 8 ⁢ 0 ⁢ 9 ⁢ 5 ⁢ 2 ⁢ 1 ⁢ 1 ⁢ 8$ $q \left[9⁢0\right] = 0 . 9 ⁢ 9 ⁢ 8 ⁢ 9 ⁢ 7 ⁢ 1 ⁢ 6 ⁢ 5 ⁢ 0 ⁢ 4$ $q \left[9⁢1\right] = 0 . 9 ⁢ 9 ⁢ 9 ⁢ 6 ⁢ 8 ⁢ 4 ⁢ 7 ⁢ 8 ⁢ 0 ⁢ 6$ $q \left[9⁢2\right] = 1 . 0 ⁢ 0 ⁢ 0 ⁢ 2 ⁢ 3 ⁢ 6 ⁢ 9 ⁢ 8 ⁢ 3 ⁢ 7$ $q \left[9⁢3\right] = 1.0006301028$ $q \left[9⁢4\right] = 1.0008654482$ $q \left[95\right] = 1.0009438063$ $q \left[9⁢6\right] = 1 . 0 ⁢ 0 ⁢ 0 ⁢ 8 ⁢ 6 ⁢ 5 ⁢ 4 ⁢ 4 ⁢ 8 ⁢ 2$ $q \left[9⁢7\right] = 1 . 0 ⁢ 0 ⁢ 0 ⁢ 6 ⁢ 3 ⁢ 0 ⁢ 1 ⁢ 0 ⁢ 2 ⁢ 8$ $q \left[9⁢8\right] = 1 . 0 ⁢ 0 ⁢ 0 ⁢ 2 ⁢ 3 ⁢ 6 ⁢ 9 ⁢ 8 ⁢ 3 ⁢ 7$ $q \left[9⁢9\right] = 0 . 9 ⁢ 9 ⁢ 9 ⁢ 6 ⁢ 8 ⁢ 4 ⁢ 7 ⁢ 8 ⁢ 0 ⁢ 6$ $q \left[1⁢0⁢0\right] = 0 . 9 ⁢ 9 ⁢ 8 ⁢ 9 ⁢ 7 ⁢ 1 ⁢ 6 ⁢ 5 ⁢ 0 ⁢ 4$ $q \left[1⁢0⁢1\right] = 0.9980952118$ $q \left[1⁢0⁢2\right] = 0.9970525352$ $q \left[1⁢0⁢3\right] = 0.9958401318$ $q \left[1⁢0⁢4\right] = 0 . 9 ⁢ 9 ⁢ 4 ⁢ 4 ⁢ 5 ⁢ 3 ⁢ 9 ⁢ 3 ⁢ 9 ⁢ 5$ $q \left[1⁢0⁢5\right] = 0.9928893067$ $q \left[1⁢0⁢6\right] = 0 . 9 ⁢ 9 ⁢ 1 ⁢ 1 ⁢ 4 ⁢ 0 ⁢ 9 ⁢ 7 ⁢ 2 ⁢ 8$ $q \left[1⁢0⁢7\right] = 0 .9892030462$ $q \left[1⁢0⁢8\right] = 0 . 9870 ⁢ 6 ⁢ 8 ⁢ 9 ⁢ 7 ⁢ 9 ⁢ 0$ $q \left[1⁢0⁢9\right] = 0 .9847315377$ $q \left[1⁢1⁢0\right] = 0.9821827692$ $q \left[1⁢1⁢1\right] = 0 . 9 ⁢ 7 ⁢ 9 ⁢ 4 ⁢ 1 ⁢ 3 ⁢ 9 ⁢ 6 ⁢ 4 ⁢ 0$ $q \left[1⁢1⁢2\right] = 0.9764156119$ $q \left[1⁢1⁢3\right] = 0.9731773547$ $q \left[1⁢1⁢4\right] = 0.9696879297$ $q \left[1⁢1⁢5\right] = 0.9659351065$ $q \left[116\right] = 0.9619056158$ $q \left[117\right] = 0.9575850672$ $q \left[118\right] = 0.9529578566$ $q \left[119\right] = 0.9480070606$ $q \left[120\right] = 0.9427143143$ $q \left[1⁢2⁢1\right] = 0 . 9 ⁢ 3 ⁢ 7 ⁢ 0 ⁢ 5 ⁢ 9 ⁢ 6 ⁢ 7 ⁢ 3 ⁢ 9$ $q \left[1⁢2⁢2\right] = 0 . 9 ⁢ 3 ⁢ 1 ⁢ 0 ⁢ 2 ⁢ 1 ⁢ 4 ⁢ 5 ⁢ 8 ⁢ 1$ $q \left[1⁢2⁢3\right] = 0 . 9 ⁢ 2 ⁢ 4 ⁢ 5 ⁢ 7 ⁢ 6 ⁢ 0 ⁢ 6 ⁢ 8 ⁢ 3$ $q \left[1⁢2⁢4\right] = 0.9176977825$ $q \left[1⁢2⁢5\right] = 0 . 9 ⁢ 1 ⁢ 0 ⁢ 3 ⁢ 5 ⁢ 8 ⁢ 5 ⁢ 196$ $q \left[1⁢2⁢6\right] = 0 . 9 ⁢ 0 ⁢ 2 ⁢ 5 ⁢ 2 ⁢ 7 ⁢ 5 ⁢ 7 ⁢ 1 ⁢ 3$ $q \left[127\right] = 0.8941712974$ $q \left[128\right] = 0.2911752349$ $q \left[129\right] = 0.2790029236$ $q \left[130\right] = 0.2671158700$ $q \left[1⁢3⁢1\right] = 0 .2554979664$ $q \left[1⁢3⁢2\right] = 0.2441343742$ $q \left[1⁢3⁢3\right] = 0.2330113868$ $q \left[1⁢3⁢4\right] = 0.2221163080$ $q \left[1⁢3⁢5\right] = 0.2114373458$ $q \left[1⁢3⁢6\right] = 0 . 2 ⁢ 0 ⁢ 0 ⁢ 9 ⁢ 6 ⁢ 3 ⁢ 5 ⁢ 1 ⁢ 9 ⁢ 1$ $q \left[137\right] = 0.1906845753$ $q \left[138\right] = 0.1805909194$ $q \left[139\right] = 0.1706735517$ $q \left[140\right] = 0.1609240126$ $q \left[1⁢4⁢1\right] = 0 .1513343370$ $q \left[1⁢4⁢2\right] = 0.1418970123$ $q \left[1⁢4⁢3\right] = 0.1326049434$ $q \left[1⁢4⁢4\right] = 0.1234514222$ $q \left[1⁢4⁢5\right] = 0.1144301000$ $q \left[1⁢4⁢6\right] = 0.1055349658$ $q \left[1⁢4⁢7\right] = 0.0967603259$ $q \left[1⁢4⁢8\right] = 0.0881007879$ $q \left[1⁢4⁢9\right] = 0.0795512453$ $q \left[1⁢5⁢0\right] = 0.0711068657$ $q \left[1⁢5⁢1\right] = 0.0627630810$ $q \left[1⁢5⁢2\right] = 0.0545155789$ $q \left[1⁢5⁢3\right] = 0.0463602959$ $q \left[1⁢5⁢4\right] = 0 .0382934126$ $q \left[1⁢5⁢5\right] = 0.0303113495$ $q \left[156\right] = 0.0224107648$ $q \left[157\right] = 0.0145885527$ $q \left[158\right] = 0.0068418435$ $q \left[159\right] = - 0.0008319956$ $q \left[160\right] = - 0.0084353584$ $q \left[1⁢6⁢1\right] = - 0 . 0 ⁢ 1 ⁢ 5 ⁢ 9 ⁢ 7 ⁢ 0 ⁢ 3 ⁢ 9 ⁢ 5 ⁢ 7$ $q \left[1⁢6⁢2\right] = - 0 . 0 ⁢ 2 ⁢ 3 ⁢ 4 ⁢ 3 ⁢ 9 ⁢ 0 ⁢ 1 ⁢ 1 ⁢ 5$ $q \left[1⁢6⁢3\right] = - 0 . 0 ⁢ 3 ⁢ 0 ⁢ 8 ⁢ 4 ⁢ 2 ⁢ 8572$ $q \left[1⁢6⁢4\right] = - 0.0381833249$ $q \left[165\right] = - 0.0454615388$ $q \left[1⁢6⁢6\right] = - 0.0526783466$ $q \left[1⁢6⁢7\right] = - 0 .0598343081$ $q \left[1⁢6⁢8\right] = - 0.0669296831$ $q \left[169\right] = - 0.0739644174$ $q \left[170\right] = - 0.0809381268$ $q \left[1⁢7⁢1\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[1⁢7⁢2\right] = - 0 . 0 ⁢ 9 ⁢ 4 ⁢ 6 ⁢ 9 ⁢ 9178 ⁢ 3$ $q \left[1⁢7⁢3\right] = - 0 .1014839341$ $q \left[1⁢7⁢4\right] = - 0.1082024454$ $q \left[1⁢7⁢5\right] = - 0.1148523686$ $q \left[1⁢7⁢6\right] = - 0.1 ⁢ 2 ⁢ 1 ⁢ 4 ⁢ 3 ⁢ 0 ⁢ 8 ⁢ 8 ⁢ 7 ⁢ 6$ $q \left[1⁢7⁢7\right] = - 0 . 1 ⁢ 2 ⁢ 7 ⁢ 9 ⁢ 3 ⁢ 4 ⁢ 6 ⁢ 7 ⁢ 9 ⁢ 0$ $q \left[178\right] = - 0.1343598738$ $q \left[179\right] = - 0.1407020132$ $q \left[180\right] = - 0.1469560005$ $q \left[1⁢8⁢1\right] = - 0.1531160455$ $q \left[1⁢8⁢2\right] = - 0.1591756024$ $q \left[1⁢8⁢3\right] = - 0.1651273005$ $q \left[184\right] = - 0.1709628636$ $q \left[1⁢8⁢5\right] = - 0 . 1 ⁢ 766730202$ $q \left[1⁢8⁢6\right] = - 0.1822474011$ $q \left[1⁢8⁢7\right] = - 0.1876744222$ $q \left[1⁢8⁢8\right] = - 0.1929411519$ $q \left[1⁢8⁢9\right] = - 0.1980331588$ $q \left[1⁢9⁢0\right] = - 0.2029343380$ $q \left[1⁢9⁢1\right] = - 0 . 2 ⁢ 0 ⁢ 7 ⁢ 6 ⁢ 2 ⁢ 6 ⁢ 7 ⁢ 1 ⁢ 3 ⁢ 7$

Hence, the present invention relates to the application of an arbitrary filter to a signal which is available in the transform domain of a complex exponential modulated filter bank, when this filter bank is designed to give virtually alias free performance of operations like equalization, spectral envelope adjustment, frequency selective panning, or frequency selective spatialization of audio signals.

The present invention permits to efficiently transform a given finite impulse response (FIR) filter in the time domain into a set of shorter FIR filters, to be applied with one filter for each subband of the filter bank.

The present invention also teaches how to convert a given discrete time domain filter into to a set of subband domain filters. The result is that any given filter can be implemented with a high degree of accuracy in the subband domain of a complex exponential modulated filter bank. In a preferred embodiment, the filter converter consists of a second complex exponential modulated analysis filter bank. For the special case of filters that implement a pure delay, the methods of the present invention coincides with that of PCT/EP2004/004607 "Advanced processing based on a complex-exponential modulated filterbank and adaptive time framing".

Furthermore, the present invention comprises the following features:
- A method for obtaining a high quality approximation to the filtering of a discrete-time input signal with a given filter, comprising the steps of
   - analyzing the input signal with a downsampled complex analysis filter bank in order to obtain a multitude of subband signals,
   - filtering each subband signal with a subband filter, where the multitude of subband filters are obtained from the given filter by means of a filter converter,
   - synthesizing an output signal from the filtered subband signals with a downsampled complex synthesis filter bank.
- A method according to the above where the filter converter consists of a downsampled complex analysis filter bank.
- An apparatus for performing a method for obtaining a high quality approximation to the filtering of a discrete-time input signal with a given filter, the method comprising the steps of
   - analyzing the input signal with a downsampled complex analysis filter bank in order to obtain a multitude of subband signals,
   - filtering each subband signal with a subband filter, where the multitude of subband filters are obtained from the given filter by means of a filter converter,
   - synthesizing an output signal from the filtered subband signals with a downsampled complex synthesis filter bank.
- A computer program having instructions for performing, when running on a computer, a method for obtaining a high quality approximation to the filtering of a discrete-time input signal with a given filter, the method comprising the steps of
   - analyzing the input signal with a downsampled complex analysis filter bank in order to obtain a multitude of subband signals,
   - filtering each subband signal with a subband filter, where the multitude of subband filters are obtained from the given filter by means of a filter converter,
   - synthesizing an output signal from the filtered subband signals with a downsampled complex synthesis filter bank.

### Adaptation for real cosine modulated filter banks

Whereas the above derivation is based on complex modulated filter banks, a note can be made here for the critically sampled real representation obtained by a cosine modulated filter bank defined by taking the real part of the subband samples (1) for an appropriate phase factor θ. In this case it is no longer feasible to use the in-band subband filtering method (3) to obtain a good approximation to a given filter. However, due to the assumptions made on the prototype filter response, a generalization to a multiband filter of the type ${d}_{n} \left(k\right) = {\sum }_{r = - 1}^{1} {\sum }_{l}^{ } {g}_{n}^{r} \left(l\right) ⁢ {c}_{n + r} ⁢ \left(k-l\right) ,$ will be applicable, (with obvious modifications for the first and last subbands). Due to the critical sampling there is much less freedom in the construction of the filter mask ${g}_{n}^{′} \left(l\right) .$ One has to do the following, which is obvious for those skilled in the art. For each *m*=0,1,...,*L*-1, use the elementary subband signal *dₙ*(*k*) = δ[*n-m*]δ[*k*] as input to the real synthesis bank, and filter the resulting output *y*(*v*) with the filter *h*(*v*) to get the filtered synthesis waveform *z*(*v*). Now use this filtered waveform as input to the real analysis bank. The resulting subband signal carries the coefficients of the masks ${g}_{n}^{′} \left(l\right)$ for *n+r=m.* Some reduction in work necessary for the filter is obtained by observing that the three cases *m*=3κ+ε for ε=0,1,2 can be processed in parallel by feeding the first synthesis bank with all the corresponding elementary subband signals for each case. Thus the real valued filter converter comprises three real synthesis and three real analysis bank operations. This parallel computation represents an implementation short cut for real valued filter converter for the case of a QMF band with good side lope suppression

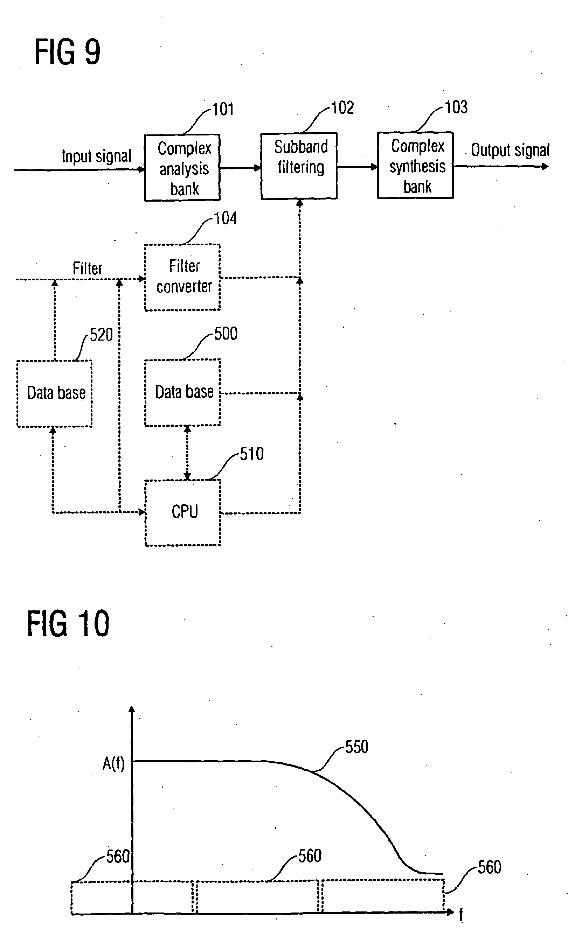

Fig. 9 illustrates an embodiment of an inventive filter apparatus for filtering a time domain input signal of an inventive filter apparatus to obtain a time domain output signal. As already mentioned in the context of Fig. la, the filter apparatus of Fig. 9 comprises a complex analysis filter bank **101,** a subband filtering **102** and a complex synthesis filter bank **103,** which outputs the time domain output signal.

While Fig. 1 shows a system comprising an embodiment of an inventive filter apparatus along with an embodiment of a filter generator **104,** the filter apparatus shown in Fig. 9 comprises only as an option a filter converter **104,** which provides the subband filtering **102** with the intermediate filter definition signal, for instance in the form of the filter taps or the impulse response for each of the intermediate filters **190** of the subband filtering **102.** The filter apparatus shown in Fig. 9, comprises additional optional components, which can provide the subband filtering **102** with the filter taps for the plurality of intermediate filters **190** of the subband filtering **102.**

As an example, the filter taps can also be taken from an optional data base **500,** which is connected to the subband filtering **102.** In one embodiment, the data base **500** comprises the complex valued filter taps of the intermediate filters **190.** The data base can be implemented as a memory system, for instance in the form of a nonvolatile memory system or volatile memory system depending on the concrete implementation. Hence, memory solutions for the data base **500** comprise ROM (ROM = read only memory), RAM (RAM = random access memory), flash memory, magnetical memory, optical memory or other memory systems.

Depending on the concrete implementation, a processor or a CPU (CPU = central processing unit) **510** can access the data base and provide the filter taps to the subband filtering **102** or can also access the data base to provide the corresponding filter taps to the intermediate filters of the subband filtering **102.** Hence, such an embodiment comprises a data base **500** from which the filter taps for the subband filtering **102** can be taken.

In a further embodiment of an inventive filter apparatus, which is also depicted as an option in Fig. 9, the CPU **510** is capable of on-line calculating the filter taps. In such an embodiment, the CPU **510** accesses the data base **500** according to a set of parameters provided by the user and/or according to a set of parameters, which are based on further circumstances, reads one or more sets of filter taps for the intermediate filters of the subband filtering **102** and calculates, optionally accompanied by an interpolation scheme or another estimation scheme, the desired intermediate filter taps and provides them to the subband filtering **102.** In a further embodiment, the CPU **510** or another processor or computer system provides the filter taps of the intermediate filters **190** to the subband filtering **102** without accessing a data base **500.** In such an embodiment, the CPU **510** or another processor calculates the filter taps and provides them to the subband filtering **102.** Examples for such an embodiment will be explained more closely with respect to Fig. 10.

In a further embodiment depicted in Fig. 9, the CPU **510** accesses a further data base **520,** reads one or more filter definition signals (e.g. in the form of impulse response signals corresponding to filter characteristic in the time domain), calculates an effective filter definition signal, for instance an appropriate impulse response, and provides the results of this computation to the filter converter **104.** In this embodiment, the filter converter **104** then provides the subband filtering **102** with the appropriate filter taps for the intermediate filters **190.** Hence, in this embodiment, the filter converter **104** generates the effective subband filters or intermediate filters applied to each individual subband filters of each individual subband signal inside the subband filtering **102** leading to a filtering effect audibly indistinguishable from a corresponding filter applied to the time domain input signal (input signal). As consequence, this embodiment is also capable of on-line calculating the filter taps via the filter converter **104.**

An example might for instance be a device, which calculates the taps of the intermediate filters **190** of the subband filtering **102** according to a set of parameters for instance provided by the user, wherein the parameter basis is so large, that an effective predetermination of the filter taps, optionally accompanied by some sort of interpolation scheme, would not lead to the desired results.

A more concrete application comes for instance of the field of dynamic chance of HRTF filters in one domain to be converted to the subband or QMF domain. As mentioned before, this is for instance relevant in applications involving a head-tracker in which the data base **520** is an HRTF data base comprising the time impulse responses of the HRTF filters. As the HRTF filters usually have very long impulse responses, the use of such a scheme is especially interesting, as the taps for the intermediate filters **190** or the QMF taps are complex. Storing the data base in this domain would roughly double the memory requirements compared to the memory requirement of storing the impulse responses in the time domain. However, the advantage of the reduced memory requirement can also be employed without having a CPU **510** which calculates the impulse response provided to the filter converter **504.** Instead, the data base **520** can be simply be prompted to output the corresponding definition signal, which might be an impulse response in the time domain to the filter converter **104.**

In Fig. 10, an amplitude/frequency characteristic **550** is illustrated in the frequency domain. In some applications, as explained before, the filter coefficients or filter taps are the intermediate filters **190** of the subband filtering **102** can be stored in the data base like the data base **500** of Fig. 9. Alternatively or additionally, for some applications, the filter taps of the intermediate filters can also be calculated by the CPU **510** of Fig. 9. In the case of a special effect filtering or a lower quality signal processing, in which aliasing effects might become tolerable (at least to some extend), the filter taps of the intermediate filters **190** after subband filtering **102** can be estimated without a filter converter **104** or another embodiment of a filter generator. Possible applications especially comprise voice transmission over low quality lines, like telephones or small band radio communications. Hence, in these applications a determination of the filter taps corresponding the transfer function **550** of Fig. 10 or another amplitude/frequency characteristic into several subbands **560** with different subband frequencies can be carried out without employing an inventive filter converter.

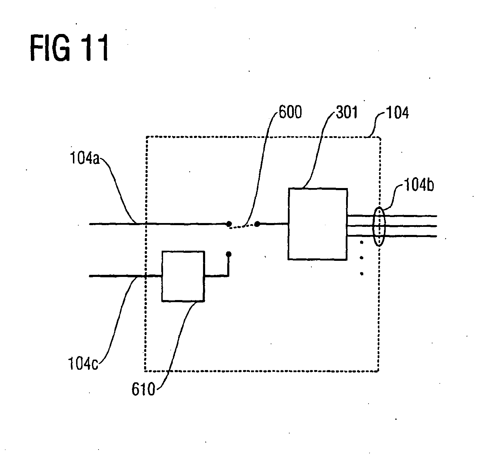

Fig. 11 shows an embodiment of an inventive filter converter **104.** As previously outlined in the context of Fig. 3, the filter converter **104** comprises a complex analysis filter bank **301** to which a (real valued) impulse response signal indicative of an amplitude/frequency filter characteristic can be supplied via an input **104a** and via an optional switch **600.** As outlined before, the complex analysis filter bank **301** converts the impulse response signal into a plurality of complex valued subband signals and the intermediate filter definition signal output at an output **104b** of the filter converter. As indicated in Fig. 1a and Fig. 9, the output **104b** of the filter converter **104** can be connected to a subband filtering **102.**

As already mentioned earlier, each of the complex valued subband signals of the complex modulated filter bank **301** corresponds to an impulse response for one of the intermediate filters **190** for a subband signal in the subband filtering **102** shown in Fig. 1a and 9. Typically, the complex valued subband signals are significantly shorter than the impulse response signal of the filter characteristic provided at the input **104a** in the time domain. Furthermore, typically at least one of the complex valued subband signals output at the output **104b** comprises at least two different non-vanishing values. Especially the last feature distinguishes the output of the filter converter **104** from a simple gain adjustment in the frame work of filtering using a direct Fourier transform procedure.

If, however, the filter converter **104** is not provided with an impulse response signal indicative of an amplitude/frequency filter characteristic, but a filter definition signal, which comprises at least one of an amplitude/frequency filter characteristic, a phase/frequency filter characteristic or the filter taps in the time domain or another domain of a filter, the filter converter **104** comprises an impulse response generator **610** for converting the filter definition signal into the impulse response signal, which is then provided via the optional switch **600** to the complex analysis filter bank **301.** In a concrete implementation, the impulse response generator **610** can for instance calculate the impulse response signal provided to the complex analysis filter bank **301** by superposition of real valued oscillations (Fourier synthesis), wherein the amplitude characteristics and the phase characteristics of the intended filter to be transferred into the complex subband domain are regarded as defined by the definition signal provided to the input **104c.** In other words, if at least one of an amplitude/frequency characteristic and a phase/frequency characteristic is applied to the impulse response generator **610,** an impulse response signal can be computed by the impulse response generator **610** by supposition of (harmonic) oscillations considering the amplitude and phase relations as defined by the filter definition signal.

Possible applications of both embodiments of the filter apparatus and the filter generator and especially in the field of high quality audio coding and decoding.

Recent developments in audio coding have provided means to obtain a multi-channel signal impression over stereo headphones. This is commonly done by downmixing a multi-channel signal to stereo using the original multi-channel signal and HRTF filters. It has been shown in prior art that the parametric multi-channel audio decoder can be combined with a binaural downmix algorithm making it possible to render a multi-channel signal over headphones without the need for first re-creating the multi-channel signal from the transmitted downmix signal, and subsequently downmixing it again by means of the HRTF filters. However, this requires that the parameters for recreating the multi-channel signal (e.g. IID, CLD parameters) are combined with the HRTF filters, which in turn requires a parameterization of the HRTF filters. This requirement for a parameterization of the HRTF filters imposes high limitation on the system, since HRTF filters can be long and thus very hard to correctly model with a parametric approach. This limitation makes it impossible to use long HRTF filters for combined parametric multi-channel and binaural downmix decoders. The crucial algorithmic component required to obtain a proper combination of multi-channel parameters and HRTF filters is to have access to a representation of the given HRTF filters in the subband domain assumed by the spatial parameters. This is exactly what is offered by the embodiments of the present invention. Once this representation is available, the HRTF filters can be combined into 2*N* filters as a function of the parametric multi-channel representation. This gives a significant advantage in terms of computational complexity over the method that first recreates the *M* channels and then applies 2*M* filtering operations.

An example of a different application of the method employed by embodiments of the current invention is the efficient compensation for non-perfect audio rendering devices for audio content coded in the MPEG HE-AAC format [ISO/IEC 14496-3:2001/AMD1:2003]. Such advanced filtering steps, possibly including cross talk cancellation, can be applied directly in the subband domain prior to the time domain synthesis.

Other developments in audio coding has made methods available to recreate a multi-channel representation of an audio signal based on a stereo (or mono) signal and corresponding control data. These methods differ substantially from older matrix based solution such as Dolby® Prologic, since additional control data is transmitted to control the re-creation, also referred to as up-mix, of the surround channels based on the transmitted mono or stereo channels.

Hence, such a parametric multi-channel audio decoder, e.g. MPEG Surround reconstructs *N* channels based on *M* transmitted channels, where *N*>*M*, and the additional control data. The additional control data represents a significantly lower data rate than that required for transmission of all *N* channels, making the coding very efficient while at the same time ensuring compatibility with both *M* channel devices and *N* channel devices. [J. Breebaart et al. "MPEG spatial audio coding / MPEG Surround: overview and current status", Proc. 119th AES convention, New York, USA, October 2005, Preprint 6447].

These parametric surround coding methods usually comprise a parameterization of the surround signal based on Channel Level Difference (CLD) and Inter-channel coherence/cross-correlation (ICC). These parameters describe power ratios and correlation between channel pairs in the up-mix process. Further Channel Prediction Coefficients (CPC) are also used in prior art to predict intermediate or output channels during the up-mix procedure.

Depending on certain implementation requirements of the inventive methods, the inventive methods can be implemented in hardware or in software. The implementation can be performed using a digital storage medium, in particular a disc, CD or a DVD having an electronically readable control signal stop thereon, which cooperates with a programmable computer system in such that an embodiment of the inventive methods is performed. Generally, an embodiment of the present invention is, therefore, a computer program product with a program code stored on an machine-readable carrier, the program code being operative for performing the inventive methods when the computer program product runs on a computer or a processor. In other words, embodiments of the inventive methods are, therefore, a computer program having a program code for performing at least one of the inventive methods when the computer program runs of a computer.

## Claims

1. Filter apparatus for filtering a time domain input signal to obtain a time domain output signal, which is a representation of the time domain input signal filtered using a filter characteristic having an non-uniform amplitude/frequency characteristic,
comprising:
a complex analysis filter bank **(101)** for generating L complex subband signals from the time domain input signal;
a plurality of intermediate filters **(190),** each intermediate filter **(190)** having a finite impulse response comprising (K_{H} + K_{Q} - 1) filter taps, wherein one intermediate filter is provided for each complex subband signal;
a complex synthesis filter bank **(103)** for synthesizing, the output of the intermediate filters **(190)** to obtain the time domain output signal,
a filter tap generator **(104)** comprising a complex modulated filter bank **(301)** based on a prototype filter comprising K_{Q} · L taps for filtering a finite impulse response signal indicative of the amplitude/frequency filter characteristic in the time domain and comprising K_{H} · L filter taps to obtain L complex valued subband signals as an intermediate filter definition signal,
wherein each complex valued subband signal of the complex modulated filter bank of the filter tap generator corresponds to an impulse response for one intermediate filter (**190**) comprising (K_{H} + K_{Q} - 1) filter taps;
wherein at least one of the complex valued subband signals of the complex modulated filter bank of the filter tap generator comprises at least two different non-vanishing values;
wherein each complex valued subband signal of the modulated filter bank of the filter tap generator comprising (K_{H} + K_{Q} - 1) filter taps is shorter than the impulse response signal comprising K_{H} · L filter taps provided to the filter tap generator;
wherein the plurality of intermediate filters is operative to receive the intermediate filter definition signal from the filter tap generator **(104);**
wherein each intermediate filter **(190)** of the plurality of intermediate filters is operative to have an impulse response depending on the intermediate filter definition signal;
wherein at least one of the intermediate filters **(190)** of the plurality of the intermediate filters **(190)** has a non-uniform amplitude/frequency characteristic;
wherein the non-uniform amplitude/frequency characteristics of the plurality of intermediate filters together represent the non-uniform filter characteristic; and
wherein *L,* K_{Q} and K_{H} are positive integers.

2. Filter apparatus according to claim 1, wherein at least one of the immediate filters **(190)** has a low pass filter characteristic, a high pass filter characteristic, a band pass filter characteristic, a band rejection filter characteristic or a notch filter characteristic.

3. Filter apparatus according to any of the preceding claims, wherein the intermediate filters **(190)** of the plurality of intermediate filters **(190)** are finite impulse response filters.

4. Filter apparatus according to any of the preceding claims, wherein the plurality of intermediate filters **(190)** is further operative to receive the intermediate filter definition signal from a data base **(500)** or from a processor **(510).**

5. Filter apparatus according to any of the preceding claims, wherein the complex analysis filter bank **(101)** is operative to output *L* complex subband signals, wherein the plurality of intermediate filters **(190)** comprises *L* intermediate filters **(190),** wherein the complex synthesis filter bank **(103)** is operative to synthesize the output of the *L* intermediate filters **(190),** and wherein *L* is a positive integer greater than 1.

6. Filter apparatus according to claim 5, wherein the complex analysis filter bank **(101),** the plurality of intermediate filters **(190)** and the complex synthesis filter bank **(103)** is operative to have *L* = 64.

7. Filter apparatus according to any of the claims 5 or 6, wherein the plurality of intermediate filters **(190)** is operative to filter the complex subband signals based on the equation ${d}_{n} \left(k\right) = {\sum }_{l} {g}_{n} \left(l\right) ⁢ {c}_{n} ⁢ \left(k-l\right)$ wherein *n* is an integer in the range from 0 to (*L*-1) indicating an index of the subband signals, wherein *L* and *k* are integers, wherein *dₙ*(*k*) is the output of the intermediate filter (190) of the subband signal with the index *n*, wherein *cₙ*(*k*) is the subband signal with the index n*,* and wherein *gₙ*(*l*) is the impulse response of the intermediate filter **(190)** for the subband signal with the index *n*.

8. Filter apparatus according to any of the claims 5 to 7, wherein the intermediate filter **(190)** with an index *n* has an impulse response *gₙ*(*k*), which is based on the equation ${g}_{n} \left(k\right) = {\sum }_{ν = - ∞}^{∞} h ⁢ \left(ν+kL\right) ⁢ q \left(ν\right) ⁢ exp \left(-i⁢\frac{π}{L}⁢\left(n+\frac{1}{2}\right)⁢ν\right)$ wherein *n* is an integer in the range from 0 to (L-1) indicating the index of the subband signal, wherein *k* and ν are integers, wherein *h*(ν) is the response of a filter having the filter characteristic, wherein π = 3.1415926... is the circular number, wherein i = $\sqrt{- 1}$is the complex unit, and wherein *q*(υ) are filter taps of a real valued prototype filter.

9. Filter apparatus according to any of the claims 5 to 8, wherein at least one of the intermediate filters. **(190)** with an index *n* has an impulse response *gₙ*(*k*), which is based on the equation ${g}_{n} \left(l\right) = {\sum }_{ν = 0}^{191} {h}^{} ⁢ \left(υ+64⋅\left(l-2\right)\right) ⋅ q \left(υ\right) ⋅ exp \left(-i⁢\frac{π}{6 ⁢ 4}⁢\left(n+\frac{1}{2}\right)⁢\left(υ-9⁢5\right)\right)$ wherein ${h}^{} \left(υ\right) = { \begin{matrix}h \left(υ\right) & , & υ = 0 , 1 , … , {N}_{h} - 1 , \\ 0 & , & otherwise\end{matrix}$ wherein *Nₕ* is the length of the impulse response *h*(υ) of a filter having the filter characteristic, wherein π = 3.1415926... is the circular number, wherein *i* = $\sqrt{- 1}$is the complex unit, and wherein *q*(υ) are filter taps of a real valued prototype filter.

10. Filter apparatus according to any of the claims 8 or 9, wherein the intermediate filters **(190)** are adapted so that the prototype filter taps *q*(υ̇) fulfill for integers υ from 0 to 191 the relations:$- 0 . 2 ⁢ 0 ⁢ 4 \leq q \left[0\right] \leq - 0 . 2 ⁢ 0 ⁢ 2$ $- 0 . 1 ⁢ 9 ⁢ 9 \leq q \left[1\right] \leq - 0 . 1 ⁢ 9 ⁢ 7$ $- 0 . 1 ⁢ 9 ⁢ 4 \leq q \left[2\right] \leq - 0 . 1 ⁢ 9 ⁢ 2$ $- 0 . 1 ⁢ 8 ⁢ 9 \leq q \left[3\right] \leq - 0 . 1 ⁢ 8 ⁢ 7$ $- 0 . 1 ⁢ 8 ⁢ 3 \leq q \left[4\right] \leq - 0 . 1 ⁢ 8 ⁢ 1$ $- 0 . 1 ⁢ 7 ⁢ 8 \leq q \left[5\right] \leq - 0 . 1 ⁢ 7 ⁢ 6$ $- 0 . 1 ⁢ 7 ⁢ 2 \leq q \left[6\right] \leq - 0 . 1 ⁢ 7 ⁢ 0$ $- 0 . 1 ⁢ 6 ⁢ 6 \leq q \left[7\right] \leq - 0 . 1 ⁢ 6 ⁢ 4$ $- 0 . 1 ⁢ 6 ⁢ 0 \leq q \left[8\right] \leq - 0 . 1 ⁢ 5 ⁢ 8$ $- 0 . 1 ⁢ 5 ⁢ 4 \leq q \left[9\right] \leq - 0 . 1 ⁢ 5 ⁢ 2$ $- 0 . 1 ⁢ 4 ⁢ 8 \leq q \left[1⁢0\right] \leq - 0 . 1 ⁢ 4 ⁢ 6$ $- 0 . 1 ⁢ 4 ⁢ 2 \leq q \left[1⁢1\right] \leq - 0 . 1 ⁢ 4 ⁢ 0$ $- 0 . 1 ⁢ 3 ⁢ 5 \leq q \left[1⁢2\right] \leq - 0 . 1 ⁢ 3 ⁢ 3$ $- 0 . 1 ⁢ 2 ⁢ 9 \leq q \left[1⁢3\right] \leq - 0 . 1 ⁢ 2 ⁢ 7$ $- 0 . 1 ⁢ 2 ⁢ 2 \leq q \left[1⁢4\right] \leq - 0 . 1 ⁢ 2 ⁢ 0$ $- 0 . 1 ⁢ 1 ⁢ 6 \leq q \left[1⁢5\right] \leq - 0 . 1 ⁢ 1 ⁢ 4$ $- 0 . 1 ⁢ 0 ⁢ 9 \leq q \left[1⁢6\right] \leq - 0 . 1 ⁢ 0 ⁢ 7$ $- 0 . 1 ⁢ 0 ⁢ 2 \leq q \left[17\right] \leq - 0 . 1 ⁢ 0 ⁢ 0$ $- 0 . 0 ⁢ 9 ⁢ 6 \leq q \left[1⁢8\right] \leq - 0 . 0 ⁢ 9 ⁢ 4$ $- 0 . 0 ⁢ 8 ⁢ 9 \leq q \left[1⁢9\right] \leq - 0 . 0 ⁢ 8 ⁢ 7$ $- 0 . 0 ⁢ 8 ⁢ 2 \leq q \left[2⁢0\right] \leq - 0 . 0 ⁢ 8 ⁢ 0$ $- 0 . 0 ⁢ 7 ⁢ 5 \leq q \left[2⁢1\right] \leq - 0 . 0 ⁢ 7 ⁢ 3$ $- 0 . 0 ⁢ 6 ⁢ 8 \leq q \left[2⁢2\right] \leq - 0 . 0 ⁢ 6 ⁢ 6$ $- 0 . 0 ⁢ 6 ⁢ 1 \leq q \left[2⁢3\right] \leq - 0 . 0 ⁢ 5 ⁢ 9$ $- 0 . 0 ⁢ 5 ⁢ 4 \leq q \left[2⁢4\right] \leq - 0 . 0 ⁢ 5 ⁢ 2$ $- 0 . 0 ⁢ 4 ⁢ 6 \leq q \left[2⁢5\right] \leq - 0 . 0 ⁢ 4 ⁢ 4$ $- 0 . 0 ⁢ 3 ⁢ 9 \leq q \left[2⁢6\right] \leq - 0 . 0 ⁢ 3 ⁢ 7$ $- 0 . 0 ⁢ 3 ⁢ 2 \leq q \left[2⁢7\right] \leq - 0 . 0 ⁢ 3 ⁢ 0$ $- 0 . 0 ⁢ 2 ⁢ 4 \leq q \left[2⁢8\right] \leq - 0 . 0 ⁢ 2 ⁢ 2$ $- 0 . 0 ⁢ 1 ⁢ 7 \leq q \left[2⁢9\right] \leq - 0 . 0 ⁢ 1 ⁢ 5$ $- 0 . 0 ⁢ 0 ⁢ 9 \leq q \left[3⁢0\right] \leq - 0 . 0 ⁢ 0 ⁢ 7$ $- 0 . 0 ⁢ 0 ⁢ 2 \leq q \left[3⁢1\right] \leq 0 . 0 ⁢ 0 ⁢ 0$ $0.0 ⁢ 0 ⁢ 6 \leq q \left[3⁢2\right] \leq 0 . 0 ⁢ 0 ⁢ 8$ $0.0 ⁢ 1 ⁢ 4 \leq q \left[3⁢3\right] \leq 0 . 0 ⁢ 1 ⁢ 6$ $0.0 ⁢ 2 ⁢ 1 \leq q \left[3⁢4\right] \leq 0 . 0 ⁢ 2 ⁢ 3$ $0.0 ⁢ 2 ⁢ 9 \leq q \left[3⁢5\right] \leq 0 . 0 ⁢ 3 ⁢ 1$ $0.0 ⁢ 3 ⁢ 7 \leq q \left[3⁢6\right] \leq 0 . 0 ⁢ 3 ⁢ 9$ $0.0 ⁢ 4 ⁢ 5 \leq q \left[3⁢7\right] \leq 0 . 0 ⁢ 4 ⁢ 7$ $0.0 ⁢ 5 ⁢ 4 \leq q \left[3⁢8\right] \leq 0 . 0 ⁢ 5 ⁢ 6$ $0.0 ⁢ 6 ⁢ 2 \leq q \left[3⁢9\right] \leq 0.0 ⁢ 6 ⁢ 4$ $0.0 ⁢ 7 ⁢ 0 \leq q \left[4⁢0\right] \leq 0.0 ⁢ 7 ⁢ 2$ $0.0 ⁢ 7 ⁢ 9 \leq q \left[4⁢1\right] \leq 0 . 0 ⁢ 8 ⁢ 1$ $0.0 ⁢ 8 ⁢ 7 \leq q \left[4⁢2\right] \leq 0 . 0 ⁢ 8 ⁢ 9$ $0.0 ⁢ 9 ⁢ 6 \leq q \left[4⁢3\right] \leq 0 . 0 ⁢ 9 ⁢ 8$ $0.1 ⁢ 0 ⁢ 5 \leq q \left[4⁢4\right] \leq 0 . 1 ⁢ 0 ⁢ 7$ $0.1 ⁢ 1 ⁢ 3 \leq q \left[4⁢5\right] \leq 0 . 1 ⁢ 1 ⁢ 5$ $0.1 ⁢ 2 ⁢ 2 \leq q \left[4⁢6\right] \leq 0.1 ⁢ 2 ⁢ 4$ $0.1 ⁢ 3 ⁢ 2 \leq q \left[4⁢7\right] \leq 0.1 ⁢ 3 ⁢ 4$ $0.1 ⁢ 4 ⁢ 1 \leq q \left[4⁢8\right] \leq 0.1 ⁢ 4 ⁢ 3$ $0.1 ⁢ 5 ⁢ 0 \leq q \left[4⁢9\right] \leq 0.1 ⁢ 5 ⁢ 2$ $0.1 ⁢ 6 ⁢ 0 \leq q \left[5⁢0\right] \leq 0.1 ⁢ 6 ⁢ 2$ $0.1 ⁢ 7 ⁢ 0 \leq q \left[5⁢1\right] \leq 0 . 1 ⁢ 7 ⁢ 2$ $0.1 ⁢ 8 ⁢ 0 \leq q \left[5⁢2\right] \leq 0 . 1 ⁢ 8 ⁢ 2$ $0.1 ⁢ 9 ⁢ 0 \leq q \left[5⁢3\right] \leq 0 . 1 ⁢ 9 ⁢ 2$ $0.2 ⁢ 0 ⁢ 0 \leq q \left[5⁢4\right] \leq 0 . 2 ⁢ 0 ⁢ 2$ $0.2 ⁢ 1 ⁢ 0 \leq q \left[5⁢5\right] \leq 0 . 2 ⁢ 1 ⁢ 2$ $0.2 ⁢ 2 ⁢ 1 \leq q \left[5⁢6\right] \leq 0 . 2 ⁢ 2 ⁢ 3$ $0.2 ⁢ 3 ⁢ 2 \leq q \left[5⁢7\right] \leq 0 . 2 ⁢ 3 ⁢ 4$ $0.2 ⁢ 4 ⁢ 3 \leq q \left[5⁢8\right] \leq 0 . 2 ⁢ 4 ⁢ 5$ $0.2 ⁢ 5 ⁢ 4 \leq q \left[5⁢9\right] \leq 0 . 2 ⁢ 5 ⁢ 6$ $0.2 ⁢ 6 ⁢ 6 \leq q \left[6⁢0\right] \leq 0 . 2 ⁢ 6 ⁢ 8$ $0.2 ⁢ 7 ⁢ 8 \leq q \left[6⁢1\right] \leq 0.2 ⁢ 8 ⁢ 0$ $0.2 ⁢ 9 ⁢ 0 \leq q \left[6⁢2\right] \leq 0.2 ⁢ 9 ⁢ 2$ $0.3 ⁢ 0 ⁢ 3 \leq q \left[6⁢3\right] \leq 0.3 ⁢ 0 ⁢ 5$ $0.9 ⁢ 0 ⁢ 2 \leq q \left[6⁢4\right] \leq 0.9 ⁢ 0 ⁢ 4$ $0.9 ⁢ 0 ⁢ 9 \leq q \left[6⁢5\right] \leq 0.9 ⁢ 1 ⁢ 1$ $0.9 ⁢ 1 ⁢ 7 \leq q \left[6⁢6\right] \leq 0 . 9 ⁢ 1 ⁢ 9$ $0.9 ⁢ 2 ⁢ 4 \leq q \left[6⁢7\right] \leq 0 . 9 ⁢ 2 ⁢ 6$ $0.9 ⁢ 3 ⁢ 0 \leq q \left[6⁢8\right] \leq 0 . 9 ⁢ 3 ⁢ 2$ $0.9 ⁢ 3 ⁢ 6 \leq q \left[6⁢9\right] \leq 0 . 9 ⁢ 3 ⁢ 8$ $0.9 ⁢ 4 ⁢ 2 \leq q \left[7⁢0\right] \leq 0 . 9 ⁢ 4 ⁢ 4$ $0.9 ⁢ 4 ⁢ 7 \leq q \left[7⁢1\right] \leq 0 . 9 ⁢ 4 ⁢ 9$ $0.9 ⁢ 5 ⁢ 2 \leq q \left[7⁢2\right] \leq 0.954$ $0.9 ⁢ 5 ⁢ 7 \leq q \left[7⁢3\right] \leq 0 . 9 ⁢ 5 ⁢ 9$ $0.9 ⁢ 6 ⁢ 1 \leq q \left[7⁢4\right] \leq 0 . 9 ⁢ 6 ⁢ 3$ $0.9 ⁢ 6 ⁢ 5 \leq q \left[7⁢5\right] \leq 0 . 9 ⁢ 6 ⁢ 7$ $0.9 ⁢ 6 ⁢ 9 \leq q \left[7⁢6\right] \leq 0 . 9 ⁢ 7 ⁢ 1$ $0.9 ⁢ 7 ⁢ 2 \leq q \left[7⁢7\right] \leq 0 . 9 ⁢ 7 ⁢ 4$ $0.9 ⁢ 7 ⁢ 5 \leq q \left[7⁢8\right] \leq 0 . 9 ⁢ 7 ⁢ 7$ $0.9 ⁢ 7 ⁢ 8 \leq q \left[7⁢9\right] \leq 0 . 9 ⁢ 8 ⁢ 0$ $0.9 ⁢ 8 ⁢ 1 \leq q \left[8⁢0\right] \leq 0 . 9 ⁢ 8 ⁢ 3$ $0.9 ⁢ 8 ⁢ 4 \leq q \left[8⁢1\right] \leq 0.9 ⁢ 8 ⁢ 6$ $0.9 ⁢ 8 ⁢ 6 \leq q \left[8⁢2\right] \leq 0.9 ⁢ 8 ⁢ 8$ $0.9 ⁢ 8 ⁢ 8 \leq q \left[8⁢3\right] \leq 0.9 ⁢ 9 ⁢ 0$ $0.9 ⁢ 9 ⁢ 0 \leq q \left[8⁢4\right] \leq 0.9 ⁢ 9 ⁢ 2$ $0.9 ⁢ 9 ⁢ 2 \leq q \left[8⁢5\right] \leq 0.9 ⁢ 9 ⁢ 4$ $0.9 ⁢ 9 ⁢ 3 \leq q \left[8⁢6\right] \leq 0 . 9 ⁢ 9 ⁢ 5$ $0.9 ⁢ 9 ⁢ 5 \leq q \left[8⁢7\right] \leq 0.997$ $0.9 ⁢ 9 ⁢ 6 \leq q \left[8⁢8\right] \leq 0.998$ $0.9 ⁢ 9 ⁢ 7 \leq q \left[8⁢9\right] \leq 0.999$ $0.9 ⁢ 9 ⁢ 8 \leq q \left[9⁢0\right] \leq 1.0 ⁢ 0 ⁢ 0$ $0.9 ⁢ 9 ⁢ 9 \leq q \left[9⁢1\right] \leq 1 . 0 ⁢ 0 ⁢ 1$ $0.9 ⁢ 9 ⁢ 9 \leq q \left[9⁢2\right] \leq 1 . 0 ⁢ 0 ⁢ 1$ $1.0 ⁢ 0 ⁢ 0 \leq q \left[9⁢3\right] \leq 1 . 0 ⁢ 0 ⁢ 2$ $1.0 ⁢ 0 ⁢ 0 \leq q \left[9⁢4\right] \leq 1 . 0 ⁢ 0 ⁢ 2$ $1.0 ⁢ 0 ⁢ 0 \leq q \left[9⁢5\right] \leq 1 . 0 ⁢ 0 ⁢ 2$ $1.0 ⁢ 0 ⁢ 0 \leq q \left[9⁢6\right] \leq 1 . 0 ⁢ 0 ⁢ 2$ $1.0 ⁢ 0 ⁢ 0 \leq q \left[9⁢7\right] \leq 1 . 0 ⁢ 0 ⁢ 2$ $0.9 ⁢ 9 ⁢ 9 \leq q \left[9⁢8\right] \leq 1.0 ⁢ 0 ⁢ 1$ $0.9 ⁢ 9 ⁢ 9 \leq q \left[9⁢9\right] \leq 1.0 ⁢ 0 ⁢ 1$ $0.9 ⁢ 9 ⁢ 8 \leq q \left[1⁢0⁢0\right] \leq 1.0 ⁢ 0 ⁢ 0$ $0.9 ⁢ 9 ⁢ 7 \leq q \left[1⁢0⁢1\right] \leq 0.9 ⁢ 9 ⁢ 9$ $0.9 ⁢ 9 ⁢ 6 \leq q \left[1⁢0⁢2\right] \leq 0.9 ⁢ 9 ⁢ 8$ $0.9 ⁢ 9 ⁢ 5 \leq q \left[1⁢0⁢3\right] \leq 0.9 ⁢ 9 ⁢ 7$ $0.9 ⁢ 9 ⁢ 3 \leq q \left[1⁢0⁢4\right] \leq 0.9 ⁢ 9 ⁢ 5$ $0.9 ⁢ 9 ⁢ 2 \leq q \left[1⁢0⁢5\right] \leq 0.9 ⁢ 9 ⁢ 4$ $0.9 ⁢ 9 ⁢ 0 \leq q \left[1⁢0⁢6\right] \leq 0 . 9 ⁢ 9 ⁢ 2$ $0.9 ⁢ 8 ⁢ 8 \leq q \left[1⁢0⁢7\right] \leq 0 . 9 ⁢ 9 ⁢ 0$ $0.9 ⁢ 8 ⁢ 6 \leq q \left[1⁢0⁢8\right] \leq 0 . 9 ⁢ 8 ⁢ 8$ $0.9 ⁢ 8 ⁢ 4 \leq q \left[1⁢0⁢9\right] \leq 0 . 9 ⁢ 8 ⁢ 6$ $0.9 ⁢ 8 ⁢ 1 \leq q \left[110\right] \leq 0 . 9 ⁢ 8 ⁢ 3$ $0.9 ⁢ 7 ⁢ 8 \leq q \left[1⁢1⁢1\right] \leq 0.9 ⁢ 8 ⁢ 0$ $0.9 ⁢ 7 ⁢ 5 \leq q \left[1⁢1⁢2\right] \leq 0 . 9 ⁢ 7 ⁢ 7$ $0.9 ⁢ 7 ⁢ 2 \leq q \left[1⁢1⁢3\right] \leq 0.9 ⁢ 7 ⁢ 4$ $0.9 ⁢ 6 ⁢ 9 \leq q \left[1⁢1⁢4\right] \leq 0.9 ⁢ 7 ⁢ 1$ $0.9 ⁢ 6 ⁢ 5 \leq q \left[1⁢1⁢5\right] \leq 0.9 ⁢ 6 ⁢ 7$ $0.9 ⁢ 6 ⁢ 1 \leq q \left[1⁢1⁢6\right] \leq 0 . 9 ⁢ 6 ⁢ 3$ $0.9 ⁢ 5 ⁢ 7 \leq q \left[1⁢1⁢7\right] \leq 0 . 9 ⁢ 5 ⁢ 9$ $0.9 ⁢ 5 ⁢ 2 \leq q \left[1⁢1⁢8\right] \leq 0 . 9 ⁢ 5 ⁢ 4$ $0.947 \leq q \left[1⁢1⁢9\right] \leq 0 . 9 ⁢ 4 ⁢ 9$ $0.9 ⁢ 4 ⁢ 2 \leq q \left[1⁢2⁢0\right] \leq 0 . 9 ⁢ 4 ⁢ 4$ $0.9 ⁢ 3 ⁢ 6 \leq q \left[1⁢2⁢1\right] \leq 0.9 ⁢ 3 ⁢ 8$ $0.9 ⁢ 3 ⁢ 0 \leq q \left[1⁢2⁢2\right] \leq 0.9 ⁢ 3 ⁢ 2$ $0.9 ⁢ 2 ⁢ 4 \leq q \left[1⁢2⁢3\right] \leq 0.9 ⁢ 2 ⁢ 6$ $0.9 ⁢ 1 ⁢ 7 \leq q \left[1⁢2⁢4\right] \leq 0.9 ⁢ 1 ⁢ 9$ $0.9 ⁢ 0 ⁢ 9 \leq q \left[1⁢2⁢5\right] \leq 0.9 ⁢ 1 ⁢ 1$ $0.9 ⁢ 0 ⁢ 2 \leq q \left[1⁢2⁢6\right] \leq 0 . 9 ⁢ 0 ⁢ 4$ $0.8 ⁢ 9 ⁢ 3 \leq q \left[1⁢2⁢7\right] \leq 0 . 8 ⁢ 9 ⁢ 5$ $0.2 ⁢ 9 ⁢ 0 \leq q \left[1⁢2⁢8\right] \leq 0 . 2 ⁢ 9 ⁢ 2$ $0.278 \leq q \left[1⁢2⁢9\right] \leq 0 . 2 ⁢ 8 ⁢ 0$ $0.2 ⁢ 6 ⁢ 6 \leq q \left[1⁢3⁢0\right] \leq 0 . 2 ⁢ 6 ⁢ 8$ $0.2 ⁢ 5 ⁢ 4 \leq q \left[1⁢3⁢1\right] \leq 0 . 2 ⁢ 5 ⁢ 6$ $0.2 ⁢ 4 ⁢ 3 \leq q \left[1⁢3⁢2\right] \leq 0 . 2 ⁢ 4 ⁢ 5$ $0.2 ⁢ 3 ⁢ 2 \leq q \left[1⁢3⁢3\right] \leq 0 . 2 ⁢ 3 ⁢ 4$ $0.2 ⁢ 2 ⁢ 1 \leq q \left[1⁢3⁢4\right] \leq 0 . 2 ⁢ 2 ⁢ 3$ $0.2 ⁢ 1 ⁢ 0 \leq q \left[1⁢3⁢5\right] \leq 0 . 2 ⁢ 1 ⁢ 2$ $0.2 ⁢ 0 ⁢ 0 \leq q \left[1⁢3⁢6\right] \leq 0 . 2 ⁢ 0 ⁢ 2$ $0.1 ⁢ 9 ⁢ 0 \leq q \left[1⁢3⁢7\right] \leq 0 . 1 ⁢ 9 ⁢ 2$ $0.1 ⁢ 8 ⁢ 0 \leq q \left[1⁢3⁢8\right] \leq 0.1 ⁢ 8 ⁢ 2$ $0.1 ⁢ 7 ⁢ 0 \leq q \left[1⁢3⁢9\right] \leq 0.1 ⁢ 7 ⁢ 2$ $0.1 ⁢ 6 ⁢ 0 \leq q \left[1⁢4⁢0\right] \leq 0.1 ⁢ 6 ⁢ 2$ $0.1 ⁢ 5 ⁢ 0 \leq q \left[1⁢4⁢1\right] \leq 0 . 1 ⁢ 5 ⁢ 2$ $0.1 ⁢ 4 ⁢ 1 \leq q \left[1⁢4⁢2\right] \leq 0 . 1 ⁢ 4 ⁢ 3$ $0.1 ⁢ 3 ⁢ 2 \leq q \left[1⁢4⁢3\right] \leq 0 . 1 ⁢ 3 ⁢ 4$ $0.1 ⁢ 2 ⁢ 2 \leq q \left[1⁢4⁢4\right] \leq 0 . 1 ⁢ 2 ⁢ 4$ $0.1 ⁢ 1 ⁢ 3 \leq q \left[1⁢4⁢5\right] \leq 0 . 1 ⁢ 1 ⁢ 5$ $0.1 ⁢ 0 ⁢ 5 \leq q \left[1⁢4⁢6\right] \leq 0.1 ⁢ 0 ⁢ 7$ $0.0 ⁢ 9 ⁢ 6 \leq q \left[1⁢4⁢7\right] \leq 0.0 ⁢ 9 ⁢ 8$ $0.0 ⁢ 8 ⁢ 7 \leq q \left[1⁢4⁢8\right] \leq 0.0 ⁢ 89$ $0.0 ⁢ 7 ⁢ 9 \leq q \left[1⁢4⁢9\right] \leq 0.0 ⁢ 8 ⁢ 1$ $0.0 ⁢ 7 ⁢ 0 \leq q \left[1⁢5⁢0\right] \leq 0.0 ⁢ 72$ $0.0 ⁢ 6 ⁢ 2 \leq q \left[1⁢5⁢1\right] \leq 0 . 0 ⁢ 6 ⁢ 4$ $0.0 ⁢ 5 ⁢ 4 \leq q \left[1⁢5⁢2\right] \leq 0 . 0 ⁢ 5 ⁢ 6$ $0.0 ⁢ 4 ⁢ 5 \leq q \left[1⁢5⁢3\right] \leq 0 . 0 ⁢ 4 ⁢ 7$ $0.0 ⁢ 3 ⁢ 7 \leq q \left[1⁢5⁢4\right] \leq 0 . 0 ⁢ 3 ⁢ 9$ $0.0 ⁢ 2 ⁢ 9 \leq q \left[1⁢5⁢5\right] \leq 0 . 0 ⁢ 3 ⁢ 1$ $0.0 ⁢ 2 ⁢ 1 \leq q \left[1⁢5⁢6\right] \leq 0.0 ⁢ 2 ⁢ 3$ $0.0 ⁢ 1 ⁢ 4 \leq q \left[1⁢5⁢7\right] \leq 0.0 ⁢ 1 ⁢ 6$ $0.0 ⁢ 0 ⁢ 6 \leq q \left[1⁢5⁢8\right] \leq 0.0 ⁢ 0 ⁢ 8$ $- 0 . 0 ⁢ 0 ⁢ 2 \leq q \left[1⁢5⁢9\right] \leq 0.0 ⁢ 0 ⁢ 0$ $- 0 . 0 ⁢ 0 ⁢ 9 \leq q \left[1⁢6⁢0\right] \leq - 0 . 0 ⁢ 0 ⁢ 7$ $- 0.0 ⁢ 1 ⁢ 7 \leq q \left[1⁢6⁢1\right] \leq - 0.0 ⁢ 1 ⁢ 5$ $- 0.0 ⁢ 2 ⁢ 4 \leq q \left[1⁢6⁢2\right] \leq - 0.0 ⁢ 22$ $- 0.0 ⁢ 3 ⁢ 2 \leq q \left[1⁢6⁢3\right] \leq - 0.0 ⁢ 3 ⁢ 0$ $- 0 . 0 ⁢ 3 ⁢ 9 \leq q \left[1⁢6⁢4\right] \leq - 0.0 ⁢ 3 ⁢ 7$ $- 0.0 ⁢ 4 ⁢ 6 \leq q \left[1⁢6⁢5\right] \leq - 0.0 ⁢ 44$ $- 0 . 0 ⁢ 5 ⁢ 4 \leq q \left[1⁢6⁢6\right] \leq - 0 . 0 ⁢ 5 ⁢ 2$ $- 0 . 0 ⁢ 6 ⁢ 1 \leq q \left[1⁢6⁢7\right] \leq - 0 . 0 ⁢ 5 ⁢ 9$ $- 0 . 0 ⁢ 6 ⁢ 8 \leq q \left[1⁢6⁢8\right] \leq - 0 . 0 ⁢ 6 ⁢ 6$ $- 0 . 0 ⁢ 7 ⁢ 5 \leq q \left[1⁢6⁢9\right] \leq - 0 . 0 ⁢ 7 ⁢ 3$ $- 0 . 0 ⁢ 8 ⁢ 2 \leq q \left[1⁢7⁢0\right] \leq - 0 . 0 ⁢ 8 ⁢ 0$ $- 0 . 0 ⁢ 8 ⁢ 9 \leq q \left[1⁢7⁢1\right] \leq - 0 . 0 ⁢ 8 ⁢ 7$ $- 0 . 0 ⁢ 9 ⁢ 6 \leq q \left[1⁢7⁢2\right] \leq - 0 . 0 ⁢ 9 ⁢ 4$ $- 0 . 1 ⁢ 0 ⁢ 2 \leq q \left[1⁢7⁢3\right] \leq - 0 . 1 ⁢ 0 ⁢ 0$ $- 0 . 1 ⁢ 0 ⁢ 9 \leq q \left[1⁢7⁢4\right] \leq - 0 . 1 ⁢ 0 ⁢ 7$ $- 0 . 1 ⁢ 1 ⁢ 6 \leq q \left[1⁢7⁢5\right] \leq - 0 . 1 ⁢ 1 ⁢ 4$ $- 0 . 1 ⁢ 2 ⁢ 2 \leq q \left[1⁢7⁢6\right] \leq - 0 . 1 ⁢ 2 ⁢ 0$ $- 0 . 1 ⁢ 2 ⁢ 9 \leq q \left[1⁢7⁢7\right] \leq - 0 . 1 ⁢ 2 ⁢ 7$ $- 0 . 1 ⁢ 3 ⁢ 5 \leq q \left[1⁢7⁢8\right] \leq - 0 . 1 ⁢ 3 ⁢ 3$ $- 0 . 1 ⁢ 4 ⁢ 2 \leq q \left[1⁢7⁢9\right] \leq - 0 . 1 ⁢ 4 ⁢ 0$ $- 0 . 1 ⁢ 4 ⁢ 8 \leq q \left[1⁢8⁢0\right] \leq - 0 . 1 ⁢ 4 ⁢ 6$ $- 0 . 1 ⁢ 5 ⁢ 4 \leq q \left[1⁢8⁢1\right] \leq - 0 . 1 ⁢ 5 ⁢ 2$ $- 0 . 1 ⁢ 6 ⁢ 0 \leq q \left[1⁢8⁢2\right] \leq - 0 . 1 ⁢ 5 ⁢ 8$ $- 0 . 1 ⁢ 6 ⁢ 6 \leq q \left[1⁢8⁢3\right] \leq - 0 . 1 ⁢ 6 ⁢ 4$ $- 0 . 1 ⁢ 7 ⁢ 2 \leq q \left[1⁢8⁢4\right] \leq - 0 . 1 ⁢ 7 ⁢ 0$ $- 0 . 1 ⁢ 7 ⁢ 8 \leq q \left[1⁢8⁢5\right] \leq - 0 . 1 ⁢ 7 ⁢ 6$ $- 0 . 1 ⁢ 8 ⁢ 3 \leq q \left[1⁢8⁢6\right] \leq - 0 . 1 ⁢ 8 ⁢ 1$ $- 0 . 1 ⁢ 8 ⁢ 9 \leq q \left[1⁢8⁢7\right] \leq - 0 . 1 ⁢ 8 ⁢ 7$ $- 0 . 1 ⁢ 9 ⁢ 4 \leq q \left[1⁢8⁢8\right] \leq - 0 . 19 ⁢ 2$ $- 0 . 1 ⁢ 9 ⁢ 9 \leq q \left[1⁢8⁢9\right] \leq - 0 . 1 ⁢ 9 ⁢ 7$ $\begin{matrix}- 0 . 2 ⁢ 0 ⁢ 4 \leq q \left[1⁢9⁢0\right] \leq - 0 . 2 ⁢ 0 ⁢ 2\end{matrix}$$\begin{matrix}- 0 . 209 \leq q \left[191\right] \leq - 0 . 207.\end{matrix}$

11. Filter apparatus according to any of the claims 8 to 10, wherein the intermediate filters (190) are adapted so that the prototype filter taps *q*(υ) fulfill for integers υ from 0 to 191 the relations:$- 0.2 ⁢ 0 ⁢ 2 ⁢ 9 ⁢ 4 \leq q \left[0\right] \leq - 0.2 ⁢ 0 ⁢ 2 ⁢ 9 ⁢ 2$ $- 0.1 ⁢ 9 ⁢ 8 ⁢ 0 ⁢ 4 \leq q \left[1\right] \leq - 0.1 ⁢ 9 ⁢ 8 ⁢ 0 ⁢ 2$ $- 0.1 ⁢ 9 ⁢ 2 ⁢ 9 ⁢ 5 \leq q \left[2\right] \leq - 0.1 ⁢ 9 ⁢ 2 ⁢ 9 ⁢ 3$ $- 0.1 ⁢ 8 ⁢ 7 ⁢ 6 ⁢ 8 \leq q \left[3\right] \leq - 0.1 ⁢ 8 ⁢ 7 ⁢ 6 ⁢ 6$ $- 0.1 ⁢ 8 ⁢ 2 ⁢ 2 ⁢ 6 \leq q \left[4\right] \leq - 0.1 ⁢ 8 ⁢ 2 ⁢ 2 ⁢ 4$ $- 0 . 1 ⁢ 7 ⁢ 6 ⁢ 68 \leq q \left[5\right] \leq - 0 . 1 ⁢ 7 ⁢ 6 ⁢ 6 ⁢ 6$ $- 0.17097 \leq q \left[6\right] \leq - 0.17095$ $- 0.16514 \leq q \left[7\right] \leq - 0.16512$ $- 0.15919 \leq q \left[8\right] \leq - 0.15917$ $- 0.15313 \leq q \left[9\right] \leq - 0.15311$ $- 0 . 1 ⁢ 4 ⁢ 6 ⁢ 9 ⁢ 7 \leq q \left[1⁢0\right] \leq - 0.14695$ $- 0 . 14071 \leq q \left[11\right] \leq - 0.14069$ $- 0 . 1 ⁢ 3 ⁢ 4 ⁢ 37 \leq q \left[1⁢2\right] \leq - 0.13435$ $- 0.12794 \leq q \left[13\right] \begin{matrix}\leq - 0 . 1 ⁢ 2 ⁢ 7 ⁢ 9 ⁢ 2\end{matrix}$ $- 0.12144 \leq q \left[1⁢4\right] \leq - 0.12142$ $- 0 . 1 ⁢ 1 ⁢ 4 ⁢ 8 ⁢ 6 \leq q \left[1⁢5\right] \leq - 0.11484$ $- 0 . 10821 \leq q \left[16\right] \leq - 0.10819$ $- 0 . 1 ⁢ 0 ⁢ 1 ⁢ 4 ⁢ 9 \leq q \left[1⁢7\right] \leq - 0.10147$ $- 0 . 09471 \leq q \left[18\right] \leq - 0.09469$ $- 0 . 08786 \leq q \left[19\right] \leq - 0.08784$ $- 0.0 ⁢ 8 ⁢ 0 ⁢ 9 ⁢ 5 \leq q \left[2⁢0\right] \leq - 0.0 ⁢ 8 ⁢ 0 ⁢ 9 ⁢ 3$ $- 0 . 0 ⁢ 7 ⁢ 3 ⁢ 9 ⁢ 7 \leq q \left[2⁢1\right] \leq - 0 . 0 ⁢ 7 ⁢ 3 ⁢ 9 ⁢ 5$ $- 0 . 0 ⁢ 6 ⁢ 6 ⁢ 9 ⁢ 4 \leq q \left[2⁢2\right] \leq - 0 . 0 ⁢ 6 ⁢ 6 ⁢ 9 ⁢ 2$ $- 0 . 0 ⁢ 5 ⁢ 9 ⁢ 8 ⁢ 4 \leq q \left[2⁢3\right] \leq - 0 . 0 ⁢ 5 ⁢ 9 ⁢ 8 ⁢ 2$ $- 0 . 0 ⁢ 5 ⁢ 2 ⁢ 6 ⁢ 9 \leq q \left[2⁢4\right] \leq - 0 . 0 ⁢ 5 ⁢ 2 ⁢ 6 ⁢ 7$ $- 0 . 0 ⁢ 4 ⁢ 5 ⁢ 4 ⁢ 7 \leq q \left[2⁢5\right] \leq - 0 . 0 ⁢ 4 ⁢ 5 ⁢ 4 ⁢ 5$ $- 0 . 0 ⁢ 3 ⁢ 8 ⁢ 1 ⁢ 9 \leq q \left[2⁢6\right] \leq - 0 . 0 ⁢ 3 ⁢ 8 ⁢ 1 ⁢ 7$ $- 0 . 0 ⁢ 3 ⁢ 0 ⁢ 8 ⁢ 5 \leq q \left[2⁢7\right] \leq - 0 . 0 ⁢ 3 ⁢ 0 ⁢ 8 ⁢ 3$ $- 0.02345 \leq q \left[2⁢8\right] \leq - 0 . 0 ⁢ 2 ⁢ 3 ⁢ 4 ⁢ 3$ $- 0 . 0 ⁢ 1 ⁢ 5 ⁢ 9 ⁢ 8 \leq q \left[2⁢9\right] \leq - 0 . 0 ⁢ 1 ⁢ 5 ⁢ 9 ⁢ 6$ $- 0 . 0 ⁢ 0 ⁢ 8 ⁢ 4 ⁢ 5 \leq q \left[3⁢0\right] \leq - 0 . 0 ⁢ 0 ⁢ 8 ⁢ 4 ⁢ 3$ $- 0 . 0 ⁢ 0 ⁢ 0 ⁢ 8 ⁢ 4 \leq q \left[3⁢1\right] \leq - 0 . 0 ⁢ 0 ⁢ 0 ⁢ 8 ⁢ 2$ $0.0 ⁢ 0 ⁢ 6 ⁢ 8 ⁢ 3 \leq q \left[3⁢2\right] \leq 0 . 0 ⁢ 0 ⁢ 6 ⁢ 8 ⁢ 5$ $0.0 ⁢ 1 ⁢ 4 ⁢ 5 ⁢ 8 \leq q \left[3⁢3\right] \leq 0 . 0 ⁢ 1 ⁢ 4 ⁢ 6 ⁢ 0$ $0.0 ⁢ 2 ⁢ 2 ⁢ 4 ⁢ 0 \leq q \left[3⁢4\right] \leq 0 . 0 ⁢ 2 ⁢ 2 ⁢ 4 ⁢ 2$ $0.0 ⁢ 3 ⁢ 0 ⁢ 3 ⁢ 0 \leq q \left[3⁢5\right] \leq 0 . 0 ⁢ 3 ⁢ 0 ⁢ 3 ⁢ 2$ $0.0 ⁢ 3 ⁢ 8 ⁢ 2 ⁢ 8 \leq q \left[3⁢6\right] \leq 0 . 0 ⁢ 3 ⁢ 8 ⁢ 3 ⁢ 0$ $0.0 ⁢ 4 ⁢ 6 ⁢ 3 ⁢ 5 \leq q \left[3⁢7\right] \leq 0 . 0 ⁢ 4 ⁢ 6 ⁢ 3 ⁢ 7$ $0.0 ⁢ 5 ⁢ 4 ⁢ 5 ⁢ 1 \leq q \left[3⁢8\right] \leq 0 . 0 ⁢ 5 ⁢ 4 ⁢ 5 ⁢ 3$ $0.0 ⁢ 6 ⁢ 2 ⁢ 7 ⁢ 5 \leq q \left[3⁢9\right] \leq 0 . 0 ⁢ 6 ⁢ 2 ⁢ 7 ⁢ 7$ $0.0 ⁢ 7 ⁢ 1 ⁢ 1 ⁢ 0 \leq q \left[4⁢0\right] \leq 0 . 0 ⁢ 7 ⁢ 1 ⁢ 1 ⁢ 2$ $0.0 ⁢ 7 ⁢ 9 ⁢ 5 ⁢ 4 \leq q \left[4⁢1\right] \leq 0 . 0 ⁢ 7 ⁢ 9 ⁢ 5 ⁢ 6$ $0.0 ⁢ 8 ⁢ 8 ⁢ 0 ⁢ 9 \leq q \left[4⁢2\right] \leq 0 . 0 ⁢ 8 ⁢ 8 ⁢ 1 ⁢ 1$ $0.0 ⁢ 9 ⁢ 6 ⁢ 7 ⁢ 5 \leq q \left[4⁢3\right] \leq 0 . 0 ⁢ 9 ⁢ 6 ⁢ 7 ⁢ 7$ $0.10552 \leq q \left[4⁢4\right] \leq 0.10554$ $0.1 ⁢ 1 ⁢ 4 ⁢ 4 ⁢ 2 \leq q \left[4⁢5\right] \leq 0 . 1 ⁢ 1 ⁢ 4 ⁢ 4 ⁢ 4$ $0.1 ⁢ 2 ⁢ 3 ⁢ 4 ⁢ 4 \leq q \left[4⁢6\right] \leq 0 . 1 ⁢ 2 ⁢ 3 ⁢ 4 ⁢ 6$ $0.1 ⁢ 3 ⁢ 2 ⁢ 5 ⁢ 9 \leq q \left[4⁢7\right] \leq 0 . 1 ⁢ 3 ⁢ 2 ⁢ 6 ⁢ 1$ $0.14189 \leq q \left[48\right] \leq 0.14191$ $0.15132 \leq q \left[49\right] \leq 0.15134$ $0.16091 \leq q \left[5⁢0\right] \leq 0.16093$ $0.17066 \leq q \left[51\right] \leq 0.17068$ $0.18058 \leq q \left[5⁢2\right] \leq 0.18060$ $0.19067 \leq q \left[53\right] \leq 0.19069$ $0.20095 \leq q \left[54\right] \leq 0.20097$ $0.2 ⁢ 1 ⁢ 1 ⁢ 4 ⁢ 3 \leq q \left[5⁢5\right] \leq 0 . 2 ⁢ 1 ⁢ 1 ⁢ 4 ⁢ 5$ $0.2 ⁢ 2 ⁢ 2 ⁢ 1 ⁢ 1 \leq q \left[5⁢6\right] \leq 0 . 2 ⁢ 2 ⁢ 2 ⁢ 1 ⁢ 3$ $0.2 ⁢ 3 ⁢ 3 ⁢ 0 ⁢ 0 \leq q \left[5⁢7\right] \leq 0 . 2 ⁢ 3 ⁢ 3 ⁢ 0 ⁢ 2$ $0.2 ⁢ 4 ⁢ 4 ⁢ 1 ⁢ 2 \leq q \left[5⁢8\right] \leq 0 . 2 ⁢ 4 ⁢ 4 ⁢ 1 ⁢ 4$ $0 . 2 ⁢ 5 ⁢ 5 ⁢ 4 ⁢ 9 \leq q \left[5⁢9\right] \leq 0 . 2 ⁢ 5 ⁢ 5 ⁢ 5 ⁢ 1$ $0.2 ⁢ 6 ⁢ 7 ⁢ 1 ⁢ 1 \leq q \left[6⁢0\right] \leq 0 . 2 ⁢ 6 ⁢ 7 ⁢ 1 ⁢ 3$ $0.2 ⁢ 7 ⁢ 8 ⁢ 9 ⁢ 9 \leq q \left[6⁢1\right] \leq 0 . 2 ⁢ 7 ⁢ 9 ⁢ 0 ⁢ 1$ $0.2 ⁢ 9 ⁢ 1 ⁢ 1 ⁢ 7 \leq q \left[6⁢2\right] \leq 0 . 2 ⁢ 9 ⁢ 1 ⁢ 1 ⁢ 9$ $0.30364 \leq q \left[63\right] \leq 0.30366$ $0.90252 \leq q \left[64\right] \leq 0.90254$ $0.9 ⁢ 1 ⁢ 0 ⁢ 3 ⁢ 5 \leq q \left[6⁢5\right] \leq 0 . 9 ⁢ 1 ⁢ 0 ⁢ 37$ $0.9 ⁢ 1 ⁢ 7 ⁢ 6 ⁢ 9 \leq q \left[6⁢6\right] \leq 0 . 9 ⁢ 1 ⁢ 7 ⁢ 71$ $0.92457 \leq q \left[67\right] \leq 0.92459 \begin{matrix}\end{matrix}$ $0.9 ⁢ 3 ⁢ 1 ⁢ 0 ⁢ 1 \leq q \left[6⁢8\right] \leq 0 . 9 ⁢ 3 ⁢ 1 ⁢ 03$ $0.9 ⁢ 3 ⁢ 7 ⁢ 0 ⁢ 5 \leq q \left[6⁢9\right] \leq 0.9 ⁢ 3 ⁢ 7 ⁢ 07$ $0 . 9 ⁢ 4 ⁢ 2 ⁢ 7 ⁢ 0 \leq q \left[7⁢0\right] \leq 0 . 9 ⁢ 4 ⁢ 2 ⁢ 7 ⁢ 2$ $0.9 ⁢ 4 ⁢ 8 ⁢ 0 ⁢ 0 \leq q \left[7⁢1\right] \leq 0 . 9 ⁢ 4 ⁢ 8 ⁢ 0 ⁢ 2$ $0.9 ⁢ 5 ⁢ 2 ⁢ 9 ⁢ 5 \leq q \left[7⁢2\right] \leq 0 . 9 ⁢ 5 ⁢ 2 ⁢ 9 ⁢ 7$ $0.9 ⁢ 5 ⁢ 7 ⁢ 5 ⁢ 8 \leq q \left[7⁢3\right] \leq 0 . 9 ⁢ 5 ⁢ 7 ⁢ 6 ⁢ 0$ $0.9 ⁢ 6 ⁢ 1 ⁢ 9 ⁢ 0 \leq q \left[7⁢4\right] \leq 0 . 9 ⁢ 6 ⁢ 1 ⁢ 9 ⁢ 2$ $0.9 ⁢ 6 ⁢ 5 ⁢ 9 ⁢ 3 \leq q \left[7⁢5\right] \leq 0 . 9 ⁢ 6 ⁢ 5 ⁢ 9 ⁢ 5$ $0.9 ⁢ 6 ⁢ 9 ⁢ 6 ⁢ 8 \leq q \left[7⁢6\right] \leq 0 . 9 ⁢ 6 ⁢ 9 ⁢ 7 ⁢ 0$ $0.9 ⁢ 7 ⁢ 3 ⁢ 1 ⁢ 7 \leq q \left[7⁢7\right] \leq 0 . 9 ⁢ 7 ⁢ 3 ⁢ 1 ⁢ 9$ $0.9 ⁢ 7 ⁢ 6 ⁢ 4 ⁢ 1 \leq q \left[7⁢8\right] \leq 0 . 9 ⁢ 7 ⁢ 6 ⁢ 4 ⁢ 3$ $0.9 ⁢ 7 ⁢ 9 ⁢ 4 ⁢ 0 \leq q \left[79\right] \leq 0 . 9 ⁢ 7 ⁢ 9 ⁢ 4 ⁢ 2$ $0.98217 \leq q \left[8⁢0\right] \leq 0 . 9 ⁢ 8 ⁢ 2 ⁢ 1 ⁢ 9$ $0.9 ⁢ 8 ⁢ 4 ⁢ 7 ⁢ 2 \leq q \left[8⁢1\right] \leq 0 . 9 ⁢ 8 ⁢ 4 ⁢ 7 ⁢ 4$ $0.9 ⁢ 8 ⁢ 7 ⁢ 0 ⁢ 6 \leq q \left[8⁢2\right] \leq 0 . 9 ⁢ 8 ⁢ 7 ⁢ 0 ⁢ 8$ $0.9 ⁢ 8 ⁢ 9 ⁢ 1 ⁢ 9 \leq q \left[8⁢3\right] \leq 0 . 9 ⁢ 8 ⁢ 9 ⁢ 2 ⁢ 1$ $0.9 ⁢ 9 ⁢ 1 ⁢ 1 ⁢ 3 \leq q \left[8⁢4\right] \leq 0 . 9 ⁢ 9 ⁢ 1 ⁢ 1 ⁢ 5$ $0.9 ⁢ 9 ⁢ 2 ⁢ 8 ⁢ 8 \leq q \left[8⁢5\right] \leq 0 . 9 ⁢ 9 ⁢ 2 ⁢ 9 ⁢ 0$ $0.9 ⁢ 9 ⁢ 4 ⁢ 4 ⁢ 4 \leq q \left[8⁢6\right] \leq 0 . 9 ⁢ 9 ⁢ 4 ⁢ 4 ⁢ 6$ $0.9 ⁢ 9 ⁢ 5 ⁢ 8 ⁢ 3 \leq q \left[8⁢7\right] \leq 0 . 9 ⁢ 9 ⁢ 5 ⁢ 8 ⁢ 5$ $0.9 ⁢ 9 ⁢ 7 ⁢ 0 ⁢ 4 \leq q \left[8⁢8\right] \leq 0 . 9 ⁢ 9 ⁢ 7 ⁢ 0 ⁢ 6$ $0.9 ⁢ 9 ⁢ 8 ⁢ 0 ⁢ 9 \leq q \left[8⁢9\right] \leq 0 . 9 ⁢ 9 ⁢ 8 ⁢ 1 ⁢ 1$ $0.9 ⁢ 9 ⁢ 8 ⁢ 9 ⁢ 6 \leq q \left[9⁢0\right] \leq 0.9 ⁢ 9 ⁢ 8 ⁢ 9 ⁢ 8$ $0.9 ⁢ 9 ⁢ 9 ⁢ 6 ⁢ 7 \leq q \left[9⁢1\right] \leq 0.9 ⁢ 9 ⁢ 9 ⁢ 6 ⁢ 9$ $1.0 ⁢ 0 ⁢ 0 ⁢ 2 ⁢ 3 \leq q \left[9⁢2\right] \leq 1.0 ⁢ 0 ⁢ 0 ⁢ 25$ $1.0 ⁢ 0062 \leq q \left[93\right] \leq 1.00064$ $1.0 ⁢ 0086 \leq q \left[94\right] \leq 1.0 ⁢ 0 ⁢ 088$ $1.00093 \leq q \left[95\right] \leq 1.00095$ $1.00086 \leq q \left[96\right] \leq 1.00088$ $1.00062 \leq q \left[95\right] \leq 1.00064$ $1.00023 \leq q \left[98\right] \leq 1.00025$ $0.99967 \leq q \left[99\right] \leq 0.99969$ $0.99896 \leq q \left[100\right] \leq 0.99898$ $0.99809 \leq q \left[1⁢0⁢1\right] \leq 0.99811$ $0.99704 \leq q \left[102\right] \leq 0.99706$ $0.99583 \leq q \left[103\right] \leq 0.99585$ $0.99444 \leq q \left[104\right] \leq 0.99446$ $0.99288 \leq q \left[105\right] \leq 0.99290$ $0.9 ⁢ 9 ⁢ 1 ⁢ 1 ⁢ 3 \leq q \left[1⁢0⁢6\right] \leq 0 . 9 ⁢ 9 ⁢ 1 ⁢ 1 ⁢ 5$ $0.9 ⁢ 8 ⁢ 9 ⁢ 1 ⁢ 9 \leq q \left[1⁢0⁢7\right] \leq 0 . 9 ⁢ 8 ⁢ 9 ⁢ 2 ⁢ 1$ $0.98706 \leq q \left[108\right] \leq 0.98708$ $0.98472 \leq q \left[109\right] \leq 0.98474$ $0.98217 \leq q \left[110\right] \leq 0.98219$ $0.97940 \leq q \left[111\right] \leq 0.97942$ $0.97641 \leq q \left[112\right] \leq 0.97643$ $0.97317 \leq q \left[113\right] \leq 0.97319$ $0.96968 \leq q \left[114\right] \leq 0.96970$ $0.96593 \leq q \left[1⁢1⁢5\right] \leq 0.96595$ $0.96190 \leq q \left[116\right] \leq 0.96192$ $0.95758 \leq q \left[117\right] \leq 0.95760$ $0.95295 \leq q \left[118\right] \leq 0.95297$ $0.94800 \leq q \left[1⁢1⁢9\right] \leq 0.94802$ $0.9 ⁢ 4 ⁢ 2 ⁢ 7 ⁢ 0 \leq q \left[1⁢2⁢0\right] \leq 0.9 ⁢ 4 ⁢ 2 ⁢ 7 ⁢ 2$ $0.9 ⁢ 3 ⁢ 7 ⁢ 0 ⁢ 5 \leq q \left[1⁢2⁢1\right] \leq 0.9 ⁢ 3 ⁢ 7 ⁢ 0 ⁢ 7$ $0.93101 \leq q \left[122\right] \leq 0.93103$ $0.92457 \leq q \left[1⁢2⁢3\right] \leq 0.92459$ $0.91769 \leq q \left[1⁢2⁢4\right] \leq 0.91771$ $0.91035 \leq q \left[125\right] \leq 0.91037$ $0.90252 \leq q \left[126\right] \leq 0.90254$ $0.89416 \leq q \left[127\right] \leq 0.89418$ $0.29117 \leq q \left[128\right] \leq 0.29119$ $0.27899 \leq q \left[129\right] \leq 0.27901$ $0.26711 \leq q \left[130\right] \leq 0.26713$ $0.25549 \leq q \left[1⁢3⁢1\right] \leq 0.25551$ $0.24412 \leq q \left[132\right] \leq 0.24414$ $0.23300 \leq q \left[133\right] \leq 0.23302$ $0.22211 \leq q \left[134\right] \leq 0.22213$ $0.2 ⁢ 1 ⁢ 1 ⁢ 4 ⁢ 3 \leq q \left[1⁢3⁢5\right] \leq 0 . 2 ⁢ 1 ⁢ 1 ⁢ 4 ⁢ 5$ $0.200 ⁢ 9 ⁢ 5 \leq q \left[1⁢3⁢6\right] \leq 0 . 2 ⁢ 0 ⁢ 0 ⁢ 9 ⁢ 7$ $0.19067 \leq q \left[137\right] \leq 0.19069$ $0.18058 \leq q \left[138\right] \leq 0.18060$ $0.17066 \leq q \left[139\right] \leq 0.17068$ $0.16091 \leq q \left[1⁢4⁢0\right] \leq 0.16093$ $0.15132 \leq q \left[141\right] \leq 0.15134$ $0.14189 \leq q \left[142\right] \leq 0.14191$ $0.13259 \leq q \left[143\right] \leq 0.13261$ $0.12344 \leq q \left[144\right] \leq 0.12346$ $0.11442 \leq q \left[145\right] \leq 0.11444$ $0.10552 \leq q \left[146\right] \leq 0.10554$ $0.09675 \leq q \left[147\right] \leq 0.09677$ $0.08809 \leq q \left[148\right] \leq 0.08811$ $0.07954 \leq q \left[149\right] \leq 0.07956$ $0.0 ⁢ 7 ⁢ 1 ⁢ 1 ⁢ 0 \leq q \left[1⁢5⁢0\right] \leq 0 . 0 ⁢ 7 ⁢ 1 ⁢ 1 ⁢ 2$ $0.06275 \leq q \left[1⁢5⁢1\right] \leq 0 .06277$ $0.05451 \leq q \left[1⁢5⁢2\right] \leq 0.05453$ $0.04635 \leq q \left[1⁢5⁢3\right] \leq 0 . 0 ⁢ 4 ⁢ 6 ⁢ 3 ⁢ 7$ $0.03828 \leq q \left[1⁢5⁢4\right] \leq 0.03830$ $0.03030 \leq q \left[1⁢5⁢5\right] \leq 0.03032$ $0.02240 \leq q \left[156\right] \leq 0.02242$ $0.01458 \leq q \left[157\right] \leq 0.01460$ $0.00683 \leq q \left[1⁢5⁢8\right] \leq 0.00685$ $- 0.0 ⁢ 0 ⁢ 0 ⁢ 84 \leq q \left[1⁢5⁢9\right] \leq - 0.00082$ $- 0 . 0 ⁢ 0 ⁢ 8 ⁢ 4 ⁢ 5 \leq q \left[1⁢6⁢0\right] \leq - 0 . 0 ⁢ 0 ⁢ 8 ⁢ 4 ⁢ 3$ $- 0 . 0 ⁢ 1 ⁢ 5 ⁢ 9 ⁢ 8 \leq q \left[1⁢6⁢1\right] \leq - 0.0 ⁢ 1 ⁢ 5 ⁢ 9 ⁢ 6$ $- 0 . 0 ⁢ 2 ⁢ 3 ⁢ 4 ⁢ 5 \leq q \left[1⁢6⁢2\right] \leq - 0 . 0 ⁢ 2 ⁢ 3 ⁢ 4 ⁢ 3$ $- 0 . 0 ⁢ 3 ⁢ 0 ⁢ 8 ⁢ 5 \leq q \left[1⁢6⁢3\right] \leq - 0 . 0 ⁢ 3 ⁢ 0 ⁢ 8 ⁢ 3$ $- 0 . 0 ⁢ 3 ⁢ 8 ⁢ 1 ⁢ 9 \leq q \left[1⁢6⁢4\right] \leq - 0 . 0 ⁢ 3 ⁢ 8 ⁢ 1 ⁢ 7$ $- 0 . 0 ⁢ 4 ⁢ 5 ⁢ 4 ⁢ 7 \leq q \left[1⁢6⁢5\right] \leq - 0 . 0 ⁢ 4 ⁢ 5 ⁢ 4 ⁢ 5$ $- 0 . 0 ⁢ 5 ⁢ 2 ⁢ 6 ⁢ 9 \leq q \left[1⁢6⁢6\right] \leq - 0 . 0 ⁢ 5 ⁢ 2 ⁢ 6 ⁢ 7$ $- 0 . 0 ⁢ 5 ⁢ 9 ⁢ 8 ⁢ 4 \leq q \left[1⁢6⁢7\right] \leq - 0 . 0 ⁢ 5 ⁢ 9 ⁢ 8 ⁢ 2$ $- 0 . 0 ⁢ 6 ⁢ 6 ⁢ 9 ⁢ 4 \leq q \left[1⁢6⁢8\right] \leq - 0 . 0 ⁢ 6 ⁢ 6 ⁢ 9 ⁢ 2$ $- 0 . 073 ⁢ 9 ⁢ 7 \leq q \left[1⁢6⁢9\right] \leq - 0 . 0 ⁢ 7 ⁢ 3 ⁢ 9 ⁢ 5$ $- 0 . 0 ⁢ 8 ⁢ 0 ⁢ 9 ⁢ 5 \leq q \left[1⁢7⁢0\right] \leq - 0 . 0 ⁢ 8 ⁢ 0 ⁢ 9 ⁢ 3$ $- 0 . 0 ⁢ 8 ⁢ 7 ⁢ 8 ⁢ 6 \leq q \left[1⁢7⁢1\right] \leq - 0 . 0 ⁢ 8 ⁢ 7 ⁢ 8 ⁢ 4$ $- 0 . 0 ⁢ 9 ⁢ 4 ⁢ 7 ⁢ 1 \leq q \left[1⁢7⁢2\right] \leq - 0 . 0 ⁢ 9 ⁢ 4 ⁢ 6 ⁢ 9$ $- 0 . 1 ⁢ 0 ⁢ 1 ⁢ 4 ⁢ 9 \leq q \left[1⁢7⁢3\right] \leq - 0 . 1 ⁢ 0 ⁢ 1 ⁢ 4 ⁢ 7$ $- 0 . 1 ⁢ 0 ⁢ 8 ⁢ 2 ⁢ 1 \leq q \left[1⁢7⁢4\right] \leq - 0 . 1 ⁢ 0 ⁢ 8 ⁢ 1 ⁢ 9$ $- 0 . 1 ⁢ 1 ⁢ 4 ⁢ 8 ⁢ 6 \leq q \left[1⁢7⁢5\right] \leq - 0 . 1 ⁢ 1 ⁢ 4 ⁢ 8 ⁢ 4$ $- 0 . 1 ⁢ 2 ⁢ 1 ⁢ 4 ⁢ 4 \leq q \left[1⁢7⁢6\right] \leq - 0 . 1 ⁢ 2 ⁢ 1 ⁢ 4 ⁢ 2$ $- 0 . 1 ⁢ 2 ⁢ 7 ⁢ 9 ⁢ 4 \leq q \left[1⁢7⁢7\right] \leq - 0 . 1 ⁢ 2 ⁢ 7 ⁢ 9 ⁢ 2$ $- 0 . 1 ⁢ 3 ⁢ 4 ⁢ 3 ⁢ 7 \leq q \left[1⁢7⁢8\right] \leq - 0 . 1 ⁢ 3 ⁢ 4 ⁢ 3 ⁢ 5$ $- 0 . 1 ⁢ 4 ⁢ 0 ⁢ 7 ⁢ 1 \leq q \left[1⁢7⁢9\right] \leq - 0 . 1 ⁢ 4 ⁢ 0 ⁢ 6 ⁢ 9$ $- 0.14697 \leq q \left[1⁢8⁢0\right] \leq - 0.1 ⁢ 4 ⁢ 6 ⁢ 9 ⁢ 5$ $- 0.1 ⁢ 5 ⁢ 3 ⁢ 1 ⁢ 3 \leq q \left[181\right] \leq - 0.1 ⁢ 5 ⁢ 3 ⁢ 1 ⁢ 1$ $- 0.1 ⁢ 5 ⁢ 9 ⁢ 1 ⁢ 9 \leq q \left[1⁢8⁢2\right] \leq - 0.1 ⁢ 5 ⁢ 9 ⁢ 1 ⁢ 7$ $- 0.1 ⁢ 6 ⁢ 5 ⁢ 1 ⁢ 4 \leq q \left[183\right] \leq - 0.1 ⁢ 6 ⁢ 5 ⁢ 12$ $- 0.1 ⁢ 7 ⁢ 0 ⁢ 9 ⁢ 7 \leq q \left[1⁢8⁢4\right] \leq - 0.1 ⁢ 7 ⁢ 0 ⁢ 9 ⁢ 5$ $- 0 . 1 ⁢ 7 ⁢ 6 ⁢ 6 ⁢ 8 \leq q \left[1⁢8⁢5\right] \leq - 0 . 1 ⁢ 7 ⁢ 6 ⁢ 6 ⁢ 6$ $- 0 . 1 ⁢ 8 ⁢ 2 ⁢ 2 ⁢ 6 \leq q \left[1⁢8⁢6\right] \leq - 0 . 1 ⁢ 8 ⁢ 2 ⁢ 2 ⁢ 4$ $- 0 . 1 ⁢ 8 ⁢ 7 ⁢ 6 ⁢ 8 \leq q \left[1⁢8⁢7\right] \leq - 0 . 1 ⁢ 8 ⁢ 7 ⁢ 6 ⁢ 6$ $- 0 . 1 ⁢ 9 ⁢ 2 ⁢ 9 ⁢ 5 \leq q \left[1⁢8⁢8\right] \leq - 0 . 1 ⁢ 9 ⁢ 2 ⁢ 9 ⁢ 3$ $- 0 . 1 ⁢ 9 ⁢ 8 ⁢ 0 ⁢ 4 \leq q \left[1⁢8⁢9\right] \leq - 0 . 1 ⁢ 9 ⁢ 8 ⁢ 0 ⁢ 2$ $- 0 . 2 ⁢ 0 ⁢ 2 ⁢ 9 ⁢ 4 \leq q \left[1⁢9⁢0\right] \leq - 0 . 2 ⁢ 0 ⁢ 2 ⁢ 9 ⁢ 2$ $- 0.20764 \leq q \left[191\right] \leq - 0.20762$

12. Filter apparatus according to any of the claims 8 to 11, wherein the intermediate filters (190) are adapted, so that the real valued prototype filter coefficients *q*(υ) for integer υ in the range from 0 to 191 are given by$q \left[0\right] = - 0 . 2 ⁢ 0 ⁢ 2 ⁢ 9 ⁢ 3 ⁢ 4 ⁢ 3 ⁢ 3 ⁢ 8 ⁢ 0$ $q \left[1\right] = - 0 . 1 ⁢ 9 ⁢ 8 ⁢ 0 ⁢ 3 ⁢ 3 ⁢ 1 ⁢ 5 ⁢ 8 ⁢ 8$ $q \left[2\right] = - 0 . 1 ⁢ 9 ⁢ 2 ⁢ 9 ⁢ 4 ⁢ 1 ⁢ 1 ⁢ 5 ⁢ 1 ⁢ 9$ $q \left[3\right] = - 0 . 1 ⁢ 8 ⁢ 7 ⁢ 6 ⁢ 7 ⁢ 4 ⁢ 4 ⁢ 2 ⁢ 2 ⁢ 2$ $q \left[4\right] = - 0 . 1 ⁢ 8 ⁢ 2 ⁢ 2 ⁢ 4 ⁢ 7 ⁢ 4 ⁢ 0 ⁢ 1 ⁢ 1$ $q \left[5\right] = - 0 . 1 ⁢ 7 ⁢ 6 ⁢ 6 ⁢ 7 ⁢ 3 ⁢ 0 ⁢ 2 ⁢ 0 ⁢ 2$ $q \left[6\right] = - 0 . 1 ⁢ 7 ⁢ 0 ⁢ 9 ⁢ 6 ⁢ 2 ⁢ 8 ⁢ 6 ⁢ 3 ⁢ 6$ $q \left[7\right] = - 0 . 1 ⁢ 6 ⁢ 5 ⁢ 1 ⁢ 2 ⁢ 7 ⁢ 3 ⁢ 0 ⁢ 0 ⁢ 5$ $q \left[8\right] = - 0.1 ⁢ 5 ⁢ 9 ⁢ 1 ⁢ 7 ⁢ 5 ⁢ 6 ⁢ 0 ⁢ 2 ⁢ 4$ $q \left[9\right] = - 0 . 1 ⁢ 5 ⁢ 3 ⁢ 1 ⁢ 1 ⁢ 6 ⁢ 0 ⁢ 4 ⁢ 5 ⁢ 5$ $q \left[1⁢0\right] = - 0.1469560005$ $q \left[1⁢1\right] = - 0.1407020132$ $q \left[1⁢2\right] = - 0.1343598738$ $q \left[1⁢3\right] = - 0 . 1 ⁢ 2 ⁢ 7 ⁢ 9 ⁢ 3 ⁢ 4 ⁢ 6 ⁢ 7 ⁢ 9 ⁢ 0$ $q \left[1⁢4\right] = - 0 . 1 ⁢ 2 ⁢ 1 ⁢ 4 ⁢ 3 ⁢ 0 ⁢ 8 ⁢ 8 ⁢ 7 ⁢ 6$ $q \left[15\right] = - 0.1148523686$ $q \left[1⁢6\right] = - 0.1082024454$ $q \left[1⁢7\right] = - 0.1014839341$ $q \left[1⁢8\right] = - 0 . 0 ⁢ 9 ⁢ 4 ⁢ 6 ⁢ 9 ⁢ 9 ⁢ 1 ⁢ 7 ⁢ 8 ⁢ 3$ $q \left[1⁢9\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[20\right] = - 0 . 0809381268$ $q \left[21\right] = - 0.0739644174$ $q \left[22\right] = - 0.0669296831$ $q \left[2⁢3\right] = - 0.0 ⁢ 5 ⁢ 9 ⁢ 8 ⁢ 3 ⁢ 4 ⁢ 3 ⁢ 0 ⁢ 8 ⁢ 1$ $q \left[2⁢4\right] = - 0.0 ⁢ 5 ⁢ 2 ⁢ 6 ⁢ 7 ⁢ 8 ⁢ 3 ⁢ 4 ⁢ 6 ⁢ 6$ $q \left[2⁢5\right] = - 0.0 ⁢ 4 ⁢ 5 ⁢ 4 ⁢ 6 ⁢ 1 ⁢ 5 ⁢ 3 ⁢ 8 ⁢ 8$ $q \left[2⁢6\right] = - 0 . 0 ⁢ 3 ⁢ 8 ⁢ 1 ⁢ 8 ⁢ 3 ⁢ 3 ⁢ 2 ⁢ 4 ⁢ 9$ $q \left[2⁢7\right] = - 0.0 ⁢ 3 ⁢ 0 ⁢ 8 ⁢ 4 ⁢ 2 ⁢ 8 ⁢ 5 ⁢ 7 ⁢ 2$ $q \left[2⁢8\right] = - 0 . 0 ⁢ 2 ⁢ 3 ⁢ 4 ⁢ 3 ⁢ 9 ⁢ 0 ⁢ 1 ⁢ 1 ⁢ 5$ $q \left[2⁢9\right] = - 0 . 0 ⁢ 1 ⁢ 5 ⁢ 9 ⁢ 7 ⁢ 0 ⁢ 3 ⁢ 9 ⁢ 5 ⁢ 7$ $q \left[3⁢0\right] = - 0 . 0 ⁢ 0 ⁢ 8 ⁢ 4 ⁢ 3 ⁢ 5 ⁢ 3 ⁢ 5 ⁢ 8 ⁢ 4$ $q \left[3⁢1\right] = - 0 . 0 ⁢ 0 ⁢ 0 ⁢ 8 ⁢ 3 ⁢ 1 ⁢ 9 ⁢ 9 ⁢ 5 ⁢ 6$ $q \left[3⁢2\right] = 0 . 0 ⁢ 0 ⁢ 6 ⁢ 8 ⁢ 4 ⁢ 1 ⁢ 8 ⁢ 4 ⁢ 3 ⁢ 5$ $q \left[3⁢3\right] = 0 . 0 ⁢ 1 ⁢ 4 ⁢ 5 ⁢ 8 ⁢ 8 ⁢ 5 ⁢ 5 ⁢ 2 ⁢ 7$ $q \left[3⁢4\right] = 0.0 ⁢ 2 ⁢ 2 ⁢ 4 ⁢ 1 ⁢ 0 ⁢ 7 ⁢ 6 ⁢ 48$ $q \left[3⁢5\right] = 0 . 0 ⁢ 3 ⁢ 0 ⁢ 3 ⁢ 1 ⁢ 1 ⁢ 3 ⁢ 4 ⁢ 9 ⁢ 5$ $q \left[3⁢6\right] = 0 . 0 ⁢ 3 ⁢ 8 ⁢ 2 ⁢ 9 ⁢ 3 ⁢ 4 ⁢ 1 ⁢ 2 ⁢ 6$ $q \left[3⁢7\right] = 0 . 0 ⁢ 4 ⁢ 6 ⁢ 3 ⁢ 6 ⁢ 0 ⁢ 2 ⁢ 9 ⁢ 5 ⁢ 9$ $q \left[3⁢8\right] = 0.0 ⁢ 5 ⁢ 4 ⁢ 5 ⁢ 1 ⁢ 5 ⁢ 5 ⁢ 7 ⁢ 89$ $q \left[3⁢9\right] = 0.0 ⁢ 6 ⁢ 2 ⁢ 7 ⁢ 6 ⁢ 3 ⁢ 0 ⁢ 8 ⁢ 1 ⁢ 0$ $q \left[4⁢0\right] = 0.0 ⁢ 7 ⁢ 1 ⁢ 1 ⁢ 0 ⁢ 6 ⁢ 8 ⁢ 6 ⁢ 5 ⁢ 7$ $q \left[4⁢1\right] = 0.0 ⁢ 7 ⁢ 9 ⁢ 5 ⁢ 5 ⁢ 1 ⁢ 2 ⁢ 4 ⁢ 5 ⁢ 3$ $q \left[4⁢2\right] = 0.0 ⁢ 8 ⁢ 8 ⁢ 1 ⁢ 0 ⁢ 0 ⁢ 7 ⁢ 8 ⁢ 7 ⁢ 9$ $q \left[4⁢3\right] = 0 . 0 ⁢ 9 ⁢ 6 ⁢ 7 ⁢ 6 ⁢ 0 ⁢ 3 ⁢ 2 ⁢ 5 ⁢ 9$ $q \left[4⁢4\right] = 0 . 1 ⁢ 0 ⁢ 5 ⁢ 5 ⁢ 3 ⁢ 4 ⁢ 9 ⁢ 6 ⁢ 5 ⁢ 8$ $q \left[4⁢5\right] = 0 . 1 ⁢ 1 ⁢ 4 ⁢ 4 ⁢ 3 ⁢ 0 ⁢ 1 ⁢ 0 ⁢ 0 ⁢ 0$ $q \left[46\right] = 0.1234514222$ $q \left[47\right] = 0.1326049434$ $q \left[4⁢8\right] = 0 .1418970123$ $q \left[4⁢9\right] = 0.1513343370$ $q \left[5⁢0\right] = 0.1609240126$ $q \left[5⁢1\right] = 0.1706735517$ $q \left[5⁢2\right] = 0.1805909194$ $q \left[5⁢3\right] = 0.1 ⁢ 9 ⁢ 0 ⁢ 6 ⁢ 8 ⁢ 4 ⁢ 5 ⁢ 7 ⁢ 5 ⁢ 3$ $q \left[5⁢4\right] = 0.2 ⁢ 0 ⁢ 0 ⁢ 9 ⁢ 6 ⁢ 3 ⁢ 5 ⁢ 1 ⁢ 91$ $q \left[5⁢5\right] = 0.2 ⁢ 1 ⁢ 1 ⁢ 4 ⁢ 3 ⁢ 7 ⁢ 3 ⁢ 4 ⁢ 5 ⁢ 8$ $q \left[5⁢6\right] = 0.2 ⁢ 2 ⁢ 2 ⁢ 1 ⁢ 1 ⁢ 6 ⁢ 3 ⁢ 0 ⁢ 8 ⁢ 0$ $q \left[5⁢7\right] = 0.2 ⁢ 3 ⁢ 3 ⁢ 0 ⁢ 1 ⁢ 1 ⁢ 3 ⁢ 8 ⁢ 6 ⁢ 8$ $q \left[5⁢8\right] = 0 . 2 ⁢ 4 ⁢ 4 ⁢ 1 ⁢ 3 ⁢ 4 ⁢ 3 ⁢ 7 ⁢ 4 ⁢ 2$ $q \left[5⁢9\right] = 0 . 2 ⁢ 5 ⁢ 5 ⁢ 4 ⁢ 9 ⁢ 7 ⁢ 9 ⁢ 6 ⁢ 6 ⁢ 4$ $q \left[6⁢0\right] = 0 . 2 ⁢ 6 ⁢ 7 ⁢ 1 ⁢ 1 ⁢ 5 ⁢ 8 ⁢ 7 ⁢ 0 ⁢ 0$ $q \left[6⁢1\right] = 0 . 2 ⁢ 7 ⁢ 9 ⁢ 0 ⁢ 0 ⁢ 2 ⁢ 9 ⁢ 2 ⁢ 3 ⁢ 6$ $q \left[6⁢2\right] = 0.2911752349$ $q \left[6⁢3\right] = 0 . 3 ⁢ 036503350$ $q \left[6⁢4\right] = 0 . 9 ⁢ 0 ⁢ 2 ⁢ 5 ⁢ 2 ⁢ 7 ⁢ 5 ⁢ 7 ⁢ 1 ⁢ 3$ $q \left[6⁢5\right] = 0 . 9 ⁢ 1 ⁢ 0 ⁢ 3 ⁢ 5 ⁢ 8 ⁢ 5 ⁢ 1 ⁢ 9 ⁢ 6$ $q \left[6⁢6\right] = 0 . 9 ⁢ 1 ⁢ 7 ⁢ 6 ⁢ 9 ⁢ 7 ⁢ 7 ⁢ 8 ⁢ 2 ⁢ 5$ $q \left[6⁢7\right] = 0 . 9 ⁢ 2 ⁢ 4 ⁢ 5 ⁢ 7 ⁢ 6 ⁢ 0 ⁢ 6 ⁢ 8 ⁢ 3$ $q \left[6⁢8\right] = 0.9 ⁢ 3 ⁢ 1021 ⁢ 4 ⁢ 581$ $q \left[6⁢9\right] = 0.9370 ⁢ 5 ⁢ 9 ⁢ 6 ⁢ 7 ⁢ 3 ⁢ 9$ $q \left[7⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[7⁢1\right] = 0 . 9 ⁢ 4 ⁢ 8 ⁢ 0070 ⁢ 6 ⁢ 0 ⁢ 6$ $q \left[7⁢2\right] = 0 . 9 ⁢ 5 ⁢ 2 ⁢ 9 ⁢ 5 ⁢ 7856 ⁢ 6$ $q \left[7⁢3\right] = 0 . 9 ⁢ 5 ⁢ 7 ⁢ 5 ⁢ 8 ⁢ 5 ⁢ 0 ⁢ 6 ⁢ 7 ⁢ 2$ $q \left[7⁢4\right] = 0 . 9 ⁢ 6 ⁢ 1 ⁢ 9 ⁢ 0 ⁢ 5 ⁢ 6 ⁢ 1 ⁢ 5 ⁢ 8$ $q \left[7⁢5\right] = 0 . 9 ⁢ 6 ⁢ 5 ⁢ 9 ⁢ 3 ⁢ 5 ⁢ 1 ⁢ 0 ⁢ 6 ⁢ 5$ $q \left[7⁢6\right] = 0 . 9 ⁢ 6 ⁢ 9 ⁢ 6 ⁢ 8 ⁢ 7 ⁢ 9 ⁢ 2 ⁢ 9 ⁢ 7$ $q \left[7⁢7\right] = 0 . 9 ⁢ 7 ⁢ 3 ⁢ 1 ⁢ 7 ⁢ 7 ⁢ 3 ⁢ 5 ⁢ 4 ⁢ 7$ $q \left[78\right] = 0 . 9764156119$ $q \left[7⁢9\right] = 0 . 9 ⁢ 7 ⁢ 9 ⁢ 4 ⁢ 1 ⁢ 3 ⁢ 9 ⁢ 6 ⁢ 4 ⁢ 0$ $q \left[8⁢0\right] = 0 . 9 ⁢ 8 ⁢ 2 ⁢ 1 ⁢ 8 ⁢ 2 ⁢ 7 ⁢ 6 ⁢ 9 ⁢ 2$ $q \left[8⁢1\right] = 0 . 9 ⁢ 8 ⁢ 4 ⁢ 7 ⁢ 3 ⁢ 15377$ $q \left[8⁢2\right] = 0 . 9 ⁢ 8 ⁢ 7 ⁢ 0 ⁢ 6 ⁢ 8 ⁢ 9 ⁢ 7 ⁢ 9 ⁢ 0$ $q \left[8⁢3\right] = 0 . 9 ⁢ 8 ⁢ 9 ⁢ 2 ⁢ 0 ⁢ 3 ⁢ 0 ⁢ 4 ⁢ 6 ⁢ 2$ $q \left[8⁢4\right] = 0 . 9 ⁢ 9 ⁢ 1 ⁢ 1 ⁢ 4 ⁢ 09728$ $q \left[8⁢5\right] = 0 . 9 ⁢ 9 ⁢ 2 ⁢ 8 ⁢ 8 ⁢ 9 ⁢ 3 ⁢ 0 ⁢ 6 ⁢ 7$ $q \left[8⁢6\right] = 0 . 9 ⁢ 9 ⁢ 4 ⁢ 4 ⁢ 5 ⁢ 3 ⁢ 9 ⁢ 3 ⁢ 9 ⁢ 5$ $q \left[8⁢7\right] = 0 . 9 ⁢ 9 ⁢ 5 ⁢ 8 ⁢ 4 ⁢ 0 ⁢ 1 ⁢ 3 ⁢ 1 ⁢ 8$ $q \left[8⁢8\right] = 0 . 9 ⁢ 9 ⁢ 7 ⁢ 0 ⁢ 5 ⁢ 2 ⁢ 5 ⁢ 3 ⁢ 5 ⁢ 2$ $q \left[8⁢9\right] = 0 . 9 ⁢ 9 ⁢ 8 ⁢ 0 ⁢ 9 ⁢ 5 ⁢ 2 ⁢ 1 ⁢ 18$ $q \left[9⁢0\right] = 0 . 9 ⁢ 9 ⁢ 8 ⁢ 9 ⁢ 7 ⁢ 1 ⁢ 6 ⁢ 5 ⁢ 0 ⁢ 4$ $q \left[9⁢1\right] = 0 . 9 ⁢ 9 ⁢ 9 ⁢ 6 ⁢ 8 ⁢ 4 ⁢ 7 ⁢ 8 ⁢ 0 ⁢ 6$ $q \left[9⁢2\right] = 1 . 0 ⁢ 0 ⁢ 0 ⁢ 2 ⁢ 3 ⁢ 6 ⁢ 9 ⁢ 8 ⁢ 3 ⁢ 7$ $q \left[9⁢3\right] = 1 . 0 ⁢ 006301028$ $q \left[9⁢4\right] = 1 . 0 ⁢ 0 ⁢ 0 ⁢ 8 ⁢ 654482$ $q \left[9⁢5\right] = 1.0009438063$ $q \left[9⁢6\right] = 1.0008654482$ $q \left[9⁢7\right] = 1.0006301028$ $q \left[9⁢8\right] = 1 . 0 ⁢ 0 ⁢ 0 ⁢ 2 ⁢ 3 ⁢ 6 ⁢ 9 ⁢ 837$ $q \left[9⁢9\right] = 0 . 9 ⁢ 9 ⁢ 9 ⁢ 6 ⁢ 8 ⁢ 4 ⁢ 7 ⁢ 8 ⁢ 0 ⁢ 6$ $q \left[100\right] = 0.9989716504$ $q \left[101\right] = 0.9980952118$ $q \left[102\right] = 0.9970525352$ $q \left[1⁢0⁢3\right] = 0.9958401318$ $q \left[1⁢0⁢4\right] = 0 . 9 ⁢ 9 ⁢ 4 ⁢ 4 ⁢ 5 ⁢ 3 ⁢ 9 ⁢ 395$ $q \left[1⁢0⁢5\right] = 0.9928893067$ $q \left[1⁢0⁢6\right] = 0.9911409728$ $q \left[1⁢0⁢7\right] = 0.9892030462$ $q \left[1⁢0⁢8\right] = 0 . 9 ⁢ 8 ⁢ 7 ⁢ 0 ⁢ 6 ⁢ 8 ⁢ 9 ⁢ 7 ⁢ 9 ⁢ 0$ $q \left[1⁢0⁢9\right] = 0 . 9 ⁢ 8 ⁢ 4 ⁢ 7 ⁢ 3 ⁢ 1 ⁢ 5 ⁢ 3 ⁢ 7 ⁢ 7$ $q \left[1⁢1⁢0\right] = 0 . 9 ⁢ 8 ⁢ 2 ⁢ 1 ⁢ 8 ⁢ 2 ⁢ 7 ⁢ 6 ⁢ 9 ⁢ 2$ $q \left[1⁢1⁢1\right] = 0 . 9 ⁢ 7 ⁢ 9 ⁢ 4 ⁢ 1 ⁢ 3 ⁢ 9 ⁢ 6 ⁢ 4 ⁢ 0$ $q \left[1⁢1⁢2\right] = 0 . 9 ⁢ 7 ⁢ 6 ⁢ 4 ⁢ 1 ⁢ 5 ⁢ 6 ⁢ 1 ⁢ 1 ⁢ 9$ $q \left[1⁢1⁢3\right] = 0.9 ⁢ 7 ⁢ 3 ⁢ 1 ⁢ 7 ⁢ 7 ⁢ 3 ⁢ 5 ⁢ 4 ⁢ 7$ $q \left[1⁢1⁢4\right] = 0 . 9 ⁢ 6 ⁢ 9 ⁢ 6 ⁢ 8 ⁢ 7 ⁢ 9 ⁢ 2 ⁢ 9 ⁢ 7$ $q \left[1⁢1⁢5\right] = 0.9659351065$ $q \left[116\right] = 0.9619056158$ $q \left[1⁢1⁢7\right] = 0.9575850672$ $q \left[1⁢1⁢8\right] = 0 . 9 ⁢ 5 ⁢ 2 ⁢ 9 ⁢ 5 ⁢ 7 ⁢ 8 ⁢ 5 ⁢ 6 ⁢ 6$ $q \left[1⁢1⁢9\right] = 0 . 9 ⁢ 4 ⁢ 8 ⁢ 0 ⁢ 0 ⁢ 7 ⁢ 0 ⁢ 6 ⁢ 0 ⁢ 6$ $q \left[1⁢2⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[121\right] = 0.9370596739$ $q \left[122\right] = 0.9310214581$ $q \left[1⁢2⁢3\right] = 0 . 9 ⁢ 2 ⁢ 4 ⁢ 5 ⁢ 7 ⁢ 6 ⁢ 0 ⁢ 6 ⁢ 8 ⁢ 3$ $q \left[1⁢2⁢4\right] = 0 . 9 ⁢ 1 ⁢ 7 ⁢ 6 ⁢ 9 ⁢ 7 ⁢ 7 ⁢ 8 ⁢ 2 ⁢ 5$ $q \left[1⁢2⁢5\right] = 0.9103585196$ $q \left[1⁢2⁢6\right] = 0.9025275713$ $q \left[1⁢2⁢7\right] = 0.8941712974$ $q \left[128\right] = 0.2911752349$ $q \left[129\right] = 0.2790029236$ $q \left[130\right] = 0.2671158700$ $q \left[131\right] = 0.2554979664$ $q \left[132\right] = 0.2441343742$ $q \left[1⁢3⁢3\right] = 0.2330113868$ $q \left[134\right] = 0.2221163080$ $q \left[135\right] = 0.2114373458$ $q \left[1⁢3⁢6\right] = 0.2009635191$ $q \left[1⁢3⁢7\right] = 0.1906845753$ $q \left[1⁢3⁢8\right] = 0.1805909194$ $q \left[1⁢3⁢9\right] = 0.1706735517$ $q \left[1⁢4⁢0\right] = 0.1609240126$ $q \left[1⁢4⁢1\right] = 0.1513343370$ $q \left[1⁢4⁢2\right] = 0.1418970123$ $q \left[143\right] = 0.1326049434$ $q \left[144\right] = 0.1234514222$ $q \left[145\right] = 0.1144301000$ $q \left[146\right] = 0.1055349658$ $q \left[147\right] = 0.0967603259$ $q \left[1⁢4⁢8\right] = 0 . 0 ⁢ 8 ⁢ 8 ⁢ 1 ⁢ 0 ⁢ 0 ⁢ 7 ⁢ 879$ $q \left[1⁢4⁢9\right] = 0 . 0 ⁢ 7 ⁢ 9 ⁢ 5 ⁢ 5 ⁢ 1 ⁢ 2 ⁢ 4 ⁢ 5 ⁢ 3$ $q \left[1⁢5⁢0\right] = 0 . 0 ⁢ 7 ⁢ 1 ⁢ 1 ⁢ 0 ⁢ 6 ⁢ 8 ⁢ 6 ⁢ 5 ⁢ 7$ $q \left[1⁢5⁢1\right] = 0 . 0 ⁢ 6 ⁢ 2 ⁢ 7 ⁢ 6 ⁢ 3 ⁢ 0 ⁢ 8 ⁢ 1 ⁢ 0$ $q \left[1⁢5⁢2\right] = 0 . 0 ⁢ 5 ⁢ 4 ⁢ 5 ⁢ 1 ⁢ 5 ⁢ 5 ⁢ 7 ⁢ 8 ⁢ 9$ $q \left[1⁢5⁢3\right] = 0.0463602959$ $q \left[1⁢5⁢4\right] = 0.0382934126$ $q \left[1⁢5⁢5\right] = 0.0303113495$ $q \left[1⁢5⁢6\right] = 0.0224107648$ $q \left[1⁢5⁢7\right] = 0.145885527$ $q \left[1⁢5⁢8\right] = 0 . 0 ⁢ 0 ⁢ 6 ⁢ 8 ⁢ 4 ⁢ 1 ⁢ 8 ⁢ 4 ⁢ 3 ⁢ 5$ $q \left[1⁢5⁢9\right] = - 0 . 0 ⁢ 0 ⁢ 0 ⁢ 8 ⁢ 3 ⁢ 1 ⁢ 9 ⁢ 956$ $q \left[1⁢6⁢0\right] = - 0.0084353584$ $q \left[1⁢6⁢1\right] = - 0.0159703957$ $q \left[1⁢6⁢2\right] = - 0.0234390115$ $q \left[1⁢6⁢3\right] = - 0 . 0 ⁢ 3 ⁢ 0 ⁢ 8 ⁢ 4 ⁢ 2 ⁢ 8 ⁢ 5 ⁢ 7 ⁢ 2$ $q \left[1⁢6⁢4\right] = - 0 . 0 ⁢ 3 ⁢ 8 ⁢ 1 ⁢ 8 ⁢ 3 ⁢ 3 ⁢ 2 ⁢ 4 ⁢ 9$ $q \left[165\right] = - 0 . 0457615388$ $q \left[166\right] = - 0 . 0526783466$ $q \left[167\right] = - 0 . 0598343081$ $q \left[1⁢6⁢8\right] = - 0 . 0 ⁢ 6 ⁢ 6 ⁢ 9 ⁢ 2 ⁢ 9 ⁢ 6 ⁢ 8 ⁢ 3 ⁢ 1$ $q \left[169\right] = - 0 . 0 ⁢ 7 ⁢ 3 ⁢ 9 ⁢ 6 ⁢ 4 ⁢ 4 ⁢ 1 ⁢ 7 ⁢ 4$ $q \left[1⁢7⁢0\right] = - 0 . 0 ⁢ 8 ⁢ 0 ⁢ 9 ⁢ 3 ⁢ 8 ⁢ 1 ⁢ 2 ⁢ 6 ⁢ 8$ $q \left[1⁢7⁢1\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[172\right] = - 0 . 0946991783$ $\begin{matrix}q \left[1⁢7⁢3\right] = - 0 . 1 ⁢ 0 ⁢ 1 ⁢ 4 ⁢ 8 ⁢ 3 ⁢ 9 ⁢ 3 ⁢ 4 ⁢ 1\end{matrix}$ $\begin{matrix}q \left[174\right] = - 0 . 1082024454\end{matrix}$ $\begin{matrix}q \left[175\right] = - 0 . 1148523686\end{matrix}$ $\begin{matrix}q \left[176\right] = - 0 . 1214308876\end{matrix}$ $\begin{matrix}q \left[177\right] = - 0 . 1279346790\end{matrix}$ $q \left[178\right] = - 0.1343598738$ $q \left[179\right] = - 0.1407020132$ $q \left[1⁢8⁢0\right] = - 0.1469560005$ $q \left[1⁢8⁢1\right] = - 0.1531160455$ $q \left[1⁢8⁢2\right] = - 0.1591756024$ $q \left[1⁢8⁢3\right] = - 0.1651273005$ $q \left[184\right] = - 0 . 1709628636$ $q \left[1⁢8⁢5\right] = - 0.1766730202$ $q \left[186\right] = - 0 . 1822474011$ $q \left[1⁢8⁢7\right] = - 0.1876744222$ $\begin{matrix}q \left[188\right] = - 0 . 1929411519\end{matrix}$ $\begin{matrix}q \left[189\right] = - 0 . 1980331588\end{matrix}$ $\begin{matrix}q \left[190\right] = - 0 . 2029343380\end{matrix}$ $\begin{matrix}q \left[191\right] = - 0 . 2076267137\end{matrix}$

13. Filter apparatus according to any of preceding, wherein the filter characteristic is based on an HRTF filter characteristic.

14. Filter apparatus according to any of the preceding claims, wherein the complex analysis filter bank **(101)** comprises a downsampler **(140)** for each subband signal output by the complex analysis filter bank **(101).**

15. Filter apparatus according to claim 14, wherein the complex analysis filter bank **(101)** is adapted to output *L* complex subband signals, wherein *L* is a positive integer greater than 1, and wherein each of the downsampler **(140)** is adapted to downsample the subband signals by a factor of *L*.

16. Filter apparatus according to any of the preceding claims, wherein the complex analysis filter bank **(101)** comprises a complex modulated filter for each complex subband signal based on a prototype filter.

17. Filter apparatus according to any of the preceding claims, wherein the complex synthesis filter bank **(103)** comprises an upsampler **(160)** for each of the subband signals.

18. Filter apparatus according to claim 17, wherein the complex synthesis filter bank **(103)** is operative to synthesize *L* signals of the intermediate filters to obtain the time domain output signal, wherein *L* is a positive integer greater than 1, wherein the complex synthesis filter bank **(103)** comprises *L* upsampler **(160)** and wherein each of the upsampler **(160)** is adapted for upsampling the output of the intermediate filters **(190)** by a factor of *L.*

19. Filter apparatus according to any of the preceding claims, wherein the complex synthesis filter bank **(103)** comprises for each subband signal an intermediate synthesis filter, wherein the complex synthesis filter bank **(103)** comprises a real part extractor **(180)** for each signal output by intermediate synthesis filters **(150),** and wherein the complex synthesis filter bank **(103)** further comprises an adder **(170)** for adding the output of each of a the real part extractor **(180)** to obtain the time domain output signal.

20. Filter apparatus according to any of the claims 1 to 18, wherein the complex synthesis filter bank **(103)** comprises an intermediate synthesis filter **(150)** for each of the subband signals output by the intermediate filters **(190),** wherein the complex synthesis filter bank **(103)** further comprises an adder **(170)** for summing up the ouputs of each intermediate synthesis filters **(150)** and wherein the complex synthesis filter bank **(103)** further comprises a real part extractor **(180)** for extracting a real valued signal as the time domain output signal from the output of the adder **(170).**

21. Filter apparatus according to any of the preceding claims, wherein the filter apparatus further comprises a gain adjuster for at least one subband signal or for at least one signal output by intermediate filter **(190)** for adjusting the gain.

22. Filtering apparatus according to any of the preceding claims, wherein the filtering apparatus further comprises a further intermediate filter for filtering at least one of the complex valued subband signals or for filtering at least one of the signals output by one of the intermediate filters **(190).**

23. Method for filtering a time domain input signal to obtain a time domain output signal, which is a representation of the time domain input signal filtered using a filter characteristic having a non-uniform amplitude/frequency characteristic,
comprising the steps:
filtering a finite impulse response signal comprising K_{H} · L filter taps and being indicative of the filter characteristic of the non-uniform amplitude/frequency characteristic based on a prototype filter comprising K_{Q} · L taps to obtain L complex valued subband signals as an intermediate filter definition signal,
wherein each complex valued subband signal of the intermediate filter definition signal corresponds to a filter impulse response for one subband comprising (K_{H} + K_{Q} - 1) filter taps;
wherein at least one of the complex valued subband signals of the intermediate filter definition signal comprises at least two different non-vanishing values; and
wherein at least one of the complex valued subband signals of the intermediate filter definition signal corresponds to a non-uniform amplitude/frequency characteristic;
analyzing the time domain input signal to obtain L complex subband signals;
filtering each of the analyzed complex subband signals,
wherein at least one of the complex subband signals is filtered using a non-uniform amplitude/frequency characteristic,
wherein each of the complex subband signals is filtered based on an filter impulse response of the filter definition signal;
wherein the filter impulse responses of the filter definition signal comprising (K_{H} + K_{Q} - 1) filter taps each are shorter than the impulse response of a filter having the filter characteristic comprising K_{H} · L taps; and
wherein the non-uniform amplitude/frequency characteristic of the impulse responses used for filtering the plurality of subband signals together represent the non-uniform filter characteristic; and
synthesizing from the output of the filtering of the analyzed complex subband signals the time domain output signal,
wherein L, K_{Q} and K_{H} are positive integers.

24. Computer program for performing, when running on a computer, a method in accordance with the method of claim 23.

## Patentansprüche

1. Filtervorrichtung zum Filtern eines Zeitbereichseingangssignals, um ein Zeitbereichsausgangssignal zu erhalten, das eine Darstellung des Zeitbereichseingangssignals ist, gefiltert unter Verwendung einer Filtercharakteristik mit einer nicht einheitlichen Amplituden/Frequenz-Charakteristik, die folgende Merkmale aufweist:
eine komplexe Analysefilterbank (101) zum Erzeugen L komplexer Teilbandsignale aus dem Zeitbereichseingangssignal;
eine Mehrzahl von Zwischenfiltern (190), wobei jedes Zwischenfilter (190) eine finite Impulsantwort aufweist, die (K_{H} + K_{Q} - 1) Filterabgriffe aufweist, wobei ein Zwischenfilter für jedes komplexe Teilbandsignal vorgesehen ist;
eine komplexe Synthesefilterbank (103) zum Synthetisieren der Ausgabe der Zwischenfilter (190), um das Zeitbereichsausgangssignal zu erhalten,
einen Filterabgriffgenerator (104), der eine komplex modulierte Filterbank (301) aufweist, basierend auf einem Prototyp-Filter, das K_{Q} · L Abgriffe aufweist zum Filtern eines finiten Impulsantwortsignals, das anzeigend für die Amplituden/Frequenz-Filtercharakteristik in dem Zeitbereich ist und K_{H} · L Filterabgriffe aufweist, um L komplexwertige Teilbandsignale als ein Zwischenfilterdefinitionssignal zu erhalten,
wobei jedes komplexwertige Teilbandsignal der komplex modulierten Filterbank des Filterabgriffgenerators einer Impulsantwort für ein Zwischenfilter (190) entspricht, das (K_{H} + K_{Q} - 1) Filterabgriffe aufweist;
wobei zumindest eines der komplexwertigen Teilbandsignale der komplex modulierten Filterbank des Filterabgriffgenerators zumindest zwei unterschiedliche nicht-verschwindende Werte aufweist;
wobei jedes komplexwertige Teilbandsignal der modulierten Filterbank des Filterabgriffgenerators, das (K_{H} + K_{Q} - 1) Filterabgriffe aufweist, kürzer ist als das Impulsantwortsignal, das K_{H} · L Filterabgriffe aufweist, die zu dem Filterabgriffgenerator geliefert werden;
wobei die Mehrzahl der Zwischenfilter wirksam ist, um das Zwischenfilterdefinitionssignal von dem Filterabgriffgenerator (104) zu empfangen;
wobei jedes Zwischenfilter (190) der Mehrzahl der Zwischenfilter wirksam ist, um eine Impulsantwort abhängig von dem Zwischenfilterdefinitionssignal zu haben;
wobei zumindest eines der Zwischenfilter (190) der Mehrzahl der Zwischenfilter (190) eine nichteinheitliche Amplituden/Frequenz-Charakteristik aufweist;
wobei die nichteinheitlichen Amplituden/Frequenz-Charakteristika der Mehrzahl der Zwischenfilter zusammen die nichteinheitliche Filtercharakteristik darstellen; und
wobei L, K_{Q} und K_{H} positive ganze Zahlen sind.

2. Filtervorrichtung gemäß Anspruch 1, bei der zumindest eines der Zwischenfilter (190) eine Tiefpassfiltercharakteristik, eine Hochpassfiltercharakteristik, eine Bandpassfiltercharakteristik, eine Bandsperrfiltercharakteristik oder eine Kerbfiltercharakteristik aufweist.

3. Filtervorrichtung gemäß einem der vorangehenden Ansprüche, bei der die Zwischenfilter (190) der Mehrzahl der Zwischenfilter (190) Finite-Impulsantwort-Filter sind.

4. Filtervorrichtung gemäß einem der vorangehenden Ansprüche, bei der die Mehrzahl der Zwischenfilter (190) ferner wirksam ist, um das Zwischenfilterdefinitionssignal von einer Datenbank (500) oder von einem Prozessor (510) zu empfangen.

5. Filtervorrichtung gemäß einem der vorangehenden Ansprüche, bei der die komplexe Analysefilterbank (101) wirksam ist, um L komplexe Teilbandsignale auszugeben, wobei die Mehrzahl der Zwischenfilter (190) L Zwischenfilter (190) aufweist, wobei die komplexe Synthesefilterbank (103) wirksam ist, um die Ausgabe der L Zwischenfilter (190) zu synthetisieren, und wobei L eine positive ganze Zahl größer als 1 ist.

6. Filtervorrichtung gemäß Anspruch 5, bei der die komplexe Analysefilterbank (101), die Mehrzahl der Zwischenfilter (190) und die komplexe Synthesefilterbank (103) wirksam ist, um L = 64 aufzuweisen.

7. Filtervorrichtung gemäß einem der Ansprüche 5 oder 6, bei der die Mehrzahl der Zwischenfilter (190) wirksam ist, um die komplexen Teilbandsignale zu filtern, basierend auf der Gleichung ${d}_{n} \left(k\right) = {\sum }_{l} {g}_{n} \left(l\right) {c}_{n} ⁢ \left(k-l\right)$ wobei n eine ganze Zahl im Bereich von 0 bis (L-1) ist, was einen Index der Teilbandsignale anzeigt, wobei L und *k* ganze Zahlen sind, wobei dₙ(k) die Ausgabe des Zwischenfilters (190) des Teilbandsignals mit dem Index n ist, wobei cₙ(k) das Teilbandsignal mit dem Index n ist, und wobei gₙ(l) die Impulsantwort des Zwischenfilters (190) für das Teilbandsignal mit dem Index n ist.

8. Filtervorrichtung gemäß einem der Ansprüche 5 bis 7, bei der das Zwischenfilter (190) mit einem Index n eine Impulsantwort gₙ(k) aufweist, die auf der folgenden Gleichung basiert: ${g}_{n} \left(k\right) = {\sum }_{ν = - ∞}^{∞} h ⁢ \left(ν+k⁢L\right) ⁢ q \left(ν\right) ⁢ exp \left(-i⁢\frac{π}{L}⁢\left(n+\frac{1}{2}\right)⁢ν\right)$ wobei n eine ganze Zahl im Bereich von 0 bis (L-1) ist, was den Index des Teilbandsignals anzeigt, wobei k und v ganze Zahlen sind, wobei h (v) die Antwort eines Filters mit der Filtercharakteristik ist, wobei π = 3.1415926... die Kreiszahl ist, wobei $i = \sqrt{- 1}$ die komplexe Einheit ist, und wobei q (v) Filterabgriffe eines echtwertigen Prototypfilters sind.

9. Filtervorrichtung gemäß einem der Ansprüche 5 bis 8, bei der zumindest eines der Zwischenfilter (190) mit einem Index n eine Impulsantwort gₙ(k) aufweist, die auf folgender Gleichung basiert ${g}_{n} \left(1\right) = {\sum }_{v = 0}^{1 ⁢ 9 ⁢ 1} {h}^{} ⁢ \left(υ+6⁢4⋅\left(1-2\right)\right) ⋅ q \left(υ\right) ⋅ exp \left(-i⁢\frac{π}{6 ⁢ 4}⁢\left(n+\frac{1}{2}\right)⁢\left(υ-9⁢5\right)\right)$ wobei ${h}^{} \left(υ\right) = { \begin{matrix}h \left(υ\right) & , υ = 0 , 1 , … , {N}_{h} - 1 , \\ 0 & , ansonsten\end{matrix}$ wobei Nₕ die Länge der Impulsantwort h(v) eines Filters mit der Filtercharakteristik ist, wobei π = 3.1415926... die Kreiszahl ist, wobei $i = \sqrt{- 1}$ die komplexe Einheit ist, und wobei q(v) Filterabgriffe eines echtwertigen Prototypfilters sind.

10. Filtervorrichtung gemäß einem der Ansprüche 8 oder 9, bei der die Zwischenfilter (190) angepasst sind, so dass die Prototypfilterabgriffe q(v) für die ganzen Zahlen v von 0 bis 191 folgende Gleichungen erfüllen:$- 0 . 2 ⁢ 0 ⁢ 4 \leq q \left[0\right] \leq - 0 . 2 ⁢ 0 ⁢ 2$ $- 0 . 1 ⁢ 9 ⁢ 9 \leq q \left[1\right] \leq - 0 . 1 ⁢ 9 ⁢ 7$ $- 0 . 1 ⁢ 9 ⁢ 4 \leq q \left[2\right] \leq - 0 . 1 ⁢ 9 ⁢ 2$ $- 0 . 189 \leq q \left[3\right] \leq - 0 . 1 ⁢ 8 ⁢ 7$ $- 0 . 1 ⁢ 8 ⁢ 3 \leq q \left[4\right] \leq - 0 . 1 ⁢ 8 ⁢ 1$ $- 0.1 ⁢ 7 ⁢ 8 \leq q \left[5\right] \leq - 0.1 ⁢ 7 ⁢ 6$ $- 0 . 1 ⁢ 7 ⁢ 2 \leq q \left[6\right] ⌉ \leq - 0 . 1 ⁢ 7 ⁢ 0$ $- 0 . 1 ⁢ 6 ⁢ 6 \leq q \left[7\right] \leq - 0 . 1 ⁢ 6 ⁢ 4$ $- 0 . 1 ⁢ 6 ⁢ 0 \leq q \left[8\right] \leq - 0 . 1 ⁢ 5 ⁢ 8$ $- 0 . 1 ⁢ 5 ⁢ 4 \leq q \left[9\right] \leq - 0 . 1 ⁢ 5 ⁢ 2$ $- 0 . 1 ⁢ 4 ⁢ 8 \leq q \left[1⁢0\right] \leq - 0 . 1 ⁢ 4 ⁢ 6$ $- 0 . 1 ⁢ 4 ⁢ 2 \leq q \left[1⁢1\right] \leq - 0 . 1 ⁢ 4 ⁢ 0$ $- 0 . 1 ⁢ 3 ⁢ 5 \leq q \left[1⁢2\right] \leq - 0 . 1 ⁢ 3 ⁢ 3$ $- 0 . 1 ⁢ 2 ⁢ 9 \leq q \left[1⁢3\right] \leq - 0 . 1 ⁢ 2 ⁢ 7$ $- 0 . 1 ⁢ 2 ⁢ 2 \leq q \left[1⁢4\right] \leq - 0 . 1 ⁢ 2 ⁢ 0$ $- 0 . 1 ⁢ 1 ⁢ 6 \leq q \left[1⁢5\right] \leq - 0 . 1 ⁢ 1 ⁢ 4$ $- 0 . 1 ⁢ 0 ⁢ 9 \leq q \left[1⁢6\right] \leq - 0 . 1 ⁢ 0 ⁢ 7$ $- 0 . 1 ⁢ 0 ⁢ 2 \leq q \left[1⁢7\right] \leq - 0 . 1 ⁢ 0 ⁢ 0$ $- 0 . 0 ⁢ 9 ⁢ 6 \leq q \left[1⁢8\right] \leq - 0. ⁢ 0 ⁢ 9 ⁢ 4$ $- 0 . 089 \leq q \left[1⁢9\right] \leq - 0 . 0 ⁢ 8 ⁢ 7$ $- 0 . 0 ⁢ 8 ⁢ 2 \leq q \left[2⁢0\right] \leq - 0. ⁢ 0 ⁢ 8 ⁢ 0$ $- 0.0 ⁢ 7 ⁢ 5 \leq q \left[2⁢1\right] \leq - 0.0 ⁢ 7 ⁢ 3$ $- 0.0 ⁢ 6 ⁢ 8 \leq q \left[2⁢2\right] \leq - 0. ⁢ 0 ⁢ 6 ⁢ 6$ $- 0.0 ⁢ 6 ⁢ 1 \leq q \left[2⁢3\right] \leq - 0.0 ⁢ 5 ⁢ 9$ $- 0.0 ⁢ 5 ⁢ 4 \leq q \left[2⁢4\right] \leq - 0. ⁢ 0 ⁢ 5 ⁢ 2$ $- 0 . 0 ⁢ 4 ⁢ 6 \leq q \left[2⁢5\right] \leq - 0 . 0 ⁢ 4 ⁢ 4$ $- 0 . 0 ⁢ 3 ⁢ 9 \leq q \left[2⁢6\right] \leq - 0. ⁢ 0 ⁢ 3 ⁢ 7$ $- 0 . 0 ⁢ 3 ⁢ 2 \leq q \left[2⁢7\right] \leq - 0 . 0 ⁢ 3 ⁢ 0$ $- 0 . 0 ⁢ 2 ⁢ 4 \leq q \left[2⁢8\right] \leq - 0 . 0 ⁢ 2 ⁢ 2$ $- 0 . 0 ⁢ 1 ⁢ 7 \leq q \left[2⁢9\right] \leq - 0. ⁢ 0 ⁢ 1 ⁢ 5$ $- 0.0 ⁢ 0 ⁢ 9 \leq q \left[3⁢0\right] \leq - 0.0 ⁢ 0 ⁢ 7$ $- 0.0 ⁢ 0 ⁢ 2 \leq q \left[3⁢1\right] \leq 0.0 ⁢ 0 ⁢ 0$ $0. ⁢ 0 ⁢ 0 ⁢ 6 \leq q \left[3⁢2\right] \leq 0.0 ⁢ 0 ⁢ 8$ $0. ⁢ 0 ⁢ 1 ⁢ 4 \leq q \left[3⁢3\right] \leq 0.0 ⁢ 1 ⁢ 6$ $0.0 ⁢ 2 ⁢ 1 \leq q \left[3⁢4\right] \leq 0.0 ⁢ 2 ⁢ 3$ $0. ⁢ 0 ⁢ 2 ⁢ 9 \leq q \left[3⁢5\right] \leq 0.0 ⁢ 3 ⁢ 1$ $0 . 0 ⁢ 3 ⁢ 7 \leq q \left[3⁢6\right] \leq 0 . 0 ⁢ 3 ⁢ 9$ $0. ⁢ 0 ⁢ 4 ⁢ 5 \leq q \left[3⁢7\right] \leq 0. ⁢ 0 ⁢ 4 ⁢ 7$ $0. ⁢ 0 ⁢ 5 ⁢ 4 \leq q \left[3⁢8\right] \leq 0.0 ⁢ 5 ⁢ 6$ $0.0 ⁢ 6 ⁢ 2 \leq q \left[3⁢9\right] \leq 0.0 ⁢ 6 ⁢ 4$ $0. ⁢ 0 ⁢ 7 ⁢ 0 \leq q \left[4⁢0\right] \leq 0 . 0 ⁢ 7 ⁢ 2$ $0. ⁢ 0 ⁢ 7 ⁢ 9 \leq q \left[4⁢1\right] \leq 0. ⁢ 0 ⁢ 8 ⁢ 1$ $0. ⁢ 0 ⁢ 8 ⁢ 7 \leq q \left[4⁢2\right] \leq 0 . 0 ⁢ 8 ⁢ 9$ $0 . 0 ⁢ 9 ⁢ 6 \leq q \left[4⁢3\right] \leq 0 . 0 ⁢ 9 ⁢ 8$ $0 . 1 ⁢ 0 ⁢ 5 \leq q \left[4⁢4\right] \leq 0 . 1 ⁢ 0 ⁢ 7$ $0.1 ⁢ 1 ⁢ 3 \leq q \left[4⁢5\right] \leq 0.1 ⁢ 1 ⁢ 5$ $0.1 ⁢ 2 ⁢ 2 \leq q \left[4⁢6\right] \leq 0.1 ⁢ 2 ⁢ 4$ $0.1 ⁢ 3 ⁢ 2 \leq q \left[4⁢7\right] \leq 0.1 ⁢ 3 ⁢ 4$ $0.1 ⁢ 4 ⁢ 1 \leq q \left[4⁢8\right] \leq 0.1 ⁢ 4 ⁢ 3$ $0.1 ⁢ 5 ⁢ 0 \leq q \left[4⁢9\right] \leq 0.1 ⁢ 5 ⁢ 2$ $0.1 ⁢ 6 ⁢ 0 \leq q \left[5⁢0\right] \leq 0.1 ⁢ 6 ⁢ 2$ $0 . 1 ⁢ 7 ⁢ 0 \leq q \left[5⁢1\right] \leq 0 . 1 ⁢ 7 ⁢ 2$ $0 . 1 ⁢ 8 ⁢ 0 \leq q \left[5⁢2\right] \leq 0 . 1 ⁢ 8 ⁢ 2$ $0 . 1 ⁢ 9 ⁢ 0 \leq q \left[5⁢3\right] \leq 0 . 1 ⁢ 9 ⁢ 2$ $0 . 2 ⁢ 0 ⁢ 0 \leq q \left[5⁢4\right] \leq 0 . 2 ⁢ 0 ⁢ 2$ $0. ⁢ 2 ⁢ 1 ⁢ 0 \leq q \left[5⁢5\right] \leq 0 . 2 ⁢ 1 ⁢ 2$ $0. ⁢ 2 ⁢ 2 ⁢ 1 \leq q \left[5⁢6\right] \leq 0 . 2 ⁢ 2 ⁢ 3$ $0. ⁢ 2 ⁢ 3 ⁢ 2 \leq q \left[5⁢7\right] \leq 0. ⁢ 2 ⁢ 3 ⁢ 4$ $0. ⁢ 2 ⁢ 4 ⁢ 3 \leq q \left[5⁢8\right] \leq 0 . 2 ⁢ 4 ⁢ 5$ $0. ⁢ 2 ⁢ 5 ⁢ 4 \leq q \left[5⁢9\right] \leq 0. ⁢ 2 ⁢ 5 ⁢ 6$ $0 . 2 ⁢ 6 ⁢ 6 \leq q \left[6⁢0\right] \leq 0 . 2 ⁢ 6 ⁢ 8$ $0 . 2 ⁢ 7 ⁢ 8 \leq q \left[6⁢1\right] \leq 0 . 2 ⁢ 8 ⁢ 0$ $0. ⁢ 2 ⁢ 9 ⁢ 0 \leq q \left[6⁢2\right] \leq 0. ⁢ 2 ⁢ 9 ⁢ 2$ $0.303 \leq q \left[63\right] \leq 0.305$ $0 . 9 ⁢ 0 ⁢ 2 \leq q \left[6⁢4\right] \leq 0 . 9 ⁢ 0 ⁢ 4$ $0.9 ⁢ 0 ⁢ 9 \leq q \left[6⁢5\right] \leq 0.9 ⁢ 1 ⁢ 1$ $0.9 ⁢ 1 ⁢ 7 \leq q \left[6⁢6\right] \leq 0.9 ⁢ 1 ⁢ 9$ $0.9 ⁢ 2 ⁢ 4 \leq q \left[6⁢7\right] \leq 0.9 ⁢ 2 ⁢ 6$ $0. ⁢ 9 ⁢ 3 ⁢ 0 \leq q \left[68\right] \leq 0.9 ⁢ 3 ⁢ 2$ $0.9 ⁢ 3 ⁢ 6 \leq q \left[6⁢9\right] \leq 0.9 ⁢ 3 ⁢ 8$ $0.9 ⁢ 4 ⁢ 2 \leq q \left[7⁢0\right] \leq 0 . 9 ⁢ 4 ⁢ 4$ $0. ⁢ 9 ⁢ 4 ⁢ 7 \leq q \left[7⁢1\right] \leq 0. ⁢ 9 ⁢ 4 ⁢ 9$ $0 . 9 ⁢ 5 ⁢ 2 \leq q \left[7⁢2\right] \leq 0. ⁢ 9 ⁢ 5 ⁢ 4$ $0 . 9 ⁢ 5 ⁢ 7 \leq q \left[7⁢3\right] \leq 0. ⁢ 9 ⁢ 5 ⁢ 9$ $0 . 9 ⁢ 6 ⁢ 1 \leq q \left[7⁢4\right] \leq 0 . 9 ⁢ 6 ⁢ 3$ $0 . 9 ⁢ 6 ⁢ 5 \leq q \left[7⁢5\right] \leq 0 . 9 ⁢ 6 ⁢ 7$ $0 . 9 ⁢ 6 ⁢ 9 \leq q \left[7⁢6\right] \leq 0 . 9 ⁢ 7 ⁢ 1$ $0 . 9 ⁢ 7 ⁢ 2 \leq q \left[7⁢7\right] \leq 0 . 9 ⁢ 7 ⁢ 4$ $0 . 9 ⁢ 7 ⁢ 5 \leq q \left[7⁢8\right] \leq 0 . 9 ⁢ 7 ⁢ 7$ $0 . 978 \leq q \left[7⁢9\right] \leq 0. ⁢ 9 ⁢ 8 ⁢ 0$ $0. ⁢ 9 ⁢ 8 ⁢ 1 \leq q \left[8⁢0\right] \leq 0. ⁢ 9 ⁢ 8 ⁢ 3$ $0 . 9 ⁢ 8 ⁢ 4 \leq q \left[8⁢1\right] \leq 0. ⁢ 9 ⁢ 8 ⁢ 6$ $0 . 9 ⁢ 8 ⁢ 6 \leq q \left[8⁢2\right] \leq 0.9 ⁢ 8 ⁢ 8$ $0.9 ⁢ 8 ⁢ 8 \leq q \left[83\right] \leq 0.9 ⁢ 9 ⁢ 0$ $0.9 ⁢ 9 ⁢ 0 \leq q \left[84\right] \leq 0.9 ⁢ 9 ⁢ 2$ $0 . 9 ⁢ 9 ⁢ 2 \leq q \left[85\right] \leq 0 . 9 ⁢ 9 ⁢ 4$ $0 . 9 ⁢ 9 ⁢ 3 \leq q \left[8⁢6\right] \leq 0 . 9 ⁢ 9 ⁢ 5$ $0 . 9 ⁢ 9 ⁢ 5 \leq q \left[8⁢7\right] \leq 0. ⁢ 9 ⁢ 9 ⁢ 7$ $0 . 9 ⁢ 9 ⁢ 6 \leq q \left[8⁢8\right] \leq 0 . 9 ⁢ 9 ⁢ 8$ $0 . 9 ⁢ 9 ⁢ 7 \leq q \left[8⁢9\right] \leq 0 . 9 ⁢ 9 ⁢ 9$ $0 . 998 \leq q \left[9⁢0\right] \leq 1. ⁢ 0 ⁢ 0 ⁢ 0$ $0 . 9 ⁢ 9 ⁢ 9 \leq q \left[9⁢1\right] \leq 1. ⁢ 0 ⁢ 0 ⁢ 1$ $0 . 9 ⁢ 9 ⁢ 9 \leq q \left[9⁢2\right] \leq 1. ⁢ 0 ⁢ 0 ⁢ 1$ $1. ⁢ 0 ⁢ 0 ⁢ 0 \leq q \left[9⁢3\right] \leq 1. ⁢ 0 ⁢ 0 ⁢ 2$ $1. ⁢ 0 ⁢ 0 ⁢ 0 \leq q \left[9⁢4\right] \leq 1. ⁢ 0 ⁢ 0 ⁢ 2$ $1. ⁢ 0 ⁢ 0 ⁢ 0 \leq q \left[9⁢5\right] \leq 1. ⁢ 0 ⁢ 0 ⁢ 2$ $1. ⁢ 0 ⁢ 0 ⁢ 0 \leq q \left[9⁢6\right] \leq 1. ⁢ 0 ⁢ 0 ⁢ 2$ $1. ⁢ 0 ⁢ 0 ⁢ 0 \leq q \left[9⁢7\right] \leq 1. ⁢ 0 ⁢ 0 ⁢ 2$ $0 . 9 ⁢ 9 ⁢ 9 \leq q \left[9⁢8\right] \leq 1. ⁢ 0 ⁢ 0 ⁢ 1$ $0 . 9 ⁢ 9 ⁢ 9 \leq q \left[9⁢9\right] \leq 1. ⁢ 0 ⁢ 0 ⁢ 1$ $0 . 998 \leq q \left[1⁢0⁢0\right] \leq 1. ⁢ 0 ⁢ 0 ⁢ 0$ $0.9 ⁢ 9 ⁢ 7 \leq q \left[1⁢0⁢1\right] \leq 0.9 ⁢ 9 ⁢ 9$ $0 . 9 ⁢ 9 ⁢ 6 \leq q \left[1⁢0⁢2\right] \leq 0 . 9 ⁢ 9 ⁢ 8$ $0 . 9 ⁢ 9 ⁢ 5 \leq q \left[1⁢0⁢3\right] \leq 0 . 9 ⁢ 9 ⁢ 7$ $0 . 9 ⁢ 9 ⁢ 3 \leq q \left[1⁢0⁢4\right] \leq 0 . 9 ⁢ 9 ⁢ 5$ $0 . 9 ⁢ 9 ⁢ 2 \leq q \left[1⁢0⁢5\right] \leq 0 . 9 ⁢ 9 ⁢ 4$ $0. ⁢ 9 ⁢ 9 ⁢ 0 \leq q \left[1⁢0⁢6\right] \leq 0 . 9 ⁢ 9 ⁢ 2$ $0. ⁢ 9 ⁢ 8 ⁢ 8 \leq q \left[1⁢0⁢7\right] \leq 0 . 9 ⁢ 9 ⁢ 0$ $0 . 9 ⁢ 8 ⁢ 6 \leq q \left[1⁢0⁢8\right] \leq 0 . 9 ⁢ 8 ⁢ 8$ $0 . 984 \leq q \left[1⁢0⁢9\right] \leq 0 . 9 ⁢ 8 ⁢ 6$ $0 . 981 \leq q \left[1⁢1⁢0\right] \leq 0. ⁢ 9 ⁢ 8 ⁢ 3$ $0 . 978 \leq q \left[1⁢1⁢1\right] \leq 0 . 9 ⁢ 8 ⁢ 0$ $0 . 9 ⁢ 7 ⁢ 5 \leq q \left[1⁢1⁢2\right] \leq 0 . 9 ⁢ 7 ⁢ 7$ $0 . 9 ⁢ 7 ⁢ 2 \leq \left[113\right] \leq 0 . 9 ⁢ 7 ⁢ 4$ $0 . 9 ⁢ 6 ⁢ 9 \leq q \left[1⁢1⁢4\right] \leq 0 . 9 ⁢ 7 ⁢ 1$ $0. ⁢ 9 ⁢ 6 ⁢ 5 \leq q \left[1⁢1⁢5\right] \leq 0 . 9 ⁢ 6 ⁢ 7$ $0 . 9 ⁢ 6 ⁢ 1 \leq q \left[1⁢1⁢6\right] \leq 0 . 9 ⁢ 6 ⁢ 3$ $0 . 9 ⁢ 5 ⁢ 7 \leq q \left[1⁢1⁢7\right] \leq 0 . 9 ⁢ 5 ⁢ 9$ $0 . 9 ⁢ 5 ⁢ 2 \leq q \left[1⁢1⁢8\right] \leq 0. ⁢ 9 ⁢ 5 ⁢ 4$ $0. ⁢ 9 ⁢ 4 ⁢ 7 \leq q \left[1⁢1⁢9\right] \leq 0 . 9 ⁢ 4 ⁢ 9$ $0 . 9 ⁢ 4 ⁢ 2 \leq q \left[1⁢2⁢0\right] \leq 0 . 9 ⁢ 4 ⁢ 4$ $0 . 9 ⁢ 3 ⁢ 6 \leq q \left[121\right] \leq 0 . 9 ⁢ 3 ⁢ 8$ $0 . 9 ⁢ 3 ⁢ 0 \leq q \left[1⁢2⁢2\right] \leq 0 . 9 ⁢ 3 ⁢ 2$ $0 . 9 ⁢ 2 ⁢ 4 \leq q \left[1⁢23\right] \leq 0 . 9 ⁢ 2 ⁢ 6$ $0 . 9 ⁢ 1 ⁢ 7 \leq q \left[1⁢24\right] \leq 0 . 9 ⁢ 1 ⁢ 9$ $0 . 9 ⁢ 0 ⁢ 9 \leq q \left[1⁢2⁢5\right] \leq 0. ⁢ 9 ⁢ 1 ⁢ 1$ $0 . 9 ⁢ 0 ⁢ 2 \leq q \left[1⁢2⁢6\right] \leq 0 . 9 ⁢ 0 ⁢ 4$ $0 . 8 ⁢ 9 ⁢ 3 \leq q \left[1⁢2⁢7\right] \leq 0 . 8 ⁢ 9 ⁢ 5$ $0. ⁢ 2 ⁢ 9 ⁢ 0 \leq q \left[1⁢2⁢8\right] \leq 0 . 2 ⁢ 9 ⁢ 2$ $0 . 2 ⁢ 7 ⁢ 8 \leq q \left[1⁢2⁢9\right] \leq 0 . 2 ⁢ 8 ⁢ 0$ $0 . 2 ⁢ 6 ⁢ 6 \leq q \left[1⁢3⁢0\right] \leq 0. ⁢ 2 ⁢ 6 ⁢ 8$ $0. ⁢ 2 ⁢ 5 ⁢ 4 \leq q \left[1⁢3⁢1\right] \leq 0. ⁢ 2 ⁢ 5 ⁢ 6$ $0 . 2 ⁢ 4 ⁢ 3 \leq q \left[1⁢3⁢2\right] \leq 0 . 2 ⁢ 4 ⁢ 5$ $0. ⁢ 2 ⁢ 3 ⁢ 2 \leq q \left[1⁢3⁢3\right] \leq 0 . 2 ⁢ 3 ⁢ 4$ $0 . 2 ⁢ 2 ⁢ 1 \leq q \left[1⁢3⁢4\right] \leq 0. ⁢ 2 ⁢ 2 ⁢ 3$ $0. ⁢ 2 ⁢ 1 ⁢ 0 \leq q \left[1⁢3⁢5\right] \leq 0 . 2 ⁢ 1 ⁢ 2$ $0 . 2 ⁢ 0 ⁢ 0 \leq q \left[1⁢3⁢6\right] \leq 0. ⁢ 2 ⁢ 0 ⁢ 2$ $0 . 1 ⁢ 9 ⁢ 0 \leq q \left[1⁢3⁢7\right] \leq 0 . 1 ⁢ 9 ⁢ 2$ $0 . 180 \leq q \left[138\right] \leq 0 . 1 ⁢ 8 ⁢ 2$ $0 . 1 ⁢ 7 ⁢ 0 \leq q \left[1⁢3⁢9\right] \leq 0 . 1 ⁢ 7 ⁢ 2$ $0 . 1 ⁢ 6 ⁢ 0 \leq q \left[1⁢4⁢0\right] \leq 0 . 1 ⁢ 6 ⁢ 2$ $0 . 1 ⁢ 5 ⁢ 0 \leq q \left[1⁢4⁢1\right] \leq 0 . 1 ⁢ 5 ⁢ 2$ $0 . 1 ⁢ 4 ⁢ 1 \leq q \left[1⁢4⁢2\right] \leq 0 . 1 ⁢ 4 ⁢ 3$ $0 . 1 ⁢ 3 ⁢ 2 \leq q \left[1⁢4⁢3\right] \leq 0 . 1 ⁢ 3 ⁢ 4$ $0 . 1 ⁢ 2 ⁢ 2 \leq q \left[1⁢44\right] \leq 0 . 1 ⁢ 2 ⁢ 4$ $0. ⁢ 1 ⁢ 1 ⁢ 3 \leq q \left[145\right] \leq 0 . 1 ⁢ 1 ⁢ 5$ $0. ⁢ 1 ⁢ 0 ⁢ 5 \leq q \left[146\right] \leq 0 . 1 ⁢ 0 ⁢ 7$ $0. ⁢ 0 ⁢ 9 ⁢ 6 \leq q \left[1⁢4⁢7\right] \leq 0 . 0 ⁢ 9 ⁢ 8$ $0 . 087 \leq q \left[1⁢4⁢8\right] \leq 0 . 0 ⁢ 8 ⁢ 9$ $0 . 0 ⁢ 7 ⁢ 9 \leq \left[149\right] \leq 0 . 0 ⁢ 8 ⁢ 1$ $0 . 0 ⁢ 7 ⁢ 0 \leq q \left[1⁢50\right] \leq 0. ⁢ 0 ⁢ 7 ⁢ 2$ $0. ⁢ 0 ⁢ 6 ⁢ 2 \leq q \left[1⁢51\right] \leq 0 . 0 ⁢ 6 ⁢ 4$ $0.054 \leq q \left[152\right] \leq 0 . 0 ⁢ 5 ⁢ 6$ $0 . 0 ⁢ 4 ⁢ 5 \leq q \left[153\right] \leq 0 . 0 ⁢ 4 ⁢ 7$ $0 . 0 ⁢ 3 ⁢ 7 \leq q \left[1⁢54\right] \leq 0 . 0 ⁢ 3 ⁢ 9$ $0.029 \leq q \left[155\right] \leq 0 . 0 ⁢ 3 ⁢ 1$ $0 . 0 ⁢ 2 ⁢ 1 \leq q \left[1⁢5⁢6\right] \leq 0 . 0 ⁢ 2 ⁢ 3$ $0.014 \leq q \left[157\right] \leq 0. ⁢ 0 ⁢ 1 ⁢ 6$ $0. ⁢ 0 ⁢ 0 ⁢ 6 \leq q \left[158\right] \leq 0 . 0 ⁢ 0 ⁢ 8$ $- 0 . 0 ⁢ 0 ⁢ 2 \leq q \left[1⁢5⁢9\right] \leq 0 . 0 ⁢ 0 ⁢ 0$ $- 0 . 0 ⁢ 0 ⁢ 9 \leq q \left[1⁢6⁢0\right] \leq - 0 . 0 ⁢ 0 ⁢ 7$ $- 0 . 0 ⁢ 1 ⁢ 7 \leq q \left[1⁢6⁢1\right] \leq - 0. ⁢ 0 ⁢ 1 ⁢ 5$ $- 0 . 0 ⁢ 2 ⁢ 4 \leq q \left[1⁢6⁢2\right] \leq - 0 . 0 ⁢ 2 ⁢ 2$ $- 0 . 0 ⁢ 3 ⁢ 2 \leq q \left[163\right] \leq - 0. ⁢ 0 ⁢ 3 ⁢ 0$ $- 0 . 0 ⁢ 3 ⁢ 9 \leq q \left[164\right] \leq - 0 . 0 ⁢ 3 ⁢ 7$ $- 0 . 0 ⁢ 4 ⁢ 6 \leq q \left[165\right] \leq - 0 . 0 ⁢ 4 ⁢ 4$ $- 0. ⁢ 0 ⁢ 5 ⁢ 4 \leq 0 \left[166\right] \leq - 0.0 ⁢ 5 ⁢ 2$ $- 0 . 0 ⁢ 6 ⁢ 1 \leq q \left[1⁢6⁢7\right] \leq - 0 . 0 ⁢ 5 ⁢ 9$ $- 0 . 0 ⁢ 6 ⁢ 8 \leq q \left[1⁢6⁢8\right] \leq - 0 . 0 ⁢ 6 ⁢ 6$ $- 0. ⁢ 0 ⁢ 7 ⁢ 5 \leq q \left[1⁢6⁢9\right] \leq - 0 . 0 ⁢ 7 ⁢ 3$ $- 0. ⁢ 0 ⁢ 8 ⁢ 2 \leq q \left[1⁢70\right] \leq - 0 . 0 ⁢ 8 ⁢ 0$ $- 0 . 0 ⁢ 8 ⁢ 9 \leq q \left[1⁢71\right] \leq - 0 . 0 ⁢ 8 ⁢ 7$ $- 0. ⁢ 0 ⁢ 9 ⁢ 6 \leq q \left[1⁢72\right] \leq - 0 . 0 ⁢ 9 ⁢ 4$ $- 0 . 1 ⁢ 0 ⁢ 2 \leq q \left[1⁢73\right] \leq - 0 . 1 ⁢ 0 ⁢ 0$ $- 0. ⁢ 1 ⁢ 0 ⁢ 9 \leq q \left[1⁢74\right] \leq - 0 . 1 ⁢ 0 ⁢ 7$ $- 0 . 116 \leq q \left[175\right] \leq - 0 . 114$ $- 0 . 122 \leq q \left[176\right] \leq - 0 . 120$ $- 0 . 1 ⁢ 2 ⁢ 9 \leq q \left[1⁢7⁢7\right] \leq - 0 . 1 ⁢ 2 ⁢ 7$ $- 0 . 1 ⁢ 3 ⁢ 5 \leq q \left[178\right] \leq - 0 . 1 ⁢ 3 ⁢ 3$ $- 0 . 1 ⁢ 4 ⁢ 2 \leq q \left[1⁢7⁢9\right] \leq - 0 . 1 ⁢ 4 ⁢ 0$ $- 0 . 1 ⁢ 4 ⁢ 8 \leq q \left[180\right] \leq - 0 . 1 ⁢ 4 ⁢ 6$ $- 0 . 1 ⁢ 5 ⁢ 4 \leq q \left[181\right] \leq - 0 . 1 ⁢ 5 ⁢ 2$ $- 0 . 1 ⁢ 6 ⁢ 0 \leq q \left[182\right] \leq - 0 . 1 ⁢ 5 ⁢ 8$ $- 0. ⁢ 1 ⁢ 6 ⁢ 6 \leq q \left[1⁢8⁢3\right] \leq - 0 . 1 ⁢ 6 ⁢ 4$ $- 0 . 1 ⁢ 7 ⁢ 2 \leq q \left[1⁢8⁢4\right] \leq - 0 . 1 ⁢ 7 ⁢ 0$ $- 0. ⁢ 1 ⁢ 7 ⁢ 8 \leq q \left[1⁢8⁢5\right] \leq - 0. ⁢ 1 ⁢ 7 ⁢ 6$ $- 0 . 183 \leq q \left[1⁢8⁢6\right] \leq - 0 . 1 ⁢ 8 ⁢ 1$ $- 0 . 189 \leq q \left[1⁢8⁢7\right] \leq - 0 . 1 ⁢ 8 ⁢ 7$ $- 0 . 1 ⁢ 9 ⁢ 4 \leq q \left[188\right] \leq - 0 . 1 ⁢ 9 ⁢ 2$ $- 0 . 1 ⁢ 9 ⁢ 9 \leq q \left[1⁢8⁢9\right] \leq - 0 . 1 ⁢ 9 ⁢ 7$ $- 0. ⁢ 2 ⁢ 0 ⁢ 4 \leq q \left[1⁢9⁢0\right] \leq - 0. ⁢ 2 ⁢ 0 ⁢ 2$ $- 0. ⁢ 2 ⁢ 0 ⁢ 9 \leq q \left[1⁢9⁢1\right] \leq - 0. ⁢ 2 ⁢ 0 ⁢ 7.$

11. Filtervorrichtung gemäß einem der Ansprüche 8 bis 10, bei der die Zwischenfilter (190) angepasst sind, so dass die Prototypfilterabgriffe q(v) für ganze Zahlen von 0 bis 191 folgende Beziehungen erfüllen:$- 0. ⁢ 2 ⁢ 0 ⁢ 2 ⁢ 9 ⁢ 4 \leq q \left[0\right] \leq - 0 . 2 ⁢ 0 ⁢ 2 ⁢ 9 ⁢ 2$ $- 0 . 1980 ⁢ 4 \leq q \left[1\right] \leq - 0 . 1 ⁢ 9 ⁢ 8 ⁢ 0 ⁢ 2$ $- 0 . 1 ⁢ 9 ⁢ 2 ⁢ 9 ⁢ 5 \leq q \left[2\right] \leq - 0 . 1 ⁢ 9 ⁢ 2 ⁢ 9 ⁢ 3$ $- 0 . 1 ⁢ 8 ⁢ 7 ⁢ 6 ⁢ 8 \leq q \left[3\right] \leq - 0.18766$ $- 0 . 1 ⁢ 8 ⁢ 2 ⁢ 2 ⁢ 6 \leq q \left[4\right] \leq - 0 . 1 ⁢ 8 ⁢ 2 ⁢ 2 ⁢ 4$ $- 0 . 1 ⁢ 7 ⁢ 6 ⁢ 6 ⁢ 8 \leq q \left[5\right] \leq - 0 . 1 ⁢ 7 ⁢ 6 ⁢ 6 ⁢ 6$ $- 0 . 1 ⁢ 7 ⁢ 0 ⁢ 9 ⁢ 7 \leq q \left[6\right] \leq - 0 . 1 ⁢ 7 ⁢ 0 ⁢ 9 ⁢ 5$ $- 0 . 1 ⁢ 6 ⁢ 5 ⁢ 1 ⁢ 4 \leq q \left[7\right] \leq - 0 . 1 ⁢ 6 ⁢ 5 ⁢ 1 ⁢ 2$ $- 0 . 1 ⁢ 5 ⁢ 9 ⁢ 1 ⁢ 9 \leq q \left[8\right] \leq - 0 . 1 ⁢ 5 ⁢ 9 ⁢ 1 ⁢ 7$ $- 0 . 1 ⁢ 5 ⁢ 3 ⁢ 1 ⁢ 3 \leq q \left[9\right] \leq - 0 . 1 ⁢ 5 ⁢ 3 ⁢ 1 ⁢ 1$ $- 0 . 1 ⁢ 4 ⁢ 6 ⁢ 9 ⁢ 7 \leq q \left[1⁢0\right] \leq - 0 . 1 ⁢ 4 ⁢ 6 ⁢ 9 ⁢ 5$ $- 0 . 1 ⁢ 4 ⁢ 0 ⁢ 7 ⁢ 1 \leq q \left[11\right] \leq - 0.14069$ $- 0 . 1 ⁢ 3 ⁢ 4 ⁢ 3 ⁢ 7 \leq q \left[1⁢2\right] \leq - 0 . 1 ⁢ 3 ⁢ 4 ⁢ 3 ⁢ 5$ $- 0 . 1 ⁢ 2 ⁢ 7 ⁢ 9 ⁢ 4 \leq q \left[1⁢3\right] \leq - 0 . 1 ⁢ 2 ⁢ 7 ⁢ 9 ⁢ 2$ $- 0 . 1 ⁢ 2 ⁢ 1 ⁢ 4 ⁢ 4 \leq q \left[14\right] \leq - 0 . 1 ⁢ 2 ⁢ 1 ⁢ 4 ⁢ 2$ $- 0 . 1 ⁢ 1 ⁢ 4 ⁢ 8 ⁢ 6 \leq q \left[1⁢5\right] \leq - 0 . 1 ⁢ 1 ⁢ 4 ⁢ 8 ⁢ 4$ $- 0 . 1 ⁢ 0 ⁢ 8 ⁢ 2 ⁢ 1 \leq q \left[1⁢6\right] \leq - 0 . 1 ⁢ 0 ⁢ 8 ⁢ 1 ⁢ 9$ $- 0 . 1 ⁢ 0 ⁢ 1 ⁢ 4 ⁢ 9 \leq q \left[1⁢7\right] \leq - 0 . 1 ⁢ 0 ⁢ 1 ⁢ 4 ⁢ 7$ $- 0. ⁢ 0 ⁢ 9 ⁢ 4 ⁢ 7 ⁢ 1 \leq q \left[1⁢8\right] \leq - 0. ⁢ 0 ⁢ 9 ⁢ 4 ⁢ 6 ⁢ 9$ $- 0 . 0 ⁢ 8 ⁢ 7 ⁢ 8 ⁢ 6 \leq q \left[1⁢9\right] \leq - 0.08784$ $- 0. ⁢ 0 ⁢ 8 ⁢ 0 ⁢ 9 ⁢ 5 \leq q \left[2⁢0\right] \leq - 0 . 0 ⁢ 8 ⁢ 0 ⁢ 9 ⁢ 3$ $- 0 . 0 ⁢ 7 ⁢ 3 ⁢ 9 ⁢ 7 \leq q \left[2⁢1\right] \leq - 0 . 0 ⁢ 7 ⁢ 3 ⁢ 9 ⁢ 5$ $- 0 . 0 ⁢ 6 ⁢ 6 ⁢ 9 ⁢ 4 \leq q \left[2⁢2\right] \leq - 0 . 0 ⁢ 6 ⁢ 6 ⁢ 9 ⁢ 2$ $- 0 . 0 ⁢ 5 ⁢ 9 ⁢ 8 ⁢ 4 \leq q \left[2⁢3\right] \leq - 0 . 0 ⁢ 5 ⁢ 9 ⁢ 8 ⁢ 2$ $- 0 . 0 ⁢ 5 ⁢ 2 ⁢ 6 ⁢ 9 \leq q \left[2⁢4\right] \leq - 0 . 0 ⁢ 5 ⁢ 2 ⁢ 6 ⁢ 7$ $- 0 . 0 ⁢ 4 ⁢ 5 ⁢ 4 ⁢ 7 \leq q \left[2⁢5\right] \leq - 0 . 0 ⁢ 4 ⁢ 5 ⁢ 4 ⁢ 5$ $- 0 . 0 ⁢ 3 ⁢ 8 ⁢ 1 ⁢ 9 \leq q \left[2⁢6\right] \leq - 0 . 0 ⁢ 3 ⁢ 8 ⁢ 1 ⁢ 7$ $- 0 . 0 ⁢ 3 ⁢ 0 ⁢ 8 ⁢ 5 \leq q \left[2⁢7\right] \leq - 0 . 0 ⁢ 3 ⁢ 0 ⁢ 8 ⁢ 3$ $- 0 . 0 ⁢ 2 ⁢ 3 ⁢ 4 ⁢ 5 \leq q \left[2⁢8\right] \leq - 0. ⁢ 0 ⁢ 2 ⁢ 3 ⁢ 4 ⁢ 3$ $- 0 . 0 ⁢ 1 ⁢ 5 ⁢ 9 ⁢ 8 \leq q \left[2⁢9\right] \leq - 0 . 0 ⁢ 1 ⁢ 5 ⁢ 9 ⁢ 6$ $- 0 . 0084 ⁢ 5 \leq q \left[3⁢0\right] \leq - 0 . 0 ⁢ 0 ⁢ 8 ⁢ 4 ⁢ 3$ $- 0 . 0 ⁢ 0084 \leq q \left[3⁢1\right] \leq - 0. ⁢ 0 ⁢ 0 ⁢ 0 ⁢ 8 ⁢ 2$ $0 . 0 ⁢ 0 ⁢ 6 ⁢ 8 ⁢ 3 \leq q \left[3⁢2\right] \leq 0 . 0 ⁢ 0 ⁢ 6 ⁢ 8 ⁢ 5$ $0.01458 \leq q \left[3⁢3\right] \leq 0 . 0 ⁢ 1 ⁢ 4 ⁢ 6 ⁢ 0$ $0.02240 \leq q \left[3⁢4\right] \leq 0 . 0 ⁢ 2 ⁢ 2 ⁢ 4 ⁢ 2$ $0.03030 \leq q \left[3⁢5\right] \leq 0 . 0 ⁢ 3 ⁢ 0 ⁢ 3 ⁢ 2$ $0.03828 \leq q \left[3⁢6\right] \leq 0 . 0 ⁢ 3 ⁢ 8 ⁢ 3 ⁢ 0$ $0.04635 \leq q \left[3⁢7\right] \leq 0 . 0 ⁢ 4 ⁢ 6 ⁢ 3 ⁢ 7$ $0. ⁢ 0 ⁢ 5 ⁢ 4 ⁢ 5 ⁢ 1 \leq q \left[3⁢8\right] \leq 0 . 0 ⁢ 5 ⁢ 4 ⁢ 5 ⁢ 3$ $0.06275 \leq q \left[3⁢9\right] \leq 0 . 0 ⁢ 6 ⁢ 2 ⁢ 7 ⁢ 7$ $0.07110 \leq q \left[40\right] \leq 0 . 0 ⁢ 7 ⁢ 1 ⁢ 1 ⁢ 2$ $0.07954 \leq q \left[4⁢1\right] \leq 0 . 0 ⁢ 7 ⁢ 9 ⁢ 5 ⁢ 6$ $0.08809 \leq q \left[4⁢2\right] \leq 0 . 0 ⁢ 8 ⁢ 8 ⁢ 1 ⁢ 1$ $0 . 0 ⁢ 9 ⁢ 6 ⁢ 7 ⁢ 5 \leq q \left[4⁢3\right] \leq 0. ⁢ 0 ⁢ 9 ⁢ 6 ⁢ 7 ⁢ 7$ $0.10552 \leq q \left[4⁢4\right] \leq 0.10554$ $0.11442 \leq q \left[4⁢5\right] \leq 0 . 1 ⁢ 1 ⁢ 4 ⁢ 4 ⁢ 4$ $0.12344 \leq q \left[4⁢6\right] \leq 0 . 1 ⁢ 2 ⁢ 3 ⁢ 4 ⁢ 6$ $0.13259 \leq q \left[4⁢7\right] \leq 0 . 1 ⁢ 3 ⁢ 2 ⁢ 6 ⁢ 1$ $0.14189 \leq q \left[4⁢8\right] \leq 0 . 1 ⁢ 4 ⁢ 1 ⁢ 9 ⁢ 1$ $0.15132 \leq q \left[4⁢9\right] \leq 0 . 1 ⁢ 5 ⁢ 1 ⁢ 3 ⁢ 4$ $0.1 ⁢ 6 ⁢ 0 ⁢ 9 ⁢ 1 \leq q \left[5⁢0\right] \leq 0 . 1 ⁢ 6 ⁢ 0 ⁢ 9 ⁢ 3$ $0.17066 \leq q \left[5⁢1\right] \leq 0 . 1 ⁢ 7 ⁢ 0 ⁢ 6 ⁢ 8$ $0.18058 \leq q \left[5⁢2\right] \leq 0 . 1 ⁢ 8 ⁢ 0 ⁢ 6 ⁢ 0$ $0.19067 \leq q \left[5⁢3\right] \leq 0 . 1 ⁢ 9 ⁢ 0 ⁢ 6 ⁢ 9$ $0.20095 \leq q \left[5⁢4\right] \leq 0 . 2 ⁢ 0 ⁢ 0 ⁢ 9 ⁢ 7$ $0.21143 \leq q \left[5⁢5\right] \leq 0 . 2 ⁢ 1 ⁢ 1 ⁢ 4 ⁢ 5$ $0.22211 \leq q \left[5⁢6\right] \leq 0 . 2 ⁢ 2 ⁢ 2 ⁢ 1 ⁢ 3$ $0.23300 \leq q \left[5⁢7\right] \leq 0 . 2 ⁢ 3 ⁢ 3 ⁢ 0 ⁢ 2$ $0. ⁢ 2 ⁢ 4 ⁢ 4 ⁢ 1 ⁢ 2 \leq q \left[5⁢8\right] \leq 0 . 2 ⁢ 4 ⁢ 4 ⁢ 1 ⁢ 4$ $0.25549 \leq q \left[5⁢9\right] \leq 0 . 2 ⁢ 5 ⁢ 5 ⁢ 5 ⁢ 1$ $0.26711 \leq q \left[6⁢0\right] \leq 0 . 2 ⁢ 6 ⁢ 7 ⁢ 1 ⁢ 3$ $0.27899 \leq q \left[6⁢1\right] \leq 0 . 2 ⁢ 7 ⁢ 9 ⁢ 0 ⁢ 1$ $0.29117 \leq q \left[6⁢2\right] \leq 0 . 2 ⁢ 9 ⁢ 1 ⁢ 1 ⁢ 9$ $0.30364 \leq q \left[6⁢3\right] \leq 0.30366$ $0.90252 \leq q \left[6⁢4\right] \leq 0 . 9 ⁢ 0 ⁢ 2 ⁢ 5 ⁢ 4$ $0.91035 \leq q \left[6⁢5\right] \leq 0 . 9 ⁢ 1 ⁢ 0 ⁢ 3 ⁢ 7$ $0.91769 \leq q \left[6⁢6\right] \leq 0 . 9 ⁢ 1 ⁢ 7 ⁢ 7 ⁢ 1$ $0.92457 \leq q \left[6⁢7\right] \leq 0 . 9 ⁢ 2 ⁢ 4 ⁢ 5 ⁢ 9$ $0.93101 \leq q \left[68\right] \leq 0.93103$ $0.93705 \leq q \left[69\right] \leq 0.93707$ $0.94270 \leq q \left[70\right] \leq 0.94272$ $0.94800 \leq q \left[71\right] \leq 0.94802$ $0.95295 \leq q \left[72\right] \leq 0.95297$ $0.95758 \leq q \left[7⁢3\right] \leq 0.95760$ $0.96190 \leq q \left[7⁢4\right] \leq 0 . 9 ⁢ 6 ⁢ 1 ⁢ 9 ⁢ 2$ $0.96593 \leq q \left[7⁢5\right] \leq 0 . 9 ⁢ 6 ⁢ 5 ⁢ 9 ⁢ 5$ $0.96968 \leq q \left[7⁢6\right] \leq 0 . 9 ⁢ 6 ⁢ 9 ⁢ 7 ⁢ 0$ $0.97317 \leq q \left[7⁢7\right] \leq 0 . 9 ⁢ 7 ⁢ 3 ⁢ 1 ⁢ 9$ $0. ⁢ 9 ⁢ 7 ⁢ 6 ⁢ 4 ⁢ 1 \leq q \left[78\right] \leq 0 . 9 ⁢ 7 ⁢ 6 ⁢ 4 ⁢ 3$ $0 . 9 ⁢ 7 ⁢ 9 ⁢ 4 ⁢ 0 \leq q \left[7⁢9\right] \leq 0 . 9 ⁢ 7 ⁢ 9 ⁢ 4 ⁢ 2$ $0.98217 \leq q \left[8⁢0\right] \leq 0.98219$ $0.98472 \leq q \left[8⁢1\right] \leq 0 . 9 ⁢ 8 ⁢ 4 ⁢ 7 ⁢ 4$ $0. ⁢ 9 ⁢ 8 ⁢ 7 ⁢ 0 ⁢ 6 \leq q \left[8⁢2\right] \leq 0 . 9 ⁢ 8 ⁢ 7 ⁢ 0 ⁢ 8$ $0.98919 \leq q \left[8⁢3\right] \leq 0 . 9 ⁢ 8 ⁢ 9 ⁢ 2 ⁢ 1$ $0.99113 \leq q \left[8⁢4\right] \leq 0 . 9 ⁢ 9 ⁢ 1 ⁢ 1 ⁢ 5$ $0.99288 \leq q \left[8⁢5\right] \leq 0 . 9 ⁢ 9 ⁢ 2 ⁢ 9 ⁢ 0$ $0.99444 \leq q \left[8⁢6\right] \leq 0 . 9 ⁢ 9 ⁢ 4 ⁢ 4 ⁢ 6$ $0.99583 \leq q \left[8⁢7\right] \leq 0 . 9 ⁢ 9 ⁢ 5 ⁢ 8 ⁢ 5$ $0 . 9 ⁢ 9 ⁢ 7 ⁢ 0 ⁢ 4 \leq q \left[8⁢8\right] \leq 0 . 9 ⁢ 9 ⁢ 7 ⁢ 0 ⁢ 6$ $0. ⁢ 9 ⁢ 9 ⁢ 8 ⁢ 0 ⁢ 9 \leq q \left[8⁢9\right] \leq 0 . 9 ⁢ 9 ⁢ 8 ⁢ 1 ⁢ 1$ $0 . 9989 ⁢ 6 \leq q \left[9⁢0\right] \leq 0 . 9 ⁢ 9 ⁢ 8 ⁢ 9 ⁢ 8$ $0 . 9 ⁢ 9 ⁢ 9 ⁢ 6 ⁢ 7 \leq q \left[9⁢1\right] \leq 0 . 9 ⁢ 9 ⁢ 9 ⁢ 6 ⁢ 9$ $1. ⁢ 0 ⁢ 0 ⁢ 0 ⁢ 2 ⁢ 3 \leq q \left[9⁢2\right] \leq 1. ⁢ 0 ⁢ 0 ⁢ 0 ⁢ 2 ⁢ 5$ $1. ⁢ 0 ⁢ 0 ⁢ 0 ⁢ 6 ⁢ 2 \leq q \left[9⁢3\right] \leq 1. ⁢ 0 ⁢ 0 ⁢ 0 ⁢ 6 ⁢ 4$ $1.00086 \leq q \left[9⁢4\right] \leq 1 . 0 ⁢ 0 ⁢ 0 ⁢ 8 ⁢ 8$ $1.00093 \leq q \left[9⁢5\right] \leq 1 . 0 ⁢ 0 ⁢ 0 ⁢ 9 ⁢ 5$ $1.00086 \leq q \left[9⁢6\right] \leq 1 . 0 ⁢ 0 ⁢ 0 ⁢ 8 ⁢ 8$ $1.00062 \leq q \left[9⁢7\right] \leq 1 . 0 ⁢ 0 ⁢ 0 ⁢ 6 ⁢ 4$ $1. ⁢ 0 ⁢ 0 ⁢ 0 ⁢ 2 ⁢ 3 \leq q \left[9⁢8\right] \leq 1. ⁢ 0 ⁢ 0 ⁢ 0 ⁢ 2 ⁢ 5$ $0.99967 \leq q \left[99\right] \leq 0.99969$ $0.99896 \leq q \left[100\right] \leq 0.99898$ $0.99809 \leq q \left[101\right] \leq 0.99811$ $0.99704 \leq q \left[102\right] \leq 0.99706$ $0. ⁢ 9 ⁢ 9 ⁢ 5 ⁢ 8 ⁢ 3 \leq q \left[1⁢0⁢3\right] \leq 0.99585$ $0.99444 \leq q \left[1⁢0⁢4\right] \leq 0 . 9 ⁢ 9 ⁢ 4 ⁢ 4 ⁢ 6$ $0.99288 \leq q \left[105\right] \leq 0 . 9 ⁢ 9 ⁢ 2 ⁢ 9 ⁢ 0$ $0.99113 \leq q \left[106\right] \leq 0 . 9 ⁢ 9 ⁢ 1 ⁢ 1 ⁢ 5$ $0.98919 \leq q \left[1⁢0⁢7\right] \leq 0 . 9 ⁢ 8 ⁢ 9 ⁢ 2 ⁢ 1$ $0.98706 \leq q \left[1⁢0⁢8\right] \leq 0 . 9 ⁢ 8 ⁢ 7 ⁢ 0 ⁢ 8$ $0.98472 \leq q \left[109\right] \leq 0 . 9 ⁢ 8 ⁢ 4 ⁢ 7 ⁢ 4$ $0.98217 \leq q \left[110\right] \leq 0 . 9 ⁢ 8 ⁢ 2 ⁢ 1 ⁢ 9$ $0.97940 \leq q \left[111\right] \leq 0 . 9 ⁢ 7 ⁢ 9 ⁢ 4 ⁢ 2$ $0.97641 \leq q \left[1⁢1⁢2\right] \leq 0 . 9 ⁢ 7 ⁢ 6 ⁢ 4 ⁢ 3$ $0 . 9 ⁢ 7 ⁢ 3 ⁢ 1 ⁢ 7 \leq q \left[1⁢1⁢3\right] \leq 0 . 9 ⁢ 7 ⁢ 3 ⁢ 1 ⁢ 9$ $0. ⁢ 9 ⁢ 6 ⁢ 9 ⁢ 6 ⁢ 8 \leq q \left[114\right] \leq 0 . 9 ⁢ 6 ⁢ 9 ⁢ 7 ⁢ 0$ $0.96593 \leq q \left[115\right] \leq 0 . 9 ⁢ 6 ⁢ 5 ⁢ 9 ⁢ 5$ $0. ⁢ 9 ⁢ 6 ⁢ 1 ⁢ 9 ⁢ 0 \leq q \left[116\right] \leq 0 . 9 ⁢ 6 ⁢ 1 ⁢ 9 ⁢ 2$ $0.95758 \leq q \left[1⁢1⁢7\right] \leq 0.95760$ $0.95295 \leq q \left[118\right] \leq 0.95297$ $0.94800 \leq q \left[119\right] \leq 0.94802$ $0.94270 \leq q \left[120\right] \leq 0.94272$ $0.93705 \leq q \left[121\right] \leq 0.93707$ $0.93101 \leq q \left[122\right] \leq 0.93103$ $0. ⁢ 9 ⁢ 2 ⁢ 4 ⁢ 5 ⁢ 7 \leq q \left[1⁢2⁢3\right] \leq 0 . 9 ⁢ 2 ⁢ 4 ⁢ 5 ⁢ 9$ $0.91769 \leq q \left[1⁢2⁢4\right] \leq 0 . 9 ⁢ 1 ⁢ 7 ⁢ 7 ⁢ 1$ $0.91035 \leq q \left[1⁢2⁢5\right] \leq 0 . 9 ⁢ 1 ⁢ 0 ⁢ 3 ⁢ 7$ $0.90252 \leq q \left[1⁢2⁢6\right] \leq 0 . 9 ⁢ 0 ⁢ 2 ⁢ 5 ⁢ 4$ $0.89416 \leq q \left[1⁢2⁢7\right] \leq 0 . 8 ⁢ 9 ⁢ 4 ⁢ 1 ⁢ 8$ $0 . 2 ⁢ 9 ⁢ 1 ⁢ 1 ⁢ 7 \leq q \left[128\right] \leq 0. ⁢ 2 ⁢ 9 ⁢ 1 ⁢ 1 ⁢ 9$ $0.27899 \leq q \left[129\right] \leq 0 . 2 ⁢ 7 ⁢ 9 ⁢ 0 ⁢ 1$ $0.26711 \leq q \left[130\right] \leq 0.26713$ $0.25549 \leq q \left[1⁢3⁢1\right] \leq 0 . 2 ⁢ 5 ⁢ 5 ⁢ 5 ⁢ 1$ $0.24412 \leq q \left[1⁢3⁢2\right] \leq 0 . 2 ⁢ 4 ⁢ 4 ⁢ 1 ⁢ 4$ $0.23300 \leq q \left[133\right] \leq 0.23302$ $0.22211 \leq q \left[134\right] \leq 0.22213$ $0.21143 \leq q \left[135\right] \leq 0.21145$ $0.20095 \leq q \left[136\right] \leq 0.20097$ $0.19067 \leq q \left[137\right] \leq 0.19069$ $0.18058 \leq q \left[1⁢3⁢8\right] - \leq 0 . 1 ⁢ 8 ⁢ 0 ⁢ 6 ⁢ 0$ $0 . 17066 \leq q \left[139\right] \leq 0.17068$ $0 . 16091 \leq q \left[140\right] \leq 0.16093$ $0.15132 \leq q \left[1⁢4⁢1\right] \leq 0 . 1 ⁢ 5 ⁢ 1 ⁢ 3 ⁢ 4$ $0.14189 \leq q \left[142\right] \leq 0 . 1 ⁢ 4 ⁢ 1 ⁢ 9 ⁢ 1$ $0.13259 \leq q \left[143\right] \leq 0 . 1 ⁢ 3 ⁢ 2 ⁢ 6 ⁢ 1$ $0.12344 \leq q \left[144\right] \leq 0 . 1 ⁢ 2 ⁢ 3 ⁢ 4 ⁢ 6$ $0.11442 \leq q \left[145\right] \leq 0 . 1 ⁢ 1 ⁢ 4 ⁢ 4 ⁢ 4$ $0.10552 \leq q \left[1⁢4⁢6\right] \leq 0 . 1 ⁢ 0 ⁢ 5 ⁢ 5 ⁢ 4$ $0.09675 \leq q \left[1⁢4⁢7\right] \leq 0 . 0 ⁢ 9 ⁢ 6 ⁢ 7 ⁢ 7$ $0.08809 \leq q \left[148\right] \leq 0.08811$ $0.07954 \leq q \left[149\right] \leq 0.07956$ $0.07110 \leq q \left[150\right] \leq 0.07112$ $0.06275 \leq q \left[151\right] \leq 0.06277$ $0.05451 \leq q \left[152\right] \leq 0.05453$ $0.04635 \leq q \left[1⁢5⁢3\right] \leq 0 . 0 ⁢ 4 ⁢ 6 ⁢ 3 ⁢ 7$ $0.03828 \leq q \left[1⁢5⁢4\right] \leq 0 . 0 ⁢ 3 ⁢ 8 ⁢ 3 ⁢ 0$ $0.03030 \leq q \left[155\right] \leq 0.03032$ $0.02240 \leq q \left[1⁢5⁢6\right] \leq 0 . 0 ⁢ 2 ⁢ 2 ⁢ 4 ⁢ 2$ $0.01458 \leq q \left[157\right] \leq 0.01460$ $0.00683 \leq q \left[158\right] \leq 0.00685$ $- 0 . 0 ⁢ 0 ⁢ 0 ⁢ 8 ⁢ 4 \leq q \left[159\right] \leq - 0 . 0 ⁢ 0 ⁢ 0 ⁢ 8 ⁢ 2$ $- 0 . 0 ⁢ 0 ⁢ 8 ⁢ 4 ⁢ 5 \leq q \left[160\right] \leq - 0 . 0 ⁢ 0 ⁢ 8 ⁢ 4 ⁢ 3$ $- 0 . 0 ⁢ 1 ⁢ 5 ⁢ 9 ⁢ 8 \leq q \left[161\right] \leq - 0 . 0 ⁢ 1 ⁢ 5 ⁢ 9 ⁢ 6$ $- 0 . 0 ⁢ 2 ⁢ 3 ⁢ 4 ⁢ 5 \leq q \left[1⁢6⁢2\right] \leq - 0 . 0 ⁢ 2 ⁢ 3 ⁢ 4 ⁢ 3$ $- 0 . 0 ⁢ 3 ⁢ 0 ⁢ 8 ⁢ 5 \leq q \left[1⁢6⁢3\right] \leq - 0 . 0 ⁢ 3 ⁢ 0 ⁢ 8 ⁢ 3$ $- 0 . 0 ⁢ 3 ⁢ 8 ⁢ 1 ⁢ 9 \leq q \left[1⁢6⁢4\right] \leq - 0 . 0 ⁢ 3 ⁢ 817$ $- 0 . 0 ⁢ 4 ⁢ 5 ⁢ 4 ⁢ 7 \leq q \left[1⁢65\right] \leq - 0.04545$ $- 0.05269 \leq q \left[166\right] \leq - 0.05267$ $- 0.05984 \leq q \left[167\right] \leq - 0.05982$ $- 0. ⁢ 0 ⁢ 6 ⁢ 6 ⁢ 94 \leq q \left[168\right] \leq - 0.06692$ $- 0 . 07397 \leq q \left[169\right] \leq - 0 . 07395$ $- 0 . 08095 \leq q \left[170\right] \leq - 0.08093$ $- 0 . 08786 \leq q \left[171\right] \leq - 0 . 08784$ $- 0 . 09471 \leq q \left[172\right] \leq - 0 . 09469$ $- 0 . 1 ⁢ 0 ⁢ 1 ⁢ 4 ⁢ 9 \leq q \left[173\right] \leq - 0 . 10147$ $- 0 . 1 ⁢ 0 ⁢ 8 ⁢ 2 ⁢ 1 \leq q \left[1⁢7⁢4\right] \leq - 0 . 1 ⁢ 0 ⁢ 8 ⁢ 1 ⁢ 9$ $- 0 . 1 ⁢ 1 ⁢ 4 ⁢ 8 ⁢ 6 \leq q \left[175\right] \leq - 0 . 1 ⁢ 1 ⁢ 4 ⁢ 8 ⁢ 4$ $- 0 . 1 ⁢ 2 ⁢ 1 ⁢ 4 ⁢ 4 \leq q \left[1⁢7⁢6\right] \leq - 0 . 1 ⁢ 2 ⁢ 1 ⁢ 4 ⁢ 2$ $- 0 . 1 ⁢ 2 ⁢ 7 ⁢ 9 ⁢ 4 \leq q \left[1⁢7⁢7\right] \leq - 0 . 1 ⁢ 2 ⁢ 7 ⁢ 9 ⁢ 2$ $- 0 . 1 ⁢ 3 ⁢ 4 ⁢ 3 ⁢ 7 \leq q \left[1⁢78\right] \leq - 0 . 1 ⁢ 3 ⁢ 4 ⁢ 3 ⁢ 5$ $- 0 . 1 ⁢ 4 ⁢ 0 ⁢ 7 ⁢ 1 \leq q \left[1⁢7⁢9\right] \leq - 0 . 1 ⁢ 4 ⁢ 0 ⁢ 6 ⁢ 9$ $- 0 . 1 ⁢ 4 ⁢ 6 ⁢ 9 ⁢ 7 \leq q \left[180\right] \leq - 0 . 1 ⁢ 4 ⁢ 6 ⁢ 9 ⁢ 5$ $- 0 . 1 ⁢ 5 ⁢ 3 ⁢ 1 ⁢ 3 \leq q \left[1⁢81\right] \leq - 0 . 1 ⁢ 5 ⁢ 3 ⁢ 1 ⁢ 1$ $- 0.15919 \leq q \left[182\right] \leq - 0 . 1 ⁢ 5 ⁢ 9 ⁢ 1 ⁢ 7$ $- 0 . 1 ⁢ 6 ⁢ 5 ⁢ 1 ⁢ 4 \leq q \left[1⁢8⁢3\right] \leq - 0 . 1 ⁢ 6 ⁢ 5 ⁢ 1 ⁢ 2$ $- 0 . 1 ⁢ 7 ⁢ 0 ⁢ 9 ⁢ 7 \leq q \left[1⁢8⁢4\right] \leq - 0 . 1 ⁢ 7 ⁢ 0 ⁢ 9 ⁢ 5$ $- 0 . 1 ⁢ 7 ⁢ 6 ⁢ 6 ⁢ 8 \leq q \left[1⁢8⁢5\right] \leq - 0 . 1 ⁢ 7 ⁢ 6 ⁢ 6 ⁢ 6$ $- 0 . 1 ⁢ 8 ⁢ 2 ⁢ 2 ⁢ 6 \leq q \left[1⁢8⁢6\right] \leq - 0 . 1 ⁢ 8 ⁢ 2 ⁢ 2 ⁢ 4$ $- 0 . 1 ⁢ 8 ⁢ 7 ⁢ 6 ⁢ 8 \leq q \left[187\right] \leq - 0 . 1 ⁢ 8 ⁢ 7 ⁢ 6 ⁢ 6$ $- 0 . 1 ⁢ 9 ⁢ 2 ⁢ 9 ⁢ 5 \leq q \left[188\right] \leq - 0 . 1 ⁢ 9 ⁢ 2 ⁢ 9 ⁢ 3$ $- 0 . 1 ⁢ 9 ⁢ 8 ⁢ 0 ⁢ 4 \leq q \left[1⁢8⁢9\right] \leq - 0 . 1 ⁢ 9 ⁢ 8 ⁢ 0 ⁢ 2$ $- 0 . 2 ⁢ 0 ⁢ 2 ⁢ 9 ⁢ 4 \leq q \left[1⁢9⁢0\right] \leq - 0 . 2 ⁢ 0 ⁢ 2 ⁢ 9 ⁢ 2$ $- 0 . 2 ⁢ 0 ⁢ 7 ⁢ 6 ⁢ 4 \leq q \left[1⁢9⁢1\right] \leq - 0 . 2 ⁢ 0 ⁢ 7 ⁢ 6 ⁢ 2$

12. Filtervorrichtung gemäß einem der Ansprüche 8 bis 11, bei der die Zwischenfilter (190) angepasst sind, so dass die echtwertigen Prototypfilterkoeffizienten q(v) für die ganze Zahl v im Bereich von 0 bis 191 gegeben sind durch:$q \left[0\right] = - 0 . 2 ⁢ 0 ⁢ 2 ⁢ 9 ⁢ 3 ⁢ 4 ⁢ 3 ⁢ 3 ⁢ 8 ⁢ 0$ $q \left[1\right] = - 0 . 1 ⁢ 9 ⁢ 8 ⁢ 0 ⁢ 3 ⁢ 3 ⁢ 1 ⁢ 5 ⁢ 8 ⁢ 8$ $q \left[2\right] = - 0 . 1 ⁢ 9 ⁢ 2 ⁢ 9 ⁢ 4 ⁢ 1 ⁢ 1 ⁢ 5 ⁢ 1 ⁢ 9$ $q \left[3\right] = - 0 . 1 ⁢ 8 ⁢ 7 ⁢ 6 ⁢ 7 ⁢ 4 ⁢ 4 ⁢ 2 ⁢ 2 ⁢ 2$ $q \left[4\right] = - 0 . 1 ⁢ 8 ⁢ 2 ⁢ 2 ⁢ 4 ⁢ 7 ⁢ 4 ⁢ 0 ⁢ 1 ⁢ 1$ $q \left[5\right] = - 0 . 1 ⁢ 7 ⁢ 6 ⁢ 6 ⁢ 7 ⁢ 3 ⁢ 0 ⁢ 2 ⁢ 0 ⁢ 2$ $q \left[6\right] = - 0 . 1 ⁢ 7 ⁢ 0 ⁢ 9 ⁢ 6 ⁢ 2 ⁢ 8 ⁢ 6 ⁢ 3 ⁢ 6$ $q \left[7\right] = - 0 . 1 ⁢ 6 ⁢ 5 ⁢ 1 ⁢ 2 ⁢ 7 ⁢ 3 ⁢ 0 ⁢ 0 ⁢ 5$ $q \left[8\right] = - 0 . 1 ⁢ 5 ⁢ 9 ⁢ 1 ⁢ 7 ⁢ 5 ⁢ 6 ⁢ 0 ⁢ 2 ⁢ 4$ $q \left[9\right] = - 0 . 1 ⁢ 5 ⁢ 3 ⁢ 1 ⁢ 1 ⁢ 6 ⁢ 0 ⁢ 4 ⁢ 5 ⁢ 5$ $q \left[10\right] - 0 . 1 ⁢ 4 ⁢ 6 ⁢ 9 ⁢ 5 ⁢ 6 ⁢ 0 ⁢ 0 ⁢ 0 ⁢ 5$ $q \left[1⁢1\right] = - 0 . 1 ⁢ 4 ⁢ 0 ⁢ 7 ⁢ 0 ⁢ 2 ⁢ 0 ⁢ 1 ⁢ 3 ⁢ 2$ $q \left[4⁢0\right] = 0 . 0 ⁢ 7 ⁢ 1 ⁢ 1 ⁢ 0 ⁢ 6 ⁢ 8 ⁢ 6 ⁢ 5 ⁢ 7$ $q \left[4⁢1\right] = 0. ⁢ 0 ⁢ 7 ⁢ 9 ⁢ 5 ⁢ 5 ⁢ 1 ⁢ 2 ⁢ 4 ⁢ 5 ⁢ 3$ $q \left[4⁢2\right] = 0 . 0 ⁢ 8 ⁢ 8 ⁢ 1 ⁢ 0 ⁢ 0 ⁢ 7 ⁢ 8 ⁢ 7 ⁢ 9$ $q \left[4⁢3\right] = 0 . 0 ⁢ 9 ⁢ 6 ⁢ 7 ⁢ 6 ⁢ 0 ⁢ 3 ⁢ 2 ⁢ 5 ⁢ 9$ $q \left[4⁢4\right] = 0 . 1 ⁢ 0 ⁢ 5 ⁢ 5 ⁢ 3 ⁢ 4 ⁢ 9 ⁢ 6 ⁢ 5 ⁢ 8$ $q \left[4⁢5\right] = 0 . 1 ⁢ 1 ⁢ 4 ⁢ 4 ⁢ 3 ⁢ 0 ⁢ 1 ⁢ 0 ⁢ 0 ⁢ 0$ $q \left[4⁢6\right] = 0 . 1 ⁢ 2 ⁢ 3 ⁢ 4 ⁢ 5 ⁢ 1 ⁢ 4 ⁢ 2 ⁢ 2 ⁢ 2$ $q \left[4⁢7\right] = 0 . 1 ⁢ 3 ⁢ 2 ⁢ 6 ⁢ 0 ⁢ 4 ⁢ 9 ⁢ 4 ⁢ 3 ⁢ 4$ $q \left[4⁢8\right] = 0 . 1 ⁢ 4 ⁢ 1 ⁢ 8 ⁢ 9 ⁢ 7 ⁢ 0 ⁢ 1 ⁢ 2 ⁢ 3$ $q \left[4⁢9\right] = 0 . 1 ⁢ 5 ⁢ 1 ⁢ 3 ⁢ 3 ⁢ 4 ⁢ 3 ⁢ 3 ⁢ 7 ⁢ 0$ $q \left[5⁢0\right] = 0 . 1 ⁢ 6 ⁢ 0 ⁢ 9 ⁢ 2 ⁢ 4 ⁢ 0 ⁢ 1 ⁢ 2 ⁢ 6$ $q \left[5⁢1\right] = 0 . 1 ⁢ 7 ⁢ 0 ⁢ 6 ⁢ 7 ⁢ 3 ⁢ 5 ⁢ 5 ⁢ 1 ⁢ 7$ $q \left[5⁢2\right] = 0 . 1 ⁢ 8 ⁢ 0 ⁢ 5 ⁢ 9 ⁢ 0 ⁢ 9 ⁢ 1 ⁢ 9 ⁢ 4$ $q \left[5⁢3\right] = 0 . 1 ⁢ 9 ⁢ 0 ⁢ 6 ⁢ 8 ⁢ 4 ⁢ 5 ⁢ 7 ⁢ 5 ⁢ 3$ $q \left[54\right] = 0 . 2009635191$ $q \left[5⁢5\right] = 0 . 2 ⁢ 1 ⁢ 1 ⁢ 4 ⁢ 3 ⁢ 7 ⁢ 3 ⁢ 4 ⁢ 5 ⁢ 8$ $q \left[5⁢6\right] = 0 . 2 ⁢ 2 ⁢ 2 ⁢ 1 ⁢ 1 ⁢ 6 ⁢ 3 ⁢ 0 ⁢ 8 ⁢ 0$ $q \left[5⁢7\right] = 0 . 2 ⁢ 3 ⁢ 3 ⁢ 0 ⁢ 1 ⁢ 1 ⁢ 3 ⁢ 8 ⁢ 6 ⁢ 8$ $q \left[5⁢8\right] = 0 . 2 ⁢ 4 ⁢ 4 ⁢ 1 ⁢ 3 ⁢ 4 ⁢ 3 ⁢ 7 ⁢ 4 ⁢ 2$ $q \left[5⁢9\right] = 0 . 2 ⁢ 5 ⁢ 5 ⁢ 4 ⁢ 9 ⁢ 7 ⁢ 9 ⁢ 6 ⁢ 6 ⁢ 4$ $q \left[6⁢0\right] = 0 . 2 ⁢ 6 ⁢ 7 ⁢ 1 ⁢ 1 ⁢ 5 ⁢ 8 ⁢ 7 ⁢ 0 ⁢ 0$ $q \left[6⁢1\right] = 0 . 2 ⁢ 7 ⁢ 9 ⁢ 0 ⁢ 0 ⁢ 2 ⁢ 9 ⁢ 2 ⁢ 3 ⁢ 6$ $q \left[62\right] = 0 . 2911752349$ $q \left[6⁢3\right] = 0 . 3 ⁢ 0 ⁢ 3 ⁢ 6 ⁢ 5 ⁢ 0 ⁢ 3 ⁢ 3 ⁢ 5 ⁢ 0$ $q \left[6⁢4\right] = 0 . 9 ⁢ 0 ⁢ 2 ⁢ 5 ⁢ 2 ⁢ 7 ⁢ 5 ⁢ 7 ⁢ 1 ⁢ 3$ $q \left[6⁢5\right] = 0 . 9 ⁢ 1 ⁢ 0 ⁢ 3 ⁢ 5 ⁢ 8 ⁢ 5 ⁢ 1 ⁢ 9 ⁢ 6$ $q \left[6⁢6\right] = 0 . 9 ⁢ 1 ⁢ 7 ⁢ 6 ⁢ 9 ⁢ 7 ⁢ 7 ⁢ 8 ⁢ 2 ⁢ 5$ $q \left[6⁢7\right] = 0 . 9 ⁢ 2 ⁢ 4 ⁢ 5 ⁢ 7 ⁢ 6 ⁢ 0 ⁢ 6 ⁢ 8 ⁢ 3$ $q \left[6⁢8\right] = 0 . 9 ⁢ 3 ⁢ 1 ⁢ 0 ⁢ 2 ⁢ 1 ⁢ 4 ⁢ 5 ⁢ 8 ⁢ 1$ $q \left[69\right] = 0.9370596739$ $q \left[7⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[7⁢1\right] = 0 . 9 ⁢ 4 ⁢ 8 ⁢ 0 ⁢ 0 ⁢ 7 ⁢ 0 ⁢ 6 ⁢ 0 ⁢ 6$ $q \left[7⁢2\right] = 0 . 9 ⁢ 5 ⁢ 2 ⁢ 9 ⁢ 5 ⁢ 7 ⁢ 8 ⁢ 5 ⁢ 6 ⁢ 6$ $q \left[7⁢3\right] = 0 . 9 ⁢ 5 ⁢ 7 ⁢ 5 ⁢ 8 ⁢ 5 ⁢ 0 ⁢ 6 ⁢ 7 ⁢ 2$ $q \left[7⁢4\right] = 0 . 9 ⁢ 6 ⁢ 1 ⁢ 9 ⁢ 0 ⁢ 5 ⁢ 6 ⁢ 1 ⁢ 5 ⁢ 8$ $q \left[75\right] = 0.9659351065$ $q \left[76\right] = 0.9696879297$ $q \left[7⁢7\right] = 0 . 9 ⁢ 7 ⁢ 3 ⁢ 1 ⁢ 7 ⁢ 7 ⁢ 3 ⁢ 5 ⁢ 4 ⁢ 7$ $q \left[7⁢8\right] = 0 . 9 ⁢ 7 ⁢ 6 ⁢ 4 ⁢ 1 ⁢ 5 ⁢ 6 ⁢ 1 ⁢ 1 ⁢ 9$ $q \left[7⁢9\right] = 0 . 9 ⁢ 7 ⁢ 9 ⁢ 4 ⁢ 1 ⁢ 3 ⁢ 9 ⁢ 6 ⁢ 4 ⁢ 0$ $q \left[8⁢0\right] = 0 . 9 ⁢ 8 ⁢ 2 ⁢ 1 ⁢ 8 ⁢ 2 ⁢ 7 ⁢ 6 ⁢ 9 ⁢ 2$ $q \left[8⁢1\right] = 0 . 9 ⁢ 8 ⁢ 4 ⁢ 7 ⁢ 3 ⁢ 1 ⁢ 5 ⁢ 3 ⁢ 7 ⁢ 7$ $q \left[8⁢2\right] = 0 . 9 ⁢ 8 ⁢ 7 ⁢ 0 ⁢ 6 ⁢ 8 ⁢ 9 ⁢ 7 ⁢ 9 ⁢ 0$ $q \left[8⁢3\right] = 0 . 9 ⁢ 8 ⁢ 9 ⁢ 2 ⁢ 0 ⁢ 3 ⁢ 0 ⁢ 4 ⁢ 6 ⁢ 2$ $q \left[8⁢4\right] = 0 . 9 ⁢ 9 ⁢ 1 ⁢ 1 ⁢ 4 ⁢ 0 ⁢ 9 ⁢ 7 ⁢ 2 ⁢ 8$ $q \left[8⁢5\right] = 0 . 9 ⁢ 9 ⁢ 2 ⁢ 8 ⁢ 8 ⁢ 9 ⁢ 3 ⁢ 0 ⁢ 6 ⁢ 7$ $q \left[8⁢6\right] = 0 . 9 ⁢ 9 ⁢ 4 ⁢ 4 ⁢ 5 ⁢ 3 ⁢ 9 ⁢ 3 ⁢ 9 ⁢ 5$ $q \left[8⁢7\right] = 0 . 9 ⁢ 9 ⁢ 5 ⁢ 8 ⁢ 4 ⁢ 0 ⁢ 1 ⁢ 3 ⁢ 1 ⁢ 8$ $q \left[8⁢8\right] = 0 . 9 ⁢ 9 ⁢ 7 ⁢ 0 ⁢ 5 ⁢ 2 ⁢ 5 ⁢ 3 ⁢ 5 ⁢ 2$ $q \left[8⁢9\right] = 0 . 9 ⁢ 9 ⁢ 8 ⁢ 0 ⁢ 9 ⁢ 5 ⁢ 2 ⁢ 1 ⁢ 1 ⁢ 8$ $q \left[9⁢0\right] = 0 . 9 ⁢ 9 ⁢ 8 ⁢ 9 ⁢ 7 ⁢ 1 ⁢ 6 ⁢ 5 ⁢ 0 ⁢ 4$ $q \left[9⁢1\right] = 0 . 9 ⁢ 9 ⁢ 9 ⁢ 6 ⁢ 8 ⁢ 4 ⁢ 7 ⁢ 8 ⁢ 0 ⁢ 6$ $q \left[9⁢2\right] = 1. ⁢ 0 ⁢ 0 ⁢ 0 ⁢ 2 ⁢ 3 ⁢ 6 ⁢ 9 ⁢ 8 ⁢ 3 ⁢ 7$ $q \left[9⁢3\right] = 1. ⁢ 0 ⁢ 0 ⁢ 0 ⁢ 6 ⁢ 3 ⁢ 0 ⁢ 1 ⁢ 0 ⁢ 2 ⁢ 8$ $q \left[9⁢4\right] = 1. ⁢ 0 ⁢ 0 ⁢ 0 ⁢ 8 ⁢ 6 ⁢ 5 ⁢ 4 ⁢ 4 ⁢ 8 ⁢ 2$ $q \left[9⁢5\right] = 1. ⁢ 0 ⁢ 0 ⁢ 0 ⁢ 9 ⁢ 4 ⁢ 3 ⁢ 8 ⁢ 0 ⁢ 6 ⁢ 3$ $q \left[9⁢6\right] = 1. ⁢ 0 ⁢ 0 ⁢ 0 ⁢ 8 ⁢ 6 ⁢ 5 ⁢ 4 ⁢ 4 ⁢ 8 ⁢ 2$ $q \left[9⁢7\right] = 1. ⁢ 0 ⁢ 0 ⁢ 0 ⁢ 6 ⁢ 3 ⁢ 0 ⁢ 1 ⁢ 0 ⁢ 2 ⁢ 8$ $q \left[9⁢8\right] = 1. ⁢ 0 ⁢ 0 ⁢ 0 ⁢ 2 ⁢ 3 ⁢ 6 ⁢ 9 ⁢ 8 ⁢ 3 ⁢ 7$ $q \left[9⁢9\right] = 0 . 9 ⁢ 9 ⁢ 9 ⁢ 6 ⁢ 8 ⁢ 4 ⁢ 7 ⁢ 8 ⁢ 0 ⁢ 6$ $q \left[1⁢0⁢0\right] = 0 . 9 ⁢ 9 ⁢ 8 ⁢ 9 ⁢ 7 ⁢ 1 ⁢ 6 ⁢ 5 ⁢ 0 ⁢ 4$ $q \left[101\right] = 0.9980952118$ $q \left[1⁢0⁢2\right] = 0 . 9 ⁢ 9 ⁢ 7 ⁢ 0 ⁢ 5 ⁢ 2 ⁢ 5 ⁢ 3 ⁢ 5 ⁢ 2$ $q \left[1⁢0⁢3\right] = 0 . 9 ⁢ 9 ⁢ 5 ⁢ 8 ⁢ 4 ⁢ 0 ⁢ 1 ⁢ 3 ⁢ 1 ⁢ 8$ $q \left[1⁢0⁢4\right] = 0 . 9 ⁢ 9 ⁢ 4 ⁢ 4 ⁢ 5 ⁢ 3 ⁢ 9 ⁢ 3 ⁢ 9 ⁢ 5$ $q \left[1⁢0⁢5\right] = 0 . 9 ⁢ 9 ⁢ 2 ⁢ 8 ⁢ 8 ⁢ 9 ⁢ 3 ⁢ 0 ⁢ 6 ⁢ 7$ $q \left[1⁢0⁢6\right] = 0 . 9 ⁢ 9 ⁢ 1 ⁢ 1 ⁢ 4 ⁢ 0 ⁢ 9 ⁢ 7 ⁢ 2 ⁢ 8$ $q \left[1⁢0⁢7\right] = 0 . 9 ⁢ 8 ⁢ 9 ⁢ 2 ⁢ 0 ⁢ 3 ⁢ 0 ⁢ 4 ⁢ 6 ⁢ 2$ $q \left[108\right] = 0.9870689790$ $q \left[1⁢0⁢9\right] = 0 . 9 ⁢ 8 ⁢ 4 ⁢ 7 ⁢ 3 ⁢ 1 ⁢ 5 ⁢ 3 ⁢ 7 ⁢ 7$ $q \left[1⁢1⁢0\right] = 0 . 9 ⁢ 8 ⁢ 2 ⁢ 1 ⁢ 8 ⁢ 2 ⁢ 7 ⁢ 6 ⁢ 9 ⁢ 2$ $q \left[1⁢1⁢1\right] = 0.9794139640$ $q \left[1⁢1⁢2\right] = 0 . 9 ⁢ 7 ⁢ 6 ⁢ 4 ⁢ 1 ⁢ 5 ⁢ 6 ⁢ 1 ⁢ 1 ⁢ 9$ $q \left[1⁢1⁢3\right] = 0 . 9 ⁢ 7 ⁢ 3 ⁢ 1 ⁢ 7 ⁢ 7 ⁢ 3 ⁢ 5 ⁢ 4 ⁢ 7$ $q \left[1⁢1⁢4\right] = 0 . 9 ⁢ 6 ⁢ 9 ⁢ 6 ⁢ 8 ⁢ 7 ⁢ 9 ⁢ 2 ⁢ 9 ⁢ 7$ $q \left[115\right] = 0 . 9 ⁢ 6 ⁢ 5 ⁢ 9 ⁢ 3 ⁢ 5 ⁢ 1 ⁢ 0 ⁢ 6 ⁢ 5$ $q \left[1⁢1⁢6\right] = 0 . 9 ⁢ 6 ⁢ 1 ⁢ 9 ⁢ 0 ⁢ 5 ⁢ 6 ⁢ 1 ⁢ 5 ⁢ 8$ $q \left[1⁢1⁢7\right] = 0 . 9 ⁢ 5 ⁢ 7 ⁢ 5 ⁢ 8 ⁢ 5 ⁢ 0 ⁢ 6 ⁢ 7 ⁢ 2$ $q \left[118\right] = 0 . 9529578566$ $q \left[1⁢1⁢9\right] = 0 . 9 ⁢ 4 ⁢ 8 ⁢ 0 ⁢ 0 ⁢ 7 ⁢ 0 ⁢ 6 ⁢ 0 ⁢ 6$ $q \left[1⁢2⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[121\right] = 0.9370596739$ $q \left[1⁢2⁢2\right] = 0 . 9 ⁢ 3 ⁢ 1 ⁢ 0 ⁢ 2 ⁢ 1 ⁢ 4 ⁢ 5 ⁢ 8 ⁢ 1$ $q \left[1⁢2⁢3\right] = 0 . 9 ⁢ 2 ⁢ 4 ⁢ 5 ⁢ 7 ⁢ 6 ⁢ 0 ⁢ 6 ⁢ 8 ⁢ 3$ $q \left[1⁢2⁢5\right] = 0 . 9 ⁢ 1 ⁢ 0 ⁢ 3 ⁢ 5 ⁢ 8 ⁢ 5 ⁢ 1 ⁢ 9 ⁢ 6$ $q \left[1⁢2⁢6\right] = 0 . 9 ⁢ 0 ⁢ 2 ⁢ 5 ⁢ 2 ⁢ 7 ⁢ 5 ⁢ 7 ⁢ 1 ⁢ 3$ $q \left[1⁢2⁢7\right] = 0 . 8 ⁢ 9 ⁢ 4 ⁢ 1 ⁢ 7 ⁢ 1 ⁢ 2 ⁢ 9 ⁢ 7 ⁢ 4$ $q \left[1⁢2⁢8\right] = 0 . 2 ⁢ 9 ⁢ 1 ⁢ 1 ⁢ 7 ⁢ 5 ⁢ 2 ⁢ 3 ⁢ 4 ⁢ 9$ $q \left[1⁢2⁢9\right] = 0 . 2 ⁢ 7 ⁢ 9 ⁢ 0 ⁢ 0 ⁢ 2 ⁢ 9 ⁢ 2 ⁢ 3 ⁢ 6$ $q \left[1⁢3⁢0\right] = 0 . 2 ⁢ 6 ⁢ 7 ⁢ 1 ⁢ 1 ⁢ 5 ⁢ 8 ⁢ 7 ⁢ 0 ⁢ 0$ $q \left[1⁢3⁢1\right] = 0 . 2 ⁢ 5 ⁢ 5 ⁢ 4 ⁢ 9 ⁢ 7 ⁢ 9 ⁢ 6 ⁢ 6 ⁢ 4$ $q \left[1⁢3⁢2\right] = 0 . 2 ⁢ 4 ⁢ 4 ⁢ 1 ⁢ 3 ⁢ 4 ⁢ 3 ⁢ 7 ⁢ 4 ⁢ 2$ $q \left[133\right] = 0 . 2330113868$ $q \left[1⁢3⁢4\right] = 0 . 2 ⁢ 2 ⁢ 2 ⁢ 1 ⁢ 1 ⁢ 6 ⁢ 3 ⁢ 0 ⁢ 8 ⁢ 0$ $q \left[1⁢3⁢5\right] = 0 . 2 ⁢ 1 ⁢ 1 ⁢ 4 ⁢ 3 ⁢ 7 ⁢ 3 ⁢ 4 ⁢ 5 ⁢ 8$ $q \left[1⁢3⁢6\right] = 0 . 2 ⁢ 0 ⁢ 0 ⁢ 9 ⁢ 6 ⁢ 3 ⁢ 5 ⁢ 1 ⁢ 9 ⁢ 1$ $q \left[1⁢3⁢7\right] = 0 . 1 ⁢ 9 ⁢ 0 ⁢ 6 ⁢ 8 ⁢ 4 ⁢ 5 ⁢ 7 ⁢ 5 ⁢ 3$ $q \left[1⁢3⁢8\right] = 0 . 1 ⁢ 8 ⁢ 0 ⁢ 5 ⁢ 9 ⁢ 0 ⁢ 9 ⁢ 1 ⁢ 9 ⁢ 4$ $q \left[1⁢3⁢9\right] = 0 . 1 ⁢ 7 ⁢ 0 ⁢ 6 ⁢ 7 ⁢ 3 ⁢ 5 ⁢ 5 ⁢ 1 ⁢ 7$ $q \left[1⁢4⁢0\right] = 0 . 1 ⁢ 6 ⁢ 0 ⁢ 9 ⁢ 2 ⁢ 4 ⁢ 0 ⁢ 1 ⁢ 2 ⁢ 6$ $q \left[1⁢4⁢1\right] = 0 . 1 ⁢ 5 ⁢ 1 ⁢ 3 ⁢ 3 ⁢ 4 ⁢ 3 ⁢ 3 ⁢ 7 ⁢ 0$ $q \left[1⁢4⁢2\right] = 0 . 1 ⁢ 4 ⁢ 1 ⁢ 8 ⁢ 9 ⁢ 7 ⁢ 0 ⁢ 1 ⁢ 2 ⁢ 3$ $q \left[143\right] = 0.1326049434$ $q \left[1⁢4⁢4\right] = 0 . 1 ⁢ 2 ⁢ 3 ⁢ 4 ⁢ 5 ⁢ 1 ⁢ 4 ⁢ 2 ⁢ 2 ⁢ 2$ $q \left[1⁢4⁢5\right] = 0 . 1 ⁢ 1 ⁢ 4 ⁢ 4 ⁢ 3 ⁢ 0 ⁢ 1 ⁢ 0 ⁢ 0 ⁢ 0$ $q \left[1⁢4⁢6\right] = 0 . 1 ⁢ 0 ⁢ 5 ⁢ 5 ⁢ 3 ⁢ 4 ⁢ 9 ⁢ 6 ⁢ 5 ⁢ 8$ $q \left[1⁢4⁢7\right] = 0 . 0 ⁢ 9 ⁢ 6 ⁢ 7 ⁢ 6 ⁢ 0 ⁢ 3 ⁢ 2 ⁢ 5 ⁢ 9$ $q \left[1⁢4⁢8\right] = 0 . 0 ⁢ 8 ⁢ 8 ⁢ 1 ⁢ 0 ⁢ 0 ⁢ 7 ⁢ 8 ⁢ 7 ⁢ 9$ $q \left[1⁢4⁢9\right] = 0 . 0 ⁢ 7 ⁢ 9 ⁢ 5 ⁢ 5 ⁢ 1 ⁢ 2 ⁢ 4 ⁢ 5 ⁢ 3$ $q \left[1⁢5⁢0\right] = 0 . 0 ⁢ 7 ⁢ 1 ⁢ 1 ⁢ 0 ⁢ 6 ⁢ 8 ⁢ 6 ⁢ 5 ⁢ 7$ $q \left[1⁢5⁢1\right] = 0 . 0 ⁢ 6 ⁢ 2 ⁢ 7 ⁢ 6 ⁢ 3 ⁢ 0 ⁢ 8 ⁢ 1 ⁢ 0$ $q \left[1⁢2⁢4\right] = 0 . 9 ⁢ 1 ⁢ 7 ⁢ 6 ⁢ 9 ⁢ 7 ⁢ 7 ⁢ 8 ⁢ 2 ⁢ 5$ $q \left[1⁢5⁢2\right] = 0 . 0 ⁢ 5 ⁢ 4 ⁢ 5 ⁢ 1 ⁢ 5 ⁢ 5 ⁢ 7 ⁢ 8 ⁢ 9$ $q \left[1⁢5⁢3\right] = 0 . 0 ⁢ 4 ⁢ 6 ⁢ 3 ⁢ 6 ⁢ 0 ⁢ 2 ⁢ 9 ⁢ 5 ⁢ 9$ $q \left[1⁢5⁢4\right] = 0 . 0 ⁢ 3 ⁢ 8 ⁢ 2 ⁢ 9 ⁢ 3 ⁢ 4 ⁢ 1 ⁢ 2 ⁢ 6$ $q \left[1⁢5⁢5\right] = 0 . 0 ⁢ 3 ⁢ 0 ⁢ 3 ⁢ 1 ⁢ 1 ⁢ 3 ⁢ 4 ⁢ 9 ⁢ 5$ $q \left[1⁢5⁢6\right] = 0 . 0 ⁢ 2 ⁢ 2 ⁢ 4 ⁢ 1 ⁢ 0 ⁢ 7 ⁢ 6 ⁢ 4 ⁢ 8$ $q \left[1⁢5⁢7\right] = 0 . 0 ⁢ 1 ⁢ 4 ⁢ 5 ⁢ 8 ⁢ 8 ⁢ 5 ⁢ 5 ⁢ 2 ⁢ 7$ $q \left[1⁢5⁢8\right] = 0 . 0 ⁢ 0 ⁢ 6 ⁢ 8 ⁢ 4 ⁢ 1 ⁢ 8 ⁢ 4 ⁢ 3 ⁢ 5$ $q \left[1⁢5⁢9\right] = - 0 . 0 ⁢ 0 ⁢ 0 ⁢ 8 ⁢ 3 ⁢ 1 ⁢ 9 ⁢ 9 ⁢ 5 ⁢ 6$ $q \left[1⁢6⁢0\right] = - 0 . 0 ⁢ 0 ⁢ 8 ⁢ 4 ⁢ 3 ⁢ 5 ⁢ 3 ⁢ 5 ⁢ 8 ⁢ 4$ $q \left[1⁢6⁢1\right] = - 0 . 0 ⁢ 1 ⁢ 5 ⁢ 9 ⁢ 7 ⁢ 0 ⁢ 3 ⁢ 9 ⁢ 5 ⁢ 7$ $q \left[1⁢6⁢2\right] = - 0 . 0 ⁢ 2 ⁢ 3 ⁢ 4 ⁢ 3 ⁢ 9 ⁢ 0 ⁢ 1 ⁢ 1 ⁢ 5$ $q \left[1⁢6⁢3\right] = - 0 . 0 ⁢ 3 ⁢ 0 ⁢ 8 ⁢ 4 ⁢ 2 ⁢ 8 ⁢ 5 ⁢ 7 ⁢ 2$ $q \left[1⁢6⁢4\right] = - 0 . 0 ⁢ 3 ⁢ 8 ⁢ 1 ⁢ 8 ⁢ 3 ⁢ 3 ⁢ 2 ⁢ 4 ⁢ 9$ $q \left[1⁢6⁢5\right] = - 0 . 0 ⁢ 4 ⁢ 5 ⁢ 4 ⁢ 6 ⁢ 1 ⁢ 5 ⁢ 3 ⁢ 8 ⁢ 8$ $q \left[166\right] = - 0.0526783466$ $q \left[1⁢6⁢7\right] = - 0 . 0 ⁢ 5 ⁢ 9 ⁢ 8 ⁢ 3 ⁢ 4 ⁢ 3 ⁢ 0 ⁢ 8 ⁢ 1$ $q \left[1⁢6⁢8\right] = - 0 . 0 ⁢ 6 ⁢ 6 ⁢ 9 ⁢ 2 ⁢ 9 ⁢ 6 ⁢ 8 ⁢ 3 ⁢ 1$ $q \left[1⁢6⁢9\right] = - 0 . 0 ⁢ 7 ⁢ 3 ⁢ 9 ⁢ 6 ⁢ 4 ⁢ 4 ⁢ 1 ⁢ 7 ⁢ 4$ $q \left[1⁢7⁢0\right] = - 0 . 0 ⁢ 8 ⁢ 0 ⁢ 9 ⁢ 3 ⁢ 8 ⁢ 1 ⁢ 2 ⁢ 6 ⁢ 8$ $q \left[1⁢7⁢1\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[1⁢7⁢2\right] = - 0 . 0 ⁢ 9 ⁢ 4 ⁢ 6 ⁢ 9 ⁢ 9 ⁢ 1 ⁢ 7 ⁢ 8 ⁢ 3$ $q \left[1⁢7⁢3\right] = - 0 . 1 ⁢ 0 ⁢ 1 ⁢ 4 ⁢ 8 ⁢ 3 ⁢ 9 ⁢ 3 ⁢ 4 ⁢ 1$ $q \left[1⁢7⁢4\right] = - 0 . 1 ⁢ 0 ⁢ 8 ⁢ 2 ⁢ 0 ⁢ 2 ⁢ 4 ⁢ 4 ⁢ 5 ⁢ 4$ $q \left[1⁢7⁢5\right] = - 0 . 1 ⁢ 1 ⁢ 4 ⁢ 8 ⁢ 5 ⁢ 2 ⁢ 3 ⁢ 6 ⁢ 8 ⁢ 6$ $q \left[1⁢7⁢6\right] = - 0 . 1 ⁢ 2 ⁢ 1 ⁢ 4 ⁢ 3 ⁢ 0 ⁢ 8 ⁢ 8 ⁢ 7 ⁢ 6$ $q \left[1⁢7⁢7\right] = - 0 . 1 ⁢ 2 ⁢ 7 ⁢ 9 ⁢ 3 ⁢ 4 ⁢ 6 ⁢ 7 ⁢ 9 ⁢ 0$ $q \left[1⁢7⁢8\right] = - 0 . 1 ⁢ 3 ⁢ 4 ⁢ 3 ⁢ 5 ⁢ 9 ⁢ 8 ⁢ 7 ⁢ 3 ⁢ 8$ $q \left[1⁢7⁢9\right] = - 0 . 1 ⁢ 4 ⁢ 0 ⁢ 7 ⁢ 0 ⁢ 2 ⁢ 0 ⁢ 1 ⁢ 3 ⁢ 2$ $q \left[1⁢8⁢0\right] = - 0 . 1 ⁢ 4 ⁢ 6 ⁢ 9 ⁢ 5 ⁢ 6 ⁢ 0 ⁢ 0 ⁢ 0 ⁢ 5$ $q \left[1⁢8⁢1\right] = - 0. ⁢ 1 ⁢ 5 ⁢ 3 ⁢ 1 ⁢ 1 ⁢ 6 ⁢ 0 ⁢ 4 ⁢ 5 ⁢ 5$ $q \left[1⁢8⁢2\right] = - 0 . 1 ⁢ 5 ⁢ 9 ⁢ 1 ⁢ 7 ⁢ 5 ⁢ 6 ⁢ 0 ⁢ 2 ⁢ 4$ $q \left[1⁢8⁢3\right] = - 0 . 1 ⁢ 6 ⁢ 5 ⁢ 1 ⁢ 2 ⁢ 7 ⁢ 3 ⁢ 0 ⁢ 0 ⁢ 5$ $q \left[184\right] = 0 . 1709628636$ $q \left[1⁢8⁢5\right] = - 0 . 1 ⁢ 7 ⁢ 6 ⁢ 6 ⁢ 7 ⁢ 3 ⁢ 0 ⁢ 2 ⁢ 0 ⁢ 2$ $q \left[186\right] = - 0 . 1 ⁢ 8 ⁢ 2 ⁢ 2 ⁢ 4 ⁢ 7 ⁢ 4 ⁢ 0 ⁢ 1 ⁢ 1$ $q \left[1⁢8⁢7\right] = - 0 . 1 ⁢ 8 ⁢ 7 ⁢ 6 ⁢ 7 ⁢ 4 ⁢ 4 ⁢ 2 ⁢ 2 ⁢ 2$ $q \left[1⁢8⁢8\right] = - 0 . 1 ⁢ 9 ⁢ 2 ⁢ 9 ⁢ 4 ⁢ 1 ⁢ 1 ⁢ 5 ⁢ 1 ⁢ 9$ $q \left[1⁢8⁢9\right] = - 0 . 1 ⁢ 9 ⁢ 8 ⁢ 0 ⁢ 3 ⁢ 3 ⁢ 1 ⁢ 5 ⁢ 8 ⁢ 8$ $q \left[1⁢9⁢0\right] = - 0 . 2 ⁢ 0 ⁢ 2 ⁢ 9 ⁢ 3 ⁢ 4 ⁢ 3 ⁢ 3 ⁢ 8 ⁢ 0$ $q \left[191\right] = - 0.2076267137$

13. Filtervorrichtung gemäß einem der vorangehenden Ansprüche, bei dem die Filtercharakteristik auf einer HRTF-Filtercharakteristik basiert.

14. Filtervorrichtung gemäß einem der vorangehenden Ansprüche, bei der die komplexe Analysefilterbank (101) einen Abwärtsabtasteinrichtung (140) für jedes Teilbandsignal aufweist, das durch die komplexe Analysefilterbank (101) ausgegeben wird.

15. Filtervorrichtung gemäß Anspruch 14, bei der die komplexe Analysefilterbank (101) angepasst ist, um L komplexe Teilbandsignale auszugeben, wobei L eine positive ganze Zahl größer als 1 ist, und wobei jede der Abwärtsabtasteinrichtungen (140) angepasst ist, um die Teilbandsignale um einen Faktor von L abwärts abzutasten.

16. Filtervorrichtung gemäß einem der vorangehenden Ansprüche, bei der die komplexe Analysefilterbank (101) ein komplex moduliertes Filter für jedes komplexe Teilbandsignal basierend auf einem Prototypfilter aufweist.

17. Filtervorrichtung gemäß einem der vorangehenden Ansprüche, bei der die komplexe Synthesefilterbank (103) einen Aufwärtsabtaster (106) für jedes der Teilbandsignale aufweist.

18. Filtervorrichtung gemäß Anspruch 17, bei der die komplexe Synthesefilterbank (103) wirksam ist, um L Signale der Zwischenfilter zu synthetisieren, um das Zeitbereichsausgangssignal zu erhalten, wobei L eine positive ganze Zahl größer als 1 ist, wobei die komplexe Synthesefilterbank (103) L Aufwärtsabtasteinrichtungen (160) aufweist, und wobei jede der Aufwärtsabtasteinrichtungen zum Aufwärtsabtasten der Ausgabe der Zwischenfilter (190) um einen Faktor von L angepasst ist.

19. Filtervorrichtung gemäß einem der vorangehenden Ansprüche, bei der die komplexe Synthesefilterbank (103) für jedes Teilbandsignal ein Zwischensynthesefilter aufweist, wobei die komplexe Synthesefilterbank (103) einen Echtteilextraktor (180) für jedes Signal aufweist, das durch Zwischensynthesefilter (150) ausgegeben wird, und wobei die komplexe Synthesefilterbank (103) ferner einen Addierer (170) aufweist zum Addieren der Ausgabe von jedem des Echtteilextraktors (180), um das Zeitbereichsausgangssignal zu erhalten.

20. Filtervorrichtung gemäß einem der Ansprüche 1 bis 18, bei der die komplexe Synthesefilterbank (103) ein Zwischensynthesefilter (150) für jedes der Teilbandsignale aufweist, das durch die Zwischenfilter (190) ausgegeben wird, wobei die komplexe Synthesefilterbank (103) ferner einen Addierer (170) aufweist zum Summieren der Ausgaben von jedem Zwischensynthesefilter (150) und wobei die komplexe Synthesefilterbank (103) ferner einen Echtteilextraktor (180) zum Extrahieren eines echtwertigen Signals als das Zeitbereichsausgangssignal aus der Ausgabe des Addierers (170) aufweist.

21. Filtervorrichtung gemäß einem der vorangehenden Ansprüche, wobei die Filtervorrichtung ferner eine Verstärkungseinstelleinrichtung aufweist für zumindest ein Teilbandsignal oder für zumindest ein Signal, das durch das Zwischenfilter (190) zum Einstellen der Verstärkung ausgegeben wird.

22. Filtervorrichtung gemäß einem der vorangehenden Ansprüche, wobei die Filtervorrichtung ferner ein weiteres Zwischenfilter aufweist zum Filtern von zumindest einem der komplexwertigen Teilbandsignale oder zum Filtern von zumindest einem der Signale, die durch eines der Zwischenfilter (190) ausgegeben werden.

23. Verfahren zum Filtern eines Zeitbereichseingangssignals, um ein Zeitbereichsausgangssignal zu erhalten, das eine Darstellung des Zeitbereichseingangssignals ist, gefiltert unter Verwendung einer Filtercharakteristik mit einer nicht-einheitlichen Amplituden/Frequenz-Charakteristik,
das folgende Schritte aufweist:
Filtern eines finiten Impulsantwortsignals, das K_{H} · L Filterabgriffe aufweist und anzeigend für die Filtercharakteristik der nicht-einheitlichen Amplituden/FrequenzCharakteristik ist, basierend auf einem Prototypfilter, das K_{Q} · L Abgriffe aufweist, um L komplexwertige Teilbandsignale als ein Zwischenfilterdefinitionssignal zu erhalten,
wobei jedes komplexwertige Teilbandsignal des Zwischenfilterdefinitionssignals einer Filterimpulsantwort für ein Teilband entspricht, das (K_{H} + K_{Q} - 1) Filterabgriffe aufweist;
wobei zumindest eines der komplexwertigen Teilbandsignale des Zwischenfilterdefinitionssignals zumindest zwei unterschiedliche nicht-verschwindende Werte aufweist; und
wobei zumindest eines der komplexwertigen Teilbandsignale des Zwischenfilterdefinitionssignals einer nicht-einheitlichen Amplituden/Frequenz-Charakteristik entspricht;
Analysieren des Zeitbereichseingangssignals, um L komplexe Teilbandsignale zu erhalten;
Filtern von jedem der analysierten, komplexen Teilbandsignale,
wobei zumindest eines der komplexen Teilbandsignale unter Verwendung einer nicht-einheitlichen Amplituden/Frequenz-Charakteristik gefiltert wird,
wobei jedes der komplexen Teilbandsignale basierend auf einer Filterimpulsantwort des Filterdefinitionssignals gefiltert wird;
wobei die Filterimpulsantworten des Filterdefinitionssignals (K_{H} + K_{Q} - 1) Filterabgriffe aufweisen, die jeweils kürzer sind als die Impulsantwort eines Filters mit der Filtercharakteristik, die K_{H} · L Abgriffe aufweist; und
wobei die nicht-einheitliche Amplituden/Frequenz-Charakteristik der Impulsantworten, die zum Filtern der Mehrzahl der Teilbandsignale verwendet werden, zusammen die nicht-einheitliche Filtercharakteristik darstellen; und
Synthetisieren des Zeitbereichsausgangssignals aus der Ausgabe der Filterung der analysierten komplexen Teilbandsignale,
wobei L, K_{Q} und K_{H} positive ganze Zahlen sind.

24. Computerprogramm zum Ausführen eines Verfahrens gemäß dem Verfahren von Anspruch 23, wenn das Programm auf einem Computer ausgeführt wird.

## Revendications

1. Appareil de filtration destiné à filtrer un signal d'entrée dans le domaine temporel, pour obtenir un signal de sortie dans le domaine temporel qui est une représentation du signal d'entrée dans le domaine temporel filtré à l'aide d'une caractéristique de filtre présentant une caractéristique d'amplitude/de fréquence non uniforme,
comprenant:
un banc de filtres d'analyse complexe (101) destiné à générer L signaux de sous-bande complexes à partir du signal d'entrée dans le domaine temporel;
une pluralité de filtres intermédiaires (190), chaque filtre intermédiaire (190) ayant une réponse impulsionnelle finie comprenant (K_{H} + K_{Q} - 1) dérivations de filtre, où un filtre intermédiaire est prévu pour chaque signal de sous-bande complexe;
un banc de filtres de synthèse complexe (103) destiné à synthétiser la sortie des filtres intermédiaires (190), pour obtenir le signal de sortie dans le domaine temporel,
un générateur de dérivations de filtre (104) comprenant un banc de filtres modulé complexe (301) sur base d'un filtre prototype comprenant K_{Q} · L dérivations pour filtrer un signal de réponse impulsionnelle finie indiquant la caractéristique de filtre d'amplitude/de fréquence dans le domaine temporel et comprenant K_{H} · L dérivations de filtre, pour obtenir L signaux de sous-bande à valeurs complexes comme signal de définition de filtre intermédiaire,
dans lequel chaque signal de sous-bande à valeurs complexes du banc de filtres modulé complexe du générateur de dérivations de filtre correspond à une réponse impulsionnelle pour un filtre intermédiaire (190) comprenant (K_{H} + K_{Q} - 1) dérivations de filtre;
dans lequel au moins l'un des signaux de sous-bande à valeurs complexes du banc de filtres modulé complexe du générateur de dérivations de filtre comprend au moins deux valeurs non évanouissantes différentes;
dans lequel chaque signal de sous-bande à valeurs complexes du banc de filtres modulé complexe du générateur de dérivations de filtre comprenant (K_{H} + K_{Q} - 1) dérivations de filtre est plus court que le signal de réponse impulsionnelle comprenant K_{H} · L dérivations de filtre fourni au générateur de dérivations de filtre;
dans lequel la pluralité de filtres intermédiaires sont opérationnels pour recevoir le signal de définition de filtre intermédiaire du générateur de dérivations de filtre (104);
dans lequel chaque filtre intermédiaire (190) de la pluralité de filtres intermédiaires est opérationnel pour avoir une réponse impulsionnelle fonction du signal de définition de filtre intermédiaire;
dans lequel au moins l'un des filtres intermédiaires (190) de la pluralité de filtres intermédiaires (190) a une caractéristique d'amplitude/de fréquence non uniforme;
dans lequel les caractéristiques d'amplitude/de fréquence non uniformes de la pluralité de filtres intermédiaires représentent ensemble la caractéristique de filtre non uniforme; et
dans lequel L, K_{Q} et K_{H} sont des nombres entiers positifs.

2. Appareil de filtration selon la revendication 1, dans lequel au moins l'un des filtres intermédiaires (190) a une caractéristique de filtre passe-bas, une caractéristique de filtre passe-haut, une caractéristique de filtre passe-bande, une caractéristique de filtre de rejet de bande ou une caractéristique de filtre à encoches.

3. Appareil de filtration selon l'une quelconque des revendications précédentes, dans lequel les filtres intermédiaires (190) de la pluralité de filtres intermédiaires (190) sont des filtres de réponse impulsionnelle finie.

4. Appareil de filtration selon l'une quelconque des revendications précédentes, dans lequel la pluralité de filtres intermédiaires (190) sont par ailleurs opérationnels pour recevoir le signal de définition de filtre intermédiaire d'une base de données (500) ou d'un processeur (510).

5. Appareil de filtration selon l'une quelconque des revendications précédentes, dans lequel le banc de filtres d'analyse complexe (101) est opérationnel pour sortir L signaux de sous-bande complexes, dans lequel la pluralité de filtres intermédiaires (190) comprend L filtres intermédiaires (190), dans lequel le banc de filtres de synthèse complexe (103) est opérationnel pour synthétiser la sortie des L filtres intermédiaires (190), et dans lequel L est un nombre entier positif supérieur à 1.

6. Appareil de filtration selon la revendication 5, dans lequel le banc de filtres d'analyse complexe (101), la pluralité de filtres intermédiaires (190) et le banc de filtres de synthèse complexe (103) sont opérationnels pour avoir L = 64.

7. Appareil de filtration selon l'une quelconque des revendications 5 ou 6, dans lequel la pluralité de filtres intermédiaires (190) sont opérationnels pour filtrer les signaux de sous-bande complexes sur base de l'équation ${d}_{n} \left(k\right) = {\sum }_{l} {g}_{n} \left(l\right) {c}_{n} ⁢ \left(k-l\right)$ où n est un nombre entier dans la plage de 0 à (L-1) indiquant un indice des signaux de sous-bande, où L et k sont des nombres entiers, où *dₙ(k)* est la sortie du filtre intermédiaire (190) du signal de sous-bande à l'indice *n*, où *cₙ(k)* est le signal de sous-bande à l'indice n, et où *gₙ(l)* est la réponse impulsionnelle du filtre intermédiaire (190) pour le signal de sous-bande à l'indice n.

8. Appareil de filtration selon l'une quelconque des revendications 5 à 7, dans lequel le filtre intermédiaire (190) à l'indice n a une réponse impulsionnelle gₙ(k) qui est basée sur l'équation ${g}_{n} \left(k\right) = {\sum }_{ν = - ∞}^{∞} h ⁢ \left(ν+kL\right) ⁢ q \left(v\right) ⁢ exp \left(-i⁢\frac{π}{L}⁢\left(n+\frac{1}{2}\right)⁢v\right)$ où n est un nombre entier dans la plage de 0 à (*L*-1) indiquant l'indice du signal de sous-bande, où *k* et v sont des nombres entiers, où *h*(*v*) est la réponse d'un filtre ayant la caractéristique de filtre, où n = 3.1415926... est le nombre circulaire, où $i = \sqrt{- 1}$ est l'unité complexe, et où *q*(*v*) sont des dérivations de filtre d'un filtre prototype à valeurs réelles.

9. Appareil de filtration selon l'une quelconque des revendications 5 à 8, dans lequel au moins l'un des filtres intermédiaires (190) à indice *n* a une réponse impulsionnelle *gₙ*(*k*) qui est basée sur l'équation ${g}_{n} \left(l\right) = {\sum }_{ν = 0}^{191} {h}^{} ⁢ \left(ν+64⋅\left(l-2\right)\right) ⋅ q \left(v\right) ⁢ exp \left(-i⁢\frac{π}{64}⁢\left(n+\frac{1}{2}\right)⁢\left(v-95\right)\right)$ où ${h}^{} \left(v\right) = { \begin{matrix}h \left(v\right) , & v = 0 , 1 , \text{...} , {N}_{h} - 1 \\ 0 & , autrement\end{matrix}$ où *Nₕ* est la longueur de la réponse impulsionnelle *h*(*u)* d'un filtre ayant la caractéristique de filtre, où *n* = 3.1415926... est le nombre circulaire, où $i = \sqrt{- 1}$ est l'unité complexe, et où *q(v)* sont des dérivations de filtre d'un filtre prototype à valeurs réelles.

10. Appareil de filtration selon l'une quelconque des revendications 8 ou 9, dans lequel les filtres intermédiaires (190) sont adaptés de sorte que les dérivations de filtre prototype q(v) remplissent, pour les nombres entiers *v* de 0 à 191, les rapports:$- 0 . 2 ⁢ 0 ⁢ 4 \leq q \left[0\right] \leq - 0 . 2 ⁢ 0 ⁢ 2$ $- 0 . 1 ⁢ 9 ⁢ 9 \leq q \left[1\right] \leq - 0 . 1 ⁢ 9 ⁢ 7$ $- 0 . 1 ⁢ 9 ⁢ 4 \leq q \left[2\right] \leq - 0 . 1 ⁢ 9 ⁢ 2$ $- 0 . 189 \leq q \left[3\right] \leq - 0 . 1 ⁢ 8 ⁢ 7$ $- 0 . 183 \leq q \left[4\right] \leq - 0 . 1 ⁢ 8 ⁢ 1$ $- 0.178 \leq q \left[5\right] \leq - 0 . 1 ⁢ 7 ⁢ 6$ $- 0 . 1 ⁢ 7 ⁢ 2 \leq q \left[6\right] \leq - 0 . 1 ⁢ 7 ⁢ 0$ $- 0 . 1 ⁢ 6 ⁢ 6 \leq q \left[7\right] \leq - 0 . 1 ⁢ 6 ⁢ 4$ $- 0 . 1 ⁢ 6 ⁢ 0 \leq q \left[8\right] \leq - 0 . 1 ⁢ 5 ⁢ 8$ $- 0 . 1 ⁢ 5 ⁢ 4 \leq q \left[9\right] \leq - 0 . 1 ⁢ 5 ⁢ 2$ $- 0.148 \leq q \left[1⁢0\right] \leq - 0 . 1 ⁢ 4 ⁢ 6$ $- 0 . 1 ⁢ 4 ⁢ 2 \leq q \left[1⁢1\right] \leq - 0 . 1 ⁢ 4 ⁢ 0$ $- 0 . 1 ⁢ 3 ⁢ 5 \leq q \left[1⁢2\right] \leq - 0 . 1 ⁢ 3 ⁢ 3$ $- 0 . 1 ⁢ 2 ⁢ 9 \leq q \left[1⁢3\right] \leq - 0 . 1 ⁢ 2 ⁢ 7$ $- 0 . 1 ⁢ 2 ⁢ 2 \leq q \left[1⁢4\right] \leq - 0 . 1 ⁢ 2 ⁢ 0$ $- 0 . 1 ⁢ 1 ⁢ 6 \leq q \left[1⁢5\right] \leq - 0 . 1 ⁢ 1 ⁢ 4$ $- 0 . 1 ⁢ 0 ⁢ 9 \leq q \left[1⁢6\right] \leq - 0 . 1 ⁢ 0 ⁢ 7$ $- 0 . 1 ⁢ 0 ⁢ 2 \leq q \left[17\right] \leq - 0 . 1 ⁢ 0 ⁢ 0$ $- 0 . 0 ⁢ 9 ⁢ 6 \leq q \left[18\right] \leq - 0.094$ $- 0 . 089 \leq q \left[1⁢9\right] \leq - 0 . 0 ⁢ 8 ⁢ 7$ $- 0 . 0 ⁢ 8 ⁢ 2 \leq q \left[2⁢0\right] \leq - 0 . 0 ⁢ 8 ⁢ 0$ $- 0 . 0 ⁢ 7 ⁢ 5 \leq q \left[2⁢1\right] \leq - 0. ⁢ 0 ⁢ 7 ⁢ 3$ $- 0 . 0 ⁢ 6 ⁢ 8 \leq q \left[2⁢2\right] \leq - 0 . 0 ⁢ 6 ⁢ 6$ $- 0 . 0 ⁢ 6 ⁢ 1 \leq q \left[2⁢3\right] \leq - 0 . 0 ⁢ 5 ⁢ 9$ $- 0 . 054 \leq q \left[24\right] \leq - 0 . 052 \begin{matrix}\end{matrix}$ $- 0. ⁢ 0 ⁢ 4 ⁢ 6 \leq q \left[2⁢5\right] \leq - 0 . 0 ⁢ 4 ⁢ 4$ $- 0 . 0 ⁢ 3 ⁢ 9 \leq q \left[2⁢6\right] \leq - 0 . 0 ⁢ 3 ⁢ 7$ $- 0 . 0 ⁢ 3 ⁢ 2 \leq q \left[2⁢7\right] \leq - 0 . 0 ⁢ 3 ⁢ 0$ $- 0 . 0 ⁢ 2 ⁢ 4 \leq q \left[2⁢8\right] \leq - 0 . 0 ⁢ 2 ⁢ 2$ $- 0 . 0 ⁢ 1 ⁢ 7 \leq q \left[2⁢9\right] \leq - 0 . 0 ⁢ 1 ⁢ 5$ $- 0 . 0 ⁢ 0 ⁢ 9 \leq q \left[3⁢0\right] \leq - 0 . 0 ⁢ 0 ⁢ 7$ $- 0 . 0 ⁢ 0 ⁢ 2 \leq q \left[3⁢1\right] \leq - 0 . 0 ⁢ 0 ⁢ 0$ $0. ⁢ 0 ⁢ 0 ⁢ 6 \leq q \left[3⁢2\right] \leq 0 . 0 ⁢ 0 ⁢ 8$ $0.014 \leq q \left[33\right] \leq 0.016$ $0. ⁢ 0 ⁢ 2 ⁢ 1 \leq q \left[3⁢4\right] \leq 0 . 0 ⁢ 2 ⁢ 3$ $0 . 0 ⁢ 2 ⁢ 9 \leq q \left[3⁢5\right] \leq 0 . 0 ⁢ 3 ⁢ 1$ $0 . 0 ⁢ 3 ⁢ 7 \leq q \left[3⁢6\right] \leq 0 . 0 ⁢ 3 ⁢ 9$ $0 . 0 ⁢ 4 ⁢ 5 \leq q \left[3⁢7\right] \leq 0 . 0 ⁢ 4 ⁢ 7$ $0 . 0 ⁢ 5 ⁢ 4 \leq q \left[3⁢8\right] \leq 0 . 0 ⁢ 5 ⁢ 6$ $0 . 0 ⁢ 6 ⁢ 2 \leq q \left[39\right] \leq 0 . 0 ⁢ 6 ⁢ 4$ $0 . 0 ⁢ 7 ⁢ 0 \leq q \left[4⁢0\right] \leq 0 . 0 ⁢ 7 ⁢ 2$ $0 . 0 ⁢ 7 ⁢ 9 \leq q \left[4⁢1\right] \leq 0 . 0 ⁢ 8 ⁢ 1$ $0 . 0 ⁢ 8 ⁢ 7 \leq q \left[4⁢2\right] \leq 0 . 0 ⁢ 8 ⁢ 9$ $0. ⁢ 0 ⁢ 9 ⁢ 6 \leq q \left[43\right] \leq 0 . 0 ⁢ 9 ⁢ 8$ $0 . 1 ⁢ 0 ⁢ 5 \leq q \left[44\right] \leq 0 . 1 ⁢ 0 ⁢ 7$ $0 . 1 ⁢ 1 ⁢ 3 \leq q \left[4⁢5\right] \leq 0 . 1 ⁢ 1 ⁢ 5$ $0 . 1 ⁢ 2 ⁢ 2 \leq q \left[4⁢6\right] \leq 0 . 1 ⁢ 2 ⁢ 4$ $0 . 1 ⁢ 3 ⁢ 2 \leq q \left[4⁢7\right] \leq 0 . 1 ⁢ 3 ⁢ 4$ $0 . 1 ⁢ 4 ⁢ 1 \leq q \left[4⁢8\right] \leq 0 . 1 ⁢ 4 ⁢ 3$ $0 . 1 ⁢ 5 ⁢ 0 \leq q \left[4⁢9\right] \leq 0 . 1 ⁢ 5 ⁢ 2$ $0 . 1 ⁢ 6 ⁢ 0 \leq q \left[5⁢0\right] \leq 0 . 1 ⁢ 6 ⁢ 2$ $0 . 1 ⁢ 7 ⁢ 0 \leq q \left[5⁢1\right] \leq 0 . 1 ⁢ 7 ⁢ 2$ $0.1 ⁢ 8 ⁢ 0 \leq q \left[5⁢2\right] \leq 0 . 1 ⁢ 8 ⁢ 2$ $0 . 1 ⁢ 9 ⁢ 0 \leq q \left[53\right] \leq 0 . 1 ⁢ 9 ⁢ 2$ $0.200 \leq q \left[5⁢4\right] \leq 0 . 2 ⁢ 0 ⁢ 2$ $0 . 2 ⁢ 1 ⁢ 0 \leq q \left[5⁢5\right] \leq 0 . 2 ⁢ 1 ⁢ 2$ $0 . 2 ⁢ 2 ⁢ 1 \leq q \left[5⁢6\right] \leq 0 . 2 ⁢ 2 ⁢ 3$ $0 . 2 ⁢ 3 ⁢ 2 \leq q \left[5⁢7\right] \leq 0 . 2 ⁢ 3 ⁢ 4$ $0 . 2 ⁢ 4 ⁢ 3 \leq q \left[5⁢8\right] \leq 0 . 2 ⁢ 4 ⁢ 5$ $0 . 2 ⁢ 5 ⁢ 4 \leq q \left[5⁢9\right] \leq 0 . 2 ⁢ 5 ⁢ 6$ $0 . 2 ⁢ 6 ⁢ 6 \leq q \left[6⁢0\right] \leq 0 . 2 ⁢ 6 ⁢ 8$ $0 . 2 ⁢ 7 ⁢ 8 \leq q \left[6⁢1\right] \leq 0 . 2 ⁢ 8 ⁢ 0$ $0 . 2 ⁢ 9 ⁢ 0 \leq q \left[6⁢2\right] \leq 0 . 2 ⁢ 9 ⁢ 2$ $0 . 3 ⁢ 0 ⁢ 3 \leq q \left[6⁢3\right] \leq 0 . 3 ⁢ 0 ⁢ 5$ $0. ⁢ 9 ⁢ 0 ⁢ 2 \leq q \left[64\right] \leq 0 . 9 ⁢ 0 ⁢ 4$ $0 . 9 ⁢ 0 ⁢ 9 \leq q \left[6⁢5\right] \leq 0 . 9 ⁢ 1 ⁢ 1$ $0 . 9 ⁢ 1 ⁢ 7 \leq q \left[6⁢6\right] \leq 0 . 9 ⁢ 1 ⁢ 9$ $0 . 9 ⁢ 2 ⁢ 4 \leq q \left[6⁢7\right] \leq 0 . 9 ⁢ 2 ⁢ 6$ $0 . 9 ⁢ 3 ⁢ 0 \leq q \left[68\right] \leq 0 . 9 ⁢ 3 ⁢ 2$ $0 . 9 ⁢ 3 ⁢ 6 \leq q \left[6⁢9\right] \leq 0 . 938$ $0 . 9 ⁢ 4 ⁢ 2 \leq q \left[7⁢0\right] \leq 0. ⁢ 9 ⁢ 4 ⁢ 4$ $0 . 9 ⁢ 4 ⁢ 7 \leq q \left[7⁢1\right] \leq 0 . 9 ⁢ 4 ⁢ 9$ $0 . 9 ⁢ 5 ⁢ 2 \leq q \left[7⁢2\right] \leq 0 . 9 ⁢ 5 ⁢ 4$ $0 . 9 ⁢ 5 ⁢ 7 \leq q \left[7⁢3\right] \leq 0. ⁢ 9 ⁢ 5 ⁢ 9$ $0 . 9 ⁢ 6 ⁢ 1 \leq q \left[7⁢4\right] \leq 0 . 9 ⁢ 6 ⁢ 3$ $0 . 9 ⁢ 6 ⁢ 5 \leq q \left[7⁢5\right] \leq 0 . 9 ⁢ 6 ⁢ 7$ $0. ⁢ 9 ⁢ 6 ⁢ 9 \leq q \left[7⁢6\right] \leq 0 . 9 ⁢ 7 ⁢ 1$ $0. ⁢ 9 ⁢ 7 ⁢ 2 \leq q \left[7⁢7\right] \leq 0 . 9 ⁢ 7 ⁢ 4$ $0 . 9 ⁢ 7 ⁢ 5 \leq q \left[7⁢8\right] \leq 0 . 9 ⁢ 7 ⁢ 7$ $0 . 978 \leq q \left[7⁢9\right] \leq 0 . 9 ⁢ 8 ⁢ 0$ $0. ⁢ 9 ⁢ 8 ⁢ 1 \leq q \left[8⁢0\right] \leq 0 . 9 ⁢ 8 ⁢ 3$ $0. ⁢ 984 \leq q \left[81\right] \leq 0 . 9 ⁢ 86$ $0. ⁢ 9 ⁢ 8 ⁢ 6 \leq q \left[8⁢2\right] \leq 0 . 9 ⁢ 8 ⁢ 8$ $0. ⁢ 9 ⁢ 8 ⁢ 8 \leq q \left[8⁢3\right] \leq 0 . 9 ⁢ 9 ⁢ 0$ $0. ⁢ 9 ⁢ 9 ⁢ 0 \leq q \left[84\right] \leq 0 . 9 ⁢ 9 ⁢ 2$ $0 . 9 ⁢ 9 ⁢ 2 \leq q \left[8⁢5\right] \leq 0 . 9 ⁢ 9 ⁢ 4$ $0 . 9 ⁢ 9 ⁢ 3 \leq q \left[8⁢6\right] \leq 0. ⁢ 9 ⁢ 9 ⁢ 5$ $0. ⁢ 9 ⁢ 9 ⁢ 5 \leq q \left[8⁢7\right] \leq 0 . 9 ⁢ 9 ⁢ 7$ $0. ⁢ 9 ⁢ 9 ⁢ 6 \leq q \left[8⁢8\right] \leq 0 . 9 ⁢ 9 ⁢ 8$ $0. ⁢ 9 ⁢ 9 ⁢ 7 \leq q \left[8⁢9\right] \leq 0. ⁢ 9 ⁢ 9 ⁢ 9$ $0 . 998 \leq q \left[9⁢0\right] \leq 1. ⁢ 0 ⁢ 0 ⁢ 0$ $0. ⁢ 9 ⁢ 9 ⁢ 9 \leq q \left[9⁢1\right] \leq 1. ⁢ 0 ⁢ 0 ⁢ 1$ $0 . 9 ⁢ 9 ⁢ 9 \leq q \left[9⁢2\right] \leq 1. ⁢ 0 ⁢ 0 ⁢ 1$ $1.0 ⁢ 0 ⁢ 0 \leq q \left[9⁢3\right] \leq 1 . 0 ⁢ 0 ⁢ 2$ $1.000 \leq q \left[9⁢4\right] \leq 1. ⁢ 0 ⁢ 0 ⁢ 2$ $1. ⁢ 0 ⁢ 0 ⁢ 0 \leq q \left[9⁢5\right] \leq 1. ⁢ 0 ⁢ 0 ⁢ 2$ $1.000 \leq q \left[9⁢6\right] \leq 1. ⁢ 0 ⁢ 0 ⁢ 2$ $1. ⁢ 0 ⁢ 0 ⁢ 0 \leq q \left[9⁢7\right] \leq 1. ⁢ 0 ⁢ 0 ⁢ 2$ $1.000 \leq q \left[9⁢8\right] \leq 1. ⁢ 0 ⁢ 0 ⁢ 1$ $0 . 9 ⁢ 9 ⁢ 9 \leq q \left[9⁢9\right] \leq 1. ⁢ 0 ⁢ 0 ⁢ 1$ $0 . 998 \leq q \left[1⁢0⁢0\right] \leq 1. ⁢ 0 ⁢ 0 ⁢ 0$ $0 . 9 ⁢ 9 ⁢ 7 \leq q \left[1⁢0⁢1\right] \leq 0 . 9 ⁢ 9 ⁢ 9$ $0 . 9 ⁢ 9 ⁢ 6 \leq q \left[1⁢0⁢2\right] \leq 0 . 9 ⁢ 9 ⁢ 8$ $0 . 9 ⁢ 9 ⁢ 5 \leq q \left[1⁢0⁢3\right] \leq 0 . 9 ⁢ 9 ⁢ 7$ $0 . 9 ⁢ 9 ⁢ 3 \leq q \left[1⁢0⁢4\right] \leq 0 . 9 ⁢ 9 ⁢ 5$ $0 . 9 ⁢ 9 ⁢ 2 \leq q \left[1⁢0⁢5\right] \leq 0. ⁢ 9 ⁢ 9 ⁢ 4$ $0. ⁢ 9 ⁢ 9 ⁢ 0 \leq q \left[1⁢0⁢6\right] \leq 0. ⁢ 9 ⁢ 9 ⁢ 2$ $0 . 988 \leq q \left[1⁢0⁢7\right] \leq 0. ⁢ 9 ⁢ 9 ⁢ 0$ $0 . 986 \leq q \left[1⁢0⁢8\right] \leq 0. ⁢ 9 ⁢ 8 ⁢ 8$ $0 . 984 \leq q \left[1⁢0⁢9\right] \leq 0 . 9 ⁢ 8 ⁢ 6$ $0 . 981 \leq q \left[1⁢1⁢0\right] \leq 0. ⁢ 9 ⁢ 8 ⁢ 3$ $0 . 978 \leq q \left[1⁢1⁢1\right] \leq 0 . 9 ⁢ 8 ⁢ 0$ $0. ⁢ 9 ⁢ 7 ⁢ 5 \leq q \left[1⁢1⁢2\right] \leq 0 . 9 ⁢ 7 ⁢ 7$ $0 . 9 ⁢ 7 ⁢ 2 \leq q \left[1⁢1⁢3\right] \leq 0 . 9 ⁢ 7 ⁢ 4$ $0 . 9 ⁢ 6 ⁢ 9 \leq q \left[1⁢1⁢4\right] \leq 0 . 9 ⁢ 7 ⁢ 1$ $0 . 9 ⁢ 6 ⁢ 5 \leq q \left[1⁢1⁢5\right] \leq 0 . 9 ⁢ 6 ⁢ 7$ $0 . 9 ⁢ 6 ⁢ 1 \leq q \left[1⁢1⁢6\right] \leq 0. ⁢ 9 ⁢ 6 ⁢ 3$ $0 . 9 ⁢ 5 ⁢ 7 \leq q \left[1⁢1⁢7\right] \leq 0 . 9 ⁢ 5 ⁢ 9$ $0 . 9 ⁢ 5 ⁢ 2 \leq q \left[1⁢1⁢8\right] \leq 0 . 9 ⁢ 5 ⁢ 4$ $0 . 9 ⁢ 4 ⁢ 7 \leq q \left[1⁢1⁢9\right] \leq 0 . 9 ⁢ 4 ⁢ 9$ $0 . 9 ⁢ 4 ⁢ 2 \leq q \left[1⁢2⁢0\right] \leq 0 . 9 ⁢ 4 ⁢ 4$ $0 . 9 ⁢ 3 ⁢ 6 \leq q \left[1⁢2⁢1\right] \leq 0. ⁢ 9 ⁢ 3 ⁢ 8$ $0 . 9 ⁢ 3 ⁢ 0 \leq q \left[1⁢2⁢2\right] \leq 0 . 9 ⁢ 3 ⁢ 2$ $0. ⁢ 9 ⁢ 2 ⁢ 4 \leq q \left[1⁢2⁢3\right] \leq 0. ⁢ 9 ⁢ 2 ⁢ 6$ $0. ⁢ 9 ⁢ 1 ⁢ 7 \leq q \left[124\right] \leq 0 . 9 ⁢ 1 ⁢ 9$ $0 . 9 ⁢ 0 ⁢ 9 \leq q \left[1⁢2⁢5\right] \leq 0 . 9 ⁢ 1 ⁢ 1$ $0 . 902 \leq q \left[126\right] \leq 0 . 904$ $0 . 8 ⁢ 9 ⁢ 3 \leq q \left[1⁢2⁢7\right] \leq 0. ⁢ 8 ⁢ 9 ⁢ 5$ $0 . 2 ⁢ 9 ⁢ 0 \leq q \left[1⁢2⁢8\right] \leq 0 . 2 ⁢ 9 ⁢ 2$ $0 . 2 ⁢ 7 ⁢ 8 \leq q \left[1⁢2⁢9\right] \leq 0 . 2 ⁢ 8 ⁢ 0$ $0 . 2 ⁢ 6 ⁢ 6 \leq q \left[1⁢3⁢0\right] \leq 0 . 2 ⁢ 6 ⁢ 8$ $0 . 5 ⁢ 2 ⁢ 4 \leq q \left[1⁢3⁢1\right] \leq 0 . 2 ⁢ 5 ⁢ 6$ $0 . 2 ⁢ 4 ⁢ 3 \leq q \left[1⁢3⁢2\right] \leq 0 . 2 ⁢ 4 ⁢ 5$ $0 . 2 ⁢ 3 ⁢ 2 \leq q \left[1⁢3⁢3\right] \leq 0 . 2 ⁢ 3 ⁢ 4$ $0 . 2 ⁢ 2 ⁢ 1 \leq q \left[1⁢3⁢4\right] \leq 0 . 2 ⁢ 2 ⁢ 3$ $0 . 2 ⁢ 1 ⁢ 0 \leq q \left[1⁢3⁢5\right] \leq 0 . 2 ⁢ 1 ⁢ 2$ $0.200 \leq q \left[1⁢3⁢6\right] \leq 0 . 2 ⁢ 0 ⁢ 2$ $0 . 1 ⁢ 9 ⁢ 0 \leq q \left[1⁢3⁢7\right] \leq 0 . 1 ⁢ 9 ⁢ 2$ $0.180 \leq q \left[138\right] \leq 0 . 1 ⁢ 8 ⁢ 2$ $0 . 1 ⁢ 7 ⁢ 0 \leq q \left[1⁢3⁢9\right] \leq 0 . 1 ⁢ 7 ⁢ 2$ $0 . 1 ⁢ 6 ⁢ 0 \leq q \left[1⁢4⁢0\right] \leq 0 . 1 ⁢ 6 ⁢ 2$ $0.1 ⁢ 5 ⁢ 0 \leq q \left[1⁢4⁢1\right] \leq 0 . 1 ⁢ 5 ⁢ 2$ $0 . 1 ⁢ 4 ⁢ 1 \leq q \left[1⁢4⁢2\right] \leq 0 . 1 ⁢ 4 ⁢ 3$ $0 . 1 ⁢ 3 ⁢ 2 \leq q \left[143\right] \leq 0 . 1 ⁢ 3 ⁢ 4$ $0 . 1 ⁢ 2 ⁢ 2 \leq q \left[144\right] \leq 0 . 1 ⁢ 2 ⁢ 4$ $0 . 1 ⁢ 1 ⁢ 3 \leq q \left[145\right] \leq 0 . 1 ⁢ 1 ⁢ 5$ $0 . 1 ⁢ 0 ⁢ 5 \leq q \left[1⁢4⁢6\right] \leq 0 . 1 ⁢ 0 ⁢ 7$ $0. ⁢ 0 ⁢ 9 ⁢ 6 \leq q \left[1⁢4⁢7\right] \leq 0 . 0 ⁢ 9 ⁢ 8$ $0. ⁢ 0 ⁢ 8 ⁢ 7 \leq q \left[148\right] \leq 0 . 0 ⁢ 8 ⁢ 9$ $0 . 0 ⁢ 7 ⁢ 9 \leq q \left[1⁢4⁢9\right] \leq 0 . 0 ⁢ 8 ⁢ 1$ $0. ⁢ 0 ⁢ 7 ⁢ 0 \leq q \left[150\right] \leq 0 . 0 ⁢ 7 ⁢ 2$ $0. ⁢ 0 ⁢ 6 ⁢ 2 \leq q \left[151\right] \leq 0 . 0 ⁢ 6 ⁢ 4$ $0 . 0 ⁢ 5 ⁢ 4 \leq q \left[1⁢5⁢2\right] \leq 0 . 0 ⁢ 5 ⁢ 6$ $0. ⁢ 0 ⁢ 4 ⁢ 5 \leq q \left[1⁢5⁢3\right] \leq 0 . 0 ⁢ 4 ⁢ 7$ $0.0 ⁢ 3 ⁢ 7 \leq q \left[1⁢5⁢4\right] \leq 0 . 0 ⁢ 3 ⁢ 9$ $0. ⁢ 0 ⁢ 2 ⁢ 9 \leq q \left[1⁢5⁢5\right] \leq 0 . 0 ⁢ 3 ⁢ 1$ $0. ⁢ 0 ⁢ 2 ⁢ 1 \leq q \left[1⁢5⁢6\right] \leq 0. ⁢ 0 ⁢ 2 ⁢ 3$ $0.0 ⁢ 1 ⁢ 4 \leq q \left[1⁢5⁢7\right] \leq 0 . 0 ⁢ 1 ⁢ 6$ $0.0 ⁢ 0 ⁢ 6 \leq q \left[1⁢5⁢8\right] \leq 0 . 0 ⁢ 0 ⁢ 8$ $- 0 . 0 ⁢ 0 ⁢ 2 \leq q \left[1⁢59\right] \leq 0 . 0 ⁢ 0 ⁢ 0$ $- 0. ⁢ 0 ⁢ 0 ⁢ 9 \leq q \left[1⁢6⁢0\right] \leq - 0 . 0 ⁢ 0 ⁢ 7$ $- 0 . 0 ⁢ 1 ⁢ 7 \leq q \left[161\right] \leq - 0.015$ $- 0 . 0 ⁢ 2 ⁢ 4 \leq q \left[1⁢62\right] \leq - 0 . 0 ⁢ 2 ⁢ 2$ $- 0 . 0 ⁢ 3 ⁢ 2 \leq q \left[163\right] \leq - 0 . 030$ $- 0 . 039 \leq q \left[164\right] \leq - 0 . 037$ $- 0 . 0 ⁢ 4 ⁢ 6 \leq q \left[165\right] \leq - 0 . 0 ⁢ 4 ⁢ 4$ $- 0. ⁢ 0 ⁢ 5 ⁢ 4 \leq q \left[1⁢6⁢6\right] \leq - 0.052$ $- 0 . 0 ⁢ 6 ⁢ 1 \leq q \left[167\right] \leq - 0 . 059$ $- 0 . 0 ⁢ 6 ⁢ 8 \leq q \left[168\right] \leq - 0 . 066$ $- 0 . 0 ⁢ 7 ⁢ 5 \leq q \left[1⁢6⁢9\right] \leq - 0 . 073$ $- 0 . 0 ⁢ 8 ⁢ 2 \leq q \left[170\right] \leq - 0 . 080$ $- 0 . 0 ⁢ 8 ⁢ 9 \leq q \left[1⁢7⁢1\right] \leq - 0 . 087$ $- 0 . 0 ⁢ 9 ⁢ 6 \leq q \left[1⁢7⁢2\right] \leq - 0 . 0 ⁢ 9 ⁢ 4$ $- 0 . 1 ⁢ 0 ⁢ 2 \leq q \left[1⁢7⁢3\right] \leq - 0 . 100$ $- 0 . 1 ⁢ 0 ⁢ 9 \leq q \left[l⁢74\right] \leq - 0 . 107$ $- 0 . 116 \leq q \left[l⁢75\right] \leq - 0 . 114$ $- 0 . 1 ⁢ 2 ⁢ 2 \leq q \left[1⁢7⁢6\right] \leq - 0 . 120$ $- 0 . 1 ⁢ 2 ⁢ 9 \leq q \left[1⁢77\right] \leq - 0 . 127$ $- 0 . 1 ⁢ 3 ⁢ 5 \leq q \left[178\right] \leq - 0 . 1 ⁢ 33$ $- 0 . 1 ⁢ 4 ⁢ 2 \leq q \left[1⁢7⁢9\right] \leq - 0 . 140$ $- 0.148 \leq q \left[1⁢8⁢0\right] \leq - 0 . 1 ⁢ 4 ⁢ 6$ $- 0 . 1 ⁢ 5 ⁢ 4 \leq q \left[181\right] \leq - 0 . 1 ⁢ 5 ⁢ 2$ $- 0 . 1 ⁢ 6 ⁢ 0 \leq q \left[1⁢8⁢2\right] \leq - 0 . 1 ⁢ 5 ⁢ 8$ $- 0.166 \leq q \left[183\right] \leq - 0.164$ $- 0 . 1 ⁢ 7 ⁢ 2 \leq q \left[1⁢8⁢4\right] \leq - 0 . 1 ⁢ 7 ⁢ 0$ $- 0.178 \leq q \left[1⁢8⁢5\right] \leq - 0 . 1 ⁢ 7 ⁢ 6$ $- 0 . 183 \leq q \left[1⁢8⁢6\right] \leq - 0 . 1 ⁢ 8 ⁢ 1$ $- 0 . 189 \leq q \left[1⁢8⁢7\right] \leq - 0 . 1 ⁢ 8 ⁢ 7$ $- 0 . 1 ⁢ 9 ⁢ 4 \leq q \left[188\right] \leq - 0 . 1 ⁢ 9 ⁢ 2$ $- 0 . 1 ⁢ 9 ⁢ 9 \leq q \left[1⁢8⁢9\right] \leq - 0 . 1 ⁢ 9 ⁢ 7$ $- 0 . 2 ⁢ 0 ⁢ 4 \leq q \left[1⁢9⁢0\right] \leq - 0 . 2 ⁢ 0 ⁢ 2$ $- 0 . 2 ⁢ 0 ⁢ 9 \leq q \left[1⁢9⁢1\right] \leq - 0 . 2 ⁢ 0 ⁢ 7$

11. Appareil de filtration selon l'une quelconque des revendications 8 à 10, dans lequel les filtres intermédiaires (190) sont adaptés de sorte que les dérivations de filtre prototype q(v) remplissent, pour les nombres entiers *v* de 0 à 191, les rapports:$- 0 . 2 ⁢ 0 ⁢ 2 ⁢ 9 ⁢ 4 \leq q \left[0\right] \leq - 0 . 2 ⁢ 0 ⁢ 2 ⁢ 9 ⁢ 2$ $- 0 . 1980 ⁢ 4 \leq q \left[1\right] \leq - 0 . 1 ⁢ 9 ⁢ 8 ⁢ 0 ⁢ 2$ $- 0 . 1 ⁢ 9 ⁢ 2 ⁢ 9 ⁢ 5 \leq q \left[2\right] \leq - 0 . 1 ⁢ 9 ⁢ 2 ⁢ 9 ⁢ 3$ $- 0 . 1 ⁢ 8 ⁢ 7 ⁢ 6 ⁢ 8 \leq q \left[3\right] \leq - 0 . 1 ⁢ 8 ⁢ 7 ⁢ 6 ⁢ 6$ $- 0 . 1 ⁢ 8 ⁢ 2 ⁢ 2 ⁢ 6 \leq q \left[4\right] \leq - 0.18224$ $- 0 . 1 ⁢ 7 ⁢ 6 ⁢ 6 ⁢ 8 \leq q \left[5\right] \leq - 0.17666$ $- 0 . 1 ⁢ 7 ⁢ 0 ⁢ 9 ⁢ 7 \leq q \left[6\right] \leq - 0 . 1 ⁢ 8 ⁢ 0 ⁢ 9 ⁢ 5$ $- 0 . 1 ⁢ 6 ⁢ 5 ⁢ 1 ⁢ 4 \leq q \left[7\right] \leq - 0 . 1 ⁢ 6 ⁢ 5 ⁢ 1 ⁢ 2$ $- 0 . 1 ⁢ 5 ⁢ 9 ⁢ 1 ⁢ 9 \leq q \left[8\right] \leq - 0.15917$ $- 0 . 1 ⁢ 5 ⁢ 3 ⁢ 1 ⁢ 3 \leq q \left[9\right] \leq - 0.15311$ $- 0 . 1 ⁢ 7 ⁢ 6 ⁢ 9 ⁢ 7 \leq q \left[10\right] \leq - 0 . 1 ⁢ 4 ⁢ 6 ⁢ 9 ⁢ 5$ $- 0 . 1 ⁢ 4 ⁢ 0 ⁢ 7 ⁢ 1 \leq q \left[1⁢1\right] \leq - 0.14069$ $- 0 . 1 ⁢ 3 ⁢ 4 ⁢ 3 ⁢ 7 \leq q \left[1⁢2\right] \leq - 0.13435$ $- 0 . 1 ⁢ 2 ⁢ 7 ⁢ 9 ⁢ 4 \leq q \left[1⁢3\right] \leq - 0.12792$ $- 0 . 1 ⁢ 2 ⁢ 1 ⁢ 4 ⁢ 4 \leq q \left[1⁢4\right] \leq - 0.12142$ $- 0 . 1 ⁢ 1 ⁢ 4 ⁢ 8 ⁢ 6 \leq q \left[1⁢5\right] \leq - 0.11484$ $- 0 . 1 ⁢ 0 ⁢ 8 ⁢ 2 ⁢ 1 \leq q \left[1⁢6\right] \leq - 0.10819$ $- 0 . 1 ⁢ 0 ⁢ 1 ⁢ 4 ⁢ 9 \leq q \left[1⁢7\right] \leq - 0.10147$ $- 0 . 0 ⁢ 9 ⁢ 4 ⁢ 7 ⁢ 1 \leq q \left[1⁢8\right] \leq - 0.09469$ $- 0 . 0 ⁢ 8 ⁢ 7 ⁢ 8 ⁢ 6 \leq q \left[1⁢9\right] \leq - 0 . 0 ⁢ 8 ⁢ 7 ⁢ 8 ⁢ 4$ $- 0 . 0 ⁢ 8 ⁢ 0 ⁢ 9 ⁢ 5 \leq q \left[2⁢0\right] \leq - 0 . 0 ⁢ 8 ⁢ 0 ⁢ 9 ⁢ 3$ $- 0 . 0 ⁢ 7 ⁢ 3 ⁢ 9 ⁢ 7 \leq q \left[2⁢1\right] \leq - 0 . 0 ⁢ 7 ⁢ 3 ⁢ 9 ⁢ 5$ $- 0 . 0 ⁢ 6 ⁢ 6 ⁢ 9 ⁢ 4 \leq q \left[2⁢2\right] \leq - 0 . 0 ⁢ 6 ⁢ 6 ⁢ 9 ⁢ 2$ $- 0 . 0 ⁢ 5 ⁢ 9 ⁢ 8 ⁢ 4 \leq q \left[2⁢3\right] \leq - 0 . 0 ⁢ 5 ⁢ 9 ⁢ 8 ⁢ 2$ $- 0 . 0 ⁢ 5 ⁢ 2 ⁢ 6 ⁢ 9 \leq q \left[2⁢4\right] \leq - 0 . 0 ⁢ 5 ⁢ 2 ⁢ 6 ⁢ 7$ $- 0 . 0 ⁢ 4 ⁢ 5 ⁢ 4 ⁢ 7 \leq q \left[2⁢5\right] \leq - 0 . 0 ⁢ 4 ⁢ 5 ⁢ 4 ⁢ 5$ $- 0. ⁢ 0 ⁢ 3 ⁢ 8 ⁢ 1 ⁢ 9 \leq q \left[2⁢6\right] \leq - 0 . 0 ⁢ 3 ⁢ 8 ⁢ 1 ⁢ 7$ $- 0 . 0 ⁢ 3 ⁢ 0 ⁢ 8 ⁢ 5 \leq q \left[2⁢7\right] \leq - 0 . 0 ⁢ 3 ⁢ 0 ⁢ 8 ⁢ 3$ $- 0 . 0 ⁢ 2 ⁢ 3 ⁢ 4 ⁢ 5 \leq q \left[2⁢8\right] \leq - 0.02343$ $- 0 . 0 ⁢ 1 ⁢ 5 ⁢ 9 ⁢ 8 \leq q \left[2⁢9\right] \leq - 0.01596$ $- 0 . 0 ⁢ 0 ⁢ 8 ⁢ 4 ⁢ 5 \leq q \left[3⁢0\right] \leq - 0 . 0 ⁢ 0 ⁢ 8 ⁢ 4 ⁢ 3$ $- 0.00084 \leq q \left[3⁢1\right] \leq - 0 . 0 ⁢ 0 ⁢ 0 ⁢ 8 ⁢ 2$ $0 . 0 ⁢ 0 ⁢ 6 ⁢ 8 ⁢ 3 \leq q \left[3⁢2\right] \leq 0. ⁢ 0 ⁢ 0 ⁢ 6 ⁢ 8 ⁢ 5$ $0 . 01458 \leq q \left[33\right] \leq 0.01460$ $0 . 02240 \leq q \left[34\right] \leq 0.02242$ $0.03030 \leq q \left[35\right] \leq 0.03032$ $0.0 ⁢ 3 ⁢ 8 ⁢ 2 ⁢ 8 \leq q \left[3⁢6\right] \leq 0 . 0 ⁢ 3 ⁢ 8 ⁢ 3 ⁢ 0$ $0.04635 \leq q \left[37\right] \leq 0 . 04637$ $0.05451 \leq q \left[3⁢8\right] \leq 0 . 0 ⁢ 5 ⁢ 4 ⁢ 5 ⁢ 3$ $0.06275 \leq q \left[3⁢9\right] \leq 0 . 0 ⁢ 6 ⁢ 2 ⁢ 7 ⁢ 7$ $0.0 ⁢ 7 ⁢ 1 ⁢ 1 ⁢ 0 \leq q \left[4⁢0\right] \leq 0 . 0 ⁢ 7 ⁢ 1 ⁢ 1 ⁢ 2$ $0 . 0 ⁢ 7 ⁢ 9 ⁢ 5 ⁢ 4 \leq q \left[4⁢1\right] \leq 0 . 0 ⁢ 7 ⁢ 9 ⁢ 5 ⁢ 6$ $0.08809 \leq q \left[4⁢2\right] \leq 0 . 0 ⁢ 8 ⁢ 8 ⁢ 1 ⁢ 1$ $0. ⁢ 0 ⁢ 9 ⁢ 6 ⁢ 7 ⁢ 5 \leq q \left[4⁢3\right] \leq 0.09677$ $0.10552 \leq q \left[4⁢4\right] \leq 0 . 1 ⁢ 0 ⁢ 5 ⁢ 5 ⁢ 4$ $0.11442 \leq q \left[4⁢5\right] \leq 0.11444$ $0.1 ⁢ 2 ⁢ 3 ⁢ 4 ⁢ 4 \leq q \left[4⁢6\right] \leq 0.12346$ $0.13259 \leq q \left[4⁢7\right] \leq 0.13261$ $0.14189 \leq q \left[4⁢8\right] \leq 0 . 1 ⁢ 4 ⁢ 1 ⁢ 9 ⁢ 1$ $0.15132 \leq q \left[4⁢9\right] \leq 0 . 1 ⁢ 5 ⁢ 1 ⁢ 3 ⁢ 4$ $0.16091 \leq q \left[5⁢0\right] \leq 0.16093$ $0.17066 \leq q \left[5⁢1\right] \leq 0 . 1 ⁢ 7 ⁢ 0 ⁢ 6 ⁢ 8$ $0.1 ⁢ 8 ⁢ 0 ⁢ 5 ⁢ 8 \leq q \left[5⁢2\right] \leq 0 . 1 ⁢ 8 ⁢ 0 ⁢ 6 ⁢ 0$ $0.19067 \leq q \left[5⁢3\right] \leq 0 . 1 ⁢ 9 ⁢ 0 ⁢ 6 ⁢ 9$ $0.20095 \leq q \left[5⁢4\right] \leq 0 . 2 ⁢ 0 ⁢ 0 ⁢ 9 ⁢ 7$ $0.21143 \leq q \left[5⁢5\right] \leq 0 . 2 ⁢ 1 ⁢ 1 ⁢ 4 ⁢ 5$ $0 . 2 ⁢ 2 ⁢ 2 ⁢ 1 ⁢ 1 \leq q \left[5⁢6\right] \leq 0 . 2 ⁢ 2 ⁢ 2 ⁢ 1 ⁢ 3$ $0.23300 \leq q \left[5⁢7\right] \leq 0 . 2 ⁢ 3 ⁢ 3 ⁢ 0 ⁢ 2$ $0.24412 \leq q \left[5⁢8\right] \leq 0 . 2 ⁢ 4 ⁢ 4 ⁢ 1 ⁢ 4$ $0.25549 \leq q \left[5⁢9\right] \leq 0 . 2 ⁢ 5 ⁢ 5 ⁢ 5 ⁢ 1$ $0.26711 \leq q \left[6⁢0\right] \leq 0 . 2 ⁢ 6 ⁢ 7 ⁢ 1 ⁢ 3$ $0 . 2 ⁢ 7 ⁢ 8 ⁢ 9 ⁢ 9 \leq q \left[6⁢1\right] \leq 0 . 2 ⁢ 7 ⁢ 9 ⁢ 0 ⁢ 1$ $0 . 2 ⁢ 9 ⁢ 1 ⁢ 1 ⁢ 7 \leq q \left[6⁢2\right] \leq 0 . 2 ⁢ 9 ⁢ 1 ⁢ 1 ⁢ 9$ $0.30364 \leq q \left[6⁢3\right] \leq 0 . 3 ⁢ 0 ⁢ 3 ⁢ 6 ⁢ 6$ $0.90252 \leq q \left[6⁢4\right] \leq 0 . 9 ⁢ 0 ⁢ 2 ⁢ 5 ⁢ 4$ $0. ⁢ 9 ⁢ 1 ⁢ 0 ⁢ 3 ⁢ 5 \leq q \left[6⁢5\right] \leq 0 . 9 ⁢ 1 ⁢ 0 ⁢ 3 ⁢ 7$ $0.91769 \leq q \left[6⁢6\right] \leq 0.91771$ $0.92457 \leq q \left[6⁢7\right] \leq 0 . 9 ⁢ 2 ⁢ 4 ⁢ 5 ⁢ 9$ $0.93101 \leq q \left[6⁢8\right] \leq 0 . 9 ⁢ 3 ⁢ 1 ⁢ 0 ⁢ 3$ $0.93705 \leq q \left[6⁢9\right] \leq 0 . 9 ⁢ 3 ⁢ 7 ⁢ 0 ⁢ 7$ $0.94270 \leq q \left[7⁢0\right] \leq 0 . 9 ⁢ 4 ⁢ 2 ⁢ 7 ⁢ 2$ $0.94800 \leq q \left[7⁢1\right] \leq 0 . 9 ⁢ 4 ⁢ 8 ⁢ 0 ⁢ 2$ $0.95295 \leq q \left[7⁢2\right] \leq 0 . 9 ⁢ 5 ⁢ 2 ⁢ 9 ⁢ 7$ $0.95758 \leq q \left[7⁢3\right] \leq 0 . 9 ⁢ 5 ⁢ 7 ⁢ 6 ⁢ 0$ $0.96190 \leq q \left[74\right] \leq 0.96192$ $0.96593 \leq q \left[7⁢5\right] \leq 0 . 9 ⁢ 6 ⁢ 5 ⁢ 9 ⁢ 5$ $0. ⁢ 9 ⁢ 6 ⁢ 9 ⁢ 6 ⁢ 8 \leq q \left[7⁢6\right] \leq 0.96970$ $0.97317 \leq q \left[7⁢7\right] \leq 0 . 9 ⁢ 7 ⁢ 3 ⁢ 1 ⁢ 9$ $0.97641 \leq q \left[7⁢8\right] \leq 0 . 9 ⁢ 7 ⁢ 6 ⁢ 4 ⁢ 3$ $0.97940 \leq q \left[7⁢9\right] \leq 0 . 9 ⁢ 7 ⁢ 9 ⁢ 4 ⁢ 2$ $0.98217 \leq q \left[8⁢0\right] \leq 0 . 9 ⁢ 8 ⁢ 2 ⁢ 1 ⁢ 9$ $0.98472 \leq q \left[8⁢1\right] \leq 0.98474$ $0.98706 \leq q \left[8⁢2\right] \leq 0 . 9 ⁢ 8 ⁢ 7 ⁢ 0 ⁢ 8$ $0.98919 \leq q \left[8⁢3\right] \leq 0 . 9 ⁢ 8 ⁢ 9 ⁢ 2 ⁢ 1$ $0.99113 \leq q \left[8⁢4\right] \leq 0 . 9 ⁢ 9 ⁢ 1 ⁢ 1 ⁢ 5$ $0.99288 \leq q \left[8⁢5\right] \leq 0 . 9 ⁢ 9 ⁢ 2 ⁢ 9 ⁢ 0$ $0 . 9 ⁢ 9 ⁢ 4 ⁢ 4 ⁢ 4 \leq q \left[8⁢6\right] \leq 0 . 9 ⁢ 9 ⁢ 4 ⁢ 4 ⁢ 6$ $0. ⁢ 9 ⁢ 9 ⁢ 5 ⁢ 8 ⁢ 3 \leq q \left[8⁢7\right] \leq 0 . 9 ⁢ 9 ⁢ 5 ⁢ 8 ⁢ 5$ $0.99704 \leq q \left[8⁢8\right] \leq 0 . 9 ⁢ 9 ⁢ 7 ⁢ 0 ⁢ 6$ $0.99809 \leq q \left[8⁢9\right] \leq 0 . 9 ⁢ 9 ⁢ 8 ⁢ 1 ⁢ 1$ $0. ⁢ 9 ⁢ 9 ⁢ 8 ⁢ 9 ⁢ 6 \leq q \left[9⁢0\right] \leq 0.99898$ $0. ⁢ 9 ⁢ 9 ⁢ 9 ⁢ 6 ⁢ 7 \leq q \left[9⁢1\right] \leq 0. ⁢ 9 ⁢ 9 ⁢ 9 ⁢ 6 ⁢ 9$ $1. ⁢ 0 ⁢ 0 ⁢ 0 ⁢ 2 ⁢ 3 \leq q \left[9⁢2\right] \leq 1. ⁢ 0 ⁢ 0 ⁢ 0 ⁢ 2 ⁢ 5$ $1.0 ⁢ 0 ⁢ 0 ⁢ 6 ⁢ 2 \leq q \left[9⁢3\right] \leq 1. ⁢ 0 ⁢ 0 ⁢ 0 ⁢ 6 ⁢ 4$ $1.0 ⁢ 0 ⁢ 0 ⁢ 8 ⁢ 6 \leq q \left[9⁢4\right] \leq 1. ⁢ 0 ⁢ 0 ⁢ 0 ⁢ 8 ⁢ 8$ $1.00093 \leq q \left[9⁢5\right] \leq 1. ⁢ 0 ⁢ 0 ⁢ 0 ⁢ 9 ⁢ 5$ $1.00086 \leq q \left[9⁢6\right] \leq 1. ⁢ 0 ⁢ 0 ⁢ 0 ⁢ 8 ⁢ 8$ $1.0 ⁢ 0 ⁢ 0 ⁢ 6 ⁢ 2 \leq q \left[9⁢7\right] \leq 1.00064$ $1.00023 \leq q \left[9⁢8\right] \leq 1 . 0 ⁢ 0 ⁢ 0 ⁢ 2 ⁢ 5$ $0.99967 \leq q \left[9⁢9\right] \leq 0 . 9 ⁢ 9 ⁢ 9 ⁢ 6 ⁢ 9$ $0.99896 \leq q \left[1⁢0⁢0\right] \leq 0 . 9 ⁢ 9 ⁢ 8 ⁢ 9 ⁢ 8$ $0 . 9980 ⁢ 9 \leq q \left[1⁢0⁢1\right] \leq 0 . 9 ⁢ 9 ⁢ 8 ⁢ 1 ⁢ 1$ $0 . 9 ⁢ 9 ⁢ 7 ⁢ 0 ⁢ 4 \leq q \left[1⁢0⁢2\right] \leq 0 . 9 ⁢ 9 ⁢ 7 ⁢ 0 ⁢ 6$ $0.99583 \leq q \left[1⁢0⁢3\right] \leq 0 . 9 ⁢ 9 ⁢ 5 ⁢ 8 ⁢ 5$ $0.99444 \leq q \left[1⁢0⁢4\right] \leq 0 . 9 ⁢ 9 ⁢ 4 ⁢ 4 ⁢ 6$ $0.99288 \leq q \left[1⁢0⁢5\right] \leq 0 . 9 ⁢ 9 ⁢ 2 ⁢ 9 ⁢ 0$ $0 . 9 ⁢ 9 ⁢ 1 ⁢ 1 ⁢ 3 \leq q \left[1⁢0⁢6\right] \leq 0 . 9 ⁢ 9 ⁢ 1 ⁢ 1 ⁢ 5$ $0.98919 \leq q \left[1⁢0⁢7\right] \leq 0 . 9 ⁢ 8 ⁢ 9 ⁢ 2 ⁢ 1$ $0. ⁢ 9 ⁢ 8 ⁢ 7 ⁢ 0 ⁢ 6 \leq q \left[108\right] \leq 0 . 9 ⁢ 8 ⁢ 7 ⁢ 0 ⁢ 8$ $0. ⁢ 9 ⁢ 8 ⁢ 4 ⁢ 7 ⁢ 2 \leq q \left[1⁢0⁢9\right] \leq 0.98474$ $0. ⁢ 9 ⁢ 8 ⁢ 2 ⁢ 1 ⁢ 7 \leq q \left[1⁢1⁢0\right] \leq 0.98219$ $0. ⁢ 9 ⁢ 7 ⁢ 9 ⁢ 4 ⁢ 0 \leq q \left[1⁢1⁢1\right] \leq 0. ⁢ 9 ⁢ 7 ⁢ 9 ⁢ 4 ⁢ 2$ $0.97641 \leq q \left[112\right] \leq 0.97643$ $0. ⁢ 9 ⁢ 7 ⁢ 3 ⁢ 1 ⁢ 7 \leq q \left[1⁢1⁢3\right] \leq 0 . 9 ⁢ 7 ⁢ 3 ⁢ 1 ⁢ 9$ $0.96968 \leq q \left[1⁢1⁢4\right] \leq 0 . 9 ⁢ 6 ⁢ 9 ⁢ 7 ⁢ 0$ $0.96593 \leq q \left[1⁢1⁢5\right] \leq 0 . 9 ⁢ 6 ⁢ 5 ⁢ 9 ⁢ 5$ $0.96190 \leq q \left[1⁢1⁢6\right] \leq 0.96192$ $0.95758 \leq q \left[1⁢1⁢7\right] \leq 0 . 9 ⁢ 5 ⁢ 7 ⁢ 6 ⁢ 0$ $0.95295 \leq q \left[1⁢1⁢8\right] \leq 0 . 9 ⁢ 5 ⁢ 2 ⁢ 9 ⁢ 7$ $0.94800 \leq q \left[1⁢1⁢9\right] \leq 0 . 9 ⁢ 4 ⁢ 8 ⁢ 0 ⁢ 2$ $0.94270 \leq q \left[1⁢2⁢0\right] \leq 0 . 9 ⁢ 4 ⁢ 2 ⁢ 7 ⁢ 2$ $0.93705 \leq q \left[121\right] \leq 0 . 9 ⁢ 3 ⁢ 7 ⁢ 0 ⁢ 7$ $0.93101 \leq q \left[1⁢2⁢2\right] \leq 0 . 9 ⁢ 3 ⁢ 1 ⁢ 0 ⁢ 3$ $0.92457 \leq q \left[1⁢2⁢3\right] \leq 0 . 9 ⁢ 2 ⁢ 4 ⁢ 5 ⁢ 9$ $0.91769 \leq q \left[1⁢2⁢4\right] \leq 0 . 9 ⁢ 1 ⁢ 7 ⁢ 7 ⁢ 1$ $0.91035 \leq q \left[1⁢2⁢5\right] \leq 0 . 9 ⁢ 1 ⁢ 0 ⁢ 3 ⁢ 7$ $0.90252 \leq q \left[1⁢2⁢6\right] \leq 0 . 9 ⁢ 0 ⁢ 2 ⁢ 5 ⁢ 4$ $0.89416 \leq q \left[1⁢2⁢7\right] \leq 0 . 8 ⁢ 9 ⁢ 4 ⁢ 1 ⁢ 8$ $0.29117 \leq q \left[1⁢2⁢8\right] \leq 0 . 2 ⁢ 9 ⁢ 1 ⁢ 1 ⁢ 9$ $0.27899 \leq q \left[1⁢2⁢9\right] \leq 0 . 2 ⁢ 7 ⁢ 9 ⁢ 0 ⁢ 1$ $0.26711 \leq q \left[1⁢3⁢0\right] \leq 0 . 2 ⁢ 6 ⁢ 7 ⁢ 1 ⁢ 3$ $0.25549 \leq q \left[1⁢3⁢1\right] \leq 0 . 2 ⁢ 5 ⁢ 5 ⁢ 5 ⁢ 1$ $0.24412 \leq q \left[1⁢3⁢2\right] \leq 0 . 2 ⁢ 4 ⁢ 4 ⁢ 1 ⁢ 4$ $0.23300 \leq q \left[1⁢3⁢3\right] \leq 0 . 2 ⁢ 3 ⁢ 3 ⁢ 0 ⁢ 2$ $0.22211 \leq q \left[1⁢3⁢4\right] \leq 0 . 2 ⁢ 2 ⁢ 2 ⁢ 1 ⁢ 3$ $0.21143 \leq q \left[1⁢3⁢5\right] \leq 0 . 2 ⁢ 1 ⁢ 1 ⁢ 4 ⁢ 5$ $0 . 2 ⁢ 0 ⁢ 0 ⁢ 9 ⁢ 5 \leq q \left[1⁢3⁢6\right] \leq 0 . 2 ⁢ 0 ⁢ 0 ⁢ 9 ⁢ 7$ $0.19067 \leq q \left[1⁢3⁢7\right] \leq 0 . 1 ⁢ 9 ⁢ 0 ⁢ 6 ⁢ 9$ $0.18058 \leq q \left[138\right] \leq 0.18060$ $0.17066 \leq q \left[1⁢3⁢9\right] \leq 0 . 1 ⁢ 7 ⁢ 0 ⁢ 6 ⁢ 8$ $0.16091 \leq q \left[1⁢4⁢0\right] \leq 0 . 1 ⁢ 6 ⁢ 0 ⁢ 9 ⁢ 3$ $0.15132 \leq q \left[1⁢4⁢1\right] \leq 0 . 1 ⁢ 5 ⁢ 1 ⁢ 3 ⁢ 4$ $0.14189 \leq q \left[1⁢4⁢2\right] \leq 0 . 1 ⁢ 4 ⁢ 1 ⁢ 9 ⁢ 1$ $0.13259 \leq q \left[1⁢4⁢3\right] \leq 0.13261$ $0.12344 \leq q \left[1⁢4⁢4\right] \leq 0 . 1 ⁢ 2 ⁢ 3 ⁢ 4 ⁢ 6$ $0.11442 \leq q \left[1⁢4⁢5\right] \leq 0 . 1 ⁢ 1 ⁢ 4 ⁢ 4 ⁢ 4$ $0.10552 \leq q \left[1⁢4⁢6\right] \leq 0 . 1 ⁢ 0 ⁢ 5 ⁢ 5 ⁢ 4$ $0.09675 \leq q \left[1⁢4⁢7\right] \leq 0.09677$ $0.08809 \leq q \left[1⁢4⁢8\right] \leq 0 . 0 ⁢ 8 ⁢ 8 ⁢ 1 ⁢ 1$ $0.0 ⁢ 7 ⁢ 9 ⁢ 5 ⁢ 4 \leq q \left[1⁢4⁢9\right] \leq 0.07956$ $0.0 ⁢ 7 ⁢ 1 ⁢ 1 ⁢ 0 \leq q \left[1⁢5⁢0\right] \leq 0 . 0 ⁢ 7 ⁢ 1 ⁢ 1 ⁢ 2$ $0.0 ⁢ 6 ⁢ 2 ⁢ 7 ⁢ 5 \leq q \left[1⁢5⁢1\right] \leq 0.06277$ $0.05451 \leq q \left[1⁢5⁢2\right] \leq 0 . 0 ⁢ 5 ⁢ 4 ⁢ 5 ⁢ 3$ $0.0 ⁢ 4 ⁢ 6 ⁢ 3 ⁢ 5 \leq q \left[1⁢5⁢3\right] \leq 0 . 0 ⁢ 4 ⁢ 6 ⁢ 3 ⁢ 7$ $0.03828 \leq q \left[1⁢5⁢4\right] \leq 0 . 0 ⁢ 3 ⁢ 8 ⁢ 3 ⁢ 0$ $0.03030 \leq q \left[1⁢5⁢5\right] \leq 0 . 0 ⁢ 3 ⁢ 0 ⁢ 3 ⁢ 2$ $0.02240 \leq q \left[1⁢5⁢6\right] \leq 0 . 0 ⁢ 2 ⁢ 2 ⁢ 4 ⁢ 2$ $0.01458 \leq q \left[1⁢5⁢7\right] \leq 0 . 0 ⁢ 1 ⁢ 4 ⁢ 6 ⁢ 0$ $0.00683 \leq q \left[1⁢5⁢8\right] \leq 0 . 0 ⁢ 0 ⁢ 6 ⁢ 8 ⁢ 5$ $- 0 . 0 ⁢ 0 ⁢ 0 ⁢ 8 ⁢ 4 \leq q \left[1⁢5⁢9\right] \leq - 0.00082$ $- 0 . 0 ⁢ 0 ⁢ 8 ⁢ 4 ⁢ 5 \leq q \left[1⁢6⁢0\right] \leq - 0 . 0 ⁢ 0 ⁢ 8 ⁢ 4 ⁢ 3$ $- 0 . 0 ⁢ 1 ⁢ 5 ⁢ 9 ⁢ 8 \leq q \left[1⁢6⁢1\right] \leq - 0 . 0 ⁢ 1 ⁢ 5 ⁢ 9 ⁢ 6$ $- 0 . 0 ⁢ 2 ⁢ 3 ⁢ 4 ⁢ 5 \leq q \left[1⁢6⁢2\right] \leq - 0.02343$ $- 0 . 0 ⁢ 3 ⁢ 0 ⁢ 8 ⁢ 5 \leq q \left[1⁢6⁢3\right] \leq - 0.03083$ $- 0 . 0 ⁢ 3 ⁢ 8 ⁢ 1 ⁢ 9 \leq q \left[1⁢6⁢4\right] \leq - 0 . 0 ⁢ 3 ⁢ 8 ⁢ 1 ⁢ 7$ $- 0 . 0 ⁢ 4 ⁢ 5 ⁢ 4 ⁢ 7 \leq q \left[1⁢6⁢5\right] \leq - 0 . 0 ⁢ 4545$ $- 0 . 0 ⁢ 5 ⁢ 2 ⁢ 6 ⁢ 9 \leq q \left[1⁢6⁢6\right] \leq - 0.05267$ $- 0 . 0 ⁢ 5 ⁢ 9 ⁢ 8 ⁢ 4 \leq q \left[1⁢6⁢7\right] \leq - 0 . 0 ⁢ 5 ⁢ 9 ⁢ 8 ⁢ 2$ $- 0 . 0 ⁢ 6 ⁢ 6 ⁢ 9 ⁢ 4 \leq q \left[1⁢6⁢8\right] \leq - 0 . 0 ⁢ 6 ⁢ 6 ⁢ 9 ⁢ 2$ $- 0 . 0 ⁢ 7 ⁢ 3 ⁢ 9 ⁢ 7 \leq q \left[1⁢6⁢9\right] \leq - 0.07395$ $- 0 . 0 ⁢ 8 ⁢ 0 ⁢ 9 ⁢ 5 \leq q \left[1⁢7⁢0\right] \leq - 0 . 0 ⁢ 8 ⁢ 0 ⁢ 9 ⁢ 3$ $- 0 . 0 ⁢ 8 ⁢ 7 ⁢ 8 ⁢ 6 \leq q \left[1⁢7⁢1\right] \leq - 0 . 0 ⁢ 8 ⁢ 7 ⁢ 8 ⁢ 4$ $- 0 . 0 ⁢ 9 ⁢ 4 ⁢ 7 ⁢ 1 \leq q \left[1⁢7⁢2\right] \leq - 0 . 0 ⁢ 9 ⁢ 4 ⁢ 6 ⁢ 9$ $- 0 . 1 ⁢ 0 ⁢ 1 ⁢ 4 ⁢ 9 \leq q \left[1⁢7⁢3\right] \leq - 0 . 1 ⁢ 0 ⁢ 1 ⁢ 4 ⁢ 7$ $- 0 . 1 ⁢ 0 ⁢ 8 ⁢ 2 ⁢ 1 \leq q \left[1⁢7⁢4\right] \leq - 0 . 1 ⁢ 0 ⁢ 8 ⁢ 1 ⁢ 9$ $- 0 . 1 ⁢ 1 ⁢ 4 ⁢ 8 ⁢ 6 \leq q \left[1⁢7⁢5\right] \leq - 0 . 1 ⁢ 1 ⁢ 4 ⁢ 8 ⁢ 4$ $- 0 . 1 ⁢ 2 ⁢ 1 ⁢ 4 ⁢ 4 \leq q \left[1⁢7⁢6\right] \leq - 0 . 1 ⁢ 2 ⁢ 1 ⁢ 4 ⁢ 2$ $- 0 . 1 ⁢ 2 ⁢ 7 ⁢ 9 ⁢ 4 \leq q \left[1⁢7⁢7\right] \leq - 0.12792$ $- 0 . 1 ⁢ 3 ⁢ 4 ⁢ 3 ⁢ 7 \leq q \left[1⁢7⁢8\right] \leq - 0.13435$ $- 0 . 1 ⁢ 4 ⁢ 0 ⁢ 7 ⁢ 1 \leq q \left[1⁢7⁢9\right] \leq - 0 . 1 ⁢ 4 ⁢ 0 ⁢ 6 ⁢ 9$ $- 0 . 1 ⁢ 4 ⁢ 6 ⁢ 9 ⁢ 7 \leq q \left[1⁢8⁢0\right] \leq - 0.14695$ $- 0 . 1 ⁢ 5 ⁢ 3 ⁢ 1 ⁢ 3 \leq q \left[1⁢8⁢1\right] \leq - 0 . 1 ⁢ 5 ⁢ 3 ⁢ 1 ⁢ 1$ $- 0 . 1 ⁢ 5 ⁢ 9 ⁢ 1 ⁢ 9 \leq q \left[182\right] \leq - 0 . 1 ⁢ 5 ⁢ 9 ⁢ 1 ⁢ 7$ $- 0 . 1 ⁢ 6 ⁢ 5 ⁢ 1 ⁢ 4 \leq q \left[1⁢8⁢3\right] \leq - 0 . 1 ⁢ 6 ⁢ 5 ⁢ 1 ⁢ 2$ $- 0 . 1 ⁢ 7 ⁢ 0 ⁢ 9 ⁢ 7 \leq q \left[1⁢8⁢4\right] \leq - 0.17095$ $- 0 . 1 ⁢ 7 ⁢ 6 ⁢ 6 ⁢ 8 \leq q \left[1⁢8⁢5\right] \leq - 0.17666$ $- 0 . 1 ⁢ 8 ⁢ 2 ⁢ 2 ⁢ 6 \leq q \left[1⁢8⁢6\right] \leq - 0.18224$ $- 0 . 1 ⁢ 8 ⁢ 7 ⁢ 6 ⁢ 8 \leq q \left[1⁢8⁢7\right] \leq - 0.18766$ $- 0 . 1 ⁢ 9 ⁢ 2 ⁢ 9 ⁢ 5 \leq q \left[1⁢8⁢8\right] \leq - 0 . 1 ⁢ 9 ⁢ 2 ⁢ 9 ⁢ 3$ $- 0 . 1 ⁢ 9 ⁢ 8 ⁢ 0 ⁢ 4 \leq q \left[1⁢8⁢9\right] \leq - 0 . 1 ⁢ 9 ⁢ 8 ⁢ 0 ⁢ 2$ $- 0 . 2 ⁢ 0 ⁢ 2 ⁢ 9 ⁢ 4 \leq q \left[1⁢9⁢0\right] \leq - 0 . 2 ⁢ 0 ⁢ 2 ⁢ 9 ⁢ 2$ $- 0 . 2 ⁢ 0 ⁢ 7 ⁢ 6 ⁢ 4 \leq q \left[1⁢9⁢1\right] \leq - 0 . 2 ⁢ 0 ⁢ 7 ⁢ 6 ⁢ 2$

12. Appareil de filtration selon l'une quelconque des revendications 8 à 11, dans lequel les filtres intermédiaires (190) sont adaptés de sorte que les coefficients de filtre prototype à valeurs réelles q(v) pour le nombre entier *v* de l'ordre de 0 à 191 soient donnés par$q \left[0\right] = - 0 . 2 ⁢ 0 ⁢ 2 ⁢ 9 ⁢ 3 ⁢ 4 ⁢ 3 ⁢ 3 ⁢ 8 ⁢ 0$ $q \left[1\right] = - 0 . 1 ⁢ 9 ⁢ 8 ⁢ 0 ⁢ 3 ⁢ 3 ⁢ 1 ⁢ 5 ⁢ 8 ⁢ 8$ $q \left[2\right] = - 0.1929411519$ $q \left[3\right] = - 0.1876744222$ $q \left[4\right] = - 0 . 1 ⁢ 8 ⁢ 2 ⁢ 2 ⁢ 4 ⁢ 7 ⁢ 4 ⁢ 0 ⁢ 1 ⁢ 1$ $q \left[5\right] = - 0 . 1 ⁢ 7 ⁢ 6 ⁢ 6 ⁢ 7 ⁢ 3 ⁢ 0 ⁢ 2 ⁢ 0 ⁢ 2$ $q \left[6\right] = - 0 . 1 ⁢ 7 ⁢ 0 ⁢ 9 ⁢ 6 ⁢ 2 ⁢ 8 ⁢ 6 ⁢ 3 ⁢ 6$ $q \left[7\right] = - 0 . 1 ⁢ 6 ⁢ 5 ⁢ 1 ⁢ 2 ⁢ 7 ⁢ 3 ⁢ 0 ⁢ 0 ⁢ 5$ $q \left[8\right] = - 0 . 1 ⁢ 5 ⁢ 9 ⁢ 1 ⁢ 7 ⁢ 5 ⁢ 6 ⁢ 0 ⁢ 2 ⁢ 4$ $q \left[9\right] = - 0 . 1 ⁢ 5 ⁢ 3 ⁢ 1 ⁢ 1 ⁢ 6 ⁢ 0 ⁢ 4 ⁢ 5 ⁢ 5$ $q \left[1⁢0\right] = - 0 . 1 ⁢ 4 ⁢ 6 ⁢ 9 ⁢ 5 ⁢ 6 ⁢ 0 ⁢ 0 ⁢ 0 ⁢ 5$ $q \left[1⁢1\right] = - 0.1407020132$ $q \left[1⁢2\right] = - 0 . 1 ⁢ 3 ⁢ 4 ⁢ 3 ⁢ 5 ⁢ 9 ⁢ 8 ⁢ 7 ⁢ 3 ⁢ 8$ $q \left[1⁢3\right] = - 0 . 1 ⁢ 2 ⁢ 7 ⁢ 9 ⁢ 3 ⁢ 4 ⁢ 6 ⁢ 7 ⁢ 9 ⁢ 0$ $q \left[1⁢4\right] = - 0 . 1 ⁢ 2 ⁢ 1 ⁢ 4 ⁢ 3 ⁢ 0 ⁢ 8 ⁢ 8 ⁢ 7 ⁢ 6$ $q \left[1⁢5\right] = - 0.1148523686$ $q \left[1⁢6\right] = - 0.1082024454$ $q \left[1⁢7\right] = - 0.1014839341$ $q \left[1⁢8\right] = - 0 . 0 ⁢ 9 ⁢ 4 ⁢ 6 ⁢ 9 ⁢ 9 ⁢ 1 ⁢ 7 ⁢ 8 ⁢ 3$ $q \left[1⁢9\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[2⁢0\right] = - 0 . 0 ⁢ 8 ⁢ 0 ⁢ 9 ⁢ 3 ⁢ 8 ⁢ 1 ⁢ 2 ⁢ 6 ⁢ 8$ $q \left[2⁢1\right] = - 0.0739644174$ $q \left[22\right] = - 0.0669296831$ $q \left[2⁢3\right] = - 0.0598343081$ $q \left[2⁢4\right] = - 0 . 0 ⁢ 5 ⁢ 2 ⁢ 6 ⁢ 7 ⁢ 8 ⁢ 3 ⁢ 4 ⁢ 6 ⁢ 6$ $q \left[2⁢5\right] = - 0.0454615388$ $q \left[26\right] = - 0 . 0 ⁢ 3 ⁢ 8 ⁢ 1 ⁢ 8 ⁢ 3 ⁢ 3 ⁢ 2 ⁢ 4 ⁢ 9$ $q \left[2⁢7\right] = - 0 . 0 ⁢ 3 ⁢ 0 ⁢ 8 ⁢ 4 ⁢ 2 ⁢ 8 ⁢ 5 ⁢ 7 ⁢ 2$ $q \left[2⁢8\right] = - 0 . 0 ⁢ 2 ⁢ 3 ⁢ 4 ⁢ 3 ⁢ 9 ⁢ 0 ⁢ 1 ⁢ 1 ⁢ 5$ $q \left[2⁢9\right] = - 0 . 0 ⁢ 1 ⁢ 5 ⁢ 9 ⁢ 7 ⁢ 0 ⁢ 3 ⁢ 9 ⁢ 5 ⁢ 7$ $q \left[3⁢0\right] = - 0 . 0 ⁢ 0 ⁢ 8 ⁢ 4 ⁢ 3 ⁢ 5 ⁢ 3 ⁢ 5 ⁢ 8 ⁢ 4$ $q \left[3⁢1\right] = - 0 . 0 ⁢ 0 ⁢ 0 ⁢ 8 ⁢ 3 ⁢ 1 ⁢ 9 ⁢ 9 ⁢ 5 ⁢ 6$ $q \left[32\right] = 0. ⁢ 0 ⁢ 0 ⁢ 6 ⁢ 8 ⁢ 4 ⁢ 1 ⁢ 8 ⁢ 4 ⁢ 3 ⁢ 5$ $q \left[3⁢3\right] = 0. ⁢ 0 ⁢ 1 ⁢ 4 ⁢ 5 ⁢ 8 ⁢ 8 ⁢ 5 ⁢ 5 ⁢ 2 ⁢ 7$ $q \left[3⁢4\right] = 0 . 0 ⁢ 2 ⁢ 2 ⁢ 4 ⁢ 1 ⁢ 0 ⁢ 7 ⁢ 6 ⁢ 4 ⁢ 8$ $q \left[35\right] = 0. ⁢ 0 ⁢ 3 ⁢ 0 ⁢ 3 ⁢ 1 ⁢ 1 ⁢ 3 ⁢ 4 ⁢ 9 ⁢ 5$ $q \left[3⁢6\right] = 0 . 0 ⁢ 3 ⁢ 8 ⁢ 2 ⁢ 9 ⁢ 3 ⁢ 4 ⁢ 1 ⁢ 2 ⁢ 6$ $q \left[3⁢7\right] = 0 . 0 ⁢ 4 ⁢ 6 ⁢ 3 ⁢ 6 ⁢ 0 ⁢ 2 ⁢ 9 ⁢ 5 ⁢ 9$ $q \left[3⁢8\right] = 0 . 0 ⁢ 5 ⁢ 4 ⁢ 5 ⁢ 1 ⁢ 5 ⁢ 5 ⁢ 7 ⁢ 8 ⁢ 9$ $q \left[3⁢9\right] = 0 . 0 ⁢ 6 ⁢ 2 ⁢ 7 ⁢ 6 ⁢ 3 ⁢ 0 ⁢ 8 ⁢ 1 ⁢ 0$ $q \left[4⁢0\right] = 0 . 0 ⁢ 7 ⁢ 1 ⁢ 1 ⁢ 0 ⁢ 6 ⁢ 8 ⁢ 6 ⁢ 5 ⁢ 7$ $q \left[4⁢1\right] = 0 . 0 ⁢ 7 ⁢ 9 ⁢ 5 ⁢ 5 ⁢ 1 ⁢ 2 ⁢ 4 ⁢ 5 ⁢ 3$ $q \left[42\right] = 0.08 ⁢ 8 ⁢ 1 ⁢ 0 ⁢ 0 ⁢ 7 ⁢ 8 ⁢ 7 ⁢ 9$ $q \left[4⁢3\right] = 0 . 0 ⁢ 9 ⁢ 6 ⁢ 7 ⁢ 6 ⁢ 0 ⁢ 3 ⁢ 2 ⁢ 5 ⁢ 9$ $q \left[4⁢4\right] = 0 . 1 ⁢ 0 ⁢ 5 ⁢ 5 ⁢ 3 ⁢ 4 ⁢ 9 ⁢ 6 ⁢ 5 ⁢ 8$ $q \left[4⁢5\right] = 0 . 1 ⁢ 1 ⁢ 4 ⁢ 4 ⁢ 3 ⁢ 0 ⁢ 1 ⁢ 0 ⁢ 0 ⁢ 0$ $q \left[4⁢6\right] = 0 . 1 ⁢ 2 ⁢ 3 ⁢ 4 ⁢ 5 ⁢ 1 ⁢ 4 ⁢ 2 ⁢ 2 ⁢ 2$ $q \left[4⁢7\right] = 0 . 1 ⁢ 3 ⁢ 2 ⁢ 6 ⁢ 0 ⁢ 4 ⁢ 9 ⁢ 4 ⁢ 3 ⁢ 4$ $q \left[4⁢8\right] = 0 . 1 ⁢ 4 ⁢ 1 ⁢ 8 ⁢ 9 ⁢ 7012 ⁢ 3$ $q \left[4⁢9\right] = 0 . 1 ⁢ 5 ⁢ 1 ⁢ 3 ⁢ 3 ⁢ 4 ⁢ 3 ⁢ 3 ⁢ 7 ⁢ 0$ $q \left[5⁢0\right] = 0 . 1 ⁢ 6 ⁢ 0 ⁢ 9 ⁢ 2 ⁢ 4 ⁢ 0 ⁢ 1 ⁢ 2 ⁢ 6$ $q \left[5⁢1\right] = 0 . 1 ⁢ 7 ⁢ 0 ⁢ 6 ⁢ 7 ⁢ 3 ⁢ 5 ⁢ 5 ⁢ 1 ⁢ 7$ $q \left[5⁢2\right] = 0 . 1 ⁢ 8 ⁢ 0 ⁢ 5 ⁢ 9 ⁢ 0 ⁢ 9 ⁢ 1 ⁢ 9 ⁢ 4$ $q \left[5⁢3\right] = 0 . 1 ⁢ 9 ⁢ 0 ⁢ 6 ⁢ 8 ⁢ 4 ⁢ 5 ⁢ 7 ⁢ 5 ⁢ 3$ $q \left[5⁢4\right] = 0 . 2 ⁢ 0 ⁢ 0 ⁢ 9 ⁢ 6 ⁢ 3 ⁢ 5 ⁢ 1 ⁢ 9 ⁢ 1$ $q \left[5⁢5\right] = 0 . 2 ⁢ 1 ⁢ 1 ⁢ 4 ⁢ 3 ⁢ 7 ⁢ 3 ⁢ 4 ⁢ 5 ⁢ 8$ $q \left[56\right] = 0 . 2 ⁢ 2 ⁢ 2 ⁢ 1 ⁢ 1 ⁢ 6 ⁢ 3 ⁢ 0 ⁢ 8 ⁢ 0$ $q \left[5⁢7\right] = 0 . 2 ⁢ 3 ⁢ 3 ⁢ 0 ⁢ 1 ⁢ 1 ⁢ 3 ⁢ 8 ⁢ 6 ⁢ 8$ $q \left[58\right] = 0 . 2 ⁢ 4 ⁢ 4 ⁢ 1 ⁢ 3 ⁢ 4 ⁢ 3 ⁢ 7 ⁢ 4 ⁢ 2$ $q \left[59\right] = 0 . 2 ⁢ 5 ⁢ 5 ⁢ 4 ⁢ 9 ⁢ 7 ⁢ 9 ⁢ 6 ⁢ 6 ⁢ 4$ $q \left[60\right] = 0 . 2 ⁢ 6 ⁢ 7 ⁢ 1 ⁢ 1 ⁢ 5 ⁢ 8 ⁢ 7 ⁢ 0 ⁢ 0$ $q \left[61\right] = 0 . 2 ⁢ 7 ⁢ 9 ⁢ 0 ⁢ 0 ⁢ 2 ⁢ 9 ⁢ 2 ⁢ 3 ⁢ 6$ $q \left[6⁢2\right] = 0 . 2 ⁢ 9 ⁢ 1 ⁢ 1 ⁢ 7 ⁢ 5 ⁢ 2 ⁢ 3 ⁢ 4 ⁢ 9$ $q \left[63\right] = 0 . 3 ⁢ 0 ⁢ 3 ⁢ 6 ⁢ 5 ⁢ 0 ⁢ 3 ⁢ 3 ⁢ 5 ⁢ 0$ $q \left[6⁢4\right] = 0 . 9 ⁢ 0 ⁢ 2 ⁢ 5 ⁢ 2 ⁢ 7 ⁢ 5 ⁢ 7 ⁢ 1 ⁢ 3$ $q \left[6⁢5\right] = 0 . 9 ⁢ 1 ⁢ 0 ⁢ 3 ⁢ 5 ⁢ 8 ⁢ 5 ⁢ 1 ⁢ 9 ⁢ 6$ $q \left[6⁢6\right] = 0.9176977825$ $q \left[67\right] = 0 . 9 ⁢ 2 ⁢ 4 ⁢ 5 ⁢ 7 ⁢ 6 ⁢ 0 ⁢ 6 ⁢ 8 ⁢ 3$ $q \left[6⁢8\right] = 0.9310214581$ $q \left[6⁢9\right] = 0 . 9 ⁢ 3 ⁢ 7 ⁢ 0 ⁢ 5 ⁢ 9 ⁢ 6 ⁢ 7 ⁢ 3 ⁢ 9$ $q \left[7⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[7⁢1\right] = 0.9480070606$ $q \left[7⁢2\right] = 0 . 9 ⁢ 5 ⁢ 2 ⁢ 9 ⁢ 5 ⁢ 7 ⁢ 8 ⁢ 5 ⁢ 6 ⁢ 6$ $q \left[7⁢3\right] = 0.9575850672$ $q \left[7⁢4\right] = 0 . 9 ⁢ 6 ⁢ 1 ⁢ 9 ⁢ 0 ⁢ 5 ⁢ 6 ⁢ 1 ⁢ 5 ⁢ 8$ $q \left[7⁢5\right] = 0 . 9 ⁢ 6 ⁢ 5 ⁢ 9 ⁢ 3 ⁢ 5 ⁢ 1 ⁢ 0 ⁢ 6 ⁢ 5$ $q \left[7⁢6\right] = 0 . 9 ⁢ 6 ⁢ 9 ⁢ 6 ⁢ 8 ⁢ 7 ⁢ 9 ⁢ 2 ⁢ 9 ⁢ 7$ $q \left[7⁢7\right] = 0 . 9 ⁢ 7 ⁢ 3 ⁢ 1 ⁢ 7 ⁢ 7 ⁢ 3 ⁢ 5 ⁢ 4 ⁢ 7$ $q \left[7⁢8\right] = 0 . 9 ⁢ 7 ⁢ 6 ⁢ 4 ⁢ 1 ⁢ 5 ⁢ 6 ⁢ 1 ⁢ 1 ⁢ 9$ $q \left[79\right] = 0 . 9794139640$ $q \left[8⁢0\right] = 0.9821827692$ $q \left[8⁢1\right] = 0.9847315377$ $q \left[8⁢2\right] = 0 . 9 ⁢ 8 ⁢ 7 ⁢ 0 ⁢ 6 ⁢ 8 ⁢ 9 ⁢ 7 ⁢ 9 ⁢ 0$ $q \left[8⁢3\right] = 0.9892030462$ $q \left[84\right] = 0. ⁢ 9 ⁢ 9 ⁢ 1 ⁢ 1 ⁢ 4 ⁢ 0 ⁢ 9 ⁢ 7 ⁢ 2 ⁢ 8$ $q \left[8⁢5\right] = 0.9928893067$ $q \left[8⁢6\right] = 0. ⁢ 9 ⁢ 9 ⁢ 4 ⁢ 4 ⁢ 5 ⁢ 3 ⁢ 9 ⁢ 3 ⁢ 9 ⁢ 5$ $q \left[8⁢7\right] = 0 . 9 ⁢ 9 ⁢ 5 ⁢ 8 ⁢ 4 ⁢ 0 ⁢ 1 ⁢ 3 ⁢ 1 ⁢ 8$ $q \left[8⁢8\right] = 0.9970525352$ $q \left[8⁢9\right] = 0. ⁢ 9 ⁢ 9 ⁢ 8 ⁢ 0 ⁢ 9 ⁢ 5 ⁢ 2 ⁢ 1 ⁢ 1 ⁢ 8$ $q \left[9⁢0\right] = 0. ⁢ 9 ⁢ 9 ⁢ 8 ⁢ 9 ⁢ 7 ⁢ 1 ⁢ 6 ⁢ 5 ⁢ 0 ⁢ 4$ $q \left[9⁢1\right] = 0. ⁢ 9 ⁢ 9 ⁢ 9 ⁢ 6 ⁢ 8 ⁢ 4 ⁢ 7 ⁢ 8 ⁢ 0 ⁢ 6$ $q \left[9⁢2\right] = 1.0002369837$ $q \left[9⁢3\right] = 1.0006301028$ $q \left[9⁢4\right] = 1. ⁢ 0 ⁢ 0 ⁢ 0 ⁢ 8 ⁢ 6 ⁢ 5 ⁢ 4 ⁢ 4 ⁢ 8 ⁢ 2$ $q \left[9⁢5\right] = 1. ⁢ 0 ⁢ 0 ⁢ 0 ⁢ 9 ⁢ 4 ⁢ 3 ⁢ 8 ⁢ 0 ⁢ 6 ⁢ 3$ $q \left[9⁢6\right] = 1. ⁢ 0 ⁢ 0 ⁢ 0 ⁢ 8 ⁢ 6 ⁢ 5 ⁢ 4 ⁢ 4 ⁢ 8 ⁢ 2$ $q \left[97\right] = 1.0006301028$ $q \left[98\right] = 1. ⁢ 0 ⁢ 0 ⁢ 0 ⁢ 2 ⁢ 3 ⁢ 6 ⁢ 9 ⁢ 8 ⁢ 3 ⁢ 7$ $q \left[99\right] = 0.9996847806$ $q \left[100\right] = 0 . 9 ⁢ 9 ⁢ 8 ⁢ 9 ⁢ 7 ⁢ 1 ⁢ 6 ⁢ 5 ⁢ 0 ⁢ 4$ $q \left[101\right] = 0 . 9 ⁢ 9 ⁢ 8 ⁢ 0 ⁢ 9 ⁢ 5 ⁢ 2 ⁢ 1 ⁢ 1 ⁢ 8$ $q \left[1⁢0⁢2\right] = 0. ⁢ 9 ⁢ 9 ⁢ 7 ⁢ 0 ⁢ 5 ⁢ 2 ⁢ 5 ⁢ 3 ⁢ 5 ⁢ 2$ $q \left[1⁢0⁢3\right] = 0. ⁢ 9 ⁢ 9 ⁢ 5 ⁢ 8 ⁢ 4 ⁢ 0 ⁢ 1 ⁢ 3 ⁢ 1 ⁢ 8$ $q \left[1⁢0⁢4\right] = 0. ⁢ 9 ⁢ 9 ⁢ 4 ⁢ 4 ⁢ 5 ⁢ 3 ⁢ 9 ⁢ 3 ⁢ 9 ⁢ 5$ $q \left[1⁢0⁢5\right] = 0 . 9 ⁢ 9 ⁢ 2 ⁢ 8 ⁢ 8 ⁢ 9 ⁢ 3 ⁢ 0 ⁢ 6 ⁢ 7$ $q \left[106\right] = 0 . 9 ⁢ 9 ⁢ 1 ⁢ 1 ⁢ 4 ⁢ 0 ⁢ 9 ⁢ 7 ⁢ 2 ⁢ 8$ $q \left[1⁢0⁢7\right] = 0 . 9 ⁢ 8 ⁢ 9 ⁢ 2 ⁢ 0 ⁢ 3 ⁢ 0 ⁢ 4 ⁢ 6 ⁢ 2$ $q \left[1⁢0⁢8\right] = 0 . 9 ⁢ 8 ⁢ 7 ⁢ 0 ⁢ 6 ⁢ 8 ⁢ 9 ⁢ 7 ⁢ 9 ⁢ 0$ $q \left[109\right] = 0 . 9 ⁢ 8 ⁢ 4 ⁢ 7 ⁢ 3 ⁢ 1 ⁢ 5 ⁢ 3 ⁢ 7 ⁢ 7$ $q \left[1⁢10\right] = 0 . 9 ⁢ 8 ⁢ 2 ⁢ 1 ⁢ 8 ⁢ 2 ⁢ 7 ⁢ 6 ⁢ 92$ $q \left[1⁢1⁢1\right] = 0 . 9 ⁢ 7 ⁢ 9 ⁢ 4 ⁢ 1 ⁢ 3 ⁢ 9 ⁢ 6 ⁢ 4 ⁢ 0$ $q \left[1⁢1⁢2\right] = 0 . 9 ⁢ 7 ⁢ 6 ⁢ 4 ⁢ 1 ⁢ 5 ⁢ 6 ⁢ 1 ⁢ 1 ⁢ 9$ $q \left[1⁢1⁢3\right] = 0 . 9 ⁢ 7 ⁢ 3 ⁢ 1 ⁢ 7 ⁢ 7 ⁢ 3 ⁢ 5 ⁢ 4 ⁢ 7$ $q \left[1⁢1⁢4\right] = 0 . 9 ⁢ 6 ⁢ 9 ⁢ 6 ⁢ 8 ⁢ 7 ⁢ 9 ⁢ 2 ⁢ 9 ⁢ 7$ $q \left[1⁢1⁢5\right] = 0 . 9 ⁢ 6 ⁢ 5 ⁢ 9 ⁢ 3 ⁢ 5 ⁢ 1 ⁢ 0 ⁢ 6 ⁢ 5$ $q \left[1⁢1⁢6\right] = 0 . 9 ⁢ 6 ⁢ 1 ⁢ 9 ⁢ 0 ⁢ 5 ⁢ 6 ⁢ 1 ⁢ 5 ⁢ 8$ $q \left[1⁢1⁢7\right] = 0 . 9 ⁢ 5 ⁢ 7 ⁢ 5 ⁢ 8 ⁢ 5 ⁢ 0 ⁢ 6 ⁢ 7 ⁢ 2$ $q \left[1⁢1⁢8\right] = 0 . 9 ⁢ 5 ⁢ 2 ⁢ 9 ⁢ 5 ⁢ 7 ⁢ 8 ⁢ 5 ⁢ 6 ⁢ 6$ $q \left[1⁢1⁢9\right] = 0 . 9 ⁢ 4 ⁢ 8 ⁢ 0 ⁢ 0 ⁢ 7 ⁢ 0 ⁢ 6 ⁢ 0 ⁢ 6$ $q \left[1⁢2⁢0\right] = 0 . 9 ⁢ 4 ⁢ 2 ⁢ 7 ⁢ 1 ⁢ 4 ⁢ 3 ⁢ 1 ⁢ 4 ⁢ 3$ $q \left[1⁢2⁢1\right] = 0 . 9 ⁢ 3 ⁢ 7 ⁢ 0 ⁢ 5 ⁢ 9 ⁢ 6 ⁢ 7 ⁢ 3 ⁢ 9$ $q \left[1⁢2⁢2\right] = 0 . 9 ⁢ 3 ⁢ 1 ⁢ 0 ⁢ 2 ⁢ 1 ⁢ 4 ⁢ 5 ⁢ 8 ⁢ 1$ $q \left[1⁢2⁢3\right] = 0 . 9 ⁢ 2 ⁢ 4 ⁢ 5 ⁢ 7 ⁢ 6 ⁢ 0 ⁢ 6 ⁢ 8 ⁢ 3$ $q \left[124\right] = 0.9176977825$ $q \left[1⁢2⁢5\right] = 0 . 9 ⁢ 1 ⁢ 0 ⁢ 3 ⁢ 5 ⁢ 8 ⁢ 5 ⁢ 1 ⁢ 9 ⁢ 6$ $q \left[1⁢2⁢6\right] = 0 . 9 ⁢ 0 ⁢ 2 ⁢ 5 ⁢ 2 ⁢ 7 ⁢ 5 ⁢ 7 ⁢ 1 ⁢ 3$ $q \left[1⁢2⁢7\right] = 0 . 8 ⁢ 9 ⁢ 4 ⁢ 1 ⁢ 7 ⁢ 1 ⁢ 2 ⁢ 9 ⁢ 7 ⁢ 4$ $q \left[1⁢2⁢8\right] = 0 . 2 ⁢ 9 ⁢ 1 ⁢ 1 ⁢ 7 ⁢ 5 ⁢ 2 ⁢ 3 ⁢ 4 ⁢ 9$ $q \left[1⁢2⁢9\right] = 0 . 2 ⁢ 7 ⁢ 9 ⁢ 0 ⁢ 0 ⁢ 2 ⁢ 9 ⁢ 2 ⁢ 3 ⁢ 6$ $q \left[1⁢3⁢0\right] = 0 . 2 ⁢ 6 ⁢ 7 ⁢ 1 ⁢ 1 ⁢ 5 ⁢ 8 ⁢ 7 ⁢ 0 ⁢ 0$ $q \left[1⁢3⁢1\right] = 0 . 2 ⁢ 5 ⁢ 5 ⁢ 4 ⁢ 9 ⁢ 7 ⁢ 9 ⁢ 6 ⁢ 6 ⁢ 4$ $q \left[1⁢3⁢2\right] = 0 . 2 ⁢ 4 ⁢ 4 ⁢ 1 ⁢ 3 ⁢ 4 ⁢ 3 ⁢ 7 ⁢ 4 ⁢ 2$ $q \left[1⁢3⁢3\right] = 0 . 2 ⁢ 3 ⁢ 3 ⁢ 0 ⁢ 1 ⁢ 1 ⁢ 3 ⁢ 8 ⁢ 6 ⁢ 8$ $q \left[1⁢34\right] = 0 . 2 ⁢ 2 ⁢ 2 ⁢ 1 ⁢ 1 ⁢ 6 ⁢ 3 ⁢ 0 ⁢ 8 ⁢ 0$ $q \left[1⁢3⁢5\right] = 0 . 2 ⁢ 1 ⁢ 1 ⁢ 4 ⁢ 3 ⁢ 7 ⁢ 3 ⁢ 4 ⁢ 5 ⁢ 8$ $q \left[1⁢3⁢6\right] = 0.2009635191$ $q \left[137\right] = 0.1906845753$ $q \left[1⁢3⁢8\right] = 0 . 1 ⁢ 8 ⁢ 0 ⁢ 5 ⁢ 9 ⁢ 0 ⁢ 9 ⁢ 1 ⁢ 9 ⁢ 4$ $q \left[1⁢3⁢9\right] = 0 . 1 ⁢ 7 ⁢ 0 ⁢ 6 ⁢ 7 ⁢ 3 ⁢ 5 ⁢ 5 ⁢ 1 ⁢ 7$ $q \left[1⁢4⁢0\right] = 0.1609240126$ $q \left[1⁢4⁢1\right] = 0.1513343370$ $q \left[1⁢4⁢2\right] = 0 . 1 ⁢ 4 ⁢ 1 ⁢ 8 ⁢ 9 ⁢ 7 ⁢ 0 ⁢ 1 ⁢ 2 ⁢ 3$ $q \left[143\right] = 0 . 1 ⁢ 3 ⁢ 2 ⁢ 6 ⁢ 0 ⁢ 4 ⁢ 9 ⁢ 4 ⁢ 3 ⁢ 4$ $q \left[1⁢4⁢4\right] = 0.1234514222$ $q \left[1⁢4⁢5\right] = 0 . 1 ⁢ 1 ⁢ 4 ⁢ 4 ⁢ 3 ⁢ 0 ⁢ 1 ⁢ 0 ⁢ 0 ⁢ 0$ $q \left[1⁢4⁢6\right] = 0 . 1 ⁢ 0 ⁢ 5 ⁢ 5 ⁢ 3 ⁢ 4 ⁢ 9 ⁢ 6 ⁢ 5 ⁢ 8$ $q \left[1⁢4⁢7\right] = 0 . 0 ⁢ 9 ⁢ 6 ⁢ 7 ⁢ 6 ⁢ 0 ⁢ 3 ⁢ 2 ⁢ 5 ⁢ 9$ $q \left[1⁢4⁢8\right] = 0 . 0 ⁢ 8 ⁢ 8 ⁢ 1 ⁢ 0 ⁢ 0 ⁢ 7 ⁢ 8 ⁢ 7 ⁢ 9$ $q \left[1⁢4⁢9\right] = 0 . 0 ⁢ 7 ⁢ 9 ⁢ 5 ⁢ 5 ⁢ 1 ⁢ 2 ⁢ 4 ⁢ 5 ⁢ 3$ $q \left[1⁢5⁢0\right] = 0.0711068657$ $q \left[1⁢5⁢1\right] = 0 . 0 ⁢ 6 ⁢ 2 ⁢ 7 ⁢ 6 ⁢ 3 ⁢ 0 ⁢ 8 ⁢ 1 ⁢ 0$ $q \left[1⁢5⁢2\right] = 0 . 0 ⁢ 5 ⁢ 4 ⁢ 5 ⁢ 1 ⁢ 5 ⁢ 5 ⁢ 7 ⁢ 8 ⁢ 9$ $q \left[1⁢53\right] = 0 . 0 ⁢ 4 ⁢ 6 ⁢ 3 ⁢ 6 ⁢ 0 ⁢ 2 ⁢ 9 ⁢ 5 ⁢ 9$ $q \left[1⁢5⁢4\right] = 0 . 0 ⁢ 3 ⁢ 8 ⁢ 2 ⁢ 9 ⁢ 3 ⁢ 4 ⁢ 1 ⁢ 2 ⁢ 6$ $q \left[1⁢5⁢5\right] = 0 . 0 ⁢ 3 ⁢ 0 ⁢ 3 ⁢ 1 ⁢ 1 ⁢ 3 ⁢ 4 ⁢ 9 ⁢ 5$ $q \left[1⁢5⁢6\right] = 0 . 0 ⁢ 2 ⁢ 2 ⁢ 4 ⁢ 1 ⁢ 0 ⁢ 7 ⁢ 6 ⁢ 4 ⁢ 8$ $q \left[1⁢5⁢7\right] = 0 . 0 ⁢ 1 ⁢ 4 ⁢ 5 ⁢ 8 ⁢ 8 ⁢ 5 ⁢ 5 ⁢ 2 ⁢ 7$ $q \left[158\right] = 0.0068418435$ $q \left[1⁢5⁢9\right] = - 0.0008319956$ $q \left[1⁢6⁢0\right] = - 0.0084353584$ $q \left[1⁢6⁢1\right] = - 0 . 0 ⁢ 1 ⁢ 5 ⁢ 9 ⁢ 7 ⁢ 0 ⁢ 3 ⁢ 9 ⁢ 5 ⁢ 7$ $q \left[1⁢6⁢2\right] = - 0 . 0 ⁢ 2 ⁢ 3 ⁢ 4 ⁢ 3 ⁢ 9 ⁢ 0 ⁢ 1 ⁢ 1 ⁢ 5$ $q \left[1⁢6⁢3\right] = - 0 . 0 ⁢ 3 ⁢ 0 ⁢ 8 ⁢ 4 ⁢ 2 ⁢ 8 ⁢ 5 ⁢ 7 ⁢ 2$ $q \left[1⁢6⁢4\right] = - 0 . 0 ⁢ 3 ⁢ 8 ⁢ 1 ⁢ 8 ⁢ 3 ⁢ 3 ⁢ 2 ⁢ 4 ⁢ 9$ $q \left[1⁢6⁢5\right] = - 0 . 0 ⁢ 4 ⁢ 5 ⁢ 4 ⁢ 6 ⁢ 1 ⁢ 5 ⁢ 3 ⁢ 8 ⁢ 8$ $q \left[166\right] = - 0 . 0526783466$ $q \left[167\right] = - 0 . 0598343081$ $q \left[1⁢6⁢8\right] = - 0 . 0 ⁢ 6 ⁢ 6 ⁢ 9 ⁢ 2 ⁢ 9 ⁢ 6 ⁢ 8 ⁢ 3 ⁢ 1$ $q \left[1⁢6⁢9\right] = - 0 . 0 ⁢ 7 ⁢ 3 ⁢ 9 ⁢ 6 ⁢ 4 ⁢ 4 ⁢ 1 ⁢ 7 ⁢ 4$ $q \left[170\right] = - 0.0809381268$ $q \left[171\right] = - 0 . 0 ⁢ 8 ⁢ 7 ⁢ 8 ⁢ 5 ⁢ 0 ⁢ 0 ⁢ 7 ⁢ 9 ⁢ 9$ $q \left[172\right] = - 0 . 0 ⁢ 9 ⁢ 4 ⁢ 6 ⁢ 9 ⁢ 9 ⁢ 1 ⁢ 7 ⁢ 8 ⁢ 3$ $q \left[1⁢7⁢3\right] = - 0 . 1 ⁢ 0 ⁢ 1 ⁢ 4 ⁢ 8 ⁢ 3 ⁢ 9 ⁢ 3 ⁢ 4 ⁢ 1$ $q \left[1⁢7⁢4\right] = - 0.1082024454$ $q \left[1⁢7⁢5\right] = - 0.1148523686$ $q \left[1⁢7⁢6\right] = - 0.1214308876$ $q \left[1⁢7⁢7\right] = - 0.1279346790$ $q \left[1⁢7⁢8\right] = - 0.1343598738$ $q \left[1⁢7⁢9\right] = - 0.1407020132$ $q \left[180\right] = - 0 . 1 ⁢ 4 ⁢ 6 ⁢ 9 ⁢ 5 ⁢ 6 ⁢ 0 ⁢ 0 ⁢ 0 ⁢ 5$ $q \left[1⁢8⁢1\right] = - 0.1531160455$ $q \left[1⁢8⁢2\right] = - 0.1591756024$ $q \left[183\right] = - 0 . 1651273005$ $q \left[1⁢8⁢4\right] = - 0 . 1 ⁢ 7 ⁢ 0 ⁢ 9 ⁢ 6 ⁢ 2 ⁢ 8 ⁢ 6 ⁢ 3 ⁢ 6$ $q \left[1⁢8⁢5\right] = - 0 . 1 ⁢ 7 ⁢ 6 ⁢ 6 ⁢ 7 ⁢ 3 ⁢ 0 ⁢ 2 ⁢ 0 ⁢ 2$ $q \left[1⁢8⁢6\right] = - 0.1822474011$ $q \left[1⁢8⁢7\right] = - 0.1876744222$ $q \left[1⁢8⁢8\right] = - 0.1929411519$ $q \left[1⁢8⁢9\right] = - 0.1980331588$ $q \left[1⁢9⁢0\right] = - 0.2029343380$ $q \left[1⁢9⁢1\right] = - 0.2076267137$

13. Appareil de filtration selon l'une quelconque des revendications précédentes, dans lequel la caractéristique de filtre est basée sur une caractéristique de filtre HRTF.

14. Appareil de filtration selon l'une quelconque des revendications précédentes, dans lequel le banc de filtres d'analyse complexe (101) comprend un échantillonneur descendant (140) pour chaque signal de sous-bande sorti par le banc de filtres d'analyse complexe (101).

15. Appareil de filtration selon la revendication 14, dans lequel le banc de filtres d'analyse complexe (101) est adapté pour sortir L signaux de sous-bande complexes, où L est un nombre entier positif supérieur à 1, et dans lequel chacun des échantillonneurs descendants (140) est adapté pour échantillonner les signaux de sous-bande vers le bas d'un facteur de L.

16. Appareil de filtration selon l'une quelconque des revendications précédentes, dans lequel le banc de filtres d'analyse complexe (101) comprend un filtre modulé complexe pour chaque signal de sous-bande complexe sur base d'un filtre prototype.

17. Appareil de filtration selon l'une quelconque des revendications précédentes, dans lequel le banc de filtres de synthèse complexe (103) comprend un échantillonneur ascendant (160) pour chacun des signaux de sous-bande.

18. Appareil de filtration selon la revendication 17, dans lequel le banc de filtres de synthèse complexe (103) est opérationnel pour synthétiser L signaux des filtres intermédiaires, pour obtenir le signal de sortie dans le domaine temporal, où L est un nombre entier positif supérieur à 1, dans lequel le banc de filtres de synthèse complexe (103) comprend L échantillonneurs ascendants (160) et dans lequel chacun des échantillonneurs ascendants (160) est adapté pour échantillonner la sortie des filtres intermédiaires (190) vers le haut d'un facteur de L.

19. Appareil de filtration selon l'une quelconque des revendications précédentes, dans lequel le banc de filtres de synthèse complexe (103) comprend, pour chaque signal de sous-bande, un filtre de synthèse intermédiaire, dans lequel le banc de filtres de synthèse complexe (103) comprend un extracteur de partie réelle (180) pour chaque signal sorti par les filtres de synthèse intermédiaires (150), et dans lequel le banc de filtres de synthèse complexe (103) comprend par ailleurs un additionneur (170) destiné à additionner la sortie de chacun des extracteurs de partie réelle (180), pour obtenir le signal de sortie dans le domaine temporel.

20. Appareil de filtration selon l'une quelconque des revendications 1 à 18, dans lequel le banc de filtres de synthèse complexe (103) comprend un filtre de synthèse intermédiaire (150) pour chacun des signaux de sous-bande sortis par les filtres intermédiaires (190), dans lequel le banc de filtres de synthèse complexe (103) comprend par ailleurs un additionneur (170) destiné à additionner les sorties de chacun des filtres de synthèse intermédiaires (150) et dans lequel le banc de filtres de synthèse complexe (103) comprend par ailleurs un extracteur de partie réelle (180) destiné à extraire un signal à valeurs réelles comme signal de sortie dans le domaine temporel de la sortie de l'additionneur (170).

21. Appareil de filtration selon l'une quelconque des revendications précédentes, dans lequel l'appareil de filtration comprend par ailleurs un ajusteur de gain pour au moins un signal de sous-bande ou pour au moins un signal sorti par le filtre intermédiaire (190) pour ajuster le gain.

22. Appareil de filtration selon l'une quelconque des revendications précédentes, dans lequel l'appareil de filtration comprend par ailleurs un autre filtre intermédiaire destiné à filtrer au moins l'un des signaux de sous-bande à valeurs complexes ou à filtrer au moins l'un des signaux sortis par l'un des filtres intermédiaires (190).

23. Procédé pour filtrer un signal d'entrée dans le domaine temporel, pour obtenir un signal de sortie dans le domaine temporel qui est une représentation du signal d'entrée dans le domaine temporel filtré à l'aide d'une caractéristique de filtre présentant une caractéristique d'amplitude/de fréquence non uniforme,
comprenant les étapes consistant à:
filtrer un signal de réponse impulsionnelle finie comprenant K_{H} · L dérivations de filtre et indiquant la caractéristique de filtre de la caractéristique d'amplitude/de fréquence sur base d'un filtre prototype comprenant K_{Q} · L dérivations pour obtenir L signaux de sous-bande à valeurs complexes comme signal de définition de filtre intermédiaire,
dans lequel chaque signal de sous-bande à valeurs complexes du signal de définition de filtre intermédiaire correspond à une réponse impulsionnelle pour une sous-bande comprenant (K_{H} + K_{Q} - 1) dérivations de filtre;
dans lequel au moins l'un des signaux de sous-bande à valeurs complexes du signal de définition de filtre intermédiaire comprend au moins deux valeurs non évanouissantes différentes; et
dans lequel au moins l'un des signaux de sous-bande à valeurs complexes du signal de définition de filtre intermédiaire correspond à une caractéristique d'amplitude/de fréquence non uniforme;
analyser le signal d'entrée dans le domaine du temps, pour obtenir L signaux de sous-bande complexes;
filtrer chacun des signaux de sous-bande complexes analysés,
dans lequel au moins l'un des signaux de sous-bande complexes est filtré à l'aide d'une caractéristique d'amplitude/de fréquence non uniforme,
dans lequel chacun des signaux de sous-bande complexes est filtré sur base d'une réponse impulsionnelle de filtre du signal de définition de filtre;
dans lequel les réponses impulsionnelles de filtre du signal de définition de filtre comprenant (K_{H} + K_{Q} - 1) dérivations de filtre sont, chacune, plus courtes que la réponse impulsionnelle d'un filtre ayant la caractéristique de filtre comprenant K_{H} · L dérivations; et
dans lequel la caractéristique d'amplitude/de fréquence non uniforme des réponses impulsionnelles utilisée pour filtrer la pluralité de signaux de sous-bande représente, ensemble, la caractéristique de filtre non uniforme; et
synthétiser à partir de la sortie de la filtration des signaux de sous-bande complexes analysés le signal de sortie dans le domaine temporel,
dans lequel L, K_{Q} et K_{H} sont des nombres entiers positifs.

24. Programme d'ordinateur pour réaliser, lorsqu'il est exécuté sur un ordinateur, un procédé selon le procédé de la revendication 23.
